(19) Europäisches Patentamt
European Patent Office
Office européen des brevets

(11) **EP 4 529 059 A1**

(12) **EUROPEAN PATENT APPLICATION**
published in accordance with Art. 153(4) EPC

(43) Date of publication:
**26.03.2025 Bulletin 2025/13**

(21) Application number: **23826126.7**

(22) Date of filing: **05.06.2023**

(51) International Patent Classification (IPC):
**H04L 1/00** (2006.01)

(52) Cooperative Patent Classification (CPC):
**H03M 13/27; H04L 1/00**

(86) International application number:
**PCT/CN2023/098219**

(87) International publication number:
**WO 2023/246477 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 24.06.2022 CN 202210727137
22.07.2022 CN 202210867882
04.04.2023 CN 202310382561

(71) Applicant: **Huawei Technologies Co., Ltd.**
**Shenzhen, Guangdong 518129 (CN)**

(72) Inventors:
• **HUANG, Kechao**
**Shenzhen, Guangdong 518129 (CN)**
• **YANG, Xiaoling**
**Shenzhen, Guangdong 518129 (CN)**
• **MA, Huixiao**
**Shenzhen, Guangdong 518129 (CN)**

(74) Representative: **Huawei European IPR**
**Huawei Technologies Duesseldorf GmbH**
**Riesstraße 25**
**80992 München (DE)**

(54) **DATA PROCESSING METHOD AND DATA PROCESSING APPARATUS**

(57)     Embodiments of this application disclose a data processing method and a data processing apparatus. The method is specifically as follows: separately performing inner-code encoding on n first data streams to obtain n second data streams, where the n second data streams include n inner-code codewords from the n second data streams, the n inner-code codewords include n/m codeword sets, each of the codeword sets includes m inner-code codewords, and each of the inner-code codewords includes N bits; separately performing bit interleaving on the n/m codeword sets to obtain n/m target bit sets; and separately mapping m×N bits in each of the target bit sets to obtain m×N/L modulation symbols, to obtain a total of n×N/L modulation symbols, where every L bits are mapped to one modulation symbol, and the L bits in the modulation symbol are from L inner-code codewords, where if the L bits in the modulation symbol are all from information bits in the inner-code codewords, any two bits in the modulation symbol are from two different locations in two different inner-code codewords.

FIG. 3

EP 4 529 059 A1

## Description

This application claims priorities to Chinese Patent Application No. 202210727137.1, filed with the China National Intellectual Property Administration on June 24, 2022 and entitled "DATA PROCESSING METHOD AND DATA PROCESSING APPARATUS", to Chinese Patent Application No. 202210867882.6, filed with the China National Intellectual Property Administration on July 22, 2022 and entitled "DATA PROCESSING METHOD AND DATA PROCESSING APPARATUS", and to Chinese Patent Application No. 202310382561.1, filed with the China National Intellectual Property Administration on April 4, 2023 and entitled "DATA PROCESSING METHOD AND DATA PROCESSING APPARATUS", all of which are incorporated herein by reference in their entireties.

## TECHNICAL FIELD

This application relates to the communications field, and in particular, to a data processing method and a data processing apparatus.

## BACKGROUND

Continuously driven by 5G, cloud computing, big data, artificial intelligence, and the like, a high-speed optical transmission network is developing towards a large capacity, packetization, and intelligentization. Performing forward error correction (forward error correction, FEC) encoding on transmitted data for error correction can resolve the problem of transmission bit errors, to restore, from received data, original data sent by a transmitter.

Currently, a concatenated FEC transmission solution is proposed. A transmitter device and a transmitter processing module are connected through an attachment unit interface (attachment unit interface, AUI). The transmitter device performs first FEC encoding on to-be-transmitted data, and sends first-FEC encoded data to the transmitter processing module. The transmitter processing module then performs second FEC encoding on the first-FEC encoded data; performs modulation and mapping on a second-FEC encoded bit sequence, to generate a corresponding modulation symbol sequence; and finally transmits the generated symbol sequence to a receiver through an optical transmission network. The receiver may obtain, by demodulating and decoding the received modulation symbol sequence, information sent by the transmitter.

Generally, concatenated encoding and interleaving are performed before the second FEC encoding, and the first-FEC encoded data is disordered, to enhance error correction performance of the overall FEC solution. In addition, in an actual transmission process of the modulation symbol sequence, a transmission link is affected by a burst factor. Consequently, errors occur in several consecutive symbols in the modulation symbol sequence, and the receiver receives the modulation symbol sequence subject to the burst factor. Because there are a large quantity of consecutive errors, it is difficult to accurately perform error correction through FEC encoding. Consequently, a bit error rate of information transmission is high.

## SUMMARY

Embodiments of this application provide a data processing method and a data processing apparatus, so that a concatenated FEC transmission solution has a strong burst resistance capability, and can be applied to a large quantity of transmission scenarios, particularly an actual coherent transmission scenario in which there is colored noise on a channel.

According to a first aspect, this application provides a data processing method. The method includes the following steps. First, inner-code encoding is separately performed on n first data streams to obtain n second data streams, where outer-code encoding is performed on all of the n first data streams, both the inner-code encoding and the outer-code encoding are FEC encoding, the n second data streams at least include n inner-code codewords, the n inner-code codewords are from the n second data streams, the n inner-code codewords include n/m codeword sets, each codeword set includes m inner-code codewords, each of the inner-code codewords includes N bits, the N bits include K information bits and P parity bits, n is an integer greater than 1, and n is divisible by m. Then, bit interleaving is separately performed on the n/m codeword sets to obtain n/m target bit sets, where each of the target bit sets includes $m \times N$ bits. Further, the $m \times N$ bits in each of the target bit sets are separately mapped to obtain $m \times N/L$ modulation symbols, to obtain a total of $n \times N/L$ modulation symbols, where every L bits are mapped to one modulation symbol, m is divisible by L, and the L bits mapped to the modulation symbol are from L inner-code codewords. If the L bits mapped to the modulation symbol are all from information bits in the inner-code codewords, any two of the L bits mapped to the modulation symbol are from two different locations in two different inner-code codewords.

In this implementation, a concatenated-FEC transmission solution is used. That is, the outer-code encoding and the inner-code encoding are sequentially performed on the data streams. On this basis, this application designs a bit interleaving and mapping method, so that both bits in an outer-code codeword and bits in an inner-code codeword are discretely and evenly mapped to modulation symbols. In this way, the concatenated-FEC transmission solution has a strong burst resistance capability. Particularly, a burst error with a small length may be directly corrected through inner-code decoding. The concatenated-FEC transmission solution is widely applicable to transmission scenarios, particularly an actual coherent transmission scenario in which there is colored noise on a channel.

In some possible implementations, N is divisible by L, the N bits in each inner-code codeword are mapped to N modulation symbols, the N bits in the inner-code codeword include L first bit subsets, bits in a same first bit subset are separately mapped to same bits in different modulation symbols, and bits in different first bit subsets are separately mapped to different bits in different modulation symbols. For example, one modulation symbol includes a bit $b_0$, a bit $b_1$, ..., and a bit $b_{L-1}$, and quantities of bits that are in the N bits in the inner-code codeword and that are mapped to the bit $b_0$, the bit $b_1$, ..., and the bit $b_{L-1}$ are all N/L. It should be understood that, probabilities that errors occur in the L bits in transmission are not necessarily equal. Bits in one inner-code codeword are more evenly mapped to modulation symbols, so that a burst resistance capability of the concatenated-FEC solution in actual transmission can be improved.

In some possible implementations, that the bit interleaving is performed on the codeword set to obtain the target bit set includes: First location transformation is performed on the K information bits in each inner-code codeword in the codeword set to obtain a first bit set. Second location transformation is performed on bits at a same location in the first bit set to obtain the target bit set. For example, the codeword set is represented as a bit matrix. The first location transformation may be understood as performing location transformation on bits in each row, and the second location transformation may be understood as performing location transformation on bits in each column. This implementation provides a specific implementation of the bit interleaving, so that this solution has the strong anti-burst capability.

In some possible implementations, that first location transformation is performed on the K information bits in each inner-code codeword in the codeword set includes: Left circular shift or right circular shift is performed on the K information bits in each inner-code codeword in the codeword set. This implementation provides a specific implementation of the first location transformation, and has a good practical effect.

In some possible implementations, both the codeword set and the first bit set are represented as bit matrixes, the target bit set is represented as a bit matrix or a one-dimensional array, the bit matrix includes m rows and N columns of bits, the one-dimensional array includes the m×N bits, and the bits at the same location in the first bit set are a total of m bits in one column in the bit matrix corresponding to the first bit set.

In some possible implementations, the first location transformation satisfies a first condition, and the first condition includes:

$$H_2[i][j] = \begin{cases} H_1[i][(j + i \times \Delta)\%K], 0 \le j < K \\ H_1[i][j], K \le j < N \end{cases}$$

where $H_1[i][j]$ represents a bit in an $i^{th}$ row and a $j^{th}$ column in the bit matrix on which the first location transformation has not been performed, $H_2[i][j]$ represents a bit in an $i^{th}$ row and a $j^{th}$ column in the bit matrix obtained through the first location transformation, Y%Z represents a remainder obtained by dividing the integer Y by the integer Z, $\Delta$ is a non-zero integer greater than -K and less than K, and $0 \le i < m$.

In some possible implementations, each same location in the first bit set includes m/L second bit subsets, each second bit subset includes L bits, and that second location transformation is performed on bits at a same location in the first bit set includes: Upward circular shift or downward circular shift is performed on the m/L second bit subsets at each same location in the first bit set. This implementation provides a specific implementation of the second location transformation, and has a good practical effect.

In some possible implementations, the second location transformation satisfies a second condition, and the second condition includes:

$$H_3[i][j] = H_2\big[\big(i + \theta \times (j\%L)\big)\%L + \lfloor i/L \rfloor \times L\big][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, $\theta$ is a non-zero integer greater than -L and less than L, $0 \le i < m$, and $0 \le j < N$.

In some possible implementations, the second location transformation satisfies a third condition, and the third condition includes:

$$H_3[i][j] = H_2[(i\%L)\wedge(j\%L) + \lfloor i/L \rfloor \times L][j]$$

where $H_2[i][j]$ represents a bit in an $i^{th}$ row and a $j^{th}$ column in the bit matrix on which the second location transformation has

not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \le i < m$, and $0 \le j < N$.

In some possible implementations, the second location transformation satisfies a fourth condition, and the fourth condition includes:

$$H_3[i][j] = H_2[i \wedge (j\%L)][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \le i < m$, and $0 \le j < N$.

In some possible implementations, the codeword set is represented as a bit matrix, the target bit set is represented as a bit matrix or a one-dimensional array, the bit matrix includes m rows and N columns of bits, and the one-dimensional array includes the m×N bits.

In some possible implementations, the target bit set is the bit matrix, the bit interleaving satisfies a fifth condition, and the fifth condition includes:

$$H_3[i][j] = \begin{cases} H_1\left[(i + \theta \times (j\%L))\%L + \lfloor i/L \rfloor \times L\right]\left[\left(j + \left((i + \theta \times (j\%L))\%L + \lfloor i/L \rfloor \times L\right) \times \Delta\right)\%K\right], 0 \le j < K \\ H_1\left[(i + \theta \times (j\%L))\%L + \lfloor i/L \rfloor \times L\right][j], K \le j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \le i < m$.

In some possible implementations, the target bit set is the one-dimensional array, the bit interleaving satisfies a sixth condition, and the sixth condition includes:

$$A[i + j \times m]$$
$$= \begin{cases} H_1\left[(i + \theta \times (j\%L))\%L + \lfloor i/L \rfloor \times L\right]\left[\left(j + \left((i + \theta \times (j\%L))\%L + \lfloor i/L \rfloor \times L\right) \times \Delta\right)\%K\right], 0 \le j < K \\ H_1\left[(i + \theta \times (j\%L))\%L + \lfloor i/L \rfloor \times L\right][j], K \le j < N \end{cases}$$

where $H_1[i][j]$ represents a bit in an $i^{th}$ row and a $j^{th}$ column in the bit matrix on which the bit interleaving has not been performed, A[t] represents a $t^{th}$ bit in the one-dimensional array obtained through the bit interleaving, $0 \le t < m \times N$, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \le i < m$.

In some possible implementations, the target bit set is the bit matrix, the bit interleaving satisfies a seventh condition, and the seventh condition includes:

$$H_3[i][j] = \begin{cases} H_1[i \wedge (j\%L)]\left[\left(j + (i \wedge (j\%L)) \times \Delta\right)\%K\right], 0 \le j < K \\ H_1[i \wedge (j\%L)][j], K \le j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, Y^Z represents an integer corresponding to a bit sequence obtained through an exclusive OR operation performed on a bit sequence corresponding to the integer Y and a bit sequence corresponding to the integer Z, and $0 \le i < m$.

In some possible implementations, the target bit set is the one-dimensional array, the bit interleaving satisfies an eighth condition, and the eighth condition includes:

$$A[i + j \times m] = \begin{cases} H_1[i^\wedge(j\%L)][(j + (i^\wedge(j\%L)) \times \Delta)\%K], 0 \le j < K \\ H_1[i^\wedge(j\%L)][j], K \le j < N \end{cases}$$

where $H_1[i][j]$ represents a bit in an $i$th row and a $j$th column in the bit matrix on which the bit interleaving has not been performed, $A[t]$ represents a $t$th bit in the one-dimensional array obtained through the bit interleaving, $0 \le t < m \times N$, $Y\%Z$ represents a remainder obtained by dividing the integer Y by the integer Z, $\Delta$ is a non-zero integer greater than -K and less than K, $Y^\wedge Z$ represents an integer corresponding to a bit sequence obtained through an exclusive OR operation performed on a bit sequence corresponding to the integer Y and a bit sequence corresponding to the integer Z, and $0 \le i < m$.

In some possible implementations, that the m×N bits in each target bit set are mapped to obtain m×N/L modulation symbols includes: every L consecutive bits at a same location in each target bit set are mapped to one modulation symbol, to obtain the m×N/L modulation symbols.

In some possible implementations, a modulation symbol stream includes the m×N/L modulation symbols obtained through the mapping, and m/L modulation symbols obtained through mapping of m bits at the same location in each target bit set are consecutive in the modulation symbol stream, where when the target bit set is represented as the bit matrix, the m bits at the same location in the target bit set are m bits in one column in the bit matrix; or when the target bit set is represented as the one-dimensional array, the m bits at the same location in the target bit set are m consecutive bits in the one-dimensional array.

In some possible implementations, a modulation symbol stream includes the m×N/L modulation symbols obtained through the mapping, each target bit set is represented as the bit matrix including the m rows and the N columns of bits, m bits in one column in each target bit set are mapped to obtain m/L first modulation symbols, every T consecutive first modulation symbols in the m/L first modulation symbols are consecutive in the modulation symbol stream, m bits in another column in each target bit set are mapped to obtain m/L second modulation symbols, every T consecutive second modulation symbols in the m/L second modulation symbols are consecutive in the modulation symbol stream, the column is adjacent to the another column, the T consecutive first modulation symbols in the m/L first modulation symbols and the T consecutive second modulation symbols in the m/L second modulation symbols are consecutive in the modulation symbol stream, and m/L is divisible by T.

In some possible implementations, alignment marker lock and lane de-skew processing are performed on all of the n first data streams; and when W×L bits in W consecutive modulation symbols are all information bits in an inner-code codeword, the W×L bits are from more than two outer-code codewords obtained through the outer-code encoding, where W≥2.

In some possible implementations, each modulation symbol is a dual-polarization quadrature amplitude modulation (DP-16QAM) modulation symbol, and each modulation symbol includes eight bits; or each modulation symbol is a pulse amplitude modulation (PAM4) modulation symbol, and each modulation symbol includes two bits.

According to a second aspect, this application provides a data processing method. The method includes the following steps. First, inner-code encoding is separately performed on n first data streams to obtain n second data streams, where outer-code encoding is performed on all of the n first data streams, both the inner-code encoding and the outer-code encoding are FEC encoding, the n second data streams at least include n inner-code codewords, the n inner-code codewords are from the n second data streams, the n inner-code codewords include n/m codeword sets, each codeword set includes m inner-code codewords, each of the inner-code codewords includes N bits, the N bits include K information bits and P parity bits, n is an integer greater than 1, and n is divisible by m. Then, bit interleaving is separately performed on the n/m codeword sets to obtain n/m target bit sets, where each of the target bit sets includes m×N bits, and the bit interleaving includes performing location transformation on the K information bits in each inner-code codeword in the codeword set. Further, the m×N bits in each of the target bit sets are separately mapped to obtain m×N/L modulation symbols, to obtain a total of n×N/L modulation symbols, where every L bits are mapped to one modulation symbol, m is divisible by L, the L bits mapped to the modulation symbol are from $L_r$ inner-code codewords, $L_c$ bits in each of the $L_r$ inner-code codewords are mapped to the modulation symbol, 2L bits mapped to two consecutive modulation symbols are from $2L_r$ inner-code codewords, $L = L_r \times L_c$, and $L_c > 1$.

In some possible implementations, that location transformation is performed on the K information bits in each inner-code codeword in the codeword set includes: Left circular shift or right circular shift is performed on the K information bits in each inner-code codeword in the codeword set.

In some possible implementations, the codeword set is represented as a bit matrix, the target bit set is represented as a bit matrix or a one-dimensional array, the bit matrix includes m rows and N columns of bits, and the one-dimensional array includes the m×N bits.

In some possible implementations, the location transformation satisfies a target condition, and the target condition includes:

$$H_2[i][j] = \begin{cases} H_1[i][(j + i \times \Delta)\%K], 0 \le j < K \\ H_1[i][j], K \le j < N \end{cases}$$

where $H_1[i][j]$ represents a bit in an $i^{th}$ row and a $j^{th}$ column in the bit matrix on which the location transformation has not been performed, $H_2[i][j]$ represents a bit in an $i^{th}$ row and a $j^{th}$ column in the bit matrix obtained through the location transformation, Y%Z represents a remainder obtained by dividing the integer Y by the integer Z, $\Delta$ is a non-zero integer greater than -K and less than K, and $0 \le i < m$.

In some possible implementations, each target bit set includes the m rows and the N columns of bits, and a total of L bits in every $L_r$ rows and $L_c$ columns in the target bit set are mapped to one modulation symbol.

In some possible implementations, a modulation symbol stream includes the m×N/L modulation symbols obtained through the mapping, $m/L_r$ modulation symbols obtained through mapping of every $L_c$ columns of bits in the target bit set are consecutive in the modulation symbol stream, and m × N/L modulation symbols obtained through mapping of every N columns of bits in the target bit set are consecutive in the modulation symbol stream.

In some possible implementations, a modulation symbol stream includes the m×N/L modulation symbols obtained through the mapping, bits in $L_c$ columns in each target bit set are mapped to obtain $m/L_r$ first modulation symbols, every T consecutive first modulation symbols in the $m/L_r$ first modulation symbols are consecutive in the modulation symbol stream, bits in $L_c$ other columns in each target bit set are mapped to obtain $m/L_r$ second modulation symbols, every T consecutive second modulation symbols in the $m/L_r$ second modulation symbols are consecutive in the modulation symbol stream, the $L_c$ columns are adjacent to the $L_c$ other columns, the T consecutive first modulation symbols in the $m/L_r$ first modulation symbols and the T consecutive second modulation symbols in the $m/L_r$ second modulation symbols are consecutive in the modulation symbol stream, and $m/L_r$ is divisible by T.

In some possible implementations, each modulation symbol is a dual-polarization quadrature amplitude modulation (DP-16QAM) modulation symbol, and each modulation symbol includes eight bits; or each modulation symbol is a pulse amplitude modulation (PAM4) modulation symbol, and each modulation symbol includes two bits.

According to a third aspect, this application provides a data processing apparatus. The data processing apparatus includes an encoding module, a bit interleaving module, and a bit mapping module. The encoding module is configured to separately perform inner-code encoding on n first data streams to obtain n second data streams, where outer-code encoding is performed on all of the n first data streams, both the inner-code encoding and the outer-code encoding are forward error correction FEC encoding, the n second data streams at least include n inner-code codewords, the n inner-code codewords are from the n second data streams, the n inner-code codewords include n/m codeword sets, each codeword set includes m inner-code codewords, each of the inner-code codewords includes N bits, the N bits include K information bits and P parity bits, n is an integer greater than 1, and n is divisible by m. The bit interleaving module is configured to separately perform bit interleaving on the n/m codeword sets to obtain n/m target bit sets, where each of the target bit sets includes m×N bits. The bit mapping module is configured to map the m×N bits in each of the target bits set to obtain m×N/L modulation symbols, to obtain a total of n×N/L modulation symbols, where every L bits are mapped to one modulation symbol, m is divisible by L, and the L bits mapped to the modulation symbol are from L inner-code codewords. If the L bits mapped to the modulation symbol are all from information bits in the inner-code codewords, any two of the L bits mapped to the modulation symbol are from two different locations in two different inner-code codewords.

In some possible implementations, N is divisible by L, the N bits in each inner-code codeword are mapped to N modulation symbols, the N bits in the inner-code codeword include L first bit subsets, bits in a same first bit subset are separately mapped to same bits in different modulation symbols, and bits in different first bit subsets are separately mapped to different bits in different modulation symbols.

In some possible implementations, the bit mapping module is specifically configured to: perform first location transformation on the K information bits in each inner-code codeword in the codeword set to obtain a first bit set; and perform second location transformation on bits at a same location in the first bit set to obtain the target bit set.

In some possible implementations, the bit mapping module is specifically configured to perform left circular shift or right circular shift on the K information bits in each inner-code codeword in the codeword set.

In some possible implementations, both the codeword set and the first bit set are represented as bit matrixes, the target bit set is represented as a bit matrix or a one-dimensional array, the bit matrix includes m rows and N columns of bits, the one-dimensional array includes the m×N bits, and the bits at the same location in the first bit set are a total of m bits in one column in the bit matrix corresponding to the first bit set.

In some possible implementations, the first location transformation satisfies a first condition, and the first condition includes:

$$H_2[i][j] = \begin{cases} H_1[i][(j + i \times \Delta)\%K], 0 \le j < K \\ H_1[i][j], K \le j < N \end{cases}$$

where $H_1[i][j]$ represents a bit in an $i^{th}$ row and a $j^{th}$ column in the bit matrix on which the first location transformation has not

been performed, $H_2[i][j]$ represents a bit in an $i^{th}$ row and a $j^{th}$ column in the bit matrix obtained through the first location transformation, Y%Z represents a remainder obtained by dividing the integer Y by the integer Z, $\Delta$ is a non-zero integer greater than -K and less than K, and $0 \leq i < m$.

In some possible implementations, each same location in the first bit set includes m/L second bit subsets, each second bit subset includes L bits, and the bit mapping module is specifically configured to perform upward circular shift or downward circular shift on the m/L second bit subsets at each same location in the first bit set.

In some possible implementations, the second location transformation satisfies a second condition, and the second condition includes:

$$H_3[i][j] = H_2\left[(i + \theta \times (j\%L))\%L + \lfloor i/L \rfloor \times L\right][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, $\theta$ is a non-zero integer greater than -L and less than L, $0 \leq i < m$, and $0 \leq j < N$.

In some possible implementations, the second location transformation satisfies a third condition, and the third condition includes:

$$H_3[i][j] = H_2[(i\%L)\wedge(j\%L) + \lfloor i/L \rfloor \times L][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \leq i < m$, and $0 \leq j < N$.

In some possible implementations, the second location transformation satisfies a fourth condition, and the fourth condition includes:

$$H_3[i][j] = H_2[i\wedge(j\%L)][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \leq i < m$, and $0 \leq j < N$.

In some possible implementations, the codeword set is represented as a bit matrix, the target bit set is represented as a bit matrix or a one-dimensional array, the bit matrix includes m rows and N columns of bits, and the one-dimensional array includes the m×N bits.

In some possible implementations, the target bit set is the bit matrix, the bit interleaving satisfies a fifth condition, and the fifth condition includes:

$$H_3[i][j] = \begin{cases} H_1\left[(i + \theta \times (j\%L))\%L + \lfloor i/L \rfloor \times L\right]\left[\left(j + \left((i + \theta \times (j\%L))\%L + \lfloor i/L \rfloor \times L\right) \times \Delta\right)\%K\right], 0 \leq j < K \\ H_1\left[(i + \theta \times (j\%L))\%L + \lfloor i/L \rfloor \times L\right][j], K \leq j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \leq i < m$.

In some possible implementations, the target bit set is the one-dimensional array, the bit interleaving satisfies a sixth condition, and the sixth condition includes:

$$A[i + j \times m]$$

$$= \begin{cases} H_1\left[\big((i + \theta \times (j\%L))\%L + \lfloor i/L \rfloor \times L\big)\right]\left[\big(j + \big((i + \theta \times (j\%L))\%L + \lfloor i/L \rfloor \times L\big) \times \Delta\big)\%K\right], 0 \le j < K \\ H_1\left[\big((i + \theta \times (j\%L))\%L + \lfloor i/L \rfloor \times L\big)\right][j], K \le j < N \end{cases}$$

where $H_1[i][j]$ represents a bit in an $i^{th}$ row and a $j^{th}$ column in the bit matrix on which the bit interleaving has not been performed, $A[t]$ represents a $t^{th}$ bit in the one-dimensional array obtained through the bit interleaving, $0 \le t < m \times N$, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \le i < m$.

In some possible implementations, the target bit set is the bit matrix, the bit interleaving satisfies a seventh condition, and the seventh condition includes:

$$H_3[i][j] = \begin{cases} H_1[i^\wedge(j\%L)]\left[\big(j + \big(i^\wedge(j\%L)\big) \times \Delta\big)\%K\right], 0 \le j < K \\ H_1[i^\wedge(j\%L)][j], K \le j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, Y^Z represents an integer corresponding to a bit sequence obtained through an exclusive OR operation performed on a bit sequence corresponding to the integer Y and a bit sequence corresponding to the integer Z, and $0 \le i < m$.

In some possible implementations, the target bit set is the one-dimensional array, the bit interleaving satisfies an eighth condition, and the eighth condition includes:

$$A[i + j \times m] = \begin{cases} H_1[i^\wedge(j\%L)]\left[\big(j + \big(i^\wedge(j\%L)\big) \times \Delta\big)\%K\right], 0 \le j < K \\ H_1[i^\wedge(j\%L)][j], K \le j < N \end{cases}$$

where $H_1[i][j]$ represents a bit in an $i^{th}$ row and a $j^{th}$ column in the bit matrix on which the bit interleaving has not been performed, $A[t]$ represents a $t^{th}$ bit in the one-dimensional array obtained through the bit interleaving, $0 \le t < m \times N$, Y%Z represents a remainder obtained by dividing the integer Y by the integer Z, $\Delta$ is a non-zero integer greater than -K and less than K, Y^Z represents an integer corresponding to a bit sequence obtained through an exclusive OR operation performed on a bit sequence corresponding to the integer Y and a bit sequence corresponding to the integer Z, and $0 \le i < m$.

In some possible implementations, the bit mapping module is specifically configured to map every L consecutive bits at a same location in each target bit set to one modulation symbol, to obtain the $m \times N/L$ modulation symbols.

In some possible implementations, a modulation symbol stream includes the $m \times N/L$ modulation symbols obtained through the mapping, and m/L modulation symbols obtained through mapping of m bits at the same location in each target bit set are consecutive in the modulation symbol stream, where when the target bit set is represented as the bit matrix, the m bits at the same location in the target bit set are m bits in one column in the bit matrix; or when the target bit set is represented as the one-dimensional array, the m bits at the same location in the target bit set are m consecutive bits in the one-dimensional array.

In some possible implementations, a modulation symbol stream includes the $m \times N/L$ modulation symbols obtained through the mapping, each target bit set is represented as the bit matrix including the m rows and the N columns of bits, m bits in one column in each target bit set are mapped to obtain m/L first modulation symbols, every T consecutive first modulation symbols in the m/L first modulation symbols are consecutive in the modulation symbol stream, m bits in another column in each target bit set are mapped to obtain m/L second modulation symbols, every T consecutive second modulation symbols in the m/L second modulation symbols are consecutive in the modulation symbol stream, the column is adjacent to the another column, the T consecutive first modulation symbols in the m/L first modulation symbols and the T consecutive second modulation symbols in the m/L second modulation symbols are consecutive in the modulation symbol stream, and m/L is divisible by T.

In some possible implementations, alignment marker lock and lane de-skew processing are performed on all of the n first data streams; and when $W \times L$ bits in W consecutive modulation symbols are all information bits in an inner-code codeword, the $W \times L$ bits are from more than two outer-code codewords obtained through the outer-code encoding, where $W \ge 2$.

In some possible implementations, each modulation symbol is a DP-16QAM modulation symbol, and each modulation symbol includes eight bits; or each modulation symbol is a PAM4 modulation symbol, and each modulation symbol includes two bits.

According to a fourth aspect, this application provides a data processing apparatus. The data processing apparatus includes an encoding module, a bit interleaving module, and a bit mapping module. The encoding module is configured to separately perform inner-code encoding on n first data streams to obtain n second data streams, where outer-code encoding is performed on all of the n first data streams, both the inner-code encoding and the outer-code encoding are forward error correction FEC encoding, the n second data streams at least include n inner-code codewords, the n inner-code codewords are from the n second data streams, the n inner-code codewords include n/m codeword sets, each codeword set includes m inner-code codewords, each of the inner-code codewords includes N bits, the N bits include K information bits and P parity bits, n is an integer greater than 1, and n is divisible by m. The bit interleaving module is configured to separately perform bit interleaving on the n/m codeword sets to obtain n/m target bit sets, where each of the target bit sets includes m×N bits, and the bit interleaving includes performing location transformation on the K information bits in each inner-code codeword in the codeword set. The bit mapping module is configured to map the m×N bits in each of the target bit sets to obtain m×N/L modulation symbols, to obtain a total of n×N/L modulation symbols, where every L bits are mapped to one modulation symbol, m is divisible by L, the L bits mapped to the modulation symbol are from $L_r$ inner-code codewords, $L_c$ bits in each of the $L_r$ inner-code codewords are mapped to the modulation symbol, 2L bits mapped to two consecutive modulation symbols are from $2L_r$ inner-code codewords, $L = L_r \times L_c$, and $L_c > 1$.

In some possible implementations, the bit interleaving module is specifically configured to perform left circular shift or right circular shift on the K information bits in each inner-code codeword in the codeword set.

In some possible implementations, the codeword set is represented as a bit matrix, the target bit set is represented as a bit matrix or a one-dimensional array, the bit matrix includes m rows and N columns of bits, and the one-dimensional array includes the m×N bits.

In some possible implementations, the location transformation satisfies a target condition, and the target condition includes:

$$H_2[i][j] = \begin{cases} H_1[i][(j + i \times \Delta)\%K], 0 \le j < K \\ H_1[i][j], K \le j < N \end{cases}$$

where $H_1[i][j]$ represents a bit in an $i^{th}$ row and a $j^{th}$ column in the bit matrix on which the location transformation has not been performed, $H_2[i][j]$ represents a bit in an $i^{th}$ row and a $j^{th}$ column in the bit matrix obtained through the location transformation, Y%Z represents a remainder obtained by dividing the integer Y by the integer Z, $\Delta$ is a non-zero integer greater than -K and less than K, and $0 \le i < m$.

In some possible implementations, each target bit set includes the m rows and the N columns of bits, and a total of L bits in every $L_r$ rows and $L_c$ columns in the target bit set are mapped to one modulation symbol.

In some possible implementations, a modulation symbol stream includes the m×N/L modulation symbols obtained through the mapping, $m/L_r$ modulation symbols obtained through mapping of every $L_c$ columns of bits in the target bit set are consecutive in the modulation symbol stream, and m × N/L modulation symbols obtained through mapping of every N columns of bits in the target bit set are consecutive in the modulation symbol stream.

In some possible implementations, a modulation symbol stream includes the m×N/L modulation symbols obtained through the mapping, bits in $L_c$ columns in each target bit set are mapped to obtain $m/L_r$ first modulation symbols, every T consecutive first modulation symbols in the $m/L_r$ first modulation symbols are consecutive in the modulation symbol stream, bits in $L_c$ other columns in each target bit set are mapped to obtain $m/L_r$ second modulation symbols, every T consecutive second modulation symbols in the $m/L_r$ second modulation symbols are consecutive in the modulation symbol stream, the $L_c$ columns are adjacent to the $L_c$ other columns, the T consecutive first modulation symbols in the $m/L_r$ first modulation symbols and the T consecutive second modulation symbols in the $m/L_r$ second modulation symbols are consecutive in the modulation symbol stream, and $m/L_r$ is divisible by T.

In some possible implementations, each modulation symbol is a DP-16QAM modulation symbol, and each modulation symbol includes eight bits; or each modulation symbol is a PAM4 modulation symbol, and each modulation symbol includes two bits.

According to a fifth aspect, this application provides a data processing method. The method includes the following steps. First, interleaving and encoding processing is separately performed on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. Then, every two bits in the $n_2$ second data streams are separately mapped to one PAM4 symbol, to obtain a total of $n_2$ PAM4 symbol data streams. Specifically, the interleaving and encoding processing includes the following steps. $a_0$ first bit sets are obtained from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1. Inner-code encoding is separately performed on the m first bit sets to obtain m inner-code codewords, where both the inner-code encoding and the outer-code encoding are forward error correction FEC encoding, each of the inner-code codewords includes one first bit set and one parity bit set that participate in the inner-code encoding and that have a total of N bits, N=K+P, each parity bit set includes P bits, and P is an integer greater than or equal to 1. Circular shift is separately performed on the m inner-code codewords to obtain m third bit sets, where each third bit set includes the one parity bit set and one second bit set that is obtained by performing the circular shift on the first bit set. Two bits are obtained from each third bit set through round robin to obtain a fourth bit set, where the fourth bit set includes m × N bits, a total of m × K bits that are from m second bit sets and that are in the fourth bit set are consecutive, and a total of m × P bits that are from m parity bit sets and that are in the fourth bit set are consecutive. It should be understood that each of the second data streams includes a plurality of fourth bit sets, a total of m × N/2 PAM4 symbols are obtained through the mapping of each of the fourth bit sets, and m × 2 bits mapped to m consecutive PAM4 symbols in the m × N/2 PAM4 symbols are from the m inner-code codewords.

In some possible implementations, the outer-code encoding is performed on each of the first data streams at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m inner-code codewords and the m third bit sets are represented as bit matrixes, and the bit matrix includes m rows and N columns of bits.

In some possible implementations, the second bit set is obtained by performing left circular shift on the first bit set by $\varphi_i$ bits, the left circular shift satisfies a first condition, and the first condition includes:

$$M_3[i][j] = \begin{cases} M_c[i][(j + \varphi_i)\%K], 0 \le j < K \\ M_c[i][j], K \le j < N \end{cases}$$

where $M_c[i][j]$ represents a bit in an $i^{th}$ row and a $j^{th}$ column in the bit matrix corresponding to the m inner-code codewords on which the left circular shift has not been performed, $M_3[i][j]$ represents a bit in an $i^{th}$ row and a $j^{th}$ column in the bit matrix corresponding to the m third bit sets obtained through the left circular shift, Y%Z represents a remainder obtained by dividing the integer Y by the integer Z, $0 \le i < m$, and $0 \le \varphi_i < K$.

In some possible implementations, the second bit set is obtained by performing right circular shift on the first bit set by $\delta_i$ bits, the right circular shift satisfies a second condition, and the second condition includes:

$$M_3[i][j] = \begin{cases} M_c[i][(j - \delta_i)\%K], 0 \le j < K \\ M_c[i][j], K \le j < N \end{cases}$$

where $M_c[i][j]$ represents a bit in an $i^{th}$ row and a $j^{th}$ column in the bit matrix corresponding to the m inner-code codewords on which the right circular shift has not been performed, $M_3[i][j]$ represents a bit in an $i^{th}$ row and a $j^{th}$ column in the bit matrix corresponding to the m third bit sets obtained through the right circular shift, Y%Z represents a remainder obtained by dividing the integer Y by the integer Z, $0 \le i < m$, and $0 \le \delta_i < K$.

In some possible implementations, the m third bit sets and the fourth bit set satisfy a third condition, and the third condition includes:

$$A[\lfloor j/2 \rfloor \times (m \times 2) + (i \times 2) + (j\%2)] = M_3[i][j]$$

where $M_3[i][j]$ represents the bit in the $i^{th}$ row and the $j^{th}$ column in the bit matrix corresponding to the m third bit sets, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the fourth bit set, $0 \le i < m$, $0 \le j < N$, and $\lfloor \cdot \rfloor$ represents a rounding-down operation.

In some possible implementations, K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

In some possible implementations, K = 120, m = 8, an $i^{th}$ second bit set is obtained by performing the right circular shift on an $i^{th}$ first bit set by $\delta_i$ bits, $0 \le i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to a sixth aspect, this application provides a data processing method. The method includes the following steps. First, interleaving and encoding processing is separately performed on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. Then, every two bits in the $n_2$ second data streams are separately mapped to one PAM4 symbol, to obtain a total of $n_2$ PAM4 symbol data streams. Specifically, the interleaving and encoding processing includes the following steps. $a_0$ first bit sets are obtained from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1. Circular shift is separately performed on the m first bit sets to obtain m second bit sets, and inner-code encoding is separately performed on the m first bit sets to obtain m parity bit sets, where both the inner-code encoding and the outer-code encoding are forward error correction FEC encoding, each of the second bit sets includes K bits, each of the parity bit sets includes P bits, and P is an integer greater than or equal to 1. Two bits are obtained from each second bit set through round robin to obtain a total of $m \times K$ consecutive bits, and two bits are obtained from each parity bit set through round robin to obtain a total of $m \times P$ consecutive bits, to obtain a third bit set including $m \times N$ bits, where N=K+P. It should be understood that each second data stream includes a plurality of third bit sets, each of the third bit sets includes the $m \times K$ bits in the second bit sets and the $m \times P$ bits in the parity bit sets, a total of $m \times K/2$ PAM4 symbols are obtained through the mapping of the $m \times K$ bits that are from the second bit sets and that are in each of the third bit sets, a total of $m \times P/2$ PAM4 symbols are obtained through the mapping of the $m \times P$ bits that are from the parity bit sets and that are in each of the third bit sets, and $m \times 2$ bits mapped to m consecutive PAM4 symbols in a total of $m \times N/2$ PAM4 symbols are from the m second bit sets and/or the m parity bit sets.

In some possible implementations, the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m first bit sets and the m second bit sets are represented as bit matrixes, and the bit matrix includes m rows and K columns of bits.

In some possible implementations, the second bit set is obtained by performing left circular shift on the first bit set by $\varphi_i$ bits, the left circular shift satisfies a first condition, and the first condition includes:

$$M_2[i][j] = M_1[i][(j + \varphi_i)\%K]$$

where $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \le j < K$, $0 \le i < m$, and $0 \le \varphi_i < K$.

In some possible implementations, the second bit set is obtained by performing right circular shift on the first bit set by $\delta_i$ bits, the right circular shift satisfies a second condition, and the second condition includes:

$$M_2[i][j] = M_1[i][(j - \delta_i)\%K]$$

where $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \le j < K$, $0 \le i < m$, and $0 \le \delta_i < K$.

In some possible implementations, K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};

{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

In some possible implementations, $K = 120$, $m = 8$, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to a seventh aspect, this application provides a data processing method. The method includes the following steps. First, interleaving and encoding processing is separately performed on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. Then, every two bits in the $n_2$ second data streams are separately mapped to one PAM4 symbol, to obtain a total of $n_2$ PAM4 symbol data streams. Specifically, the interleaving and encoding processing includes the following steps. $a_0$ first bit sets are obtained from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1. Circular shift is separately performed on the m first bit sets to obtain m second bit sets, where each of the second bit sets includes K bits. Inner-code encoding is separately performed on the m second bit sets to obtain m inner-code codewords, where both the inner-code encoding and the outer-code encoding are forward error correction FEC encoding, each of the inner-code codewords includes one second bit set and one parity bit set that participate in the inner-code encoding and that have a total of N bits, N=K+P, each parity bit set includes P bits, and P is an integer greater than or equal to 1. Two bits are obtained from each inner-code codeword through round robin to obtain a third bit set, where the third bit set includes $m \times N$ bits, a total of $m \times K$ bits that are from the m second bit sets and that are in the third bit set are consecutive, and a total of $m \times P$ bits that are from m parity bit sets and that are in the third bit set are consecutive. It should be understood that each second data stream includes a plurality of third bit sets, a total of $m \times N/2$ PAM4 symbols are obtained through the mapping of each of the third bit sets, and $m \times 2$ bits mapped to m consecutive PAM4 symbols in the $m \times N/2$ PAM4 symbols are from the m inner-code codewords.

In some possible implementations, the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m first bit sets and the m second bit sets are represented as bit matrixes, and the bit matrix includes m rows and K columns of bits.

In some possible implementations, the second bit set is obtained by performing left circular shift on the first bit set by $\varphi_i$ bits, the left circular shift satisfies a first condition, and the first condition includes:

$$M_2[i][j] = M_1[i][(j + \varphi_i)\%K]$$

where $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, $Y\%Z$ represents a remainder obtained by dividing the integer Y by the integer Z, $0 \leq i < m$, $0 \leq j < K$, and $0 \leq \varphi_i < K$.

In some possible implementations, the second bit set is obtained by performing right circular shift on the first bit set by $\delta_i$ bits, the right circular shift satisfies a second condition, and the second condition includes:

$$M_2[i][j] = M_1[i][(j - \delta_i)\%K]$$

where $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \le i < m$, $0 \le j < K$, and $0 \le \delta_i < K$.

In some possible implementations, the m inner-code codewords are represented as a bit matrix including m rows and N columns, the m inner-code codewords and the third bit set satisfy a third condition, and the third condition includes:

$$A[\lfloor j/2 \rfloor \times (m \times 2) + (i \times 2) + (j\%2)] = M_c[i][j]$$

where $M_c[i][j]$ represents a bit in an $i^{th}$ row and a $j^{th}$ column in the bit matrix corresponding to the m inner-code codewords, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the third bit set, $0 \le i < m$, $0 \le j < N$, and $\lfloor \cdot \rfloor$ represents a rounding-down operation.

In some possible implementations, K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

In some possible implementations, K = 120, m = 8, an $i^{th}$ second bit set is obtained by performing the right circular shift on an $i^{th}$ first bit set by $\delta_i$ bits, $0 \le i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to an eighth aspect, this application provides a data processing method. The method includes the following steps. First, interleaving and encoding processing is separately performed on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. Then, every two bits in the $n_2$ second data streams are separately mapped to one PAM4 symbol, to obtain a total of $n_2$ PAM4 symbol data streams. Specifically, the interleaving and encoding processing includes the following steps. $a_0$ first bit sets are obtained from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1. Inner-code encoding is separately performed on the m first bit sets to obtain m inner-code codewords, where both the inner-code encoding and the outer-code encoding are forward error correction FEC encoding, each of the inner-code codewords includes one first bit set and one parity bit set that participate in the inner-code encoding and that have a total of N bits, N=K+P, each parity bit set includes P bits, and P is an integer greater than or equal to 1. The m inner-code codewords are separately interleaved to obtain one second bit set, where the second bit set includes $m \times N$ bits, a $(\lfloor j/2 \rfloor \times (m \times 2) + (i \times 2) + (j\%2))^{th}$ bit in the second bit set satisfies a first condition or a second condition, $0 \le i < m$, and $0 \le j < N$.

The first condition includes:

$$A[\lfloor j/2 \rfloor \times (m \times 2) + (i \times 2) + (j\%2)] = \begin{cases} C_i[(j + \varphi_i)\%K], & 0 \le j < K \\ C_i[j], & K \le j < N \end{cases}$$

where $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit

set, $C_i[(j + \varphi_i)\%K]$ represents a $((j + \varphi_i)\%K)^{th}$ bit in an $i^{th}$ inner-code codeword, and $C_i[j]$ represents a $j^{th}$ bit in the $i^{th}$ inner-code codeword.

The second condition includes:

$$A[\lfloor j/2 \rfloor \times (m \times 2) + (i \times 2) + (j\%2)] = \begin{cases} C_i[(j-\delta_i)\%K], 0 \le j < K \\ C_i[j], K \le j < N \end{cases}$$

where $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j-\delta_i)\%K]$ represents a $((j- \delta_i)\%K)^{th}$ bit in the $i^{th}$ inner-code codeword, and $C_i[j]$ represents the $j^{th}$ bit in the $i^{th}$ inner-code codeword.

It should be understood that each second data stream includes a plurality of second bit sets, a total of m × N/2 PAM4 symbols are obtained through the mapping of each of the second bit sets, and m × 2 bits mapped to m consecutive PAM4 symbols in the m × N/2 PAM4 symbols are from the m inner-code codewords.

In some possible implementations, K = 120, m = 8, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}; and
a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to a ninth aspect, this application provides a data processing apparatus. The data processing apparatus includes an interleaving and encoding module and a bit mapping module. The interleaving and encoding module is configured to separately perform interleaving and encoding processing on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. The bit mapping module is configured to separately map every two bits in the $n_2$ second data streams to one PAM4 symbol, to obtain a total of $n_2$ PAM4 symbol data streams. The interleaving and encoding module is specifically configured to: obtain $a_0$ first bit sets from each of the $n_1$ first data streams to obtain a total of m = $n_1 \times a_0$ first bit sets, where outer-code encoding is performed on all of the $n_1$ first data streams, each of the first bit sets includes K bits, and $n_1$, $a_0$, and K are all integers greater than 1; separately perform inner-code encoding on the m first bit sets to obtain m inner-code codewords, where both the inner-code encoding and the outer-code encoding are forward error correction FEC encoding, each of the inner-code codewords includes one first bit set and one parity bit set that participate in the inner-code encoding and that have a total of N bits, N=K+P, each parity bit set includes P bits, and P is an integer greater than or equal to 1; separately perform circular shift on the m inner-code codewords to obtain m third bit sets, where each of the third bit sets includes the one parity bit set and one second bit set that is obtained by performing the circular shift on the first bit set; and obtain a fourth bit set through 2-bit round robin in each of the third bit sets, where the fourth bit set includes m × N bits, a total of m × K bits that are from m second bit sets and that are in the fourth bit set are consecutive, and a total of m × P bits that are from m parity bit sets and that are in the fourth bit set are consecutive. It should be understood that each of the second data streams includes a plurality of fourth bit sets, a total of m × N/2 PAM4 symbols are obtained through the mapping of each of the fourth bit sets, and m × 2 bits mapped to m consecutive PAM4 symbols in the m × N/2 PAM4 symbols are from the m inner-code codewords.

In some possible implementations, the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m inner-code codewords and the m third bit sets are represented as bit matrixes, and the bit matrix includes m rows and N columns of bits.

In some possible implementations, the second bit set is obtained by performing left circular shift on the first bit set by $\varphi_i$ bits, the left circular shift satisfies a first condition, and the first condition includes:

$$M_3[i][j] = \begin{cases} M_c[i][(j + \varphi_i)\%K], 0 \leq j < K \\ M_c[i][j], K \leq j < N \end{cases}$$

where $M_c[i][j]$ represents a bit in an $i^{th}$ row and a $j^{th}$ column in the bit matrix corresponding to the m inner-code codewords on which the left circular shift has not been performed, $M_3[i][j]$ represents a bit in an $i^{th}$ row and a $j^{th}$ column in the bit matrix corresponding to the m third bit sets obtained through the left circular shift, Y%Z represents a remainder obtained by dividing the integer Y by the integer Z, $0 \leq i < m$, and $0 \leq \varphi_i < K$.

In some possible implementations, the second bit set is obtained by performing right circular shift on the first bit set by $\delta_i$ bits, the right circular shift satisfies a second condition, and the second condition includes:

$$M_3[i][j] = \begin{cases} M_c[i][(j - \delta_i)\%K], 0 \leq j < K \\ M_c[i][j], K \leq j < N \end{cases}$$

where $M_c[i][j]$ represents a bit in an $i^{th}$ row and a $j^{th}$ column in the bit matrix corresponding to the m inner-code codewords on which the right circular shift has not been performed, $M_3[i][j]$ represents a bit in an $i^{th}$ row and a $j^{th}$ column in the bit matrix corresponding to the m third bit sets obtained through the right circular shift, Y%Z represents a remainder obtained by dividing the integer Y by the integer Z, $0 \leq i < m$, and $0 \leq \delta_i < K$.

In some possible implementations, the m third bit sets and the fourth bit set satisfy a third condition, and the third condition includes:

$$A[\lfloor j/2 \rfloor \times (m \times 2) + (i \times 2) + (j\%2)] = M_3[i][j]$$

where $M_3[i][j]$ represents the bit in the $i^{th}$ row and the $j^{th}$ column in the bit matrix corresponding to the m third bit sets, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the fourth bit set, $0 \leq i < m$, $0 \leq j < N$, and $\lfloor \cdot \rfloor$ represents a rounding-down operation.

In some possible implementations, K = 120, m = 8, an $i^{th}$ second bit set is obtained by performing the left circular shift on an $i^{th}$ first bit set by $\varphi_i$ bits, $0 \leq i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

In some possible implementations, K = 120, m = 8, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to a tenth aspect, this application provides a data processing apparatus. The data processing apparatus includes an interleaving and encoding module and a bit mapping module. The interleaving and encoding module is configured to separately perform interleaving and encoding processing on every $n_1$ first data streams in $n_0$ first data streams to obtain one second data stream, to obtain a total of $n_2$ second data streams, where $n_2 = n_0/n_1$, $n_0$ is an

integer greater than 1, and $n_1$ is an integer greater than 0. The bit mapping module is configured to separately map every two bits in the $n_2$ second data streams to one PAM4 symbol, to obtain a total of $n_2$ PAM4 symbol data streams. The interleaving and encoding module is specifically configured to: obtain $a_0$ first bit sets from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1; separately perform circular shift on the m first bit sets to obtain m second bit sets, and separately perform inner-code encoding on the m first bit sets to obtain m parity bit sets, where both the inner-code encoding and the outer-code encoding are forward error correction FEC encoding, each of the second bit sets includes K bits, each of the parity bit sets includes P bits, and P is an integer greater than or equal to 1; and obtain, through round robin, two bits from each second bit set to obtain a total of m × K consecutive bits, and obtain, through round robin, two bits from each parity bit set to obtain a total of m × P consecutive bits, to obtain a third bit set including m × N bits, where N=K+P. It should be understood that each second data stream includes a plurality of third bit sets, each of the third bit sets includes the m × K bits in the second bit sets and the m × P bits in the parity bit sets, a total of m × K/2 PAM4 symbols are obtained through the mapping of the m × K bits that are from the second bit sets and that are in each of the third bit sets, a total of m × P/2 PAM4 symbols are obtained through the mapping of the m × P bits that are from the parity bit sets and that are in each of the third bit sets, and m × 2 bits mapped to m consecutive PAM4 symbols in a total of m × N/2 PAM4 symbols are from the m second bit sets and/or the m parity bit sets.

In some possible implementations, the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m first bit sets and the m second bit sets are represented as bit matrixes, and the bit matrix includes m rows and K columns of bits.

In some possible implementations, the second bit set is obtained by performing left circular shift on the first bit set by $\varphi_i$ bits, the left circular shift satisfies a first condition, and the first condition includes:

$$M_2[i][j] = M_1[i][(j + \varphi_i)\%K]$$

where $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \le j < K$, $0 \le i < m$, and $0 \le \varphi_i < K$.

In some possible implementations, the second bit set is obtained by performing right circular shift on the first bit set by $\delta_i$ bits, the right circular shift satisfies a second condition, and the second condition includes:

$$M_2[i][j] = M_1[i][(j - \delta_i)\%K]$$

where $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \le j < K$, $0 \le i < m$, and $0 \le \delta_i < K$.

In some possible implementations, K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

In some possible implementations, K = 120, m = 8, an $i^{th}$ second bit set is obtained by performing the right circular shift on an $i^{th}$ first bit set by $\delta_i$ bits, $0 \le i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

According to an eleventh aspect, this application provides a data processing apparatus. The data processing apparatus includes an interleaving and encoding module and a bit mapping module. The interleaving and encoding module is configured to separately perform interleaving and encoding processing on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. The bit mapping module is configured to separately map every two bits in the $n_2$ second data streams to one PAM4 symbol, to obtain a total of $n_2$ PAM4 symbol data streams. The interleaving and encoding module is specifically configured to: obtain $a_0$ first bit sets from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1; separately perform circular shift on the m first bit sets to obtain m second bit sets, where each of the second bit sets includes K bits; separately perform inner-code encoding on the m second bit sets to obtain m inner-code codewords, where both the inner-code encoding and the outer-code encoding are forward error correction FEC encoding, each of the inner-code codewords includes one second bit set and one parity bit set that participate in the inner-code encoding and that have a total of N bits, N=K+P, each parity bit set includes P bits, and P is an integer greater than or equal to 1; and obtain, through round robin, two bits from each inner-code codeword to obtain a third bit set, where the third bit set includes m × N bits, a total of m × K bits that are from the m second bit sets and that are in the third bit set are consecutive, and a total of m × P bits that are from m parity bit sets and that are in the third bit set are consecutive. It should be understood that each second data stream includes a plurality of third bit sets, a total of m × N/2 PAM4 symbols are obtained through the mapping of each of the third bit sets, and m × 2 bits mapped to m consecutive PAM4 symbols in the m × N/2 PAM4 symbols are from the m inner-code codewords.

In some possible implementations, the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

In some possible implementations, quantities of bits by which the circular shift is performed on any two of the m first bit sets are different.

In some possible implementations, both the m first bit sets and the m second bit sets are represented as bit matrixes, and the bit matrix includes m rows and K columns of bits.

In some possible implementations, the second bit set is obtained by performing left circular shift on the first bit set by $\varphi_i$ bits, the left circular shift satisfies a first condition, and the first condition includes:

$$M_2[i][j] = M_1[i][(j + \varphi_i)\%K]$$

where $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \leq i < m$, $0 \leq j < K$, and $0 \leq \varphi_i < K$.

In some possible implementations, the second bit set is obtained by performing right circular shift on the first bit set by $\delta_i$ bits, the right circular shift satisfies a second condition, and the second condition includes:

$$M_2[i][j] = M_1[i][(j - \delta_i)\%K]$$

where $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \leq i < m$, $0 \leq j < K$, and $0 \leq \delta_i < K$.

In some possible implementations, the m inner-code codewords are represented as a bit matrix including m rows and N columns, the m inner-code codewords and the third bit set satisfy a third condition, and the third condition includes:

$$A[\lfloor j/2 \rfloor \times (m \times 2) + (i \times 2) + (j\%2)] = M_c[i][j]$$

where $M_c[i][j]$ represents a bit in an $i^{th}$ row and a $j^{th}$ column in the bit matrix corresponding to the m inner-code codewords, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the third bit set, $0 \leq i < m$, $0 \leq j < N$, and $\lfloor \cdot \rfloor$ represents a rounding-down operation.

In some possible implementations, K = 120, m = 8, an $i^{th}$ second bit set is obtained by performing the left circular shift on an $i^{th}$ first bit set by $\varphi_i$ bits, $0 \leq i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

> {0, 30, 60, 90, 110, 20, 50, 80};
> {0, 30, 90, 60, 110, 20, 80, 50};
> {0, 60, 30, 90, 110, 50, 20, 80};
> {0, 60, 90, 30, 110, 50, 80, 20};
> {0, 90, 30, 60, 110, 80, 20, 50}; or
> {0, 90, 60, 30, 110, 80, 50, 20}.

In some possible implementations, K = 120, m = 8, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

> {0, 30, 60, 90, 10, 40, 70, 100};
> {0, 30, 90, 60, 10, 40, 100, 70};
> {0, 60, 30, 90, 10, 40, 40, 100};
> {0, 60, 90, 30, 10, 70, 100, 40};
> {0, 90, 30, 60, 10, 100, 40, 70}; or
> {0, 90, 60, 30, 10, 100, 70, 40}.

According to a twelfth aspect, this application provides a data processing apparatus. The data processing apparatus includes an interleaving and encoding module and a bit mapping module. The interleaving and encoding module is configured to separately perform interleaving and encoding processing on every $n_1$ first data streams in $n_0$ first data streams to obtain one second data stream, to obtain a total of $n_2$ second data streams, where $n_2 = n_0/n_1$, $n_0$ is an integer greater than 1, and $n_1$ is an integer greater than 0. The bit mapping module is configured to separately map every two bits in the $n_2$ second data streams to one PAM4 symbol, to obtain a total of $n_2$ PAM4 symbol data streams. The interleaving and encoding module is specifically configured to: obtain $a_0$ first bit sets from each of the $n_1$ first data streams to obtain a total of $m = n_1 \times a_0$ first bit sets, where outer-code encoding is performed on all of the $n_1$ first data streams, each of the first bit sets includes K bits, and $n_1$, $a_0$, and K are all integers greater than 1; separately perform inner-code encoding on the m first bit sets to obtain m inner-code codewords, where both the inner-code encoding and the outer-code encoding are forward error correction FEC encoding, each of the inner-code codewords includes one first bit set and one parity bit set that participate in the inner-code encoding and that have a total of N bits, N=K+P, each parity bit set includes P bits, and P is an integer greater than or equal to 1; and separately interleave the m inner-code codewords to obtain one second bit set, where the second bit set includes m $\times$ N bits, a $(\lfloor j/2 \rfloor \times (m \times 2) + (i \times 2) + (j\%2))^{th}$ bit in the second bit set satisfies a first condition or a second condition, $0 \leq i < m$, and $0 \leq j < N$.

The first condition includes:

$$A[\lfloor j/2 \rfloor \times (m \times 2) + (i \times 2) + (j\%2)] = \begin{cases} C_i[(j + \varphi_i)\%K], 0 \leq j < K \\ C_i[j], K \leq j < N \end{cases}$$

where $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j + \varphi_i)\%K]$ represents a $((j + \varphi_i)\%K)^{th}$ bit in an $i^{th}$ inner-code codeword, and $C_i[j]$ represents a $j^{th}$ bit in the $i^{th}$ inner-code codeword.

The second condition includes:

$$A[\lfloor j/2 \rfloor \times (m \times 2) + (i \times 2) + (j\%2)] = \begin{cases} C_i[(j - \delta_i)\%K], 0 \leq j < K \\ C_i[j], K \leq j < N \end{cases}$$

where $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j - \delta_i)\%K]$ represents a $((j - \delta_i)\%K)^{th}$ bit in the $i^{th}$ inner-code codeword, and $C_i[j]$ represents the $j^{th}$ bit in the $i^{th}$ inner-code codeword.

It should be understood that each second data stream includes a plurality of second bit sets, a total of m × N/2 PAM4 symbols are obtained through the mapping of each of the second bit sets, and m × 2 bits mapped to m consecutive PAM4 symbols in the m × N/2 PAM4 symbols are from the m inner-code codewords.

In some possible implementations, K = 120, m = 8, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ include:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}; and
a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ include:

{0, 30, 60, 90, 10, 40, 70, 100};
{0, 30, 90, 60, 10, 40, 100, 70};
{0, 60, 30, 90, 10, 40, 40, 100};
{0, 60, 90, 30, 10, 70, 100, 40};
{0, 90, 30, 60, 10, 100, 40, 70}; or
{0, 90, 60, 30, 10, 100, 70, 40}.

In embodiments of this application, the concatenated-FEC transmission solution is used. That is, the outer-code encoding and the inner-code encoding are sequentially performed on the data streams. On this basis, this application designs the bit interleaving and mapping method, so that both the bits in the outer-code codeword and the bits in the inner-code codeword are discretely and evenly mapped to the modulation symbols. In this way, the concatenated-FEC transmission solution has the strong burst resistance capability. Particularly, the burst error with the small length may be directly corrected through the inner-code decoding. The concatenated-FEC transmission solution is widely applicable to transmission scenarios, particularly the actual coherent transmission scenario in which there is colored noise on a channel.

**BRIEF DESCRIPTION OF DRAWINGS**

FIG. 1 is a diagram of a communication system to which an embodiment of this application is applicable;
FIG. 2 is a diagram of a data transmission process in the communication system shown in FIG. 1;
FIG. 3 is a schematic flowchart of a data processing method according to an embodiment of this application;
FIG. 4 is a diagram of performing left circular shift on bits in each row according to an embodiment of this application;
FIG. 5 is a diagram of performing upward circular shift on bits in each column according to an embodiment of this application;
FIG. 6 is a diagram of performing location transformation on bits in each column according to an embodiment of this application;
FIG. 7 is a first diagram of bit mapping according to an embodiment of this application;
FIG. 8 is a second diagram of bit mapping according to an embodiment of this application;
FIG. 9 is a third diagram of bit mapping according to an embodiment of this application;
FIG. 10 is a fourth diagram of bit mapping according to an embodiment of this application;
FIG. 11 is a diagram of performing inner-code encoding and interleaving, modulation, and mapping on data streams according to an embodiment of this application;
FIG. 12(a) is a diagram of a first operation procedure of a transmitter processing module according to an embodiment of this application;
FIG. 12(b) is a diagram of a second operation procedure of a transmitter processing module according to an embodiment of this application;
FIG. 12(c) is a diagram of a third operation procedure of a transmitter processing module according to an embodiment of this application;
FIG. 12(d) is a diagram of a fourth operation procedure of a transmitter processing module according to an embodiment of this application;

FIG. 13 is a diagram of a 1×800G interface scenario according to an embodiment of this application;

FIG. 14 is a diagram of a 2×400G interface scenario according to an embodiment of this application;

FIG. 15 is another diagram of a 1×800G interface scenario according to an embodiment of this application;

FIG. 16 is a first diagram of concatenated interleaving according to an embodiment of this application;

FIG. 17 is a diagram of a first structure of a convolution interleaver according to an embodiment of this application;

FIG. 18 is a second diagram of concatenated interleaving according to an embodiment of this application;

FIG. 19 is a diagram of a second structure of a convolution interleaver according to an embodiment of this application;

FIG. 20 is a third diagram of concatenated interleaving according to an embodiment of this application;

FIG. 21 is a diagram of a third structure of a convolution interleaver according to an embodiment of this application;

FIG. 22 is a diagram of a fourth structure of a convolution interleaver according to an embodiment of this application;

FIG. 23 is a diagram of a fifth structure of a convolution interleaver according to an embodiment of this application;

FIG. 24 is a schematic flowchart of data processing according to an embodiment of this application;

FIG. 25 is a diagram of a structure of a data processing apparatus according to an embodiment of this application;

FIG. 26 is another schematic flowchart of a data processing method according to an embodiment of this application;

FIG. 27 is a diagram of a first implementation of interleaving and encoding processing;

FIG. 28 is a diagram of a second implementation of interleaving and encoding processing;

FIG. 29 is a diagram of a third implementation of interleaving and encoding processing;

FIG. 30 is a diagram of a fourth implementation of interleaving and encoding processing;

FIG. 31 is a diagram of a fifth implementation of interleaving and encoding processing;

FIG. 32 is a diagram of a sixth implementation of interleaving and encoding processing;

FIG. 33 is a diagram of a seventh implementation of interleaving and encoding processing;

FIG. 34 is a diagram of an eighth implementation of interleaving and encoding processing;

FIG. 35 is a diagram of a ninth implementation of interleaving and encoding processing;

FIG. 36 is a diagram of a tenth implementation of interleaving and encoding processing;

FIG. 37 is a diagram of an eleventh implementation of interleaving and encoding processing;

FIG. 38 is a diagram of a twelfth implementation of interleaving and encoding processing;

FIG. 39 is a diagram of another structure of a data processing apparatus according to an embodiment of this application; and

FIG. 40 is a diagram of another structure of a data processing apparatus according to an embodiment of this application.

## DESCRIPTION OF EMBODIMENTS

Embodiments of this application provide a data processing method and a data processing apparatus, so that a concatenated-FEC transmission solution has a strong burst resistance capability, can be applied to a large quantity of transmission scenarios, particularly an actual coherent transmission scenario in which there is colored noise on a channel. It should be noted that in the specification, claims, and the foregoing accompanying drawings of this application, the terms "first" and "second" are intended to distinguish between similar objects but do not limit a specific order or sequence. It should be understood that the foregoing terms may be interchanged in proper cases, so that embodiments described in this application can be implemented in an order other than the content described in this application. In addition, the terms "include", "have", and any variant thereof are intended to cover a non-exclusive inclusion. For example, processes, methods, systems, products, or devices that include a series of steps or units are not limited to the steps or the units that are clearly listed, and may include other steps and units that are not clearly listed or that are inherent to the processes, methods, products, or devices.

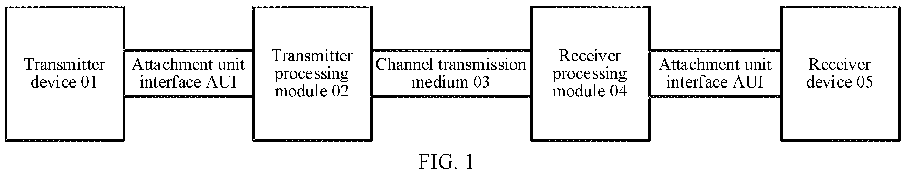

FIG. 1 is a diagram of a communication system to which an embodiment of this application is applicable. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 may be devices such as switches or routers. In addition, the transmitter device 01 is also referred to as a host chip (host chip) located at a transmitter, the receiver device 05 is also referred to as a host chip located at a receiver, and the channel transmission medium 03 may be an optical fiber. The host chip is sometimes also referred to as a host device (host device). The transmitter device 01 and the transmitter processing module 02 may be connected to each other through an attachment unit interface (attachment unit interface, AUI), and the receiver device 05 and the receiver processing module 04 may be connected to each other through an AUI. The transmitter processing module 02 and the receiver processing module 04 may be optical modules (optical modules), electrical modules, connectors (connectors), or other modules that process data in a data sending process. For example, the processing module may be an 800LR module (800LR module, which is a coherent optical module). In addition, all of the transmitter device 01, the transmitter processing module 02, the channel transmission medium 03, the receiver processing module 04, and the receiver device 05 in the communication system can support bidirectional transmission, or unidirectional transmission. This is not specifically limited herein.

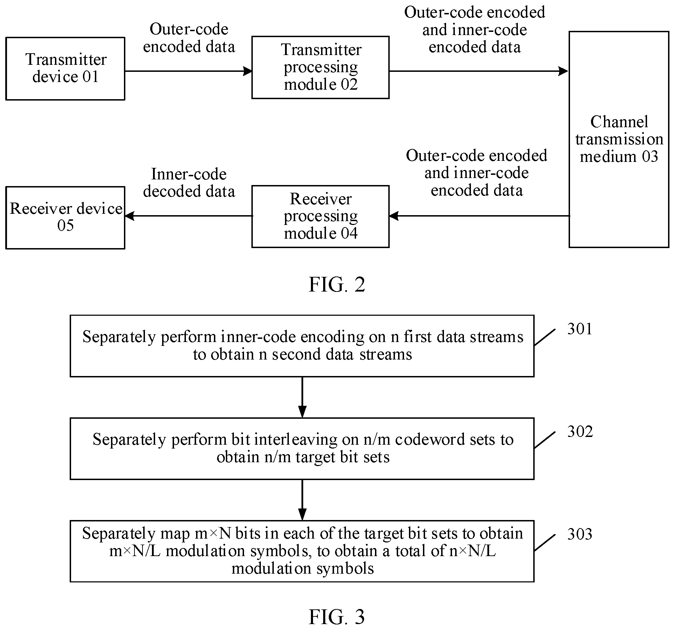

FIG. 2 is a diagram of a data transmission process in the communication system shown in FIG. 1. As shown in FIG. 2, in a process of transmitting data from the transmitter device 01 to the receiver device 05, the transmitter device 01 is configured to: perform outer-code encoding on the data, and then transmit outer-code encoded data to the transmitter processing module 02. The transmitter processing module 02 is configured to: perform inner-code encoding on the outer-code encoded data, to obtain outer-code encoded and inner-code encoded data; and transmit the outer-code encoded and inner-code encoded data to the channel transmission medium 03. The channel transmission medium 03 is configured to transmit the outer-code encoded and inner-code encoded data to the receiver processing module 04. The receiver processing module 04 is configured to: perform inner-code decoding on the outer-code encoded and inner-code encoded data, and transmit inner-code decoded data to the receiver device 05. The receiver device 05 is configured to perform outer-code decoding on the inner-code decoded data.

It should be understood that "inner" in an inner code and "outer" in an outer code are distinguished based only on a distance between an execution body that performs an operation on data and the channel transmission medium 03. An execution body that performs an operation on the inner code is closer to the channel transmission medium, and an execution body that performs an operation on the outer code is farther away from the channel transmission medium. In embodiments of this application, after being sent from the transmitter device 01, the data is transmitted to the channel transmission medium 03 via the transmitter processing module 02, and then is transmitted from the channel transmission medium 03 to the receiver device 05 via the receiver processing module 04. The data obtained through the encoding performed by the transmitter device 01 is farther away from the channel transmission medium 03 than the data obtained through the encoding performed by the transmitter processing module 02, and data obtained through the decoding performed by the receiver device 05 is farther away from the channel transmission medium 03 than the data obtained through the decoding performed by the receiver processing module 04. Therefore, the data obtained through the encoding performed by the transmitter device 01 is referred to as the outer-code encoded data, the data obtained through the encoding performed by the transmitter processing module 02 is referred to as the inner-code encoded data, the data obtained through the decoding performed by the receiver device 05 is referred to as outer-code decoded data, and the data obtained through the decoding performed by the receiver processing module 04 is referred to as the inner-code decoded data. In a possible implementation, both the inner-code encoding and the outer-code encoding use an FEC encoding manner, to form a concatenated-FEC transmission solution. For example, the transmitter device 01 may perform the outer-code encoding by using an RS code, and the transmitter processing module 02 may perform the inner-code encoding by using a Hamming (Hamming) code. For another example, the transmitter device 01 may perform the outer-code encoding by using an RS code, and the transmitter processing module 02 may perform the inner-code encoding by using a Bose-Chaudhuri-Hocquenghem (Bose-Chaudhuri-Hocquenghem, BCH) code.

It should be noted that the foregoing content is example description of an application scenario of the data processing method provided in embodiments of this application, and does not constitute any limitation on the application scenario of the data processing method. A person of ordinary skill in the art may learn that, as a service requirement changes, the application scenario of the data processing method may be adjusted based on an application requirement. Application scenarios are not enumerated in embodiments of this application.

FIG. 3 is a schematic flowchart of a data processing method according to an embodiment of this application. It should be understood that the method is for data processing performed on outer-code encoded data streams, and may be specifically implemented by the foregoing transmitter processing module 02.

301: Separately perform inner-code encoding on n first data streams to obtain n second data streams.

In this embodiment, a physical medium attachment (Physical Medium Attachment, PMA) sublayer of the transmitter processing module performs first data processing on data from a plurality of synchronous client lanes (client lanes) to obtain the n first data streams, where n is an integer greater than 1. The first data processing may include alignment marker lock (alignment lock), lane de-skew (lane de-skew) processing, lane reorder (lane reorder) processing, concatenated interleaving (concatenated interleaving) processing, or the like. The foregoing n first data streams are all outer-code encoded data streams. For example, an RS code may be used for the outer-code encoding, and the n outer-code encoded data streams may include a plurality of RS codewords. In actual application, another encoding scheme may alternatively be for performing the outer-code encoding. For ease of description, in the following descriptions, the RS codeword is uniformly for representing a codeword generated through the outer-code encoding. It should be noted that, in this application, a code length of an outer code is measured in outer-code symbols, where the symbol may include one or more bits. For example, the outer code is a used KP4 RS(544,514) code, a code length is 544 symbols, and one outer-code symbol includes 10 bits.

An inner-code encoder performs the inner-code encoding on every K bits in each first data stream, and then adds P parity bits to obtain an inner-code codeword including a total of N bits. Herein, the K bits may be referred to as an inner-code information sequence, and K+P=N. Generally, K is a multiple of 10, and the K bits correspond to K/10 outer-code symbols. In some scenarios, the K/10 outer-code symbols corresponding to the K information bits are from K/10 different outer-code codewords.

It should be understood that each second data stream obtained through the inner-code encoding includes at least one inner-code codeword. One inner-code codeword is separately obtained from each second data stream to obtain a total of n inner-code codewords, where the n inner-code codewords include n/m codeword sets, namely, a codeword set 0, a codeword set 1, $\cdots$, and a codeword set n/m-1. Each codeword set includes m inner-code codewords. A codeword set h (0 $\leq$ h < n/m) includes a codeword m $\times$ h, a codeword m $\times$ h + 1, $\cdots$, and a codeword m $\times$ h + m- 1. n is divisible by m.

It should be noted that the foregoing codeword set is merely a concept introduced for ease of description. In actual application, the second data stream is an integrate part without division. Each codeword set may be considered as a plurality of bits in the second data stream.

302: Separately perform bit interleaving on the n/m codeword sets to obtain n/m target bit sets.

It should be understood that both a quantity of bits in the codeword set and a quantity of bits in the target bit set are m$\times$N. This step is performing location transformation on the bits in the codeword set to obtain the target bit set. In an example, the target bit set may be represented as a bit matrix with m rows and N columns. In another example, the target bit set may alternatively be represented as a one-dimensional array including m$\times$N bits. It should be noted that, in an example in which the codeword set is represented as a bit matrix, the bit interleaving provided in this application includes but is not limited to performing location transformation (row transformation for short) on bits in each row in the codeword set, performing the location transformation (column transformation for short) on bits in each column in the codeword set, and performing the location transformation (row-column transformation for short) on bits in each row and each column in the codeword set. The row-column transformation includes first the row transformation and then the column transformation, first the column transformation and then the row transformation, and simultaneous row transformation and column transformation. The following describes the bit interleaving in detail with reference to several specific implementations.

For ease of description, m $\times$ N codeword bits in the codeword set h (0 $\leq$ h < n/m) are represented by using a first matrix $H_1$ with m rows and N columns, where each row in the first matrix $H_1$ includes N bits in one inner-code codeword. A bit in an $i^{th}$ (0 $\leq$ i < m) row and a $j^{th}$ (0 $\leq$ j < N) column in the first matrix $H_1$ is denoted as $H_1[i][j]$. More specifically, $H_1[i][j]$ represents a $j^{th}$ bit in an $i^{th}$ inner-code codeword in the codeword set h, and also represents a $j^{th}$ bit in a codeword m $\times$ h + i from a second data stream m $\times$ h + i. It should be noted that the n/m codeword sets correspond to n/m first matrixes $H_1$. That is, the codeword set h (0 $\leq$ h < n/m) corresponds to an $h^{th}$ first matrix $H_1$. For ease of description, the following briefly describes the $h^{th}$ first matrix $H_1$ as the first matrix $H_1$.

A total of K bits in the $0^{th}$ column to a $(K-1)^{th}$ column in each row in the first matrix $H_1$ correspond to information bits whose length is K in the one inner-code codeword; and a total of m $\times$ K bits in the $0^{th}$ column to the $(K-1)^{th}$ column in the first matrix $H_1$ correspond to m $\times$ K information bits in m inner-code codewords. Similarly, a total of P bits in a $K^{th}$ column to an $(N-1)^{th}$ column in each row in the first matrix $H_1$ correspond to a parity bit whose length is P in the one inner-code codeword, and a total of m $\times$ P bits in the $K^{th}$ column to the $(N-1)^{th}$ column in the first matrix $H_1$ correspond to m $\times$ P parity bits in the m inner-code codewords.

The following first describes specific manners in which the row transformation and the column transformation are separately implemented.

Implementation 1 of the bit interleaving: the row transformation (which may also be referred to as first location transformation).

Specifically, the first location transformation is performed on K information bits in each inner-code codeword in the codeword set. Alternatively, this may be described as "the first location transformation is performed on K information bits in each row in the first matrix $H_1$". In a possible implementation, the first location transformation is specifically performing left circular shift or right circular shift on the K information bits in each row in the first matrix $H_1$. The left circular shift is used as an example. The left circular shift is performed on K information bits in the $i^{th}$ (0 $\leq$ i < m) row in the first matrix $H_1$ by i $\times$ $\Delta$ bits, where the non-zero integer $\Delta$ is a row offset constraint factor. It should be noted that the left circular shift is performed on the K information bits ($u_0$, $u_1$, $u_2$, $u_3$, $\cdots$, $u_{K-2}$, $u_{K-1}$) by the i $\times$ $\Delta$ bits to obtain K bits ($u_{(i\times\Delta)\%K}$, $u_{(1+i\times\Delta)\%K}$, $u_{(2+i\times\Delta)\%K}$, $\cdots$, $u_{(K-2+i\times\Delta)\%K}$, $u_{(K-1+i\times\Delta)\%K}$) obtained through the shift.

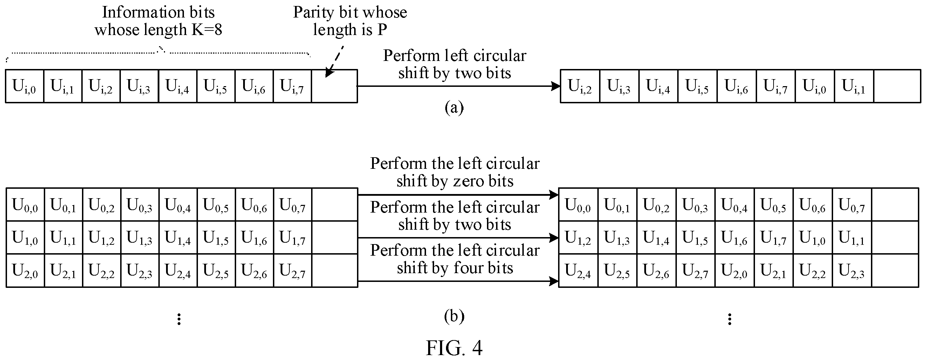

FIG. 4 is a diagram of performing left circular shift on information bits in each row according to an embodiment of this application. As shown in an example in (a) in FIG. 4, K=8, and the left circular shift is performed by two bits. The left circular shift is performed on eight information bits ($u_{i,0}$, $u_{i,1}$, $u_{i,2}$, $u_{i,3}$, $u_{i,4}$, $u_{i,5}$, $u_{i,6}$, $u_{i,7}$) in an $i^{th}$ row by two bits to obtain ($u_{i,2}$, $u_{i,3}$, $u_{i,4}$, $u_{i,5}$, $u_{i,6}$, $u_{i,7}$, $u_{i,0}$, $u_{i,1}$). As shown in an example in (b) in FIG. 4, $\Delta$= 2, and the left circular shift is performed on eight information bits in an $i^{th}$ row by i $\times$ 2 bits. For example, the left circular shift is performed on eight information bits in the $0^{th}$ row by zero bits, the left circular shift is performed on eight information bits in the $1^{st}$ row by two bits, and the left circular shift is performed on eight information bits in the $2^{nd}$ row by four bits. The circular shift is performed in this manner to perform the first location transformation on the K information bits in each row in the first matrix $H_1$.

More specifically, circular shift manners used for the first location transformation are described by using the following formulas.

In an example, the left circular shift is used for the first location transformation, and the first location transformation satisfies a formula (1.1):

$$H_2[i][j] = \begin{cases} H_1[i][(j + i \times \Delta)\%K], 0 \le j < K \\ H_1[i][j], K \le j < N \end{cases}$$

where $H_1[i][j]$ represents a bit in an $i^{th}$ row and a $j^{th}$ column in the bit matrix on which the first location transformation has not been performed, $H_2[i][j]$ represents a bit in an $i^{th}$ row and a $j^{th}$ column in a bit matrix obtained through the first location transformation, $Y\%Z$ represents a remainder obtained by dividing the integer Y by the integer Z, and $0 \le i < m$; and generally, the row offset constraint factor $\Delta$ is a multiple of 10, and $0 < \Delta < K$.

It should be noted that performing the left circular shift on the K information bits by $i \times \Delta$ bits is equivalent to performing the left circular shift on the K information bits by $(i \times \Delta)\%K$ bits. That is, the foregoing formula (1.1) may be written as the following formula (1.2):

$$H_2[i][j] = \begin{cases} H_1[i][(j + (i \times \Delta)\%K)\%K], 0 \le j < K \\ H_1[i][j], K \le j < N \end{cases}$$

The left circular shift is performed on the K information bits in the $i^{th}$ row in the first matrix $H_1$ by $i \times \Delta$ bits to obtain K bits in the $0^{th}$ column to a $(K-1)^{th}$ column in an $i^{th}$ row in a second matrix $H_2$. Equivalently, the right circular shift is performed on K information bits in the $0^{th}$ column to the $(K-1)^{th}$ column in the $i^{th}$ row in the first matrix $H_1$ by $i \times (K-\Delta)$ bits to obtain the K bits in the $0^{th}$ column to the $(K-1)^{th}$ column in the $i^{th}$ row in the second matrix $H_2$. As shown in the example in (a) in FIG. 4, K=8, and performing the left circular shift on the information bits by two bits is equivalent to performing the right circular shift by six bits.

In another example, the right circular shift is used for the first location transformation, and the first location transformation satisfies a formula (1.3):

$$H_2[i][j] = \begin{cases} H_1[i][(j - i \times \tilde{\Delta} + \alpha)\%K], 0 \le j < K \\ H_1[i][j], K \le j < N \end{cases}$$

where the integer $\alpha$ is a multiple of K, $j - i \times \tilde{\Delta} + \alpha$ is a non-negative integer when $0 \le i < m$ and $0 \le j < K$, and the integer $\tilde{\Delta} = K - \Delta$; generally, the row offset constraint factor $\tilde{\Delta}$ is a multiple of 10, and $0 < \tilde{\Delta} < K$; and other parameters that are the same as those in the foregoing formula (1.1) are not described one by one herein again.

In some specific formula expressions, for ease of description, the formula (1.3) is briefly expressed as a formula (1.4):

$$H_2[i][j] = \begin{cases} H_1[i][(j - i \times \tilde{\Delta})\%K], 0 \le j < K \\ H_1[i][j], K \le j < N \end{cases}$$

It should be further noted that performing the circular shift on the K information bits in the $0^{th}$ column to the $(K-1)^{th}$ column in each row in the first matrix $H_1$ is performing an operation only on the information bits in the first matrix $H_1$. Therefore, it may also be described as performing the circular shift on the K information bits in the $0^{th}$ column to the $(K-1)^{th}$ column in each row in the first matrix $H_1$ to obtain a fourth matrix $H_4$ with m rows and K columns. Specifically, the left circular shift is used for the first location transformation, and the first location transformation satisfies a formula (3.1):

$$H_4 = H_1[i][(j + i \times \Delta)\%K]$$

Meanings of the parameters in the formula (3.1) are similar to those in the formula (1.1). Details are not described herein again.

Implementation 2 of the bit interleaving: the column transformation (which may also be referred to as second location transformation).

It should be noted that the column transformation described in this implementation is described based on performing the row transformation on the first matrix $H_1$ to obtain the second matrix $H_2$. In some possible scenarios, the column transformation may alternatively be first performed on the first matrix $H_1$ in this implementation. Details are not described herein again.

Specifically, the second location transformation is performed on bits at a same location in the second matrix $H_2$ to obtain a third matrix $H_3$. It should be understood that the bits at the same location in the second matrix $H_2$ may be understood as m bits in a same column in the second matrix $H_2$. In other words, the location transformation is performed on the m bits in the same column. Alternatively, the bits at the same location in the second matrix $H_2$ may be understood as $G \times m$ bits in G same columns in the second matrix $H_2$, where G is an integer greater than 1. In other words, up-down location transformation is performed per G bits in the G same columns in each row. For ease of description, the following provides descriptions by using an example in which the same location is the same column.

In a possible implementation, the second matrix $H_2$ is divided into m/L first submatrixes, and each first submatrix includes L rows and N columns. Upward circular shift or downward circular shift is performed on L bits in each column in each first submatrix, to implement location transformation of bits in each first submatrix. The upward circular shift is used as an example. The upward circular shift is performed on L bits in a $j^{th}$ ($0 \leq j < N$) column in each first submatrix by $\theta \times$ (j%L) bits, where the non-zero integer $\theta$ is a column offset constraint factor. Herein, performing the upward circular shift on the L bits in the $j^{th}$ ($0 \leq j < N$) column in each first submatrix by $\theta \times$ (j%L) bits is alternatively equivalent to performing the upward circular shift by $\theta \times j$ bits. This can be known by a person of ordinary skill in the art. Details are not described herein again. The upward circular shift is performed on L bits $\begin{pmatrix} u_0 \\ u_1 \\ u_2 \\ \vdots \\ u_{L-2} \\ u_{L-1} \end{pmatrix}$ by $\theta \times$ (j%L) bits to obtain L bits $\begin{pmatrix} u_{\theta \times (j\%L)} \\ u_{(1+\theta \times (j\%L))\%L} \\ u_{(2+\theta \times (j\%L))\%L} \\ \vdots \\ u_{(L-2+\theta \times (j\%L))\%L} \\ u_{(L-1+\theta \times (j\%L))\%L} \end{pmatrix}$ obtained through the shift.

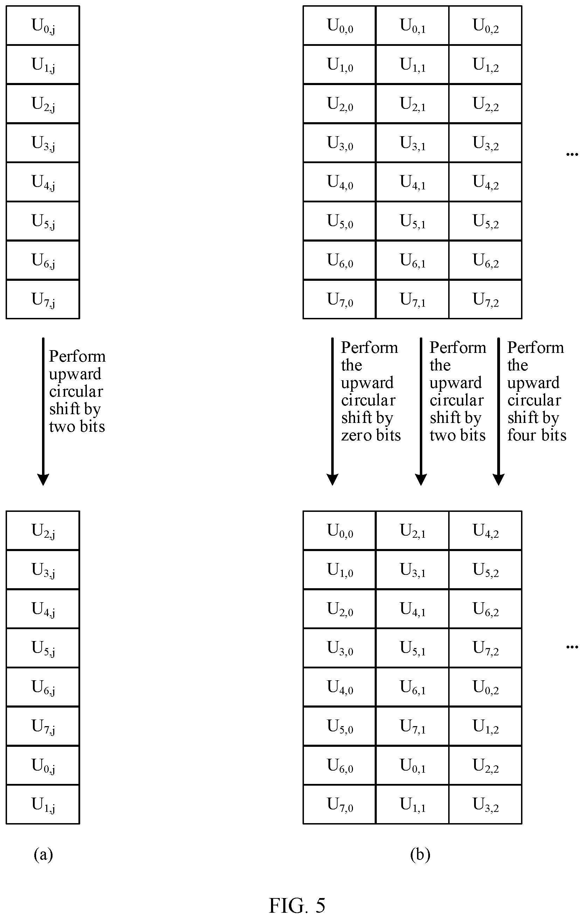

FIG. 5 is a diagram of performing upward circular shift on L bits in each column in each first submatrix according to an embodiment of this application. As shown in an example in (a) in FIG. 5, L=8, and the upward circular shift is performed by two bits. The upward circular shift is performed on eight bits $\begin{pmatrix} u_{0,j} \\ u_{1,j} \\ u_{2,j} \\ u_{3,j} \\ u_{4,j} \\ u_{5,j} \\ u_{6,j} \\ u_{7,j} \end{pmatrix}$ in the $j^{th}$ column by two bits to obtain eight bits

$\begin{pmatrix} u_{2,j} \\ u_{3,j} \\ u_{4,j} \\ u_{5,j} \\ u_{6,j} \\ u_{7,j} \\ u_{0,j} \\ u_{1,j} \end{pmatrix}$ obtained through the shift. As shown in an example in (b) in FIG. 5, $\theta = 2$, and the upward circular shift is performed on eight bits in the $j^{th}$ column by $2 \times$ (j%8) bits. For example, the upward circular shift is performed on eight bits in the $0^{th}$ column by zero bits, the upward circular shift is performed on eight bits in the $1^{st}$ column by two bits, and the upward circular shift is performed on eight information bits in the $2^{nd}$ column by four bits. The circular shift is performed in this manner to perform the second location transformation on the bits at the same location in the second matrix $H_2$.

More specifically, circular shift manners used for the second location transformation are described by using the following formulas.

In an example, the upward circular shift is used for the second location transformation, and the second location transformation satisfies a formula (2.1):

$$H_3[i][j] = H_2\big[\big(i + \theta \times (j\%L)\big)\%L + \lfloor i/L \rfloor \times L\big][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, $0 \leq i < m$, and $0 \leq j < N$; the non-zero integer $\theta$ is the column offset constraint factor; and generally, the column offset constraint factor satisfies $0 < \theta < L$.

It should be understood that the foregoing formula (2.1) may alternatively be written as : $H_3 [i][j] = H_2\big[(i + \theta \times j)\%L + \lfloor i/L \rfloor \times L\big][j]$.

Performing the upward circular shift on the L bits in the $j^{th}$ column in the first submatrix in the second matrix $H_2$ by $\theta \times$ (j%L) bits is equivalent to performing the downward circular shift by $(L-\theta) \times$ (j%L) bits. As shown in the example in (a) in FIG. 5, L=8, and performing the upward circular shift by two bits is equivalent to performing the downward circular shift by six bits.

In another example, the downward circular shift is used for the second location transformation, and the second location transformation satisfies a formula (2.2):

$$H_3[i][j] = H_2\big[\big(i - \tilde{\theta} \times (j\%L) + \beta\big)\%L + \lfloor i/L \rfloor \times L\big][j]$$

where the integer $\beta$ is a multiple of L, $i - \tilde{\theta} \times$ (j%L) $+ \beta$ is a non-negative integer when $0 \leq i < m$ and $0 \leq j < N$, and the integer $\tilde{\theta} =$

L- θ; generally, the column offset constraint factor satisfies 0 < θ < L; and other parameters that are the same as those in the foregoing formula (2.1) are not described one by one herein again.

In some specific formula expressions, for ease of description, the formula (2.2) is briefly expressed as a formula (2.3):

$$H_3[i][j] = H_2\big[(i- \tilde{\theta} \times j)\%L + \lfloor i/L \rfloor \times L\big][j]$$

In another possible implementation, different from the second location transformation for which a manner of the foregoing upward circular shift or downward circular shift is used, the second location transformation satisfies a formula (2.4):

$$H_3[i][j] = H_2\big[(i\%L)\wedge(j\%L) + \lfloor i/L \rfloor \times L\big][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \leq i < m$, and $0 \leq j < N$.

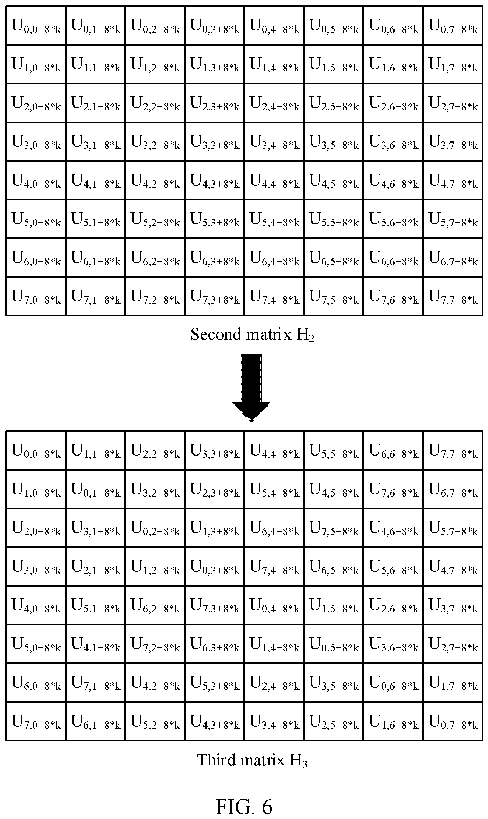

FIG. 6 is a diagram of performing location transformation on bits in each column according to an embodiment of this application. As shown in FIG. 6, when m=8, and L=8, a manner of the second location transformation that satisfies the foregoing formula (2.4) is shown. $U_{i,j}$ represents a bit in an $i^{th}$ row and a $j^{th}$ column in the second symbol matrix $H_2$. Every eight consecutive columns, namely, an $(8*k)^{th}$ column to an $(8*k+7)^{th}$ column, in the second matrix $H_2$ are interleaved and mapped to eight consecutive columns, namely, an $(8*k)^{th}$ column to an $(8*k+7)^{th}$ column, in the third symbol matrix in the manner shown in the figure.

It should be noted that, when the integer L is a power of 2, the second location transformation may further satisfy a formula (2.5):

$$H_3[i][j] = H_2\big[i\wedge(j\%L)\big][j]$$

where $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \leq i < m$, and $0 \leq j < N$.

It should be further noted that the foregoing first location transformation is location transformation performed on only the information bits, but the second location transformation is location transformation performed on both the information bits and parity bits. The foregoing descriptions are for only the fourth matrix $H_4$ with only the m rows and the K columns of information bits, the second location transformation is further expressed in the following another manner.

Specifically, the fourth matrix $H_4$ with the m rows and the K columns and the $K^{th}$ column to the $(N-1)^{th}$ column in the first matrix $H_1$, that is, a total of m rows and N columns, are divided into a plurality of second submatrixes, where each second submatrix includes L rows and N columns. The location transformation is performed on L bits in each column in each second submatrix to obtain the third matrix $H_3$ with m rows and N columns.

In a specific implementation, the upward circular shift is performed on L bits in a $j^{th}$ ($0 \leq j < N$) column in each second submatrix by $\theta \times (j\%L)$ bits. More specifically, for $0 \leq i < m$, the second location transformation may further satisfy a formula (4.1):

$$H_3[i][j] = \begin{cases} H_4\big[(i + \theta \times (j\%L))\%L + \lfloor i/L \rfloor \times L\big][j], 0 \leq j < K \\ H_1\big[(i + \theta \times (j\%L))\%L + \lfloor i/L \rfloor \times L\big][j], K \leq j < N \end{cases}$$

The integer θ is the column offset constraint factor. The formula (4.1) may alternatively be briefly expressed as:

$$H_3[i][j] = \begin{cases} H_4\big[(i + \theta \times j)\%L + \lfloor i/L \rfloor \times L\big][j], 0 \leq j < K \\ H_1\big[(i + \theta \times j)\%L + \lfloor i/L \rfloor \times L\big][j], K \leq j < N \end{cases}$$

In another specific implementation, for $0 \leq i < m$, the second location transformation may further satisfy a formula (4.2):

$$H_3[i][j] = \begin{cases} H_4[(i\%L)^\wedge(j\%L) + \lfloor i/L \rfloor \times L][j], 0 \leq j < K \\ H_1[(i\%L)^\wedge(j\%L) + \lfloor i/L \rfloor \times L][j], K \leq j < N \end{cases}$$

When L is the power of 2, for $0 \leq i < m$, the second location transformation may further satisfy a formula (4.3):

$$H_3[i][j] = \begin{cases} H_4[i^\wedge(j\%L)][j], 0 \leq j < K \\ H_1[i^\wedge(j\%L)][j], K \leq j < N \end{cases}$$

It should be understood that the foregoing describes the specific manners in which the row transformation and the column transformation are separately implemented. That is, the bit interleaving includes two steps of operations. In some possible scenarios, the row transformation and the column transformation may alternatively be implemented using one step of operation. The following describes this implementation in detail.

Implementation 3 of the bit interleaving: The row transformation and the column transformation are implemented using one step of operation.

In a specific implementation, for $0 \leq i < m$, the bit interleaving satisfies a formula (5):

$$H_3[i][j] = \begin{cases} H_1\big[(i + \theta \times (j\%L))\%L + \lfloor i/L \rfloor \times L\big]\big[\big(j + \big((i + \theta \times (j\%L))\%L + \lfloor i/L \rfloor \times L\big) \times \Delta\big)\%K\big], 0 \leq j < K \\ \qquad\qquad H_1\big[(i + \theta \times (j\%L))\%L + \lfloor i/L \rfloor \times L\big][j], K \leq j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, and $\theta$ is a non-zero integer greater than -L and less than L.

The formula (5) may alternatively be briefly expressed as:

$$H_3[i][j] = \begin{cases} H_1[(i + \theta \times j)\%L + \lfloor i/L \rfloor \times L]\big[\big(j + \big((i + \theta \times j)\%L + \lfloor i/L \rfloor \times L\big) \times \Delta\big)\%K\big], 0 \leq j < K \\ \qquad\qquad H_1[(i + \theta \times j)\%L + \lfloor i/L \rfloor \times L][j], K \leq j < N \end{cases}$$

In another specific implementation, for $0 \leq i < m$, the bit interleaving satisfies a formula (6):

$$H_3[i][j] = \begin{cases} H_1[(i\%L)^\wedge(j\%L) + \lfloor i/L \rfloor \times L]\big[(j + ((i\%L)^\wedge(j\%L) + \lfloor i/L \rfloor \times L) \times \Delta)\%K\big], 0 \leq j < K \\ \qquad\qquad H_1[(i\%L)^\wedge(j\%L) + \lfloor i/L \rfloor \times L][j], K \leq j < N \end{cases}$$

where $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $Y^\wedge Z$ represents an integer corresponding to a bit sequence obtained through an exclusive OR operation performed on a bit sequence corresponding to the integer Y and a bit sequence corresponding to the integer Z.

When L is a power of 2, for $0 \leq i < m$, the bit interleaving satisfies a formula (7):

$$H_3[i][j] = \begin{cases} H_1[i^\wedge(j\%L)]\big[\big(j + \big(i^\wedge(j\%L)\big) \times \Delta\big)\%K\big], 0 \leq j < K \\ \qquad\qquad H_1[i^\wedge(j\%L)][j], K \leq j < N \end{cases}$$

It should be noted that when the integer $\Delta$ is a multiple of 10, and one outer-code symbol in the outer-code codeword includes 10 bits, the K information bits may be considered as the K/10 symbols, where each symbol corresponds to 10 information bits. Performing circular shift on K information bits in the $i^{th}$ ($0 \leq i < m$) row in the first matrix $H_1$ by $i \times \Delta$ bits may be considered as performing the circular shift on K/10 symbols in the $i^{th}$ ($0 \leq i < m$) row in the first matrix $H_1$ by $i \times (\frac{\Delta}{10})$ symbols. A specific implementation thereof is known to a person of ordinary skill in the art. Details are not described herein again.

When specific values of parameters such as $\Delta$, $\theta$, m, and L are given, an interleaving correspondence for performing the bit interleaving on the first matrix $H_1$ to obtain the third matrix $H_3$ may be described by using a table. A specific implementation thereof is known to a person of ordinary skill in the art. Details are not described herein again.

When specific values of parameters such as $\Delta$, $\theta$, m, and L are given, the foregoing formula (5) or (6) may be simply transformed into another formula. For example, when m = L, the formula (5) may be simplified as follows:

$$H_3[i][j] = \begin{cases} H_1\big[(i + \theta \times (j\%L))\%L\big]\big[\big(j + ((i + \theta \times (j\%L))\%L) \times \Delta\big)\%K\big], 0 \le j < K \\ H_1\big[(i + \theta \times (j\%L))\%L\big][j], K \le j < N \end{cases}$$

The formula (6) may be transformed as follows:

$$H_3[i][j] = \begin{cases} H_1\big[(i\%L)\wedge(j\%L)\big]\big[\big(j + ((i\%L)\wedge(j\%L)) \times \Delta\big)\%K\big], 0 \le j < K \\ H_1\big[(i\%L)\wedge(j\%L)\big][j], K \le j < N \end{cases}; \text{ or}$$

$$H_3[i][j] = \begin{cases} H_1\big[i\wedge(j\%L)\big]\big[\big(j + (i\wedge(j\%L)) \times \Delta\big)\%K\big], 0 \le j < K \\ H_1\big[i\wedge(j\%L)\big][j], K \le j < N \end{cases}$$

It should be understood that a specific implementation of other simple transformation is known to a person of ordinary skill in the art. Details are not described herein again.

It should be noted that the foregoing codeword set, bit matrix, and submatrix are merely concepts introduced for ease of description. In actual application, the data stream is an integrate part without division. Each codeword set, bit matrix, and submatrix may be considered as one or more bits in the data stream. In addition, in actual application, the first matrix, the second matrix, the third matrix, the fourth matrix, and the like may alternatively not be presented in a form of a matrix. For example, the first matrix $H_1$ is presented as a first bit set, the first bit set includes m first bit subsets, and each first bit subset includes bit elements in one row and N columns in the corresponding first matrix $H_1$.

It should be noted that, in the foregoing implementations, the target bit set obtained through the bit interleaving of the m codewords is represented by using the third matrix $H_3$ with the m rows and the N columns. In addition, the target bit set may alternatively be represented by using the one-dimensional array (array) that is denoted as an array A and that includes the m $\times$ N bits. A $t^{th}$ ($0 \le t < m \times N$) bit in the array A is denoted as A[t]. Performing the bit interleaving on the first matrix $H_1$ to obtain the array A including the m $\times$ N bit elements may alternatively be represented in the following manner.

In an example, for $0 \le i < m$, the bit interleaving satisfies a formula (8):

$$A[i + j \times m]$$
$$= \begin{cases} H_1\big[(i + \theta \times (j\%L))\%L + \lfloor i/L \rfloor \times L\big]\big[\big(j + ((i + \theta \times (j\%L))\%L + \lfloor i/L \rfloor \times L) \times \Delta\big)\%K\big], 0 \le j < K \\ H_1\big[(i + \theta \times (j\%L))\%L + \lfloor i/L \rfloor \times L\big][j], K \le j < N \end{cases}$$

where $H_1[i][j]$ represents a bit in an $i^{th}$ row and a $j^{th}$ column in the bit matrix on which the bit interleaving has not been performed, A[t] represents a $t^{th}$ bit in the one-dimensional array obtained through the bit interleaving, $0 \le t < m \times N$, Y%Z represents a remainder obtained by dividing the integer Y by the integer Z, $\Delta$ is a non-zero integer greater than -K and less than K, $\lfloor \cdot \rfloor$ represents rounding down, and $\theta$ is a non-zero integer greater than -L and less than L.

In another example, for $0 \le i < m$, the bit interleaving satisfies a formula (9):

$$A[i + j \times m] = \begin{cases} H_1\big[(i\%L)\wedge(j\%L) + \lfloor i/L \rfloor \times L\big]\big[\big(j + ((i + \theta \times (j\%L))\%L + \lfloor i/L \rfloor \times L) \times \Delta\big)\%K\big], 0 \le j < K \\ H_1\big[(i\%L)\wedge(j\%L) + \lfloor i/L \rfloor \times L\big][j], K \le j < N \end{cases}$$

where $H_1[i][j]$ represents a bit in an $i^{th}$ row and a $j^{th}$ column in the bit matrix on which the bit interleaving has not been performed, A[t] represents a $t^{th}$ bit in the one-dimensional array obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and Y^Z represents an integer corresponding to a bit sequence obtained through an exclusive OR operation performed on a bit sequence corresponding to the integer Y and a bit sequence corresponding to the integer Z.

When L is the power of 2, for $0 \le i < m$, the bit interleaving satisfies a formula (10):

$$A[i + j \times m] = \begin{cases} H_1[i^\wedge(j\%L)][(j + (i^\wedge(j\%L)) \times \Delta)\%K], 0 \leq j < K \\ H_1[i^\wedge(j\%L)][j], K \leq j < N \end{cases}$$

303: Separately map m×N bits in each of the target bit sets to obtain m×N/L modulation symbols, to obtain a total of n×N/L modulation symbols.

In this embodiment, m is divisible by L. Every L bits in the target bit set are mapped to one modulation symbol. That is, the modulation symbol includes the L bits. L bits in each modulation symbol are from L inner-code codewords. In addition, if the L bits mapped to the modulation symbol are all from information bits in the inner-code codewords, any two of the L bits mapped to the modulation symbol are from two different locations in two different inner-code codewords.

It should be understood that the n×N/L modulation symbols obtained through the mapping of all target bit sets may be represented as one modulation symbol stream. Alternatively, the m×N/L modulation symbols obtained through the mapping of each target bit set may be represented as one modulation symbol stream, to obtain a total of n/m modulation symbol streams. Then, the modulation symbol stream may further undergo other data processing, and then be sent to a channel transmission medium for transmission. The other data processing may include polarization distribution (polarization distribution), DSP framing (framing) processing, or the like.

In a possible implementation, when N is divisible by L, the N bits in each inner-code codeword are mapped to N modulation symbols, the N bits in the inner-code codeword include L first bit subsets, bits in a same first bit subset are separately mapped to same bits in different modulation symbols, and bits in different first bit subsets are separately mapped to different bits in different modulation symbols. For example, one modulation symbol includes a bit $b_0$, a bit $b_1$, ..., and a bit $b_{L-1}$, and quantities of bits that are in the N bits in the inner-code codeword and that are mapped to the bit $b_0$, the bit $b_1$, ..., and the bit $b_{L-1}$ are all N/L. It should be understood that, probabilities that errors occur in the L bits in transmission are not necessarily equal. Bits in one inner-code codeword are more evenly mapped to modulation symbols, so that a burst resistance capability of a concatenated-FEC solution in actual transmission can be improved.

It should be noted that, in some possible scenarios, alignment marker lock and lane de-skew processing are performed on all of the n first data streams; and when W×L bits in W consecutive modulation symbols are all information bits in an inner-code codeword, the W×L bits are from more than two outer-code codewords obtained through the outer-code encoding, where W≥2.

In some implementations applied to coherent optical communication, the foregoing modulation scheme is dual-polarization quadrature amplitude modulation (Dual-polarization quadrature amplitude modulation, DP-QAM), for example, DP-QPSK or DP-16QAM. For DP-QPSK modulation, one DP-QPSK modulation symbol corresponds to L=4 bits. For DP-16QAM modulation, one DP-16QAM modulation symbol corresponds to L=8 bits.

In some implementations applied to direct-detection optical communication, the foregoing modulation scheme is pulse amplitude modulation (Pulse amplitude modulation, PAM), for example, PAM4. For PAM4 modulation, one PAM4 modulation symbol corresponds to L=2 bits.

The following describes a specific implementation of the mapping by using an example in which the target bit set is represented as the third matrix $H_3$.

Implementation 1 of the mapping:
Every L consecutive bits in m bits in each column in the third matrix $H_3$ are mapped to one modulation symbol. Each third matrix $H_3$ is mapped to m×N/L modulation symbols.

In a possible implementation, m/L modulation symbols obtained through the mapping of the m bits in each column in the third matrix $H_3$ are consecutive in the modulation symbol stream. In other words, the m/L modulation symbols obtained through the mapping of each column in the third matrix $H_3$ are used as m/L consecutive modulation symbols in the modulation symbol stream, and the m × N/L modulation symbols obtained through the mapping of the N columns in the third matrix $H_3$ are used as m × N/L consecutive modulation symbols in the modulation symbol stream.

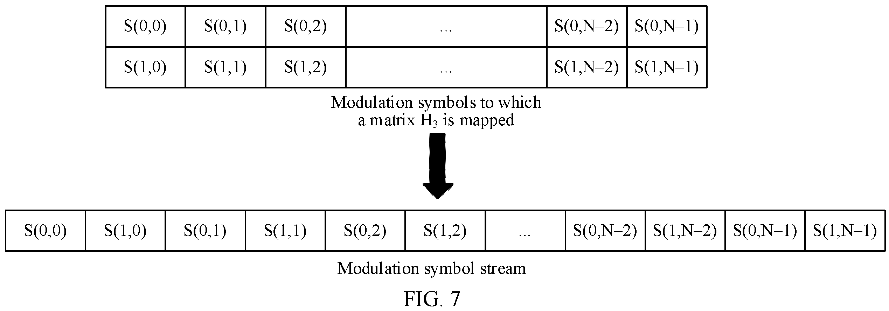

FIG. 7 is a first diagram of bit mapping according to an embodiment of this application. As shown in FIG. 7, when m/L=2, each column in the third matrix $H_3$ is mapped to two modulation symbols, and the two modulation symbols are represented by using S(0,j) and S(1,j), where $0 \leq j < N$.

In another possible implementation, m bits in a column B in the third matrix $H_3$ are mapped to obtain m/L first modulation symbols, every T consecutive first modulation symbols in the m/L first modulation symbols are consecutive in the modulation symbol stream, m bits in a column C in the third matrix $H_3$ are mapped to obtain m/L second modulation symbols, every T consecutive second modulation symbols in the m/L second modulation symbols are consecutive in the modulation symbol stream, the column B is adjacent to the column C, the T consecutive first modulation symbols in the m/L first modulation symbols and the T consecutive second modulation symbols in the m/L second modulation symbols are consecutive in the modulation symbol stream, and m/L is divisible by T.

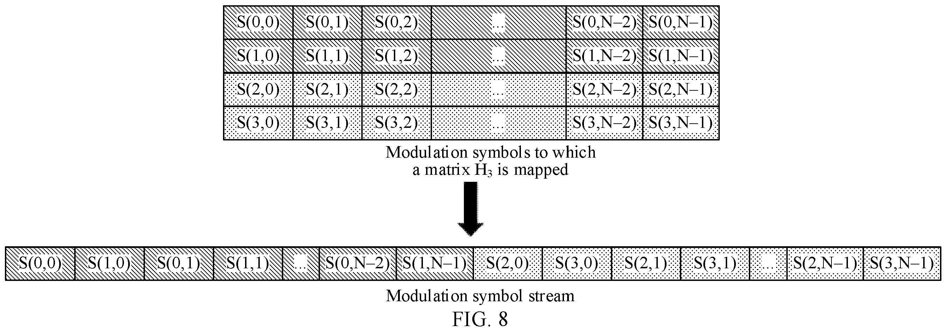

FIG. 8 is a second diagram of bit mapping according to an embodiment of this application. As shown in FIG. 8, when m/L=4, and T=2, each column in the third matrix $H_3$ is mapped to four modulation symbols that are represented by using S(0,j), S(1,j), S(2,j), and S(3,j), where $0 \leq j < N$. It can be learned that the first T modulation symbols in m/L modulation symbols obtained through the mapping of each column in the third matrix $H_3$ are used as T consecutive modulation symbols in the modulation symbol stream. Correspondingly, a total of $T \times N$ modulation symbols in the N columns are used as $T \times N$ consecutive modulation symbols in the modulation symbol stream. Next T modulation symbols in the m/L modulation symbols obtained through the mapping of each column in the third matrix $H_3$ are used as T consecutive modulation symbols in the modulation symbol stream. Correspondingly, a total of $T \times N$ modulation symbols in the N columns are used as next $T \times N$ consecutive modulation symbols in the modulation symbol stream. By analogy, $m \times N/L$ consecutive modulation symbols in the modulation symbol stream may be obtained.

Implementation 2 of the mapping:

L bits in each modulation symbol are from $L_r$ inner-code codewords. $L_c$ bits in each of the $L_r$ inner-code codewords, namely, a total of $L_r \times L_c$ bits, are mapped to one modulation symbol. 2L bits in two consecutive modulation symbols are from $2L_r$ inner-code codewords. $L_c$ bits in each of the $2L_r$ inner-code codewords are mapped to the two consecutive modulation symbols. $L = L_r \times L_c$, and $L_c > 1$. In other words, a total of $L_r \times L_c = L$ bits in $L_c$ columns in every $L_r$ rows in the third matrix $H_3$ are mapped to one modulation symbol, where $L_c > 1$. For example, L inner-code bits respectively corresponding to a bit $b_0$, a bit $b_1$, ... , and a bit $b_{L-1}$ in one modulation symbol are from $L_r$ different inner-code codewords, and each inner-code codeword provides $L_c$ bits. For the third matrix $H_3$, a total of $m \times L_c$ bits in every $L_c$ columns are mapped to $m/L_r$ modulation symbols. Each third matrix $H_3$ is mapped to $m \times N/L$ modulation symbols, to obtain $m \times N/L$ consecutive modulation symbols in the modulation symbol data stream.

In a possible implementation, the $m/L_r$ modulation symbols obtained through the mapping of the every $L_c$ columns in the third matrix $H_3$ are used as $m/L_r$ consecutive modulation symbols in the modulation symbol stream, and the $m \times N/L$ modulation symbols obtained through the mapping of the N columns are used as the $m \times N/L$ consecutive modulation symbols in the modulation symbol stream.

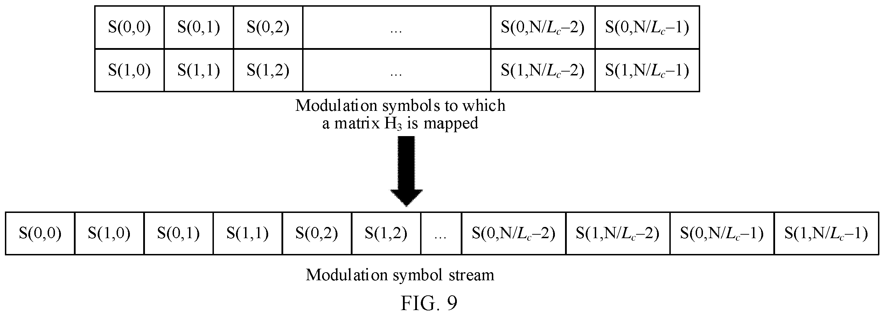

FIG. 9 is a third diagram of bit mapping according to an embodiment of this application. As shown in FIG. 9, when $\frac{m}{L_r} = 2$, the total of $m \times L_c$ bits in the every $L_c$ columns in the third matrix $H_3$ are mapped to $\frac{m \times L_c}{L} = \frac{m}{L_r} = 2$ modulation symbols that are respectively represented by using S(0,j) and S(1,j), where $0 \leq j < N/L_c$.

In another possible implementation, bits in a column B in the third matrix $H_3$ are mapped to obtain $m/L_r$ first modulation symbols, every T consecutive first modulation symbols in the $m/L_r$ first modulation symbols are consecutive in the modulation symbol stream, bits in a column C in each target bit set are mapped to obtain $m/L_r$ second modulation symbols, every T consecutive second modulation symbols in the $m/L_r$ second modulation symbols are consecutive in the modulation symbol stream, the column B includes $L_c$ columns, the column C also includes $L_c$ columns, the column B is adjacent to the column C, the T consecutive first modulation symbols in the $m/L_r$ first modulation symbols and the T consecutive second modulation symbols in the $m/L_r$ second modulation symbols are consecutive in the modulation symbol stream, and $m/L_r$ is divisible by T.

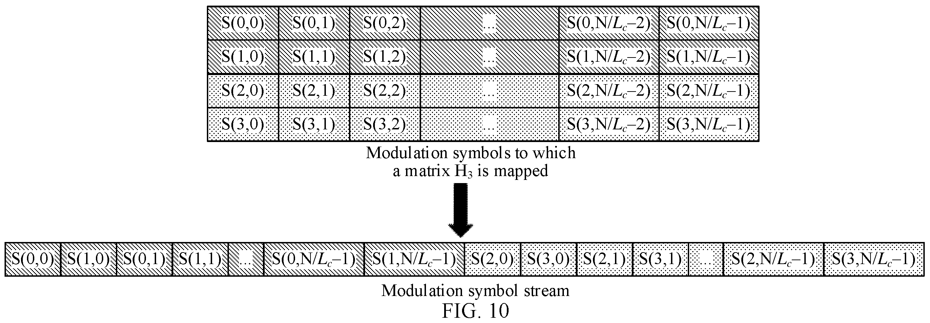

FIG. 10 is a fourth diagram of bit mapping according to an embodiment of this application. As shown in FIG. 10, when $\frac{m}{L_r} = 2$, and T=2, the total of $m \times L_c$ bits in the every $L_c$ columns in the third matrix $H_3$ are mapped to $\frac{m \times L_c}{L} = \frac{m}{L_r} = 4$ modulation symbols that are respectively represented by using S(0,j), S(1,j), S(2,j), and S(3,j), where $0 \leq j < N/L_c$. It can be learned that the first T modulation symbols in the $m/L_r$ modulation symbols obtained through the mapping of the every $L_c$ columns are used as T consecutive modulation symbols in the first modulation symbol stream. Correspondingly, a total of $T \times N/L_c$ modulation symbols in the N columns are used as $T \times N/L_c$ consecutive modulation symbols in the modulation symbol stream. Next T modulation symbols in the $m/L_r$ modulation symbols obtained through the mapping of the every $L_c$ columns are used as T consecutive modulation symbols in the first modulation symbol stream. Correspondingly, a total of $T \times N/L_c$ modulation symbols in the N columns are used as next $T \times N/L_c$ consecutive modulation symbols in the modulation symbol stream. By analogy, $m \times N/L$ consecutive modulation symbols in the modulation symbol stream may be obtained.

In this embodiment of this application, a concatenated-FEC transmission solution is used. That is, the outer-code encoding and the inner-code encoding are sequentially performed on the data streams. On this basis, this application designs a bit interleaving and mapping method, so that both bits in an outer-code codeword and bits in an inner-code codeword are discretely and evenly mapped to modulation symbols. In this way, the concatenated-FEC transmission solution has a strong burst resistance capability. Particularly, a burst error with a small length may be directly corrected through inner-code decoding. The concatenated-FEC transmission solution is widely applicable to transmission scenarios, particularly an actual coherent transmission scenario in which there is colored noise on a channel.

With reference to some specific embodiments, the following further describes a procedure of the data processing method described in FIG. 3.

Embodiment 1: A target bit set is represented as a bit matrix, where n=32, m=16, K=160, and L=8.

A physical medium attachment (Physical Medium Attachment, PMA) sublayer of a transmitter processing module processes data from a plurality of synchronous client lanes (client lanes) to obtain n=32 first data streams. The 32 first data streams are separately sent to inner-code encoders for inner-code encoding to obtain 32 second data streams. BCH(176,160) is used for the inner-code encoding. That is, a codeword bit length N=176, an information bit length K=160, and a parity bit length P=16. 160 information bits in each inner-code codeword are from 16 symbols in 16 different outer-code RS codewords.

32 codewords obtained through the inner-code encoding are grouped into h=2 codeword sets, and each codeword set includes m=16 BCH(176,160) codewords. In consideration of DP-16QAM modulation, every L=8 bits are mapped to one DP-16QAM symbol. 352 DP-16QAM symbols may be obtained through bit interleaving and mapping of the 16 BCH(176,160) codewords in each codeword set.

A total of 2816 bits in the foregoing 16 BCH(176,160) codewords are represented by using a first matrix $H_1$ with 16 rows and 176 columns, where each row in the first matrix $H_1$ includes 176 bits in one inner-code BCH(176,160) codeword. The bit interleaving is performed on the first matrix $H_1$ to obtain a third matrix $H_3$ with 16 rows and 176 columns. An interleaving correspondence between the first matrix $H_1$ and the third matrix $H_3$ is: for $0 \leq i < 16$,

$$H_3[i][j]$$
$$= \begin{cases} H_1\big[(i + \theta \times (j\%8))\%8 + \lfloor i/8 \rfloor \times 8\big]\Big[\big(j + ((i + \theta \times (j\%8))\%8 + \lfloor i/8 \rfloor \times 8) \times \Delta\big)\%160\Big], 0 \leq j < 160 \\ H_1\big[(i + \theta \times (j\%8))\%8 + \lfloor i/8 \rfloor \times 8\big][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the non-zero integer $\theta$ is a column offset constraint factor, and the non-zero integer $\theta$ satisfies $-8 < \theta < 8$; in this embodiment, typical values of the integer $\Delta$ are 10, 20, 30, 50, 60, 70, 90, 100, 110, 130, 140, and 150; and a typical value of the integer $\theta$ is $\theta = 7$, and another typical value is $\theta = 1$.

In the foregoing third matrix $H_3$ with the 16 rows and the 176 columns, each column includes 16 bits. Every eight bits in the 16 bits are mapped to one DP-16QAM symbol. Each column is separately mapped to two modulation symbols. In a specific implementation, in each column, the 0th row to the 7th row are mapped to one DP-16QAM symbol, and the 8th row to the 15th row are mapped to the other DP-16QAM symbol. Each third matrix $H_3$ is mapped to 352 DP-16QAM symbols. The two DP-16QAM symbols obtained through the mapping of each column are used as two consecutive DP-16QAM symbols in a first modulation symbol stream, and 352 DP-16QAM symbols obtained through the mapping of the 176 columns are used as 352 consecutive DP-16QAM symbols in the first modulation symbol stream.

Every 16 codewords in the 32 codewords undergo the bit interleaving, and then are mapped to 352 DP-16QAM symbols. The 32 codewords undergo the bit interleaving, and then are mapped to a total of 704 DP-16QAM symbols, and the 704 DP-16QAM symbols are used as 704 consecutive DP-16QAM symbols in the first modulation symbol stream.

In this embodiment, when there is colored noise in actual transmission, and the colored noise has a width of four DP-16QAM symbols, 32 error bits can be scattered to a plurality of inner-code BCH(176,160) codewords, and a quantity of error bits corresponding to each inner-code BCH(176,160) codeword is not greater than 2. Because the inner code BCH(176,160) can correct two bits is considered, colored noise with a width of two or three DP-16QAM symbols can be effectively corrected by the inner code. In addition, according to the designed bit interleaving and mapping method, an overall concatenated-FEC solution can resist a burst error with a length greater than 1500 bits. That is, according to the designed bit interleaving and mapping method, the overall concatenated-FEC solution can effectively resist the colored noise with the width of up to the four DP-16QAM symbols, and can resist the burst error with the length greater than 1500 bits. According to the designed bit interleaving and mapping method, the overall concatenated-FEC solution can effectively resist the colored noise with the width of up to the four DP-16QAM symbols, and can resist the burst error with the length greater than 1500 bits.

Embodiment 2: A target bit set is represented as an array, where n=32, m=16, K=160, and L=8.

Based on the solution in Embodiment 1, a total of 2816 bits in 16 BCH(176,160) codewords are represented by using a first matrix $H_1$ with 16 rows and 176 columns, and data obtained through bit interleaving of the first matrix $H_1$ is not represented by using the third matrix $H_3$ with the 16 rows and the 176 columns shown in Embodiment 1, but is represented by using an array A with a length of 2816 bits. The bit interleaving is performed on the first matrix $H_1$ to obtain the array A with the length of 2816 bits. An interleaving correspondence between the first matrix $H_1$ and array A is: for $0 \leq i < 16$,

$$A[i + j \times 16]$$
$$= \begin{cases} H_1\big[(i + \theta \times (j\%8))\%8 + \lfloor i/8 \rfloor \times 8\big]\Big[\big(j + ((i + \theta \times (j\%8))\%8 + \lfloor i/8 \rfloor \times 8) \times \Delta\big)\%160\Big], 0 \leq j < 160 \\ H_1\big[(i + \theta \times (j\%8))\%8 + \lfloor i/8 \rfloor \times 8\big][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the non-zero integer $\theta$ is a column offset constraint factor, and the integer $\theta$ satisfies $-8 < \theta < 8$; in this embodiment, typical values of the integer $\Delta$ are 10, 20, 30, 50, 60, 70, 90, 100, 110, 130, 140, and 150; and a typical value of the integer $\theta$ is $\theta = 7$, and another typical value is $\theta = 1$.

Every eight consecutive bits in the first array A that includes the 2816 bits are mapped to one DP-16QAM symbol, to obtain 352 DP-16QAM symbols, and the 352 DP-16QAM symbols are used as 352 consecutive DP-16QAM symbols in a first modulation symbol stream.

Every 16 codewords in the 32 codewords undergo the bit interleaving, and then are mapped to 352 DP-16QAM symbols. The 32 codewords undergo the bit interleaving, and then are mapped to a total of 704 DP-16QAM symbols, and the 704 DP-16QAM symbols are used as 704 consecutive DP-16QAM symbols in the first modulation symbol stream.

It should be noted that, when values of the row offset constraint factor $\Delta$ and the column offset constraint factor $\theta$ in Embodiment 1 are respectively equal to values of $\Delta$ and $\theta$ in Embodiment 2, the 704 DP-16QAM symbols that are the same as those in Embodiment 2 are obtained through the bit interleaving and the mapping of the 32 codewords in Embodiment 2.

In this embodiment, according to the designed bit interleaving and mapping method, an overall concatenated-FEC solution can effectively resist colored noise with a width of up to four DP-16QAM symbols, and can resist a burst error with a length greater than 1500 bits.

Embodiment 3: A target bit set is represented as a bit matrix, where n=32, m=8, K=160, and L=8.

Based on the solution in Embodiment 1, 32 codewords obtained through inner-code encoding are not grouped into two codeword sets shown in Embodiment 1, but are grouped into four codeword sets, where each codeword set includes m=8 BCH(176,160) codewords. In consideration of DP-16QAM modulation, every L=8 bits are mapped to one DP-16QAM symbol. 176 DP-16QAM symbols may be obtained through bit interleaving and mapping of the eight BCH(176,160) codewords in each codeword set.

A total of 1408 bits in the foregoing eight BCH(176,160) codewords are represented by using a first matrix $H_1$ with eight rows and 176 columns, where each row in the first matrix $H_1$ includes 176 bits in one inner-code BCH(176,160) codeword. The bit interleaving is performed on the first matrix $H_1$ to obtain a third matrix $H_3$ with eight rows and 176 columns. An interleaving correspondence between the first matrix $H_1$ and the third matrix $H_3$ is: for $0 \leq i < 8$,

$$H_3[i][j] = \begin{cases} H_1\left[(i + \theta \times (j\%8))\%8 + \left\lfloor \frac{i}{8} \right\rfloor \times 8\right]\left[\left(j + \left((i + \theta \times (j\%8))\%8 + \left\lfloor \frac{i}{8} \right\rfloor \times 8\right) \times \Delta\right)\%160\right], 0 \leq j < 160 \\ H_1\left[(i + \theta \times (j\%8))\%8 + \left\lfloor \frac{i}{8} \right\rfloor \times 8\right][j], 160 \leq j < 176 \end{cases}$$

The foregoing formula can be simplified as:

$$H_3[i][j] = \begin{cases} H_1\left[(i + \theta \times (j\%8))\%8\right][(j + i \times \Delta)\%160], 0 \leq j < 160 \\ H_1\left[(i + \theta \times (j\%8))\%8\right][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the non-zero integer $\theta$ is a column offset constraint factor, and the integer $\theta$ satisfies $-8 < \theta < 8$; in this embodiment, typical values of the integer $\Delta$ are 10, 20, 30, 40, 50, 60, 70, 90, 100, 110, 120, 130, 140, and 150; and a typical value of the integer $\theta$ is $\theta = 7$, and another typical value is $\theta = 1$.

In the foregoing third matrix $H_3$ with the eight rows and the 176 columns, each column includes eight bits. The eight bits in each column are mapped to one DP-16QAM symbol. Each third matrix $H_3$ is mapped to 176 DP-16QAM symbols. The 176 DP-16QAM symbols obtained through the mapping of the 176 columns are used as 176 consecutive DP-16QAM symbols in a first modulation symbol stream.

Every eight codewords in the 32 codewords undergo the bit interleaving, and then are mapped to 176 DP-16QAM symbols. The 32 codewords undergo the bit interleaving, and then are mapped to a total of 704 DP-16QAM symbols, and the 704 DP-16QAM symbols are used as 704 consecutive DP-16QAM symbols in the first modulation symbol stream.

In this embodiment, according to the designed bit interleaving and mapping method, an overall concatenated-FEC solution can effectively resist colored noise with a width of up to two DP-16QAM symbols, and can resist a burst error with a length greater than 2000 bits.

Embodiment 4: A target bit set is represented as an array, where n=32, m=8, K=160, and L=8.

Based on the solution in Embodiment 3, a total of 1408 bits in eight BCH(176,160) codewords are represented by using a first matrix $H_1$ with eight rows and 176 columns, and data obtained through bit interleaving of the first matrix $H_1$ is not represented by using the third matrix $H_3$ with the eight rows and the 176 columns shown in Embodiment 1, but is represented by using an array A with a length of 1408 bits. The bit interleaving is performed on the first matrix $H_1$ to obtain the array A with the length of 1408 bits. An interleaving correspondence between the first matrix $H_1$ and array A is: for $0 \leq i < 8$,

$$A[i + j \times 16] = \begin{cases} H_1\left[(i + \theta \times (j\%8))\%8\right]\left[\left(j + \left((i + \theta \times (j\%8))\%8\right) \times \Delta\right)\%160\right], 0 \leq j < 160 \\ H_1\left[(i + \theta \times (j\%8))\%8\right][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the non-zero integer $\theta$ is a column offset constraint factor, and the integer $\theta$ satisfies $-8 < \theta < 8$; in this embodiment, typical values of the integer $\Delta$ are 10, 20, 30, 40, 50, 60, 70, 90, 100, 110, 120, 130, 140, and 150; and a typical value of the integer $\theta$ is $\theta = 7$, and another typical value is $\theta = 1$.

Every eight consecutive bits in the first array A that includes the 1408 bits are mapped to one DP-16QAM symbol, to obtain 176 DP-16QAM symbols, and the 176 DP-16QAM symbols are used as 176 consecutive DP-16QAM symbols in a first modulation symbol stream.

Every eight codewords in the 32 codewords undergo the bit interleaving, and then are mapped to 176 DP-16QAM symbols. The 32 codewords undergo the bit interleaving, and then are mapped to a total of 704 DP-16QAM symbols.

It should be noted that, when values of the row offset constraint factor $\Delta$ and the column offset constraint factor $\theta$ in Embodiment 4 are respectively equal to values of $\Delta$ and $\theta$ in Embodiment 3, the 704 DP-16QAM symbols that are the same as those in Embodiment 3 are obtained through the bit interleaving and the mapping of the 32 codewords in Embodiment 4.

In this embodiment, according to the designed bit interleaving and mapping method, an overall concatenated-FEC solution can effectively resist colored noise with a width of up to two DP-16QAM symbols, and can resist a burst error with a length greater than 2000 bits.

Embodiment 5: A target bit set is represented as a bit matrix, where n=32, m=32, K=160, and L=8.

Based on the solution in Embodiment 1, 32 codewords obtained through inner-code encoding are not grouped into two codeword sets shown in Embodiment 1, but are used as one codeword set including m=32 BCH(176,160) codewords. In consideration of DP-16QAM modulation, every L=8 bits are mapped to one DP-16QAM symbol. 704 DP-16QAM symbols may be obtained through bit interleaving and mapping of the 32 BCH(176,160) codewords.

A total of 5632 bits in the foregoing 32 BCH(176,160) codewords are represented by using a first matrix $H_1$ with 32 rows and 176 columns, where each row in the first matrix $H_1$ includes 176 bits in one inner-code BCH(176,160) codeword. The bit interleaving is performed on the first matrix $H_1$ to obtain a third matrix $H_3$ with 32 rows and 176 columns. An interleaving correspondence between the first matrix $H_1$ and the third matrix $H_3$ is: for $0 \leq i < 32$,

$$H_3[i][j] = \begin{cases} H_1\left[(i + \theta \times (j\%8))\%8 + \left\lfloor \frac{i}{8} \right\rfloor \times 8\right]\left[\left(j + \left((i + \theta \times (j\%8))\%8 + \left\lfloor \frac{i}{8} \right\rfloor \times 8\right) \times \Delta\right)\%160\right], 0 \leq j < 160 \\ \\ H_1\left[(i + \theta \times (j\%8))\%8 + \left\lfloor \frac{i}{8} \right\rfloor \times 8\right][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the non-zero integer $\theta$ is a column offset constraint factor, and the integer $\theta$ satisfies $-8 < \theta < 8$; in this embodiment, typical values of the integer $\Delta$ are 20, 30, 50, 60, 70, 90, 100, 110, 130, and 140; and a typical value of the integer $\theta$ is $\theta = 7$, and another typical value is $\theta = 1$.

In the foregoing third matrix $H_3$ with the 32 rows and the 176 columns, each column includes 32 bits. The 32 bits in each column are mapped to four DP-16QAM symbols. The 32 codewords undergo the bit interleaving, and then are mapped to a total of 704 DP-16QAM symbols, and 704 consecutive DP-16QAM symbols in a first modulation symbol stream consist of the 704 DP-16QAM symbols.

In a specific implementation, in terms of the first T=1 DP-16QAM symbol in the four DP-16QAM symbols obtained through the mapping of each column (namely, the 0th DP-16QAM symbol obtained through the mapping of each column), a total of 176 DP-16QAM symbols in the 176 columns are used as 176 consecutive DP-16QAM symbols in the first modulation symbol stream; in terms of next T=1 DP-16QAM symbol in the four DP-16QAM symbols obtained through the mapping of each column (namely, the 1st DP-16QAM symbol obtained through the mapping of each column), a total of 176 DP-16QAM symbols in the 176 columns are used as next 176 consecutive DP-16QAM symbols in the first modulation symbol stream; and by analogy, the 704 consecutive DP-16QAM symbols in the first modulation symbol stream may be obtained.

In this embodiment, according to the designed bit interleaving and mapping method, an overall concatenated-FEC solution can effectively resist colored noise with a width of up to two DP-16QAM symbols, and can resist a burst error with a length greater than 2000 bits.

Embodiment 6: A target bit set is represented as a bit matrix, and two symbols in each column are continuously output, where n=32, m=32, K=160, and L=8.

Based on the solution in Embodiment 5, 32 codewords undergo bit interleaving, then are mapped to a total of 704 DP-16QAM symbols, and 704 consecutive DP-16QAM symbols in a first modulation symbol stream consist of the 704 DP-16QAM symbols. This embodiment provides another specific implementation: In terms of the first two DP-16QAM symbols in four DP-16QAM symbols obtained through the mapping of each column (namely, the 0th and the 1st DP-16QAM symbols obtained through the mapping of each column), a total of 352 DP-16QAM symbols in 176 columns are used as 352 consecutive DP-16QAM symbols in the first modulation symbol stream; in terms of the last two DP-16QAM symbols in the four DP-16QAM symbols obtained through the mapping of each column (namely, the 2nd and the 3rd DP-16QAM symbols obtained through the mapping of each column), a total of 352 DP-16QAM symbols in the 176 columns are used as next 352 consecutive DP-16QAM symbols in the first modulation symbol stream; and finally, the 704 consecutive DP-16QAM symbols in the first modulation symbol stream are obtained.

In this embodiment, according to the designed bit interleaving and mapping method, an overall concatenated-FEC solution can effectively resist colored noise with a width of up to four DP-16QAM symbols, and can resist a burst error with a length greater than 1500 bits.

Embodiment 7: A target bit set is represented as a bit matrix, and two symbols in each column are continuously output, where n=16, m=16, K=160, and L=8.

A physical medium attachment (Physical Medium Attachment, PMA) sublayer of a transmitter processing module processes data from a plurality of synchronous client lanes (client lanes) to obtain n=16 first data streams. The 16 first data streams are separately sent to inner-code encoders for inner-code encoding to obtain 16 second data streams. BCH(176,160) is used for the inner-code encoding. That is, a codeword bit length N=176, an information bit length K=160, and a parity bit length P=16. 160 information bits in each inner-code codeword are from 16 symbols in 16 different outer-code RS codewords.

The foregoing 16 inner-code codewords are used as one codeword set, and include m=16 BCH(176,160) codewords. In consideration of DP-16QAM modulation, every L=8 bits are mapped to one DP-16QAM symbol. 352 DP-16QAM symbols may be obtained through bit interleaving and mapping of the 16 BCH(176,160) codewords.

A total of 2816 bits in the foregoing 16 BCH(176,160) codewords are represented by using a first matrix $H_1$ with 16 rows and 176 columns, where each row in the first matrix $H_1$ includes 176 bits in one inner-code BCH(176,160) codeword. The bit interleaving is performed on the first matrix $H_1$ to obtain a third matrix $H_3$ with 16 rows and 176 columns. An interleaving correspondence between the first matrix $H_1$ and the third matrix $H_3$ is: for $0 \leq i < 16$,

$$H_3[i][j] = \begin{cases} H_1[i \wedge (j\%8)][(j + (i \wedge (j\%8)) \times \Delta)\%160], 0 \leq j < 160 \\ H_1[i \wedge (j\%8)][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $-160 < \Delta < 160$, the integer $\theta$ is a column offset constraint factor, and the non-zero integer $\theta$ satisfies $-8 < \theta < 8$; in this embodiment, typical values of the integer $\Delta$ are 20, 30, 50, 60, 70, 90, 100, 110, 130, and 140; and a typical value of the integer $\theta$ is $\theta = 7$, and another typical value is $\theta = 1$.

In the foregoing third matrix $H_3$ with the 16 rows and the 176 columns, each column includes 16 bits. The 16 bits in each column are mapped to two DP-16QAM symbols. In a specific implementation, in each column, the 0th row to the 7th row are mapped to one DP-16QAM symbol, and the 8th row to the 15th row are mapped to the other DP-16QAM symbol. The 16 codewords undergo the bit interleaving, and then are mapped to a total of 352 DP-16QAM symbols, and 352 consecutive DP-16QAM symbols in a first modulation symbol stream consist of the 352 DP-16QAM symbols. In a specific implementation, the two DP-16QAM symbols obtained through the mapping of each column are used as two consecutive DP-16QAM symbols in the first modulation symbol stream, and 352 DP-16QAM symbols obtained through the mapping of the 176 columns are used as the 352 consecutive DP-16QAM symbols in the first modulation symbol stream.

It should be noted that 2816-bit interleaved data obtained through the bit interleaving of the first matrix $H_1$ is represented by using the third matrix $H_3$ with the 16 rows and the 176 columns, or may be represented by using an array with a length of 2816 bits as shown in Embodiment 2 and Embodiment 4. A specific implementation thereof is known to a person of ordinary skill in the art. Details are not described herein again.

In this embodiment, according to the designed bit interleaving and mapping method, an overall concatenated-FEC solution can effectively resist colored noise with a width of up to four DP-16QAM symbols, and can resist a burst error with a length greater than 1500 bits.

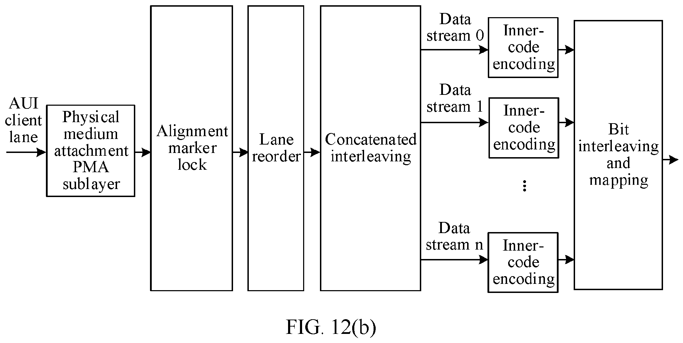

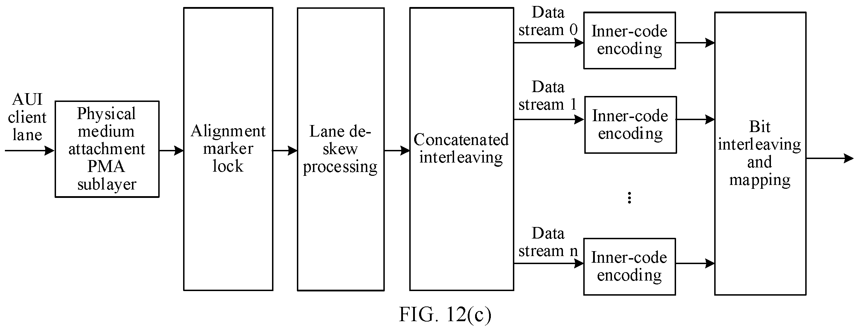

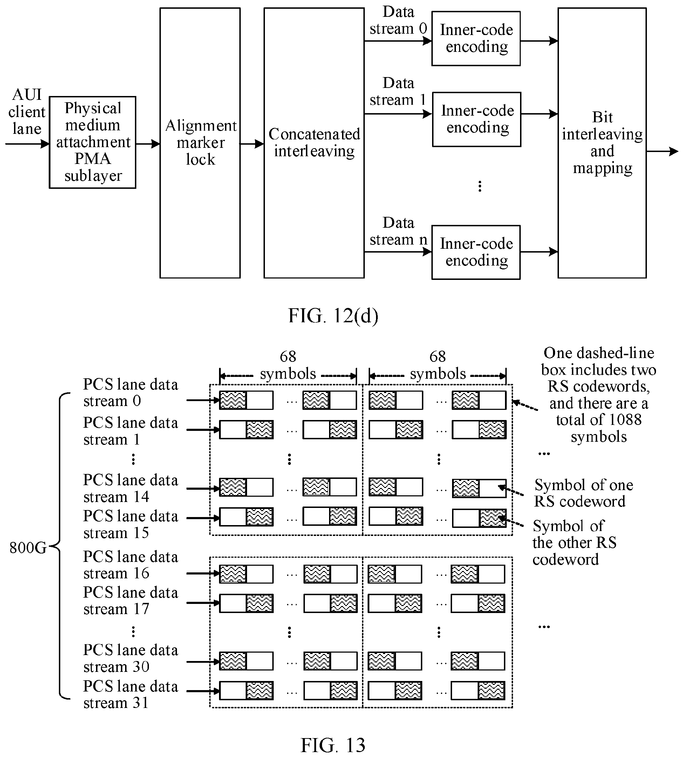

It should be noted that, an operation procedure of the transmitter processing module may alternatively be as shown in FIG. 12(b). A lane data stream obtained through alignment marker lock is directly sent to lane reorder without lane de-skew processing. When a host interface is 2×400G, an RS symbol in any one of lane data streams 0 to 15 sent to convolutional interleaving and an RS symbol in any one of lane data streams 16 to 31 sent to the convolutional interleaving are from two different RS outer-code codewords. In the 2×400G interface scenario, the transmitter processing module uses an operation procedure in FIG. 12(c) or FIG. 12(d), that is, does not perform a lane reorder operation, and it can still be ensured that the 160 information bits in the inner-code codeword correspond to the 16 RS symbols and are from the 16 different outer-code RS codewords. In this case, a delay of an overall concatenated-FEC solution can be reduced, but a capability of resisting a burst error by the concatenated-FEC solution is weakened. Whether to perform the lane de-skew processing and the lane reorder in the transmitter processing module may be determined based on an actual transmission scenario.

Embodiment 8: A target bit set is represented as a bit matrix, and four symbols in each column are continuously output, where n=8, m=8, K=120, and L=2.

A physical medium attachment (Physical Medium Attachment, PMA) sublayer of a transmitter processing module processes data from a plurality of synchronous client lanes (client lanes) to obtain n=8 first data streams. The eight first data streams are separately sent to inner-code encoders for inner-code encoding to obtain eight second data streams. A Hamming code Hamming(128,120) is used for the inner-code encoding. That is, a codeword bit length N=128, an information bit length K=120, and a parity bit length P=8. 120 information bits in each inner-code codeword are from 12 symbols in 12 different outer-code RS codewords.

The foregoing eight inner-code codewords are used as one codeword set, and include m=8 Hamming code Hamming(128,120) codewords. In consideration of PAM4 modulation, every L=2 bits are mapped to one PAM4 symbol. 512 PAM4 symbols may be obtained through bit interleaving and mapping of the eight Hamming(128,120) codewords.

A total of 1024 bits in the foregoing eight Hamming(128,120) codewords are represented by using a first matrix $H_1$ with eight rows and 128 columns, where each row in the first matrix $H_1$ includes 128 bits in one inner-code Hamming(128,120) codeword. The bit interleaving is performed on the first matrix $H_1$ to obtain a third matrix $H_3$ with eight rows and 128 columns. An interleaving correspondence between the first matrix $H_1$ and the third matrix $H_3$ is: for $0 \leq i < 8$,

$$H_3[i][j] = \begin{cases} H_1\left[(i + \theta \times (j\%2))\%2 + \left\lfloor \frac{i}{2} \right\rfloor \times 2\right]\left[\left(j + \left((i + \theta \times (j\%2))\%2 + \left\lfloor \frac{i}{2} \right\rfloor \times 2\right) \times \Delta\right)\%120\right], 0 \leq j < 120 \\ H_1\left[(i + \theta \times (j\%2))\%2 + \left\lfloor \frac{i}{2} \right\rfloor \times 2\right][j], 120 \leq j < 128 \end{cases}$$

where $\lfloor \cdot \rfloor$ represents a rounding down operation, the non-zero integer $\Delta$ is a row offset constraint factor, $\Delta$ is a multiple of 10, $0 < \Delta < 120$, the non-zero integer $\theta$ is a column offset constraint factor, and the integer $\theta = 1$; and in this embodiment, typical values of the integer $\Delta$ are 20, 30, 50, 60, 70, 90, and 100.

In the foregoing third matrix $H_3$ with the eight rows and the 176 columns, each column includes eight bits. The eight bits in each column are mapped to four PAM4 symbols. In a specific implementation, in each column, two bits in the $0^{th}$ row and the $1^{st}$ row are mapped to one PAM4 symbol, two bits in the $2^{nd}$ row and the $3^{rd}$ row are mapped to another PAM4 symbol, two bits in the $4^{th}$ row and the $5^{th}$ row are mapped to still another PAM4 symbol, and two bits in the $6^{th}$ row and the $7^{th}$ row are mapped to yet another PAM4 symbol. The eight codewords undergo the bit interleaving, and then are mapped to a total of 512 PAM4 symbols, and 512 consecutive PAM4 symbols in a first modulation symbol stream consist of the 512 PAM4 symbols. In a specific implementation, the four PAM4 symbols obtained through the mapping of each column are used as four consecutive PAM4 symbols in the first modulation symbol stream, and 512 PAM4 symbols obtained through the mapping of the 128 columns are used as the 512 consecutive PAM4 symbols in the first modulation symbol stream.

In this embodiment, according to the designed bit interleaving and mapping method, an overall concatenated-FEC solution can effectively resist colored noise with a width of up to four PAM4 symbols, and can resist a burst error with a length greater than 1200 bits.

Embodiment 9: A target bit set is represented as a bit matrix, and four symbols in each column are continuously output, where n=32, m=8, K=120, and L=2.

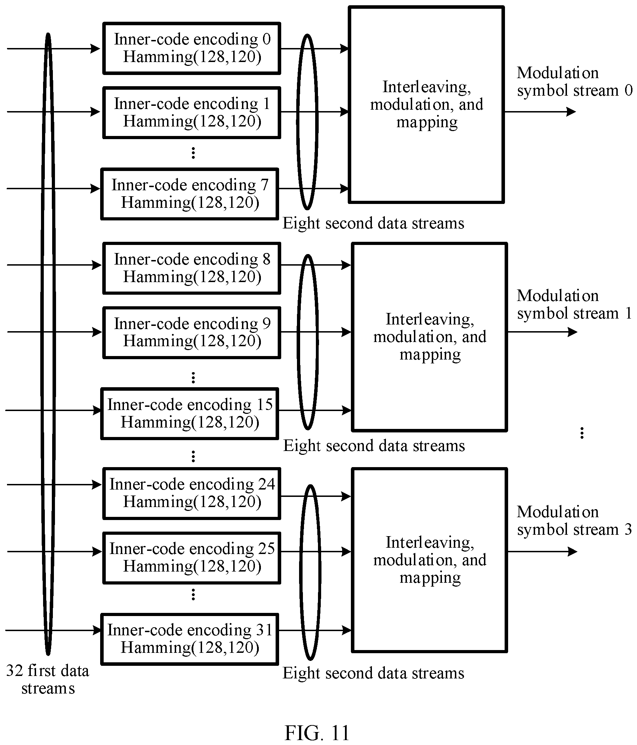

A physical medium attachment (Physical Medium Attachment, PMA) sublayer of a transmitter processing module processes data from a plurality of synchronous client lanes (client lanes) to obtain n=32 first data streams. FIG. 11 is a diagram of performing inner-code encoding and interleaving, modulation, and mapping on data streams according to an embodiment of this application. As shown in FIG. 11, the 32 first data streams are separately sent to inner-code encoders for the inner-code encoding to obtain 32 second data streams. A Hamming code Hamming(128,120) is used for the inner-code encoding. That is, a codeword bit length N=128, an information bit length K=120, and a parity bit length P=8. 120 information bits in each inner-code codeword are from 12 symbols in 12 different outer-code RS codewords. The 32 second data streams are grouped into four second data stream groups. Each group includes eight second data streams. One modulation symbol stream is obtained through interleaving and modulation of each second data stream group. Four modulation and mapping streams are obtained in total. The four modulation and mapping data streams are to be transmitted through four different channels. The four different channels may be four different wavelengths, four different optical fibers, or the like.

One Hamming(128,120) codeword is obtained from each second data stream above. A total of 1024 bits in a total of eight Hamming(128,120) codewords are represented by using a first matrix $H_1$ with eight rows and 128 columns, where each row in the first matrix $H_1$ includes 128 bits in one inner-code Hamming(128,120) codeword. Bit interleaving is performed on the first matrix $H_1$ to obtain a third matrix $H_3$ with eight rows and 128 columns. An interleaving correspondence between the first matrix $H_1$ and the third matrix $H_3$ is: for $0 \leq i < 8$,

$$H_3[i][j] = \begin{array}{l} H_1\left[(i + \theta \times (j\%2))\%2 + \left\lfloor\frac{i}{2}\right\rfloor \times 2\right]\left[\left(j + \left((i + \theta \times (j\%2))\%2 + \left\lfloor\frac{i}{2}\right\rfloor \times 2\right) \times \Delta\right)\%120\right], 0 \leq j < 120 \\ H_1\left[(i + \theta \times (j\%2))\%2 + \left\lfloor\frac{i}{2}\right\rfloor \times 2\right][j], 120 \leq j < 128 \end{array}$$

where $\lfloor\cdot\rfloor$ represents a rounding down operation, the non-zero integer $\Delta$ is a row offset constraint factor, $\Delta$ is a multiple of 10, $0 < \Delta < 120$, the non-zero integer $\theta$ is a column offset constraint factor, and the integer $\theta = 1$; and in this embodiment, typical values of the integer $\Delta$ are 10, 20, 30, 40, 50, 60, 70, 80, 90, 100, and 110.

Another interleaving mapping relationship is:

$$H_3[i][j] = \begin{cases} H_1[i\text{\textasciicircum}(j\%2)][(j + (i\text{\textasciicircum}(j\%2)) \times \Delta)\%120], 0 \leq j < 120 \\ H_1[i\text{\textasciicircum}(j\%2)][j], 120 \leq j < 128 \end{cases}$$

In the foregoing third matrix $H_3$ with the eight rows and the 176 columns, each column includes eight bits. The eight bits in each column are mapped to four PAM4 symbols. In a specific implementation, in each column, two bits in the $0^{th}$ row and the $1^{st}$ row are mapped to one PAM4 symbol, two bits in the $2^{nd}$ row and the $3^{rd}$ row are mapped to another PAM4 symbol, two bits in the $4^{th}$ row and the $5^{th}$ row are mapped to still another PAM4 symbol, and two bits in the $6^{th}$ row and the $7^{th}$ row are mapped to yet another PAM4 symbol. The eight codewords undergo the bit interleaving, and then are mapped to a total of 512 PAM4 symbols, and 512 consecutive PAM4 symbols in a first modulation symbol stream consist of the 512 PAM4 symbols.

In this embodiment, according to the designed bit interleaving and mapping method, an overall concatenated-FEC solution can effectively resist colored noise with a width of up to eight PAM4 symbols on each channel, and can resist a burst error with a length greater than 1100 bits.

It should be noted that, an operation procedure of the transmitter processing module may alternatively be as shown in FIG. 12(b). A lane data stream obtained through alignment marker lock is directly sent to lane reorder without lane de-skew processing. In this case, a delay of an overall concatenated-FEC solution can be reduced, but a capability of resisting a burst error by the concatenated-FEC solution is weakened. Whether to perform the lane de-skew processing and the lane reorder in the transmitter processing module may be determined based on an actual transmission scenario.

Embodiment 10: A target bit set is represented as a bit matrix, where n=32, m=8, K=160, L=8, $L_r = 4$, and $L_c = 2$.

A physical medium attachment (Physical Medium Attachment, PMA) sublayer of a transmitter processing module processes data from a plurality of synchronous client lanes (client lanes) to obtain n=32 first data streams. The 32 first data streams are separately sent to inner-code encoders for inner-code encoding to obtain 32 second data streams. BCH(176,160) is used for the inner-code encoding. That is, a codeword bit length N=176, an information bit length K=160, and a parity bit length P=16. 160 information bits in each inner-code codeword are from 16 symbols in 16 different outer-code RS codewords.

32 codewords obtained through the inner-code encoding are grouped into four codeword sets, and each codeword set includes m=8 BCH(176,160) codewords. In consideration of DP-16QAM modulation, every L=8 bits are mapped to one DP-16QAM symbol. 176 DP-16QAM symbols may be obtained through bit interleaving and mapping of the eight BCH(176,160) codewords in each codeword set.

A total of 1408 bits in the foregoing eight BCH(176,160) codewords are represented by using a first matrix $H_1$ with eight rows and 176 columns, where each row in the first matrix $H_1$ includes 176 bits in one inner-code BCH(176,160) codeword. The bit interleaving is performed on the first matrix $H_1$ to obtain a third matrix $H_3$ with eight rows and 176 columns. An interleaving correspondence between the first matrix $H_1$ and the third matrix $H_3$ is: for $0 \leq i < 8$,

$$H_3[i][j] = \begin{cases} H_1[i][(j + i \times \Delta)\%160], 0 \leq j < 160 \\ H_1[i][j], 160 \leq j < 176 \end{cases}$$

where $\lfloor\cdot\rfloor$ represents a rounding down operation, the non-zero integer $\Delta$ is a row offset constraint factor, $\Delta$ is a multiple of 10, $0 < \Delta < 160$, and the integer is a column offset constraint factor; and in this embodiment, typical values of the integer $\Delta$ are 10, 20, 30, 40, 50, 60, 70, 90, 100, 110, 120, 130, 140, and 150.

In the foregoing third matrix $H_3$ with the eight rows and the 176 columns, each column includes eight bits. In consideration of $L_r = 4$ and $L_c = 2$, a total of eight bits in two columns in every four rows are mapped to one DP-16QAM symbol. In the third matrix $H_3$, 2 modulation symbols obtained through the mapping of every 2 columns are used as 2 consecutive modulation symbols in a first modulation symbol stream, and 176 modulation symbols obtained through the mapping of the 176 columns are used as 176 consecutive modulation symbols in the first modulation symbol stream, and are used as 176 consecutive DP-16QAM symbols in the first modulation symbol stream.

Every eight codewords in the 32 codewords undergo the bit interleaving, and then are mapped to 176 DP-16QAM symbols. The 32 codewords undergo the bit interleaving, and then are mapped to a total of 704 DP-16QAM symbols, and the 704 DP-16QAM symbols are used as 704 consecutive DP-16QAM symbols in the first modulation symbol stream.

Embodiment 11: A target bit set is represented as a bit matrix, where n=32, m=16, K=160, L=8, $L_r = 4$, and $L_c = 2$.

A physical medium attachment (Physical Medium Attachment, PMA) sublayer of a transmitter processing module processes data from a plurality of synchronous client lanes (client lanes) to obtain n=32 first data streams. The 32 first data streams are separately sent to inner-code encoders for inner-code encoding to obtain 32 second data streams. BCH(176,160) is used for the inner-code encoding. That is, a codeword bit length N=176, an information bit length K=160, and a parity bit length P=16. 160 information bits in each inner-code codeword are from 16 symbols in 16 different outer-code RS codewords.

32 codewords obtained through the inner-code encoding are grouped into two codeword sets, and each codeword set includes m=16 BCH(176,160) codewords. In consideration of DP-16QAM modulation, every L=8 bits are mapped to one DP-16QAM symbol. 352 DP-16QAM symbols may be obtained through bit interleaving and mapping of the 16 BCH(176,160) codewords in each codeword set.

A total of 1408 bits in the foregoing 16 BCH(176,160) codewords are represented by using a first matrix $H_1$ with 16 rows and 176 columns, where each row in the first matrix $H_1$ includes 176 bits in one inner-code BCH(176,160) codeword. The bit interleaving is performed on the first matrix $H_1$ to obtain a third matrix $H_3$ with 16 rows and 176 columns. An interleaving correspondence between the first matrix $H_1$ and the third matrix $H_3$ is: for $0 \leq i < 16$,

$$H_3[i][j] = \begin{cases} H_1[i][(j + i \times \Delta)\%160], 0 \leq j < 160 \\ H_1[i][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $0 < \Delta < 160$, and the integer is a column offset constraint factor; and in this embodiment, typical values of the integer $\Delta$ are 10, 20, 30, 40, 50, 60, 70, 90, 100, 110, 120, 130, 140, and 150.

In the foregoing third matrix $H_3$ with the 16 rows and the 176 columns, each column includes 16 bits. In consideration of $L_r = 4$ and $L_c = 2$, a total of eight bits in two columns in every four rows are mapped to one DP-16QAM symbol. Every 2 columns in the third matrix $H_3$ are mapped to obtain 4 DP-16QAM symbols.

In terms of the first two DP-16QAM symbols in the four DP-16QAM symbols obtained through the mapping of the every two columns (namely, the 0th and the 1st DP-16QAM symbols obtained through the mapping of the every two columns) in the third matrix $H_3$, a total of 176 DP-16QAM symbols in the 176 columns are used as 176 consecutive DP-16QAM symbols in a first modulation symbol stream; in terms of the last two DP-16QAM symbol in the four DP-16QAM symbols obtained through the mapping of the every two columns (namely, the 2nd and the 3rd DP-16QAM symbols obtained through the mapping of the every two columns), a total of 176 DP-16QAM symbols in the 176 columns are used as next 176 consecutive DP-16QAM symbols in the first modulation symbol stream; and finally, 352 consecutive DP-16QAM symbols in the first modulation symbol stream are obtained.

Every 16 codewords in the 32 codewords undergo the bit interleaving, and then are mapped to 352 DP-16QAM symbols. The 32 codewords undergo the bit interleaving, and then are mapped to a total of 704 DP-16QAM symbols, and the 704 DP-16QAM symbols are used as 704 consecutive DP-16QAM symbols in the first modulation symbol stream.

Embodiment 12: A target bit set is represented as a bit matrix, where n=32, m=16, K=110, and L=8.

A physical medium attachment (Physical Medium Attachment, PMA) sublayer of a transmitter processing module processes data from a plurality of synchronous client lanes (client lanes) to obtain n=32 first data streams. The 32 first data streams are separately sent to inner-code encoders for inner-code encoding to obtain 32 second data streams. BCH(126,110) is used for the inner-code encoding. That is, a codeword bit length N=126, an information bit length K=110, and a parity bit length P=16. 110 information bits in each inner-code codeword are from 11 symbols in 11 different outer-code RS codewords.

32 codewords obtained through the inner-code encoding are grouped into h=2 codeword sets, and each codeword set includes m=16 BCH(126,110) codewords. In consideration of DP-16QAM modulation, every L=8 bits are mapped to one DP-16QAM symbol. 252 DP-16QAM symbols may be obtained through bit interleaving and mapping of the 16 BCH(126,110) codewords in each codeword set.

A total of 2016 bits in the foregoing 16 BCH(126,110) codewords are represented by using a first matrix $H_1$ with 16 rows and 126 columns, where each row in the first matrix $H_1$ includes 126 bits in one inner-code BCH(126,110) codeword. The bit interleaving is performed on the first matrix $H_1$ to obtain a third matrix $H_3$ with 16 rows and 126 columns. An interleaving correspondence between the first matrix $H_1$ and the third matrix $H_3$ is: for $0 \leq i < 16$,

$$H_3[i][j]$$

$$= \begin{cases} H_1\big[(i + \theta \times (j\%8))\%8 + \lfloor i/8 \rfloor \times 8\big]\Big[\big(j + ((i + \theta \times (j\%8))\%8 + \lfloor i/8 \rfloor \times 8) \times \Delta\big)\%110\Big], 0 \leq j < 110 \\ H_1\big[(i + \theta \times (j\%8))\%8 + \lfloor i/8 \rfloor \times 8\big][j], 110 \leq j < 126 \end{cases}$$

where $\lfloor \cdot \rfloor$ represents a rounding down operation, the non-zero integer $\Delta$ is a row offset constraint factor, $\Delta$ is a multiple of 10, - 110 < $\Delta$ < 110, the non-zero integer $\theta$ is a column offset constraint factor, and the non-zero integer $\theta$ satisfies - 8 < $\theta$ < 8; in this embodiment, typical values of the integer $\Delta$ are 10, 20, 30, 50, 60, 70, 90, and 100, and a typical value of the integer $\theta$ is $\theta$ = 7, and another typical value is $\theta$ = 1.

In the foregoing third matrix $H_3$ with the 16 rows and the 126 columns, each column includes 16 bits. Every eight bits in the 16 bits are mapped to one DP-16QAM symbol. Each column is separately mapped to two modulation symbols. In a specific implementation, in each column, the 0th row to the 7th row are mapped to one DP-16QAM symbol, and the 8th row to the 15th row are mapped to the other DP-16QAM symbol. Each third matrix $H_3$ is mapped to 252 DP-16QAM symbols. The two DP-16QAM symbols obtained through the mapping of each column are used as two consecutive DP-16QAM symbols in a first modulation symbol stream, and 252 DP-16QAM symbols obtained through the mapping of 126 columns are used as 252 consecutive DP-16QAM symbols in the first modulation symbol stream.

Every 16 codewords in the 32 codewords undergo the bit interleaving, and then are mapped to 252 DP-16QAM symbols. The 32 codewords undergo the bit interleaving, and then are mapped to a total of 504 DP-16QAM symbols, and the 504 DP-16QAM symbols are used as 504 consecutive DP-16QAM symbols in the first modulation symbol stream.

In this embodiment, when there is colored noise in actual transmission, and the colored noise has a width of four DP-16QAM symbols, 32 error bits can be scattered to a plurality of inner codes BCH(126,110), and a quantity of error bits corresponding to each inner code is not greater than 2. Because the inner code BCH(126,110) can correct two bits is considered, colored noise with a width of two or three DP-16QAM symbols can be effectively corrected by the inner code. In addition, according to the designed bit interleaving and mapping method, an overall concatenated-FEC solution can resist a burst error with a length greater than 1200 bits. That is, according to the designed bit interleaving and mapping method, the overall concatenated-FEC solution can effectively resist the colored noise with the width of up to the four DP-16QAM symbols, and can resist the burst error with the length greater than 1200 bits. According to the designed bit interleaving and mapping method, the overall concatenated-FEC solution can effectively resist the colored noise with the width of up to the four DP-16QAM symbols, and can resist the burst error with the length greater than 1200 bits.

Embodiment 13: A target bit set is represented as an array, where n=32, m=16, K=110, and L=8.

Based on the solution in Embodiment 12, a total of 2016 bits in 16 BCH(126,110) codewords are represented by using a first matrix $H_1$ with 16 rows and 126 columns, and data obtained through bit interleaving of the first matrix $H_1$ is not represented by using the third matrix $H_3$ with the 16 rows and the 126 columns shown in Embodiment 1, but is represented by using an array A with a length of 2016 bits. The bit interleaving is performed on the first matrix $H_1$ to obtain the array A with the length of 2016 bits. An interleaving correspondence between the first matrix $H_1$ and array A is: for $0 \leq i < 16$,

$$A[i + j \times 16]$$

$$= \begin{cases} H_1\big[(i + \theta \times (j\%8))\%8 + \lfloor i/8 \rfloor \times 8\big]\Big[\big(j + ((i + \theta \times (j\%8))\%8 + \lfloor i/8 \rfloor \times 8) \times \Delta\big)\%110\Big], 0 \leq j < 110 \\ H_1\big[(i + \theta \times (j\%8))\%8 + \lfloor i/8 \rfloor \times 8\big][j], 110 \leq j < 126 \end{cases}$$

where $\lfloor \cdot \rfloor$ represents a rounding down operation, the non-zero integer $\Delta$ is a row offset constraint factor, $\Delta$ is a multiple of 10, - 110 < $\Delta$ < 110, the non-zero integer $\theta$ is a column offset constraint factor, and the integer $\theta$ satisfies - 8 < $\theta$ < 8; in this embodiment, typical values of the integer $\Delta$ are 10, 20, 30, 50, 60, 70, 90, and 100; a typical value of the integer $\theta$ is $\theta$ = 7, and another typical value is $\theta$ = 1; and particularly, for $0 \leq i < 16$,

$$A[i + j \times 16]$$

$$= \begin{cases} H_1\big[(i + 7 \times (j\%8))\%8 + \lfloor i/8 \rfloor \times 8\big]\Big[\big(j + ((i + 7 \times (j\%8))\%8 + \lfloor i/8 \rfloor \times 8) \times 90\big)\%110\Big], 0 \leq j < 110 \\ H_1\big[(i + 7 \times (j\%8))\%8 + \lfloor i/8 \rfloor \times 8\big][j], 110 \leq j < 126 \end{cases}$$

Every eight consecutive bits in the first array A that includes the 2016 bits are mapped to one DP-16QAM symbol, to obtain 252 DP-16QAM symbols, and the 252 DP-16QAM symbols are used as 252 consecutive DP-16QAM symbols in a first modulation symbol stream.

Every 16 codewords in the 32 codewords undergo the bit interleaving, and then are mapped to 252 DP-16QAM symbols. The 32 codewords undergo the bit interleaving, and then are mapped to a total of 504 DP-16QAM symbols, and the 504 DP-16QAM symbols are used as 504 consecutive DP-16QAM symbols in the first modulation symbol stream.

It should be noted that, when values of the row offset constraint factor $\Delta$ and the column offset constraint factor $\theta$ in Embodiment 11 are respectively equal to values of $\Delta$ and $\theta$ in Embodiment 12, the 504 DP-16QAM symbols that are the same as those in Embodiment 12 are obtained through the bit interleaving and the mapping of the 32 codewords in Embodiment 11.

In this embodiment, according to the designed bit interleaving and mapping method, an overall concatenated-FEC solution can effectively resist colored noise with a width of up to four DP-16QAM symbols, and can resist a burst error with a length greater than 1200 bits.

Embodiment 14: A target bit set is represented as a bit matrix, where n=32, m=8, K=110, L=8, $L_r$ = 4, and $L_c$ = 2.

A physical medium attachment (Physical Medium Attachment, PMA) sublayer of a transmitter processing module processes data from a plurality of synchronous client lanes (client lanes) to obtain n=32 first data streams. The 32 first data streams are separately sent to inner-code encoders for inner-code encoding to obtain 32 second data streams. BCH(126,110) is used for the inner-code encoding. That is, a codeword bit length N=126, an information bit length K=110, and a parity bit length P=16. 110 information bits in each inner-code codeword are from 11 symbols in 11 different outer-code RS codewords.

32 codewords obtained through the inner-code encoding are grouped into four codeword sets, and each codeword set includes m=8 BCH(126,110) codewords. In consideration of DP-16QAM modulation, every L=8 bits are mapped to one DP-16QAM symbol. 126 DP-16QAM symbols may be obtained through bit interleaving and mapping of the eight BCH(126,110) codewords in each codeword set.

A total of 1008 bits in the foregoing eight BCH(126,110) codewords are represented by using a first matrix $H_1$ with eight rows and 126 columns, where each row in the first matrix $H_1$ includes 126 bits in one inner-code BCH(126,110) codeword. The bit interleaving is performed on the first matrix $H_1$ to obtain a third matrix $H_3$ with eight rows and 126 columns. An interleaving correspondence between the first matrix $H_1$ and the third matrix $H_3$ is: for $0 \leq i < 8$,

$$H_3[i][j] = \begin{cases} H_1[i][(j + i \times \Delta)\%110], 0 \leq j < 110 \\ H_1[i][j], 110 \leq j < 126 \end{cases}$$

where $\lfloor \cdot \rfloor$ represents a rounding down operation, the non-zero integer $\Delta$ is a row offset constraint factor, $\Delta$ is a multiple of 10, $-100 < \Delta < 100$, and the non-zero integer $\Delta$ is a column offset constraint factor; and in this embodiment, typical values of the integer $\Delta$ are 10, 20, 30, 40, 50, 60, 70, 90, and 100.

In the foregoing third matrix $H_3$ with the eight rows and the 126 columns, each column includes eight bits. In consideration of $L_r$ = 4 and $L_c$ = 2, a total of eight bits in two columns in every four rows are mapped to one DP-16QAM symbol. In the third matrix $H_3$, 2 modulation symbols obtained through the mapping of every 2 columns are used as 2 consecutive modulation symbols in a first modulation symbol stream, and 126 modulation symbols obtained through the mapping of the 126 columns are used as 126 consecutive modulation symbols in the first modulation symbol stream, and are used as 126 consecutive DP-16QAM symbols in the first modulation symbol stream.

Every eight codewords in the 32 codewords undergo the bit interleaving, and then are mapped to 126 DP-16QAM symbols. The 32 codewords undergo the bit interleaving, and then are mapped to a total of 504 DP-16QAM symbols, and the 504 DP-16QAM symbols are used as 504 consecutive DP-16QAM symbols in the first modulation symbol stream.

Embodiment 15: A target bit set is represented as a bit matrix, where n=16, m=16, K=120, and L=8.

A physical medium attachment (Physical Medium Attachment, PMA) sublayer of a transmitter processing module processes data from a plurality of synchronous client lanes (client lanes) to obtain n=16 first data streams. The 16 first data streams are separately sent to inner-code encoders for inner-code encoding to obtain 16 second data streams. BCH(136,120) is used for the inner-code encoding. That is, a codeword bit length N=136, an information bit length K=120, and a parity bit length P=16. 120 information bits in each inner-code codeword are from 12 symbols in 12 different outer-code RS codewords.

16 codewords obtained through the inner-code encoding are used as h=1 codeword set, and the codeword set includes m=16 BCH(136,120) codewords. In consideration of DP-16QAM modulation, every L=8 bits are mapped to one DP-16QAM symbol. 272 DP-16QAM symbols may be obtained through bit interleaving and mapping of the 16 BCH(136,120) codewords in each codeword set.

A total of 2176 bits in the foregoing 16 BCH(136,120) codewords are represented by using a first matrix $H_1$ with 16 rows and 136 columns, where each row in the first matrix $H_1$ includes 136 bits in one inner-code BCH(136,120) codeword. The bit interleaving is performed on the first matrix $H_1$ to obtain a third matrix $H_3$ with 16 rows and 136 columns. An interleaving correspondence between the first matrix $H_1$ and the third matrix $H_3$ is: for $0 \leq i < 16$,

$$H_3[i][j]$$

$$= \begin{cases} H_1\big[(i + \theta \times (j\%8))\%8 + \lfloor i/8 \rfloor \times 8\big]\Big[\big(j + \big((i + \theta \times (j\%8))\%8 + \lfloor i/8 \rfloor \times 8\big) \times \Delta\big)\%120\Big], 0 \le j < 120 \\ H_1\big[(i + \theta \times (j\%8))\%8 + \lfloor i/8 \rfloor \times 8\big][j], 120 \le j < 136 \end{cases}$$

where $\lfloor \cdot \rfloor$ represents a rounding down operation, the non-zero integer $\Delta$ is a row offset constraint factor, $\Delta$ is a multiple of 10, $-120 < \Delta < 120$, the non-zero integer $\theta$ is a column offset constraint factor, and the non-zero integer $\theta$ satisfies $-8 < \theta < 8$; in this embodiment, typical values of the integer $\Delta$ are 10, 20, 30, 50, 60, 70, 90, 100, and 110; and a typical value of the integer $\theta$ is $\theta = 7$, and another typical value is $\theta = 1$.

In the foregoing third matrix $H_3$ with the 16 rows and the 136 columns, each column includes 16 bits. Every eight bits in the 16 bits are mapped to one DP-16QAM symbol. Each column is separately mapped to two modulation symbols. In a specific implementation, in each column, the 0th row to the 7th row are mapped to one DP-16QAM symbol, and the 8th row to the 15th row are mapped to the other DP-16QAM symbol. Each third matrix $H_3$ is mapped to 272 DP-16QAM symbols. The two DP-16QAM symbols obtained through the mapping of each column are used as two consecutive DP-16QAM symbols in a first modulation symbol stream, and 272 DP-16QAM symbols obtained through the mapping of the 136 columns are used as 272 consecutive DP-16QAM symbols in the first modulation symbol stream.

In this embodiment, when there is colored noise in actual transmission, and the colored noise has a width of four DP-16QAM symbols, 32 error bits can be scattered to a plurality of inner codes BCH(136,120), and a quantity of error bits corresponding to each inner code is not greater than 2. Because the inner code BCH(136,120) can correct two bits is considered, colored noise with a width of two or three DP-16QAM symbols can be effectively corrected by the inner code. In addition, according to the designed bit interleaving and mapping method, an overall concatenated-FEC solution can resist a burst error with a length greater than 1200 bits. That is, according to the designed bit interleaving and mapping method, the overall concatenated-FEC solution can effectively resist the colored noise with the width of up to the four DP-16QAM symbols, and can resist the burst error with the length greater than 1200 bits. According to the designed bit interleaving and mapping method, the overall concatenated-FEC solution can effectively resist the colored noise with the width of up to the four DP-16QAM symbols, and can resist the burst error with the length greater than 1200 bits.

Embodiment 16: A target bit set is represented as an array, where n=16, m=16, K=120, and L=8.

Based on the solution in Embodiment 15, a total of 2176 bits in 16 BCH(136,120) codewords are represented by using a first matrix $H_1$ with 16 rows and 136 columns, and data obtained through bit interleaving of the first matrix $H_1$ is not represented by using the third matrix $H_3$ with the 16 rows and the 136 columns shown in Embodiment 1, but is represented by using an array A with a length of 2176 bits. The bit interleaving is performed on the first matrix $H_1$ to obtain the array A with the length of 2176 bits. An interleaving correspondence between the first matrix $H_1$ and array A is: for $0 \le i < 16$,

$$A[i + j \times 16]$$

$$= \begin{cases} H_1\big[(i + \theta \times (j\%8))\%8 + \lfloor i/8 \rfloor \times 8\big]\Big[\big(j + \big((i + \theta \times (j\%8))\%8 + \lfloor i/8 \rfloor \times 8\big) \times \Delta\big)\%120\Big], 0 \le j < 120 \\ H_1\big[(i + \theta \times (j\%8))\%8 + \lfloor i/8 \rfloor \times 8\big][j], 120 \le j < 136 \end{cases}$$

where $\lfloor \cdot \rfloor$ represents a rounding down operation, the non-zero integer $\Delta$ is a row offset constraint factor, $\Delta$ is a multiple of 10, $-120 < \Delta < 120$, the non-zero integer $\theta$ is a column offset constraint factor, and the integer $\theta$ satisfies $-8 < \theta < 8$; in this embodiment, typical values of the integer $\Delta$ are 10, 20, 30, 50, 60, 70, 90, 100, and 110; a typical value of the integer $\theta$ is $\theta = 7$, and another typical value is $\theta = 1$; and particularly, for $0 \le i < 16$,

$$A[i + j \times 16]$$

$$= \begin{cases} H_1\big[(i + 7 \times (j\%8))\%8 + \lfloor i/8 \rfloor \times 8\big]\Big[\big(j + \big((i + 7 \times (j\%8))\%8 + \lfloor i/8 \rfloor \times 8\big) \times 90\big)\%120\Big], 0 \le j < 120 \\ H_1\big[(i + 7 \times (j\%8))\%8 + \lfloor i/8 \rfloor \times 8\big][j], 120 \le j < 136 \end{cases}$$

Every eight consecutive bits in the first array A that includes the 2176 bits are mapped to one DP-16QAM symbol, to obtain 272 DP-16QAM symbols, and the 272 DP-16QAM symbols are used as 272 consecutive DP-16QAM symbols in a first modulation symbol stream.

In this embodiment, according to the designed bit interleaving and mapping method, an overall concatenated-FEC solution can effectively resist colored noise with a width of up to four DP-16QAM symbols, and can resist a burst error with a length greater than 1200 bits.

Embodiment 17: A target bit set is represented as a bit matrix, where n=16, m=8, K=120, L=8, $L_r$ = 4, and $L_c$ = 2.

A physical medium attachment (Physical Medium Attachment, PMA) sublayer of a transmitter processing module processes data from a plurality of synchronous client lanes (client lanes) to obtain n=16 first data streams. The 16 first data streams are separately sent to inner-code encoders for inner-code encoding to obtain 16 second data streams. BCH(136,120) is used for the inner-code encoding. That is, a codeword bit length N=136, an information bit length K=120, and a parity bit length P=16. 120 information bits in each inner-code codeword are from 12 symbols in 12 different outer-code RS codewords.

16 codewords obtained through the inner-code encoding are grouped into two codeword sets, and each codeword set includes m=8 BCH(136,110) codewords. In consideration of DP-16QAM modulation, every L=8 bits are mapped to one DP-16QAM symbol. 136 DP-16QAM symbols may be obtained through bit interleaving and mapping of the eight BCH(136,120) codewords in each codeword set.

A total of 1088 bits in the foregoing eight BCH(136,120) codewords are represented by using a first matrix $H_1$ with eight rows and 136 columns, where each row in the first matrix $H_1$ includes 136 bits in one inner-code BCH(136,120) codeword. The bit interleaving is performed on the first matrix $H_1$ to obtain a third matrix $H_3$ with eight rows and 136 columns. An interleaving correspondence between the first matrix $H_1$ and the third matrix $H_3$ is: for $0 \leq i < 8$,

$$H_3[i][j] = \begin{cases} H_1[i][(j + i \times \Delta)\%120], 0 \leq j < 120 \\ H_1[i][j], 120 \leq j < 136 \end{cases}$$

where $\lfloor \cdot \rfloor$ represents a rounding down operation, the non-zero integer $\Delta$ is a row offset constraint factor, $\Delta$ is a multiple of 10, $0 < \Delta < 120$, and the integer is a column offset constraint factor; and in this embodiment, typical values of the integer $\Delta$ are 10, 20, 30, 40, 50, 60, 70, 90, 100, and 110.

In the foregoing third matrix $H_3$ with the eight rows and the 136 columns, each column includes eight bits. In consideration of $L_r = 4$ and $L_c = 2$, a total of eight bits in two columns in every four rows are mapped to one DP-16QAM symbol. In the third matrix $H_3$, 2 modulation symbols obtained through the mapping of every 2 columns are used as 2 consecutive modulation symbols in a first modulation symbol stream, and 136 modulation symbols obtained through the mapping of the 136 columns are used as 136 consecutive modulation symbols in the first modulation symbol stream, and are used as 136 consecutive DP-16QAM symbols in the first modulation symbol stream.

Every eight codewords in the 16 codewords undergo the bit interleaving, and then are mapped to 136 DP-16QAM symbols. The 16 codewords undergo the bit interleaving, and then are mapped to a total of 272 DP-16QAM symbols, and the 272 DP-16QAM symbols are used as 272 consecutive DP-16QAM symbols in the first modulation symbol stream.

Embodiment 18: A target bit set is represented as a bit matrix, where n=12, m=12, K=160, L=8, $L_r = 4$, and $L_c = 2$.

A physical medium attachment (Physical Medium Attachment, PMA) sublayer of a transmitter processing module processes data from a plurality of synchronous client lanes (client lanes) to obtain n=12 first data streams. The 12 first data streams are separately sent to inner-code encoders for inner-code encoding to obtain 12 second data streams. BCH(176,160) is used for the inner-code encoding. That is, a codeword bit length N=176, an information bit length K=160, and a parity bit length P=16. 160 information bits in each inner-code codeword are from 16 symbols in 16 different outer-code RS codewords.

12 codewords obtained through the inner-code encoding are used as one codeword set, and the codeword set includes m=12 BCH(176,160) codewords. In consideration of DP-16QAM modulation, every L=8 bits are mapped to one DP-16QAM symbol. 264 DP-16QAM symbols may be obtained through bit interleaving and mapping of the 12 BCH(176,160) codewords in each codeword set.

A total of 2112 bits in the foregoing 12 BCH(176,160) codewords are represented by using a first matrix $H_1$ with 12 rows and 176 columns, where each row in the first matrix $H_1$ includes 176 bits in one inner-code BCH(176,160) codeword. The bit interleaving is performed on the first matrix $H_1$ to obtain a third matrix $H_3$ with 12 rows and 176 columns. An interleaving correspondence between the first matrix $H_1$ and the third matrix $H_3$ is: for $0 \leq i < 12$,

$$H_3[i][j] = \begin{cases} H_1[i][(j + i \times \Delta)\%160], 0 \leq j < 160 \\ H_1[i][j], 160 \leq j < 176 \end{cases}$$

where $\lfloor \cdot \rfloor$ represents a rounding down operation, the non-zero integer $\Delta$ is a row offset constraint factor, $\Delta$ is a multiple of 10, $0 < \Delta < 160$, and the integer is a column offset constraint factor; and in this embodiment, typical values of the integer $\Delta$ are 10, 20, 30, 40, 50, 60, 70, 90, 100, 110, 120, 130, 140, and 150.

In the foregoing third matrix $H_3$ with the 12 rows and the 176 columns, each column includes eight bits. In consideration of $L_r = 4$ and $L_c = 2$, a total of eight bits in two columns in every four rows are mapped to one DP-16QAM symbol. In the third matrix $H_3$, 3 modulation symbols obtained through the mapping of every 2 columns are used as 3 consecutive modulation symbols in a first modulation symbol stream, and 264 modulation symbols obtained through the mapping of the 176 columns are used as 264 consecutive DP-16QAM modulation symbols in the first modulation symbol stream.

It should be noted that the foregoing embodiments all describe the operation steps in the data processing method shown in FIG. 3. In actual application, operations performed by the transmitter processing module 02 shown in FIG. 2 include but are not limited to the data processing method shown in FIG. 3. The following describes, with reference to some specific implementations, other operations performed by the transmitter processing module 02.

Implementation 1: an operation procedure in which a transmitter processing module is used in a 1×800G interface scenario.

A physical medium attachment (Physical Medium Attachment, PMA) sublayer of the transmitter processing module performs first data processing on data from a plurality of synchronous client lanes (client lanes) to obtain the n first data streams, where n is an integer greater than 1. The first data processing may include alignment marker lock (alignment lock), lane de-skew (lane de-skew) processing, lane reorder (lane reorder) processing, concatenated interleaving (concatenated interleaving) processing, or the like. This embodiment provides specific details of the first data processing.

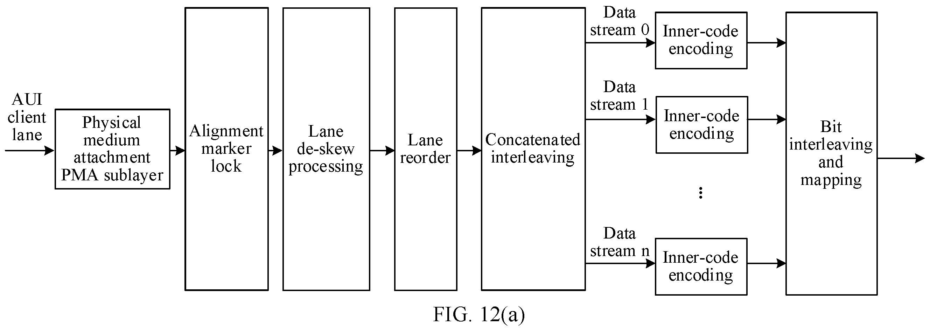

FIG. 12(a) is a diagram of a first operation procedure of a transmitter processing module according to an embodiment of this application. As shown in FIG. 12(a), the physical medium attachment (Physical Medium Attachment, PMA) sublayer of the transmitter processing module processes the data from the plurality of synchronous client lanes (client lanes) to obtain a plurality of outer-code encoded lane data streams, and use alignment markers (Alignment markers) to perform the alignment marker lock (alignment lock) and lane de-skew (lane de-skew) processing to obtain a plurality of aligned lane data streams. Then, the lane reorder (lane reorder) processing is performed on data on the plurality of lanes based on the alignment markers (Alignment markers), so that the data on the plurality of lanes can be arranged in a specified order. Lane data streams obtained through lane reorder are sent to a concatenated interleaver for data disorder processing, to obtain the n first data streams, and the n first data streams are separately sent to inner-code encoders for inner-code encoding. After designed bit interleaving and mapping are performed on data streams obtained through the inner-code encoding, to obtain modulation symbols, the modulation symbols undergo data processing, and then are sent to a channel transmission medium for transmission. The data processing may include polarization distribution (polarization distribution), DSP framing (framing) processing, or the like. Herein, n is a positive integer greater than 1.

It should be noted that, both the lane de-skew (lane de-skew) processing and the lane reorder (lane reorder) in FIG. 12(a) are optional. FIG. 12(b) is a diagram of a second operation procedure of a transmitter processing module according to an embodiment of this application. As shown in FIG. 12(b), a lane data stream obtained through alignment marker lock (alignment lock) is directly sent to lane reorder without the lane de-skew processing. FIG. 12(c) is a diagram of a third operation procedure of a transmitter processing module according to an embodiment of this application. As shown in FIG. 12(c), a lane data stream obtained through alignment marker lock is directly sent to concatenated interleaving without lane reorder after undergoing the lane de-skew processing. FIG. 12(d) is a diagram of a fourth operation procedure of a transmitter processing module according to an embodiment of this application. As shown in FIG. 12(d), a lane data stream obtained through alignment marker lock is directly sent to concatenated interleaving without the lane de-skew processing and lane reorder. It should be noted that, in the procedures of the transmitter processing module shown in FIG. 12(b) and FIG. 12(d), the lane de-skew processing is not performed on the lane data stream obtained through the alignment marker lock (alignment lock). In this case, it is required that data in each lane data stream be aligned based on an outer-code symbol. More specifically, for example, KP4 is used for the outer-code encoding. A quantity of skew bits of any two lane data streams is a multiple of 10. That is, data in the lane data streams is aligned based on a KP4 RS symbol.

FIG. 13 is a diagram of a 1×800G interface scenario according to an embodiment of this application. FIG. 13 is a diagram of 32 physical coding sublayer (Physical Coding Sublayer, PCS) lane data streams corresponding to a case in which a transmitter device uses a 1×800G interface. The transmitter device performs outer-code encoding on one lane of to-be-transmitted 800-GbE service data streams by using a KP4 RS(544,514) code, to obtain 32 PCS lane (PCS lane) data streams. 68 consecutive symbols are obtained from each of PCS lane data streams 0 to 15, and there are a total of 1088 symbols. The PCS lane data streams 0 to 15 include two RS code codewords. Two adjacent symbols in each PCS lane data stream are from different RS codewords, and two symbols at a same location in two adjacent PCS lane data streams are from different RS codewords. Similarly, each of PCS lane data streams 16 to 31 is separated by 68 symbols, and there are a total of 1088 symbols. The PCS lane data streams 16 to 31 include two RS codewords. Two adjacent symbols in each PCS lane data stream are from different RS codewords, and two symbols at a same location in two adjacent PCS lane data streams are from different RS codewords. The 32 PCS lane data streams undergo PMA processing, and then are sent to the transmitter processing module through an attachment unit interface 800G AUI-8.

Based on the foregoing diagram of data processing of the transmitter processing module shown in FIG. 12(a), the transmitter processing module performs the alignment marker lock (alignment lock) on the lane data streams by using alignment markers (Alignment markers) known to the PCS lanes. Alignment markers known to 32 channels herein are different (refer to *Ethernet Technology Consortium 800G Specification)*. The transmitter processing module then performs lane de-skew (lane de-skew) processing on the 32 lane data streams to obtain 32 aligned lane data streams. Then, the lane reorder (lane reorder) processing is performed on data on the 32 lanes based on the alignment markers, so that the data on the 32 lanes can be arranged in a specified order. One order is the same as the order in FIG. 13. That is, the lane data streams are ordered from 0 to 31 from top to bottom. 32 PCS lane data streams obtained through the lane reorder are sent to the concatenated interleaver for the data disorder processing, to obtain the n first data streams, and the n first data streams are separately sent to the inner-code encoders for the inner-code encoding. After the designed bit interleaving and mapping are performed on n second data streams obtained through the inner-code encoding, modulation symbols undergo the data processing, and then are sent to the channel transmission medium for the transmission. It should be noted that a value of n herein may be equal to 32 or 16.

It should be noted that, an operation procedure of the transmitter processing module may alternatively be as shown in FIG. 12(b). The lane data stream obtained through the alignment marker lock is directly sent to the lane reorder without the lane de-skew processing. In this case, a delay of an overall concatenated-FEC solution can be reduced, but a capability of resisting a burst error by the concatenated-FEC solution is weakened. Whether to perform the lane de-skew processing in the transmitter processing module may be determined based on an actual transmission scenario.

Implementation 2: an operation procedure in which a transmitter processing module is used in a $2\times400G$ interface scenario.

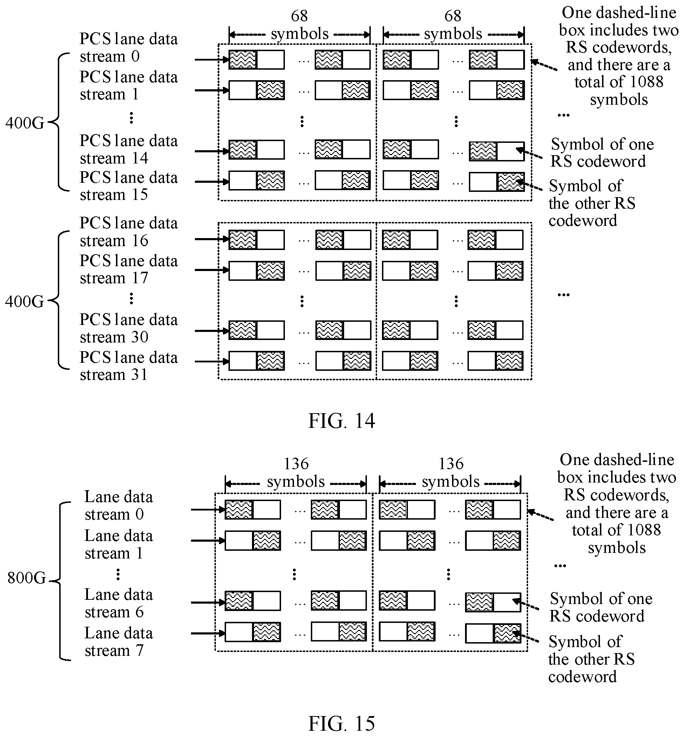

FIG. 14 is a diagram of a $2\times400G$ interface scenario according to an embodiment of this application. FIG. 14 is a diagram of 32 PCS lane data streams corresponding to a case in which a transmitter device uses a $2\times400G$ interface. The transmitter device performs outer-code encoding on two lanes of to-be-transmitted 400-GbE service data streams by using a KP4 RS(544,514) code, to obtain two lanes of 32 PCS lane data streams in total, where each lane includes 16 PCS lane data streams. Each of PCS lane data streams 0 to 15 or PCS lane data streams 16 to 31 is separated by 68 symbols, and there are a total of 1088 symbols. The PCS lane data streams 0 to 15 or the PCS lane data streams 16 to 31 include two RS code codewords. Two adjacent symbols in each PCS lane data stream are from different RS codewords, and two symbols at a same location in two adjacent PCS lane data streams are from different RS codewords. The 32 PCS lane data streams undergo PMA processing, and then are sent to the transmitter processing module through an attachment unit interface $2\times400G$ AUI-4.

Based on the foregoing diagram of data processing of the transmitter processing module shown in FIG. 12(a), the transmitter processing module performs alignment marker lock (alignment lock) on the 16 lane data streams by using alignment markers (Alignment markers) known to PCS lanes 0 to 15 or PCS lanes 16 to 31. Herein, the PCS lanes 0 to 15 may be considered as PCS lanes 0 to 15 in the $0^{th}$ 400G, and the PCS lanes 16 to 31 may be considered as PCS lanes 0 to 15 in the first 400G. Alignment markers known to the 16 lanes in the $0^{th}$ 400G are the same as known alignment markers known to the 16 lanes in the first 400G. The transmitter processing module then performs lane de-skew (lane de-skew) processing on the 32 lane data streams to obtain 32 aligned lane data streams. Then, lane reorder (lane reorder) processing is performed on data on the 16 lanes based on the alignment markers of the PCS lanes 0 to 15 or the PCS lanes 16 to 31, so that the data on the 16 lanes can be arranged in a specified order. Finally, data on the 32 lanes can be arranged in the specified order. One order is the same as the order in FIG. 14. That is, the lane data streams are ordered from 0 to 31 from top to bottom. 32 PCS lane data streams obtained through lane reorder are sent to a concatenated interleaver for data disorder processing, to obtain n first data streams, and the n first data streams are separately sent to inner-code encoders for inner-code encoding. After designed bit interleaving and mapping are performed on n second data streams obtained through the inner-code encoding, modulation symbols undergo the data processing, and then are sent to a channel transmission medium for transmission. It should be noted that a value of n herein may be equal to 32 or 16.

It should be noted that, an operation procedure of the transmitter processing module may alternatively be as shown in FIG. 12(b). The lane data stream obtained through the alignment marker lock is directly sent to the lane reorder without the lane de-skew processing. Further, considering that a host interface is $2\times400G$, an RS symbol in any one of lane data streams 0 to 15 sent to convolutional interleaving and an RS symbol in any one of lane data streams 16 to 31 sent to the convolutional interleaving are from two different RS outer-code codewords. In the $2\times400G$ interface scenario, the transmitter processing module may alternatively use an operation procedure in FIG. 12(c) or FIG. 12(d), that is, do not perform a lane reorder operation. In this case, a delay of an overall concatenated-FEC solution can be reduced, but a capability of resisting a burst error by the concatenated-FEC solution is weakened. Whether to perform the lane de-skew processing and the lane reorder in the transmitter processing module may be determined based on an actual transmission scenario.

Implementation 3: an operation procedure in which a transmitter processing module is used in another $1\times800G$ interface scenario.

FIG. 15 is another diagram of a $1\times800G$ interface scenario according to an embodiment of this application. FIG. 15 is a diagram of eight lane data streams corresponding to a case in which a transmitter device uses a $1\times800G$ interface. The transmitter device performs outer-code encoding on one lane of to-be-transmitted 800-GbE service data streams by using a KP4 RS(544,514) code, to obtain eight lane data streams. Each of lane data streams 0 to 7 is separated by 136 symbols, and there are a total of 1088 symbols. The lane data streams 0 to 7 include two RS code codewords. Two adjacent symbols in each lane data stream are from different RS codewords, and two symbols at a same location in two adjacent lane data streams are from different RS codewords. The eight lane data streams undergo PMA processing, and then are sent to the transmitter processing module through an attachment unit interface 800G AUI-8. It should be noted that, in some specific implementations, the foregoing eight lane data streams are referred to as eight PCS lane data streams. In other specific implementations, the foregoing eight lane data streams are referred to as eight FEC lane data streams. This is not specifically limited herein.

Based on the foregoing diagram of data processing of the transmitter processing module shown in FIG. 12(a), the transmitter processing module performs the alignment marker lock (alignment lock) on the lane data streams by using alignment markers (Alignment markers) known to the lanes. Alignment markers known to the eight lanes herein are different from each other. The transmitter processing module then performs lane de-skew (lane de-skew) processing on the eight lane data streams to obtain eight aligned lane data streams. Then, lane reorder (lane reorder) processing is performed on data on the eight lanes based on the alignment markers, so that the data on the eight lanes can be arranged in a specified order. One order is the same as the order in FIG. 15. That is, the lane data streams are ordered from 0 to 7 from top to bottom. Eight lane data streams obtained through lane reorder are sent to a concatenated interleaver for data disorder processing, to obtain n first data streams, and the n first data streams are separately sent to inner-code encoders for inner-code encoding. After designed bit interleaving and mapping are performed on n second data streams obtained through the inner-code encoding, modulation symbols undergo the data processing, and then are sent to a channel transmission medium for transmission. Generally, a value of n herein is 8.

It should be noted that, an operation procedure of the transmitter processing module may alternatively be as shown in FIG. 12(b). The lane data stream obtained through the alignment marker lock is directly sent to the lane reorder without the lane de-skew processing. The transmitter processing module may alternatively use an operation procedure in FIG. 12(c) or FIG. 12(d), that is, do not perform a lane reorder operation. In this case, a delay of an overall concatenated-FEC solution can be reduced, but a capability of resisting a burst error by the concatenated-FEC solution is weakened. Whether to perform the lane de-skew processing and the lane reorder in the transmitter processing module may be determined based on an actual transmission scenario.

Implementation 4: an operation procedure in which a transmitter processing module is used in concatenated interleaving in a $1 \times 800G$ or $2 \times 400G$ interface scenario.

Based on the foregoing implementation 1 or implementation 2, this embodiment provides a specific implementation of a concatenated interleaver. The concatenated interleaver performs data disorder processing on 32 PCS lane data streams that undergo lane reorder, to obtain n=32 first data streams. The following describes a specific structure of the concatenated interleaving.

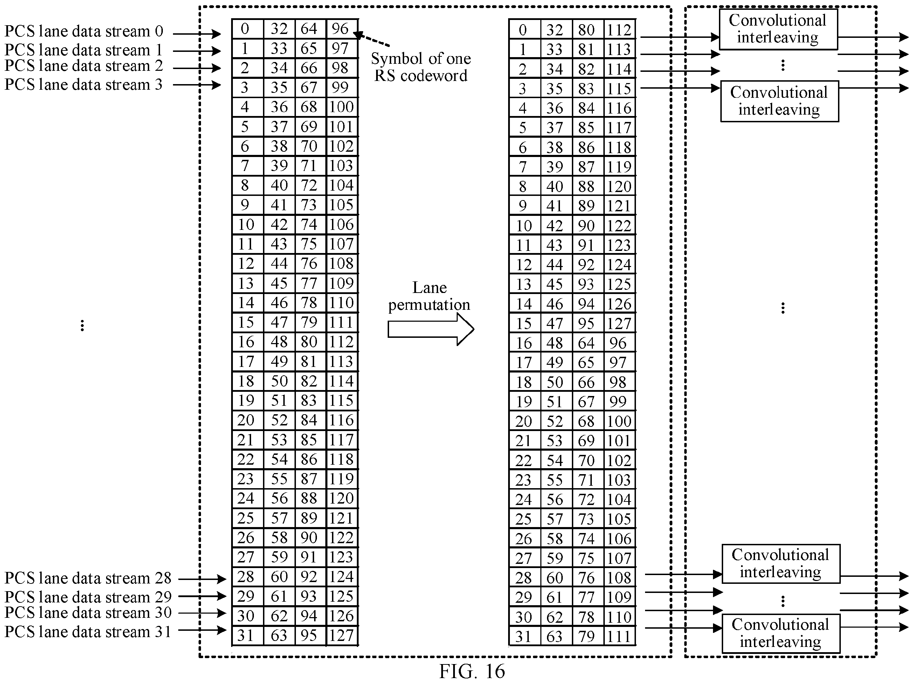

FIG. 16 is a first diagram of concatenated interleaving according to an embodiment of this application. As shown in FIG. 16, four outer-code RS symbols are obtained from each of 32 PCS lane data streams, and there are a total of 128 symbols, where each symbol includes 10 bits. 128 RS symbols on which lane permutation has not been performed may be represented by using a matrix of 32 rows and four columns, and four symbols in an $r^{th}$ row are from a PCS lane data stream r. 128 RS symbols obtained through the permutation may also be represented by using a matrix of 32 rows and four columns. In the 32 rows and the four columns of symbols obtained through the lane permutation, a symbol in the $0^{th}$ column and an r ($0 \le r < 32$) row is from a symbol in the $0^{th}$ column and an $r^{th}$ row on which the lane permutation has not been performed, a symbol in the $1^{st}$ column and the $r^{th}$ row is from a symbol in the $1^{st}$ column and the $r^{th}$ row on which the lane permutation has not been performed, a symbol in the $2^{nd}$ column and an $\tilde{r}^{th}$ ($0 \le \tilde{r} < 16$) row is from a symbol in the $2^{nd}$ column and an $(\tilde{r} + 16)^{th}$ row on which the lane permutation has not been performed, a symbol in the $2^{nd}$ column and an $(\tilde{r} + 16)^{th}$ ($0 \le \tilde{r} < 16$) row is from a symbol in the $2^{nd}$ column and an $\tilde{r}^{th}$ row on which the lane permutation has not been performed, a symbol in the $3^{rd}$ column and the $\tilde{r}^{th}$ ($0 \le \tilde{r} < 16$) row is from a symbol in the $3^{rd}$ column and the $(r + 16)^{th}$ row on which the lane permutation has not been performed, and a symbol in the $3^{rd}$ column and an $(\tilde{r} + 16)^{th}$ ($0 \le \tilde{r} < 16$) row is from a symbol in the $3^{rd}$ column and the $\tilde{r}^{th}$ row on which the lane permutation has not been performed.

As shown in FIG. 16, the lane permutation is performed on a total of 128 RS symbols in the 32 rows and the four columns, to obtain the 128 permuted RS symbols in the 32 rows and the four columns, and a lane permutation relationship may be represented by using a formula. For the 128 permuted RS symbols in the 32 rows and the four columns, a symbol in an $r_0^{th}$ row and a $c_0^{th}$ column is from a symbol in an $\left(\left(r_0 + 16 \times \left\lfloor \frac{c_0}{2} \right\rfloor\right) \% 32\right)^{th}$ row and a $c_0^{th}$ column in the 128 RS symbols that are in the 32 rows and the four columns and on which the permutation has not been performed. 32 data streams obtained through the lane permutation are sent to convolution interleavers for interleaving and data disorder.

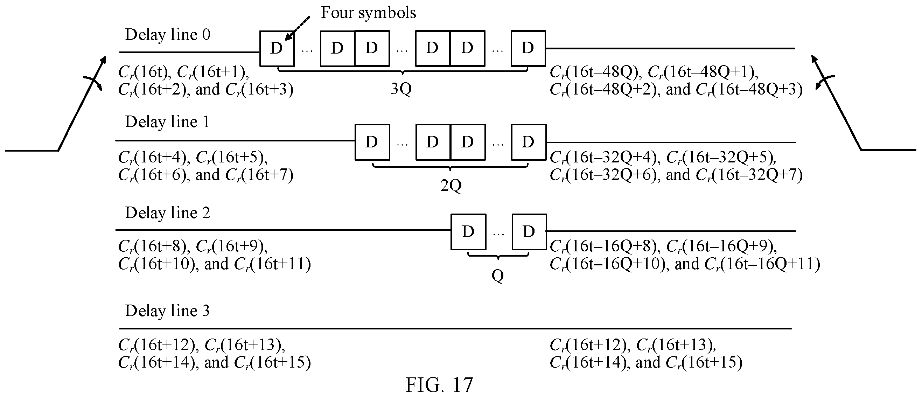

FIG. 17 is a diagram of a first structure of a convolution interleaver according to an embodiment of this application. As shown in FIG. 17, the convolution interleaver used in this embodiment includes four delay lines (delay lines). The four delay lines respectively include 3Q storage units, 2Q storage units, Q storage units, and zero storage units. Each storage unit is configured to store four RS symbols, and each symbol is 10 bits. In other words, a delay value of a delay line 0 is 12Q symbols; a delay value of a delay line 1 is 8Q symbols; a delay value of a delay line 2 is 4Q symbols; and a delay value of a delay line 3 is zero symbols, that is, there is no delay. $C_r()$ shown in FIG. 17 represents an RS symbol in a data stream r ($0 \le r < 32$) obtained through the lane permutation. For example, $C_r(16t)$, $C_r(16t+1)$, $C_r(16t+2)$, and $C_r(16t+3)$ represents four RS symbols that are in the lane data stream r and that are currently input to the delay line 0, and $C_r(16t-48Q)$, $C_r(16t-48Q+1)$, $C_r(16t-48Q+2)$, and $C_r(16t-48Q+3)$ are four RS symbols output by the delay line 0; $C_r(16t+4)$, $C_r(16t+5)$, $C_r(16t+6)$, and $C_r(16t+7)$ represents four RS symbols that are in the lane data stream and that are input to the delay line 1 next, and $C_r(16t-32Q+4)$, $C_r(16t-32Q+5)$, $C_r(16t-32Q+6)$, and $C_r(16t-32Q+7)$ are four RS symbols output by the delay line 1; $C_r(16t+8)$,

$C_r(16t+9)$, $C_r(16t+10)$, and $C_r(16t+11)$ represents four RS symbols that are in the lane data stream and that are subsequently input to the delay line 2, and $C_r(16t-16Q+8)$, $C_r(16t-16Q+9)$, $C_r(16t-16Q+10)$, and $C_r(16t-16Q+11)$ are four RS symbols output by the delay line 2; and $C_r(16t+12)$, $C_r(16t+13)$, $C_r(16t+14)$, and $C_r(16t+15)$ represents four RS symbols that are in the lane data stream and that are then input to the delay line 3, and $C_r(16t+12)$, $C_r(16t+13)$, $C_r(16t+14)$, and $C_r(16t+15)$ are four RS symbols output by the delay line 3. When $16Q+4 \geq 68$, that is, $Q \geq 4$, a total of 16 RS symbols $C_r(16t-48Q)$, $C_r(16t-48Q+1)$, $C_r(16t-48Q+2)$, $C_r(16t-48Q+3)$, $C_r(16t-32Q+4)$, $C_r(16t-32Q+5)$, $C_r(16t-32Q+6)$, $C_r(16t-32Q+7)$, $C_r(16t-16Q+8)$, $C_r(16t-16Q+9)$, $C_r(16t-16Q+10)$, $C_r(16t-16Q+11)$, $C_r(16t+12)$, $C_r(16t+13)$, $C_r(16t+14)$, and $C_r(16t+15)$ that are output after convolutional interleaving are from 16 different RS codewords. In this embodiment, Q=4 is used. The delay value of the delay line 0 is 48 RS symbols (that is, a 480-bit delay); the delay value of the delay line 1 is 32 RS symbols (that is, a 320-bit delay); the delay value of the delay line 2 is 16 RS symbols (that is, a 160-bit delay); and the delay value of the delay line 3 is 0, that is, there is no delay.

Implementation 5: another operation procedure in which a transmitter processing module is used in concatenated interleaving in a $1 \times 800G$ or $2 \times 400G$ interface scenario.

Based on the foregoing implementation 1 or implementation 2, this embodiment provides another specific implementation of a concatenated interleaver. The concatenated interleaver performs data disorder processing on 32 PCS lane data streams that undergo lane reorder, to obtain n=16 first data streams. The following describes a specific structure of the concatenated interleaving.

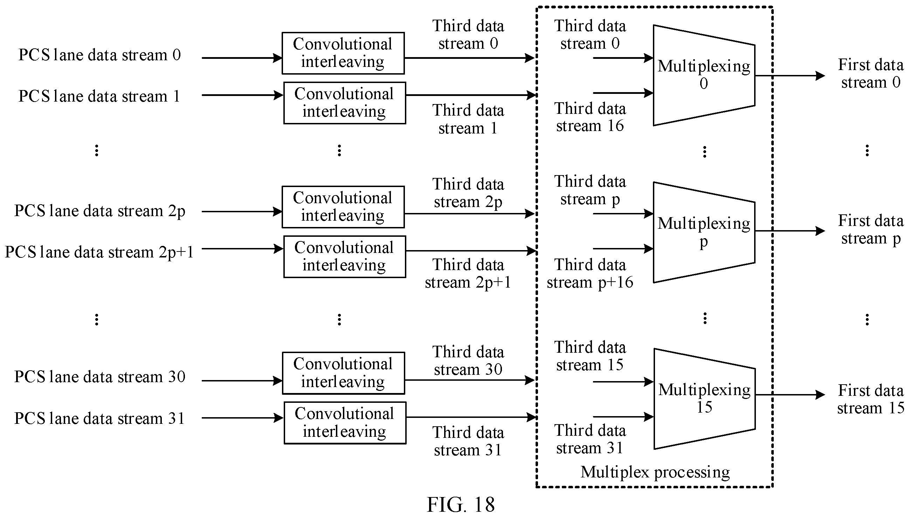

FIG. 18 is a second diagram of concatenated interleaving according to an embodiment of this application. As shown in FIG. 18, convolutional interleaving processing is separately performed on the 32 PCS lane data streams to obtain 32 third data streams, and then multiplexing processing is performed on every two of the 32 third data streams to obtain one first data stream, so that the 16 first data streams are obtained in total.

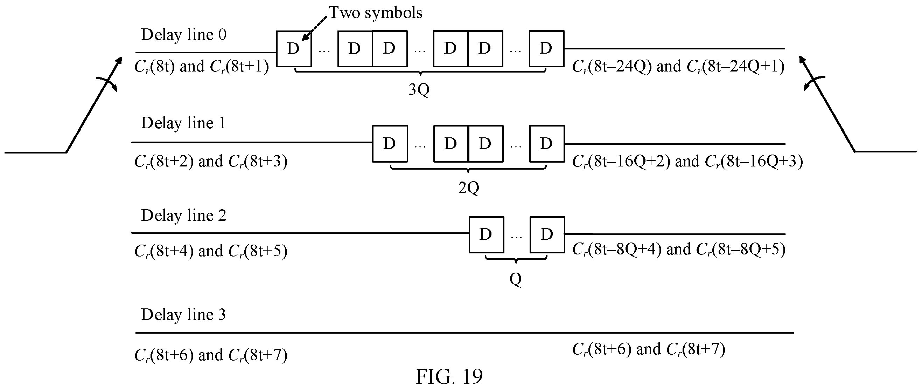

FIG. 19 is a diagram of a second structure of a convolution interleaver according to an embodiment of this application. As shown in FIG. 19, the convolution interleaver used in this embodiment includes four delay lines (delay lines). The four delay lines respectively include 3Q storage units, 2Q storage units, Q storage units, and zero storage units. Each storage unit is configured to store two RS symbols, and each symbol is 10 bits. In other words, a delay value of a delay line 0 is 6Q symbols; a delay value of a delay line 1 is 4Q symbols; a delay value of a delay line 2 is 2Q symbols; and a delay value of a delay line 3 is zero symbols, that is, there is no delay. $C_r()$ shown in FIG. 19 represents an RS symbol in a lane data stream r $(0 \leq r < 32)$. For example, $C_r(8t)$ and $C_r(8t+1)$ represent two RS symbols that are in the lane data stream r and that are currently input to the delay line 0, and $C_r(8t-24Q)$ and $C_r(8t-24Q+1)$ are two RS symbols output by the delay line 0; $C_r(8t+2)$ and $C_r(8t+3)$ represent two RS symbols that are in the lane data stream and that are input to the delay line 1 next, and $C_r(8t-16Q+2)$ and $C_r(8t-16Q+3)$ are two RS symbols output by the delay line 1; $C_r(8t+4)$ and $C_r(8t+5)$ represent two RS symbols that are in the lane data stream and that are subsequently input to the delay line 2, and $C_r(8t-8Q+4)$ and $C_r(8t-8Q+5)$ are two RS symbols output by the delay line 2; and $C_r(8t+6)$ and $C_r(8t+7)$ represent two RS symbols that are in the lane data stream and that are then input to the delay line 3, and $C_r(8t+6)$ and $C_r(8t+7)$ are two RS symbols output by the delay line 3. When $8Q+2 \geq 68$, that is, $Q \geq 9$, a total of eight RS symbols $C_r(8t-24Q)$, $C_r(8t-24Q+1)$, $C_r(8t-16Q+2)$, $C_r(8t-16Q+3)$, $C_r(8t-8Q+4)$, $C_r(8t-8Q+5)$, $C_r(8t+6)$, and $C_r(8t+7)$ that are output after convolutional interleaving are from eight different RS codewords. In this embodiment, Q=9 is used. The delay value of the delay line 0 is 54 RS symbols (that is, a 540-bit delay); the delay value of the delay line 1 is 36 RS symbols (that is, a 360-bit delay); the delay value of the delay line 2 is 18 RS symbols (that is, a 180-bit delay); and the delay value of the delay line 3 is 0, that is, there is no delay.

Multiplexing processing is performed on every two of the 32 third data streams obtained through the foregoing convolutional interleaving processing, to obtain one first data stream, so that the 16 first data streams are obtained in total. As shown in FIG. 18, multiplexing p $(0 \leq p < 16)$ multiplexes eight consecutive RS symbols in a third data stream p and eight consecutive RS symbols in a third data stream p+16 into 16 consecutive symbols in a first data stream p. The foregoing 16 consecutive symbols are from 16 RS symbols in 16 different outer-code RS codewords. In a specific implementation, the eight consecutive RS symbols $C_p(0)$, $C_p(1)$, $C_p(2)$, $C_p(3)$, $C_p(4)$, $C_p(5)$, $C_p(6)$, and $C_p(7)$ in the third data stream p and eight consecutive RS symbols $C_{p+16}(0)$, $C_{p+16}(1)$, $C_{p+16}(2)$, $C_{p+16}(3)$, $C_{p+16}(4)$, $C_{p+16}(5)$, $C_{p+16}(6)$, and $C_{p+16}(7)$ in a third data stream p+16 are multiplexed into 16 consecutive symbols $C_p(0)$, $C_p(1)$, $C_p(2)$, $C_p(3)$, $C_p(4)$, $C_p(5)$, $C_p(6)$, $C_p(7)$, $C_{p+16}(0)$, $C_{p+16}(1)$, $C_{p+16}(2)$, $C_{p+16}(3)$, $C_{p+16}(4)$, $C_{p+16}(5)$, $C_{p+16}(6)$, and $C_{p+16}(7)$ in the first data stream p. In another specific implementation, eight consecutive RS symbols $C_p(0)$, $C_p(1)$, $C_p(2)$, $C_p(3)$, $C_p(4)$, $C_p(5)$, $C_p(6)$, and $C_p(7)$ in the third data stream p and eight consecutive RS symbols $C_{p+16}(0)$, $C_{p+16}(1)$, $C_{p+16}(2)$, $C_{p+16}(3)$, $C_{p+16}(4)$, $C_{p+16}(5)$, $C_{p+16}(6)$, and $C_{p+16}(7)$ in a third data stream p+16 are multiplexed into 16 consecutive symbols $C_p(0)$, $C_{p+16}(0)$, $C_p(1)$, $C_{p+16}(1)$, $C_p(2)$, $C_{p+16}(2)$, $C_p(3)$, $C_{p+16}(3)$, $C_p(4)$, $C_{p+16}(4)$, $C_p(5)$, $C_{p+16}(5)$, $C_p(6)$, $C_{p+16}(6)$, $C_p(7)$, and $C_{p+16}(7)$ in the first data stream p. Herein, a specific arrangement order of the 16 output symbols $C_p(0)$, $C_p(1)$, $C_p(2)$, $C_p(3)$, $C_p(4)$, $C_p(5)$, $C_p(6)$, $C_p(7)$, $C_{p+16}(0)$, $C_{p+16}(1)$, $C_{p+16}(2)$, $C_{p+16}(3)$, $C_{p+16}(4)$, $C_{p+16}(5)$, $C_{p+16}(6)$, and $C_{p+16}(7)$ is not limited.

Implementation 6: still another operation procedure in which a transmitter processing module is used in concatenated interleaving in a $1 \times 800G$ interface scenario.

Based on the foregoing implementation 3, this embodiment provides still another specific implementation of a concatenated interleaver. The concatenated interleaver performs data disorder processing on eight lane data streams that undergo lane reorder, to obtain n=8 first data streams. The following describes a specific structure of the concatenated interleaving.

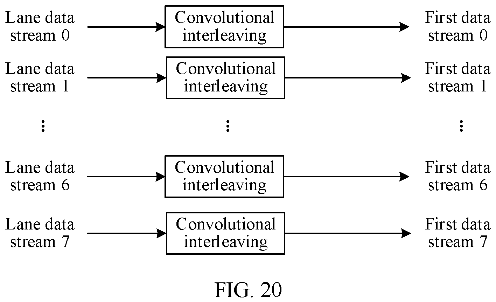

FIG. 20 is a third diagram of concatenated interleaving according to an embodiment of this application. As shown in FIG. 20, convolutional interleaving processing is separately performed on the eight lane data streams to obtain the eight first data streams.

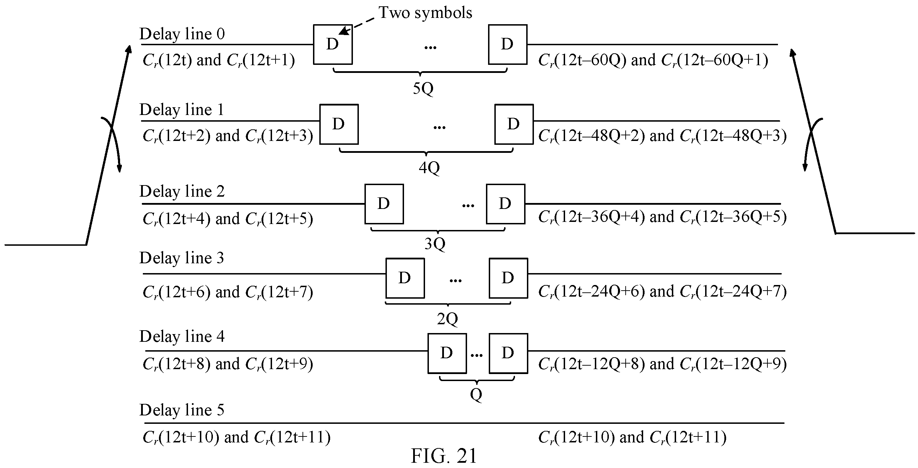

FIG. 21 is a diagram of a third structure of a convolution interleaver according to an embodiment of this application. As shown in FIG. 21, the convolution interleaver used in this embodiment includes six delay lines (delay lines). The six delay lines respectively include 5Q storage units, 4Q storage units, 3Q storage units, 2Q storage units, Q storage units, and zero storage units. Each storage unit is configured to store two RS symbols, and each symbol is 10 bits. In other words, a delay value of a delay line 0 is 10Q symbols; a delay value of a delay line 1 is 8Q symbols; a delay value of a delay line 2 is 6Q symbols; a delay value of a delay line 3 is 4Q symbols; a delay value of a delay line 4 is 2Q symbols; and a delay value of a delay line 5 is zero symbols, that is, there is no delay. $C_r()$ shown in FIG. 21 represents an RS symbol in a data stream r ($0 \leq r < 8$) obtained through lane permutation. For example, $C_r(12t)$ and $C_r(12t+1)$ represent two RS symbols that are in the lane data stream r and that are currently input to the delay line 0, and $C_r(12t-60Q)$ and $C_r(12t-60Q+1)$ are two RS symbols output by the delay line 0; $C_r(12t+2)$ and $C_r(12t+3)$ represent two RS symbols that are in the lane data stream and that are input to the delay line 1 next, and $C_r(12t-48Q+2)$ and $C_r(12t-48Q+3)$ are two RS symbols output by the delay line 1; and by analogy, $C_r(12t+10)$ and $C_r(12t+11)$ represent two RS symbols that are in the lane data stream and that are subsequently input to the delay line 2, and $C_r(12t+10)$ and $C_r(12t+11)$ are two RS symbols output by the delay line 2. When $12Q+2 \geq 68$, that is, $Q \geq 6$, a total of 12 RS symbols $C_r(12t-60Q)$, $C_r(12t-60Q+1)$, $C_r(12t-48Q+2)$, $C_r(12t-48Q+3)$, $C_r(12t-36Q+4)$, $C_r(12t-36Q+5)$, $C_r(12t-24Q+6)$, $C_r(12t-24Q+7)$, $C_r(12t-12Q+8)$, $C_r(12t-12Q+9)$, $C_r(12t+10)$, and $C_r(12t+11)$ that are output are from 12 different RS codewords. In this embodiment, Q=6 is used. The delay value of the delay line 0 is 60 RS symbols (that is, a 600-bit delay); the delay value of the delay line 1 is 48 RS symbols (that is, a 480-bit delay); the delay value of the delay line 2 is 36 RS symbols (that is, a 360-bit delay); the delay value of the delay line 3 is 24 RS symbols (that is, a 240-bit delay); the delay value of the delay line 4 is 12 RS symbols (that is, a 120-bit delay); and the delay value of delay line 5 is 0, that is, there is no delay.

Implementation 7: still another operation procedure in which a transmitter processing module is used in concatenated interleaving in a 1×800G or 2×400G interface scenario.

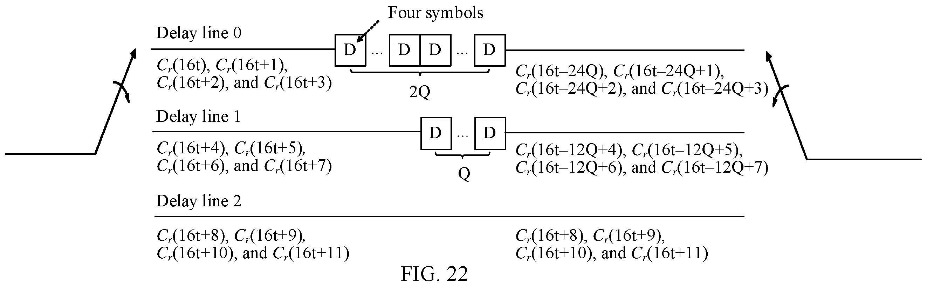

Based on the foregoing implementation 4, this embodiment provides a diagram of another structure of a convolution interleaver. FIG. 22 is a diagram of a fourth structure of a convolution interleaver according to an embodiment of this application. As shown in FIG. 22, the convolution interleaver used in this embodiment includes three delay lines (delay lines). The three delay lines respectively include 2Q storage units, Q storage units, and zero storage units. Each storage unit is configured to store four RS symbols, and each symbol is 10 bits. In other words, a delay value of a delay line 0 is 8Q symbols; a delay value of a delay line 1 is 4Q symbols; and a delay value of a delay line 2 is zero symbols, that is, there is no delay. $C_r()$ shown in FIG. 22 represents an RS symbol in a data stream r ($0 \leq r < 32$) obtained through lane permutation. For example, $C_r(16t)$, $C_r(16t+1)$, $C_r(16t+2)$, and $C_r(16t+3)$ represent four RS symbols that are in the lane data stream r and that are currently input to the delay line 0, and $C_r(16t-24Q)$, $C_r(16t-24Q+1)$, $C_r(16t-24Q+2)$, and $C_r(16t-24Q+3)$ are four RS symbols output by the delay line 0; $C_r(16t+4)$, $C_r(16t+5)$, $C_r(16t+6)$, and $C_r(16t+7)$ represent four RS symbols that are in the lane data stream and that are input to the delay line 1 next, and $C_r(16t-12Q+4)$, $C_r(16t-12Q+5)$, $C_r(16t-12Q+6)$, and $C_r(16t-12Q+7)$ are four RS symbols output by the delay line 1; and $C_r(16t+8)$, $C_r(16t+9)$, $C_r(16t+10)$, and $C_r(16t+11)$ represent four RS symbols that are in the lane data stream and that are subsequently input to the delay line 2, and $C_r(16t+8)$, $C_r(16t+9)$, $C_r(16t+10)$, and $C_r(16t+11)$ are four RS symbols output by the delay line 2. When $12Q+4 \geq 68$, that is, $Q \geq 6$, a total of 12 RS symbols $C_r(16t-24Q)$, $C_r(16t-24Q+1)$, $C_r(16t-24Q+2)$, $C_r(16t-24Q+3)$, $C_r(16t-12Q+4)$, $C_r(16t-12Q+5)$, $C_r(16t-12Q+6)$, $C_r(16t-12Q+7)$, $C_r(16t+8)$, $C_r(16t+9)$, $C_r(16t+10)$, and $C_r(16t+11)$ that are output after convolutional interleaving are from 12 different RS codewords. In this embodiment, Q=6 is used. The delay value of the delay line 0 is 48 RS symbols (that is, a 480-bit delay); the delay value of the delay line 1 is 24 RS symbols (that is, a 240-bit delay); and the delay value of the delay line 2 is 0, that is, there is no delay.

Implementation 8: yet another operation procedure in which a transmitter processing module is used in concatenated interleaving in a 1 ×800G or 2×400G interface scenario.

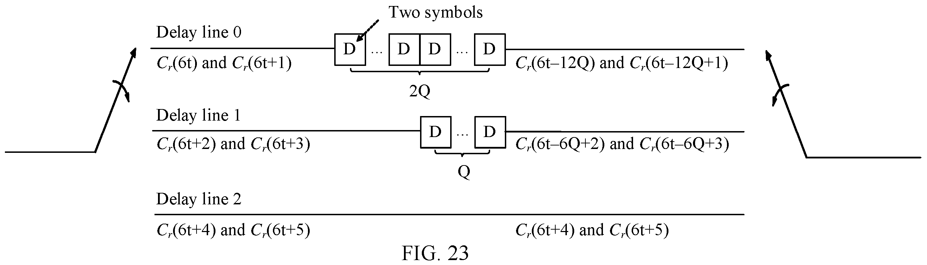

Based on the foregoing implementation 5, this embodiment provides a diagram of another structure of a convolution interleaver. FIG. 23 is a diagram of a fifth structure of a convolution interleaver according to an embodiment of this application. As shown in FIG. 23, the convolution interleaver used in this embodiment includes three delay lines (delay lines). The three delay lines respectively include 2Q storage units, Q storage units, and zero storage units. Each storage unit is configured to store two RS symbols, and each symbol is 10 bits. In other words, a delay value of a delay line 0 is 4Q symbols; a delay value of a delay line 1 is 2Q symbols; and a delay value of a delay line 2 is zero symbols, that is, there is no delay. $C_r()$ shown in FIG. 23 represents an RS symbol in a lane data stream r ($0 \leq r < 32$). For example, $C_r(6t)$ and $C_r(6t+1)$ represent two RS symbols that are in the lane data stream r and that are currently input to the delay line 0, and $C_r$

(6t-12Q) and $C_r$(6t-12Q+1) are two RS symbols output by the delay line 0; $C_r$(6t+2) and $C_r$(6t+3) represent two RS symbols that are in the lane data stream and that are input to the delay line 1 next, and $C_r$(6t-6Q+2) and $C_r$(6t-6Q+3) are two RS symbols output by the delay line 1; and $C_r$(6t+4) and $C_r$(6t+5) represent two RS symbols that are in the lane data stream and that are subsequently input to the delay line 2, and $C_r$(6t+4) and $C_r$(6t+5) are two RS symbols output by the delay line 2. When $6Q+2 \geq 68$, that is, $Q \geq 11$, a total of six RS symbols $C_r$(6t-12Q), $C_r$(6t-12Q+1), $C_r$(6t-6Q+2), $C_r$(6t-6Q+3), $C_r$(6t+4), and $C_r$(6t+5) that are output after convolutional interleaving are from six different RS codewords. In this embodiment, Q=11 is used. The delay value of the delay line 0 is 44 RS symbols (that is, a 440-bit delay); the delay value of the delay line 1 is 22 RS symbols (that is, a 220-bit delay); and the delay value of the delay line 2 is 0, that is, there is no delay.

Multiplexing processing is performed on every two of 32 third data streams obtained through the foregoing convolutional interleaving processing, to obtain one first data stream, so that 16 first data streams are obtained in total. As shown in FIG. 18, multiplexing p ($0 \leq p < 16$) multiplexes six consecutive RS symbols in a third data stream p and six consecutive RS symbols in a third data stream p+15 into 12 consecutive symbols in a first data stream p. The foregoing 12 consecutive symbols are from 12 RS symbols in 12 different outer-code RS codewords.

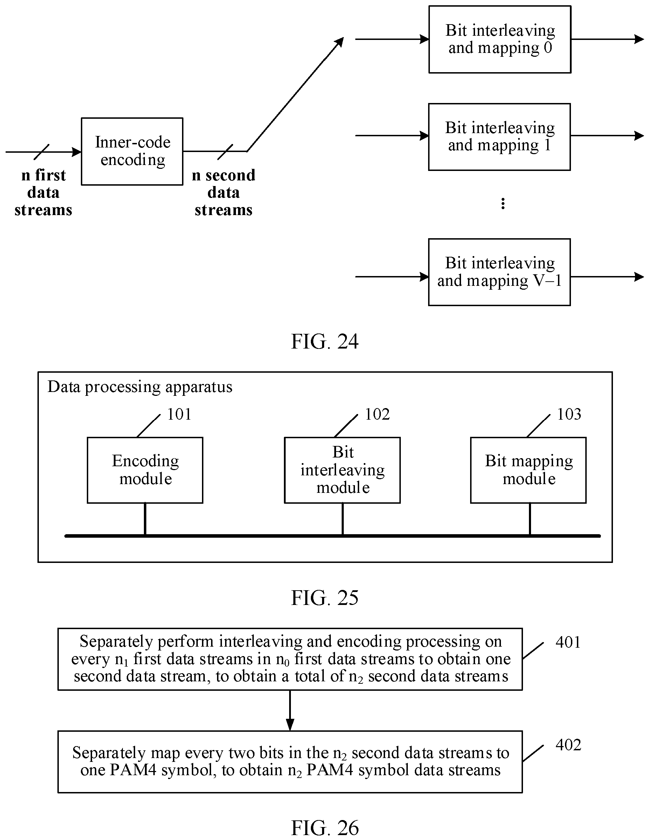

It should be noted that, in some actual application, different bit interleaving and mapping methods may be selected based on different transmission scenarios. FIG. 24 is a schematic flowchart of data processing according to an embodiment of this application. As shown in FIG. 24, V bit interleaving and mapping processing modules are provided, where V is an integer greater than 1. The V bit interleaving and mapping processing modules have different burst resistance capabilities. In specific application, inner-code encoding is performed on n first data streams to obtain n second data streams, and one of the bit interleaving and mapping processing modules is selected based on an actual transmission scenario to perform bit interleaving and mapping on data in the second data streams, to obtain a plurality of modulation symbols. It should be understood that an inner-code encoding module in FIG. 24 is configured to perform step 301 in the embodiment shown in FIG. 3, and each bit interleaving and mapping processing module in FIG. 24 is configured to perform steps 302 and 303 in the embodiment shown in FIG. 3. A specific implementation is not described herein again. In an example, the foregoing Embodiments 1 to 11 provide 11 different bit interleaving and mapping methods in total. In this case, 11 bit interleaving and mapping processing modules may be correspondingly provided in FIG. 24, to select a needed bit interleaving and mapping processing module based on the actual transmission scenario to implement a bit interleaving and mapping method in a corresponding embodiment.

The foregoing describes the data processing method provided in embodiments of this application. The following describes the data processing apparatus provided in embodiments of this application.

FIG. 25 is a diagram of a structure of a data processing apparatus according to an embodiment of this application. As shown in FIG. 25, the data processing apparatus includes an encoding module 101, a bit interleaving module 102, and a bit mapping module 103. The encoding module 101 is configured to perform an operation of step 301 in the data processing method shown in FIG. 3. The bit interleaving module 102 is configured to perform an operation of step 302 in the data processing method shown in FIG. 3. The bit mapping module 103 is configured to perform an operation of step 303 in the data processing method shown in FIG. 3. For details, refer to related descriptions in the foregoing data processing method. Details are not described herein again.

It should be understood that the apparatus provided in this application may alternatively be implemented in another manner. For example, division into the units in the foregoing apparatus is merely logical function division and may be other division during actual implementation. For example, a plurality of units or components may be combined or integrated into another system. In addition, functional units in embodiments of this application may be integrated into one processing unit, each may be an independent physical unit, or two or more functional units may be integrated into one processing unit. The integrated unit may be implemented in a form of hardware, or may be implemented in a form of a software functional unit.

It should be noted that, in the data processing method in FIG. 3, the n inner-code codewords are from the n second data streams, where one inner-code codeword is obtained from each second data stream, and then the bit interleaving is performed on the n inner-code codewords. In some specific application, a plurality of inner-code codewords may alternatively be obtained from each data stream, and the bit interleaving is performed on the plurality of inner-code codewords. FIG. 26 is another schematic flowchart of a data processing method according to an embodiment of this application. It should be understood that the method is for data processing performed on outer-code encoded data streams, and may be specifically implemented by the foregoing transmitter processing module 02.

401: Separately perform interleaving and encoding processing on every $n_1$ first data streams in $n_0$ first data streams to obtain one second data stream, to obtain a total of $n_2$ second data streams, where $n_2 = n_0/n_1$, and $n_1$ is an integer greater than 0.

In this embodiment, a physical medium attachment (Physical Medium Attachment, PMA) sublayer of the transmitter processing module performs first data processing on data from a plurality of synchronous client lanes (client lanes) to obtain the $n_0$ first data streams, where $n_0$ is an integer greater than 1. The first data processing may include alignment marker lock (alignment lock), lane de-skew (lane de-skew) processing or lane alignment processing, lane reorder (lane reorder) processing, symbol multiplexing (symbol mux) processing, or the like. The foregoing $n_0$ first data

streams are all outer-code encoded data streams. For example, an RS code may be used for the outer-code encoding, and n outer-code encoded data streams may include a plurality of RS codewords. For example, the outer code is a used KP4 RS(544,514) code, a code length is 544 symbols, and one outer-code symbol includes 10 bits.

The following describes a specific operation of performing the interleaving and encoding processing on the $n_1$ first data streams to obtain one second data stream. The interleaving and encoding processing includes inner-code encoding, circular shift, round-robin reading, and the like.

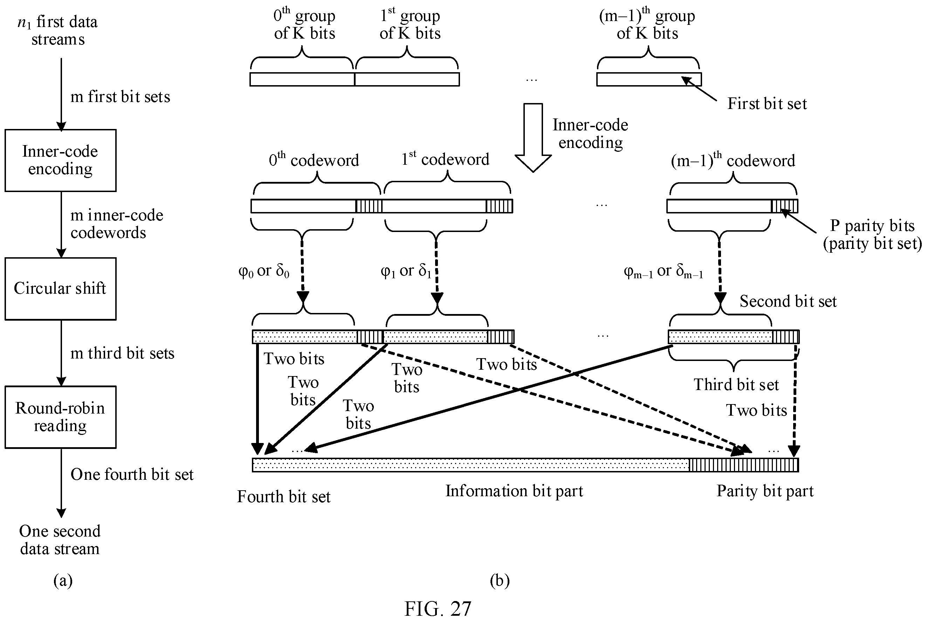

FIG. 27 is a diagram of a first implementation of interleaving and encoding processing. As shown in (a) in FIG. 27, in the interleaving and encoding processing, the inner-code encoding is first performed, then the circular shift is performed, and then the round-robin reading is performed. It should be understood that each first data stream includes at least $a_0$ first bit set, and each of the first bit sets includes K bits, where the integer $a_0 > 1$. For the $n_1$ first data streams, $a_0$ first bit sets are obtained from each first data stream, to obtain a total of $m = n_1 \times a_0$ first bit sets, where a total of $n_1 \times a_0 \times K$ bits are included.

As shown in (b) in FIG. 27, the inner-code encoding is performed on each first bit set that includes the K bits and that is in the m first bit sets, and P parity bits are added to obtain an inner-code codeword including N bits, so that m inner-code codewords are obtained in total. Herein, the first bit set including the K bits may be referred to as an inner-code information sequence, and K+P=N. The P parity bits are also referred to as a parity bit set. One inner-code codeword includes one first bit set and one parity bit set. In other words, the m inner-code codewords include m first bit sets and m parity bit sets. Generally, K is an integer multiple of 10. It should be noted that, in materials of this application, the inner-code codeword is also referred to as a codeword for short.

It should be noted that convolutional interleaving processing is usually further performed before the inner-code encoding, to enable the K information bits to correspond to a large quantity of KP4 outer-code symbols, for example, correspond to K/10 outer-code symbols, and enable the corresponding outer-code symbols to be from a large quantity of outer-code codewords, to implement good overall concatenated-FEC performance. For example, K=120, and the 120 information bits correspond to the 12 KP4 outer-code symbols, and the 12 KP4 outer-code symbols are from 12 outer-code codewords.

It should be noted that, in some scenarios in which a low delay is required, the convolutional interleaving processing is usually not performed before inner-code encoding. The K information bits correspond to the K/10 outer-code symbols, and the corresponding outer-code symbols are from less than K/10 outer-code codewords. For example, K=120, the 120 information bits correspond to the 12 KP4 outer-code symbols, and the 12 KP4 symbols are from four outer-code codewords.

As shown in (b) in FIG. 27, for an information bit sequence of the m inner-code codewords, namely, m first bit sets, in the circular shift, left circular shift is performed on each first bit set by $\varphi$ bits or right circular shift is performed on each first bit set by $\delta$ bits, to obtain one second bit set including K bits. Each second bit set is combined with a parity bit whose length is P in an inner-code codeword corresponding to the second bit set, to obtain one third bit set including N bits. It should be noted that, the third bit set including the N bits is obtained by performing the circular shift on an information bit sequence (the first bit set) that includes K bits and that is in the inner-code codeword and combining an information bit sequence obtained through the circular shift with the parity bits that include the P bits and that are in the inner-code codeword. For ease of description, in the materials of this application, the third bit set including the N bits is simply described as being obtained by performing circular shift processing on the inner-code codeword including the N bits.

The left circular shift is used as an example. For a first bit set $(u_0, u_1, u_2, u_3, \cdots, u_{K-2}, u_{K-1})$ including K bits, the left circular shift is performed by $\varphi$ bits, to obtain a second bit set $(u_{(\varphi)\%K}, u_{(1+\varphi)\%K}, u_{(2+\varphi)\%K}, \cdots, u_{(K-2+\varphi)\%K}, u_{(K-1+\varphi)\%K})$ that includes the K bits and that is obtained through the shift, where Y%Z represents a remainder obtained by dividing the integer Y by the integer Z. Generally, an offset constraint factor $\varphi$ of the left circular shift is an integer multiple of 10, and $0 \le \varphi < K$.

The right circular shift is used as an example. For a first bit set $(u_0, u_1, u_2, u_3, \cdots, u_{K-2}, u_{K-1})$ including K bits, the right circular shift is performed by $\delta$ bits, to obtain a second bit set $(u_{(-\delta)\%K}, u_{(1-\delta)\%K}, u_{(2-\delta)\%K}, \cdots, u_{(K-2-\delta)\%K}, u_{(K-1-\delta)\%K})$ that includes the K bits and that is obtained through the shift, where Y%Z represents a remainder obtained by dividing the integer Y by the integer Z. Generally, an offset constraint factor $\delta$ of the right circular shift is an integer multiple of 10, and $0 \le \delta < K$.

It should be noted that, that the second bit set is obtained by performing the left circular shift on the first bit set by the $\varphi$ bits is equivalent to that the second bit set is obtained by performing the right circular shift on the first bit set by the $\delta = K - \varphi$ bits.

It should be noted that, the offset constraint factor $\varphi$ of the left circular shift and the offset constraint factor $\delta$ of the right circular shift are not fixed, and may be time-varying. Generally, a periodicity of the circular shift is $p_c$. In the circular shift, the left circular shift is performed by $\varphi_i$ bits on an $i^{th}$ group of first bit set that includes K bits, or the right circular shift is performed by $\delta_i$ bits on an $i^{th}$ group of first bit set that includes K bits, where m is an integer multiple of the integer $p_c$, and $0 \le i < p_c$. Usually, $m = p_c$. Typically, values of any two $\varphi$ in m offset constraint factors $\varphi_i$ (namely, $\varphi_0, \varphi_1, ..., \varphi_{m-1}$) are not equal to each other, and values of any two $\delta$ in m offset constraint factors $\delta_i$ (namely, $\delta_0, \delta_1, ..., \delta_{m-1}$) are not equal to each other.

As shown in (b) in FIG. 27, for m third bit sets output through the circular shift, in the round-robin reading, two bits are obtained from each third bit set through round robin, and consecutive m × N/2 operations are performed to obtain all of the m third bit sets, to obtain a fourth bit set including m × N bits.

The second data stream includes a plurality of fourth bit sets, where the fourth bit set that includes the m × N bits is obtained by performing 2-bit round-robin reading on the m third bit sets, the m third bit sets that each include the N bits is obtained by performing the information bit circular shift on the m inner-code codewords, and the m inner-code codewords are obtained by performing the inner-code encoding on the m first bit sets, and the m first bit sets are obtained by obtaining $a_0$ first bit sets from each of the $n_1$ first data streams, where m = $n_1$ × $a_0$.

It should be noted that the "round-robin reading", to be specific, obtaining two bits from each third bit set through round robin to obtain the fourth bit set including the m × N bits is equivalent to the following operation: First, for m second bit sets, two bits are obtained from each second bit set through round robin to obtain m × K bits in total; then, for the parity bit sets in the m inner-code codewords, two bits are obtained from each parity bit set through round robin to obtain m × P bits in total; and the m × K bits obtained from the m second bit sets and the m × P bits obtained from the m parity bit sets are combined to obtain the fourth bit set including the m × N bits.

It should be noted that, in some specific application, the circular shift and the round-robin reading operation may be combined, and bit interleaving is performed, through one step of operation, on the m inner-code codewords including the m × N bits, to obtain the fourth bit set.

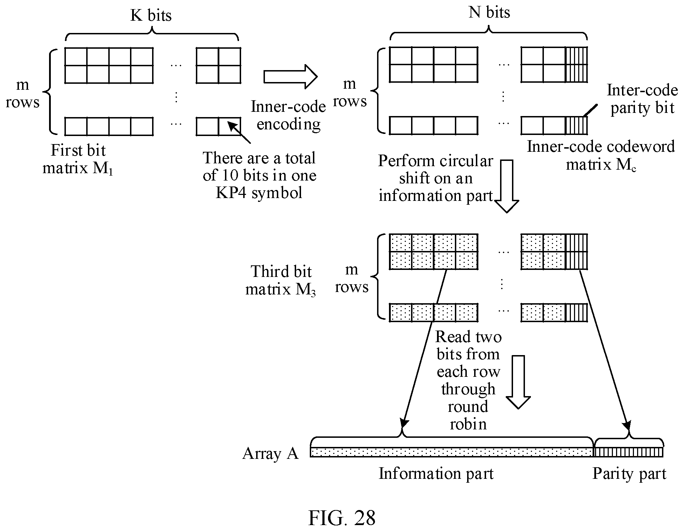

FIG. 28 is a diagram of a second implementation of interleaving and encoding processing. As shown in FIG. 28, the m first bit sets may be represented by using a first bit matrix $M_1$ with m rows and K columns, where each row in the first bit matrix $M_1$ includes K bits in one first bit set. A bit in an $i^{th}$ ($0 \leq i < m$) row and an $e^{th}$ ($0 \leq e < K$) column in the first bit matrix $M_1$ is denoted as $M_1[i][e]$. m inner-code codewords may be represented by using an inner-code codeword matrix $M_c$ with m rows and N columns, where each row in the inner-code codeword matrix $M_c$ includes N bits in one inner-code codeword. A bit in an $i^{th}$ ($0 \leq i < m$) row and a $j^{th}$ ($0 \leq j < N$) column in the inner-code codeword matrix $M_c$ is denoted as $M_c[i][j]$. m second bit sets may be represented by using a second bit matrix $M_2$ with m rows and K columns, where each row in the second bit matrix $M_2$ includes K bits in one second bit set. A bit in an $i^{th}$ ($0 \leq i < m$) row and an $e^{th}$ ($0 \leq e < K$) column in the second bit matrix $M_2$ is denoted as $M_2[i][e]$. m parity bit sets may be represented by using a parity bit matrix $M_p$ with m rows and P columns, and each row in the parity bit matrix $M_p$ includes P parity bits in one inner-code codeword. A bit in an $i^{th}$ ($0 \leq i < m$) row and an $f^{th}$ ($0 \leq f < P$) column in the parity bit matrix $M_p$ is denoted as $M_p[i][f]$. m third bit sets may be represented by using a third bit matrix $M_3$ with m rows and N columns, where each row in the third bit matrix $M_3$ includes N bits in one third bit set. A bit in an $i^{th}$ ($0 \leq i < m$) row and a $j^{th}$ ($0 \leq j < N$) column in the third bit matrix $M_3$ is denoted as $M_3[i][j]$. A fourth bit set that includes m × N bits is represented by using an array (Array) A. A $k^{th}$ ($0 \leq k < m × N$) bit in the array A is denoted as A[k].

As shown in FIG. 28, the inner-code encoding is performed on the first bit matrix $M_1$ to obtain the inner-code codeword matrix $M_c$.

For the circular shift operation, left circular shift is used as an example. The left circular shift is performed on K information bits (namely, K bits in the $i^{th}$ row in the first bit matrix $M_1$) in the $i^{th}$ ($0 \leq i < m$) row in the inner-code codeword matrix $M_c$ by $\varphi_i$ bits, to obtain K bits in the $i^{th}$ ($0 \leq i < m$) row in the third bit matrix $M_3$, where the non-zero integer $\varphi_i$ is an offset constraint factor of circular shift in the $i^{th}$ row. In this case, the third bit matrix $M_3$ and the inner-code codeword matrix $M_c$ satisfy a formula (X-1):

$$M_3[i][j] = \begin{cases} M_c[i][(j + \varphi_i)\%K], 0 \leq j < K \\ M_c[i][j], K \leq j < N \end{cases}$$

Y%Z represents a remainder obtained by dividing the integer Y by the integer Z, and $0 \leq i < m$. Generally, an offset constraint factor $\varphi_i$ of the left circular shift is an integer multiple of 10, and $0 \leq \varphi_i < K$.

It should be noted that the left circular shift is performed on K information bits in an $i^{th}$ row in a first matrix $H_1$ by $\varphi_i$ bits to obtain K bits in the $0^{th}$ column to a $(K-1)^{th}$ column in an $i^{th}$ row in a second matrix $H_2$. Equivalently, right circular shift is performed on K information bits in the $0^{th}$ column to a $(K-1)^{th}$ column in the $i^{th}$ row in the first matrix $H_1$ by K- $\varphi_i$ bits to obtain the K bits in the $0^{th}$ column to the $(K-1)^{th}$ column in the $i^{th}$ row in the second matrix $H_2$.

In another example, right circular shift is used. The third bit matrix $M_3$ and the inner-code codeword matrix $M_c$ satisfy a formula (X-2):

$$M_3[i][j] = \begin{cases} M_c[i][(j - \delta_i)\%K], 0 \leq j < K \\ M_c[i][j], K \leq j < N \end{cases}$$

Y%Z represents a remainder obtained by dividing the integer Y by the integer Z, and $0 \leq i < m$. Generally, an offset constraint factor $\delta_i$ of the right circular shift is an integer multiple of 10, and $0 \leq \delta_i < K$.

It should be noted that, the right circular shift is performed on K information bits in the $i^{th}$ row in the inner-code codeword matrix $M_c$ by $\delta_i$ bits to obtain K bits in the $0^{th}$ column to a $(K-1)^{th}$ column in the $i^{th}$ row in the third bit matrix $M_3$.

Equivalently, left circular shift is performed on the K information bits in the $0^{th}$ column to the $(K-1)^{th}$ column in the $i^{th}$ row in the third bit matrix $M_3$ by $\delta_i$ bits to obtain K bits in the $0^{th}$ column to a $(K-1)^{th}$ column in the $i^{th}$ row in the inner-code codeword matrix $M_c$. In other words, the formula (X-2) may alternatively be written as a formula (X-3):

$$M_c[i][j] = \begin{cases} M_3[i][(j + \delta_i)\%K], 0 \leq j < K \\ M_3[i][j], K \leq j < N \end{cases}$$

Circular shift of each row of information bits is performed on the inner-code codeword matrix $M_c$ to obtain the third bit matrix $M_3$.

As shown in FIG. 28, the "round-robin reading" means reading 2 bits from each row in the third bit matrix $M_3$ through round robin, 2 columns in the third bit matrix $M_3$ are obtained for m consecutive times, and all $m \times N$ bits are read by using $m \times N/2$ times of operations in total, to obtain the array A that includes $m \times N$ interleaved bits. The bit in the $i^{th}$ row and the $j^{th}$ column in the third bit matrix $M_3$ is output to a $(\lfloor j/2 \rfloor \times (m \times 2) + (i \times 2) + (j\%2))^{th}$ bit in the array A. This satisfies a formula (X-4):

$$A[\lfloor j/2 \rfloor \times (m \times 2) + (i \times 2) + (j\%2)] = M_3[i][j]$$

where $0 \leq i < m$, $0 \leq j < N$, and $\lfloor \cdot \rfloor$ represents a rounding down operation.

It should be noted that the operation of the reading 2 bits from each row in the third bit matrix $M_3$ through round robin is referred to as m-way (m-way) codeword interleaving.

The circular shift of each row of information bits is performed on the inner-code codeword matrix $M_c$ to obtain the third bit matrix $M_3$, and then two bits are read from each row through round robin. This is implemented through two steps of operations, or may be performed through one step of operation. The following directly provides a direct mapping relationship between $M_c$ and A.

If the left circular shift is used, with reference to the formula (X-1) and the formula (X-4), there is the following formula (X-5):

$$A[\lfloor j/2 \rfloor \times (m \times 2) + (i \times 2) + (j\%2)] = \begin{cases} M_c[i][(j + \varphi_i)\%K], 0 \leq j < K \\ M_c[i][j], K \leq j < N \end{cases}$$

$0 \leq i < m$. Generally, the offset constraint factor $\varphi_i$ of the circular shift is an integer multiple of 10, and $0 \leq \varphi_i < K$. Typically, values of any two $\varphi$ in m offset constraint factors $\varphi_i$ (namely, $\varphi_0, \varphi_1, ..., \varphi_{m-1}$) are unequal.

If the right circular shift is used, with reference to the formula (X-2) and the formula (X-4), there is the following formula (X-6):

$$A[\lfloor j/2 \rfloor \times (m \times 2) + (i \times 2) + (j\%2)] = \begin{cases} M_c[i][(j - \delta_i)\%K], 0 \leq j < K \\ M_c[i][j], K \leq j < N \end{cases}$$

$0 \leq i < m$. Generally, the offset constraint factor $\delta_i$ of the circular shift is an integer multiple of 10, and $0 \leq \varphi_i < K$. Typically, values of any two $\delta$ in m offset constraint factors $\delta_i$ (namely, $\delta_0, \delta_1, ..., \delta_{m-1}$) are unequal.

It should be noted that, the circular shift and the round-robin reading are performed in one step, which has advantages such as simple implementation and low complexity.

It should be noted that in the interleaving and encoding processing, the circular shift and the inner-code encoding are performed in parallel, and then the round-robin reading is performed. The following describes this implementation.

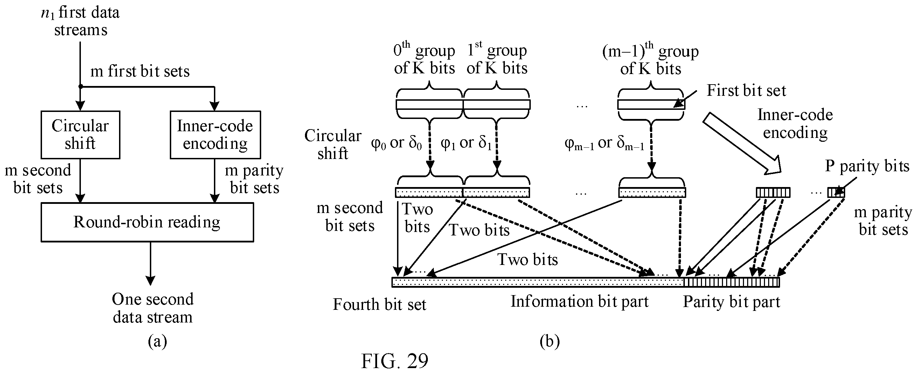

FIG. 29 is a diagram of a third implementation of interleaving and encoding processing. As shown in FIG. 29, for the $n_1$ first data streams, $a_0$ first bit sets are obtained from each first data stream, to obtain a total of $m = n_1 \times a_0$ first bit sets, where a total of $n_1 \times a_0 \times K$ bits are included.

As shown in (b) in FIG. 29, in the circular shift, left circular shift is performed by $\varphi_i$ bits or right circular shift is performed by $\delta_i$ bits on an $i^{th}$ first bit set in the m first bit sets to obtain an $i^{th}$ second bit set that includes K bits, to obtain m second bit sets in total, where $0 \leq i < m$. Generally, an offset constraint factor $\varphi_i$ of the left circular shift is an integer multiple of 10, and $0 \leq \varphi_i < K$; and an offset constraint factor $\delta_i$ of the right circular shift is an integer multiple of 10, and $0 \leq \delta_i < K$. Typically, values of any two $\varphi$ in m offset constraint factors $\varphi_i$ (namely, $\varphi_0, \varphi_1, ..., \varphi_{m-1}$) are not equal to each other, and values of any two $\delta$ in m offset constraint factors $\delta_i$ (namely, $\delta_0, \delta_1, ..., \delta_{m-1}$) are not equal to each other.

The inner-code encoding is performed on each first bit set that includes K bits and that is in the m first bit sets, to obtain a parity bit set that includes P bits, so that m parity bit sets are obtained in total. In the "round-robin reading", first, for the m second bit sets, two bits are obtained from each second bit set through round robin to obtain $m \times K$ bits in total; then, for the m parity bit sets, two bits are obtained from each parity bit set through round robin to obtain $m \times P$ bits in total; and the

$m \times K$ bits obtained from the m second bit sets and the $m \times P$ bits obtained from the m parity bit sets are combined to obtain a fourth bit set including $m \times N$ bits.

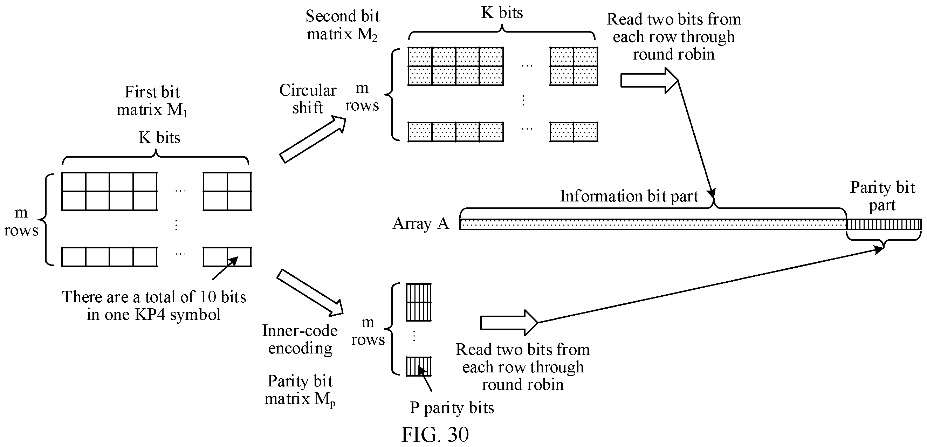

FIG. 30 is a diagram of a fourth implementation of interleaving and encoding processing. As shown in FIG. 30, m first bit sets may be represented by using a first bit matrix $M_1$ with m rows and K columns, and m second bit sets may be represented by using a second bit matrix $M_2$ with m rows and K columns. Specifically, the second bit matrix $M_2$ is obtained by performing the circular shift on the first bit matrix $M_1$.

Left circular shift is used as an example. The first bit matrix $M_1$ and the second bit matrix $M_2$ satisfy a formula (X-7):

$$M_2[i][j] = M_1[i][(j + \varphi_i)\%K]$$

Y%Z represents a remainder obtained by dividing the integer Y by the integer Z, $0 \leq i < m$, and $0 \leq j < K$. Generally, an offset constraint factor $\varphi_i$ of the left circular shift is an integer multiple of 10, and $0 \leq \varphi_i < K$.

It should be noted that, the left circular shift is performed on K bits in an $i^{th}$ row in the first bit matrix $M_1$ by $\varphi_i$ bits to obtain K bits in an $i^{th}$ row in the second bit matrix $M_2$. Equivalently, right circular shift is performed on the K bits in the $i^{th}$ row in the first bit matrix $M_1$ by K- $\varphi_i$ bits, to obtain the K bits in the $i^{th}$ row in the second bit matrix $M_2$.

In another example, location transformation is performed through right circular shift. The right circular shift is performed on an $i^{th}$ first bit set in the m first bit sets by $\delta_i$ bits, where the non-zero integer $\delta_i$ is an offset constraint factor of the circular shift corresponding to the $i^{th}$ bit set. The right circular shift satisfies a formula (X-8):

$$M_2[i][j] = M_1[i][(j - \delta_i)\%K]$$

Y%Z represents a remainder obtained by dividing the integer Y by the integer Z, $0 \leq i < m$, and $0 \leq j < K$. Generally, an offset constraint factor $\delta_i$ of the right circular shift is an integer multiple of 10, and $0 \leq \delta_i < K$.

It should be noted that, the right circular shift is performed on K bits in an $i^{th}$ row in the first bit matrix $M_1$ by $\delta_i$ bits to obtain K bits in an $i^{th}$ row in the second bit matrix $M_2$. Equivalently, left circular shift is performed on the K bits in the $i^{th}$ row in the second bit matrix $M_2$ by $\delta_i$ bits, to obtain the K bits in the $i^{th}$ row in the first bit matrix $M_1$. In other words, the formula (X-8) may alternatively be written as a formula (X-9):

$$M_1[i][j] = M_2[i][(j + \delta_i)\%K]$$

where $0 \leq i < m$, and $0 \leq j < K$.

As shown in FIG. 30, the inner-code encoding is performed on the first bit matrix $M_1$ to obtain a parity bit matrix $M_p$. 2 bits are read from each row in the second bit matrix $M_2$ through round robin, and all $m \times K$ bits in the second bit matrix $M_2$ are read through $m \times K/2$ operations in total, to obtain the $0^{th}$ bit to an $(m \times K- 1)^{th}$ bit in an array A that includes $m \times N$ interleaved bits. 2 bits are read from each row in the parity bit matrix $M_p$ through round robin, and all $m \times P$ bits in the parity bit matrix $M_p$ are read through $m \times P/2$ operations in total, to obtain an $(m \times K)^{th}$ bit to an $(m \times N- 1)^{th}$ bit in the array A.

It should be noted that, the circular shift and the inner-code encoding are performed in parallel, which has a low-delay advantage.

It should be noted that, in the interleaving and encoding processing, the circular shift is first performed, then the inner-code encoding is performed, and then the round-robin reading is performed. The following describes this implementation.

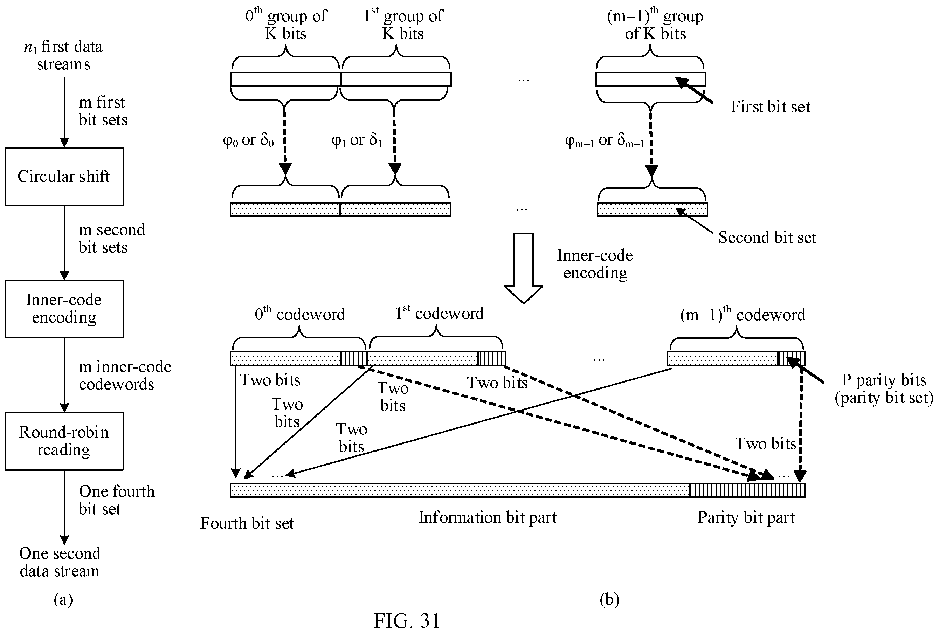

FIG. 31 is a diagram of a fifth implementation of interleaving and encoding processing. As shown in FIG. 31, for the $n_1$ first data streams, $a_0$ first bit sets are obtained from each first data stream, to obtain a total of $m = n_1 \times a_0$ first bit sets, where a total of $n_1 \times a_0 \times K$ bits are included.

As shown in (b) in FIG. 31, in the circular shift, left circular shift is performed by $\varphi_i$ bits or right circular shift is performed by $\delta_i$ bits on an $i^{th}$ first bit set in the m first bit sets to obtain an $i^{th}$ second bit set that includes K bits, to obtain m second bit sets in total, where $0 \leq i < m$. Generally, an offset constraint factor $\varphi_i$ of the left circular shift is an integer multiple of 10, and $0 \leq \varphi_i < K$; and an offset constraint factor $\delta_i$ of the right circular shift is an integer multiple of 10, and $0 \leq \delta_i < K$. Typically, values of any two $\varphi$ in m offset constraint factors $\varphi_i$ (namely, $\varphi_0$, $\varphi_1$, ..., $\varphi_{m-1}$) are not equal to each other, and values of any two $\delta$ in m offset constraint factors $\delta_i$ (namely, $\delta_0$, $\delta_1$, ..., $\delta_{m-1}$) are not equal to each other.

As shown in (b) in FIG. 31, the inner-code encoding is performed on each second bit set that includes the K bits and that is in the m second bit sets, and P parity bits are added to obtain an inner-code codeword including N bits, so that m inner-code codewords are obtained in total.

As shown in (b) in FIG. 31, for the m inner-code codewords, in the round-robin reading, two bits are obtained from each inner-code codeword through round robin, and consecutive $m \times N/2$ operations are performed to obtain all bits in the m inner-code codewords, to obtain a fourth bit set including $m \times N$ bits.

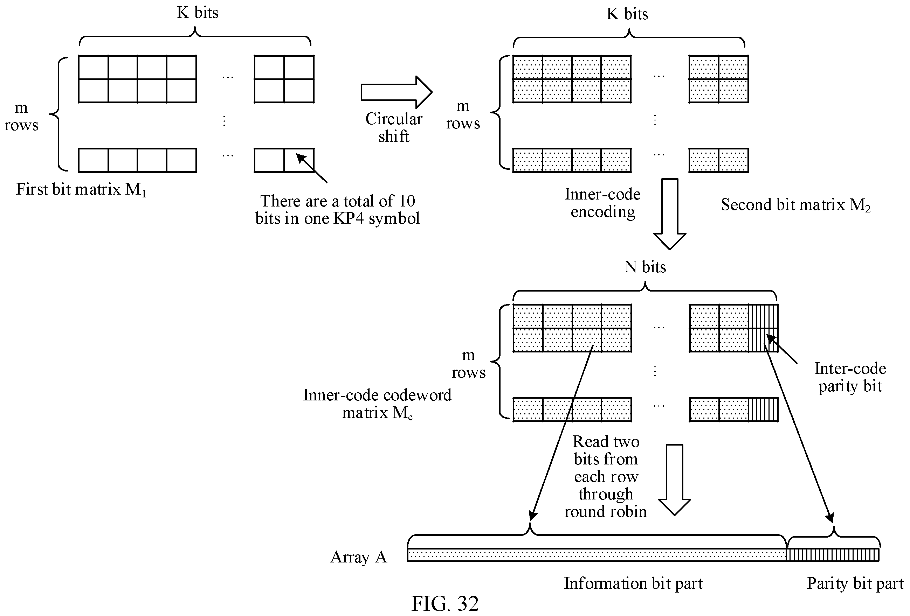

FIG. 32 is a diagram of a sixth implementation of interleaving and encoding processing. As shown in FIG. 32, m first bit sets may be represented by using a bit matrix $M_1$ with m rows and K columns, m second bit sets may be represented by using a bit matrix $M_2$ with m rows and K columns, and m inner-code codewords may be represented by using a bit matrix $M_c$ with m rows and N columns. The second bit matrix $M_2$ is obtained by performing the circular shift on the first bit matrix $M_1$.

Left circular shift is used as an example. The first bit matrix $M_1$ and the second bit matrix $M_2$ satisfy a formula (X-10):

$$M_2[i][j] = M_1[i][(j + \varphi_i)\%K]$$

Y%Z represents a remainder obtained by dividing the integer Y by the integer Z, $0 \le i < m$, and $0 \le j < K$. Generally, an offset constraint factor $\varphi_i$ of the left circular shift is an integer multiple of 10, and $0 \le \varphi_i < K$.

It should be noted that, the left circular shift is performed on K bits in an $i^{th}$ row in the first bit matrix $M_1$ by $\varphi_i$ bits to obtain K bits in an $i^{th}$ row in the second bit matrix $M_2$. Equivalently, right circular shift is performed on the K bits in the $i^{th}$ row in the first bit matrix $M_1$ by K- $\varphi_i$ bits, to obtain the K bits in the $i^{th}$ row in the second bit matrix $M_2$.

In another example, location transformation is performed through right circular shift. The right circular shift is performed on an $i^{th}$ first bit set in the m first bit sets by $\delta_i$ bits, where the non-zero integer $\delta_i$ is an offset constraint factor of the circular shift corresponding to the $i^{th}$ bit set. The right circular shift satisfies a formula (X-11):

$$M_2[i][j] = M_1[i][(j - \delta_i)\%K]$$

Y%Z represents a remainder obtained by dividing the integer Y by the integer Z, $0 \le i < m$, and $0 \le j < K$. Generally, an offset constraint factor $\delta_i$ of the right circular shift is an integer multiple of 10, and $0 \le \delta_i < K$.

It should be noted that, the right circular shift is performed on K bits in an $i^{th}$ row in the first bit matrix $M_1$ by $\delta_i$ bits to obtain K bits in an $i^{th}$ row in the second bit matrix $M_2$. Equivalently, left circular shift is performed on the K bits in the $i^{th}$ row in the second bit matrix $M_2$ by $\delta_i$ bits, to obtain the K bits in the $i^{th}$ row in the first bit matrix $M_1$. In other words, the formula (X-11) may alternatively be written as a formula (X-12):

$$M_1[i][j] = M_2[i][(j + \delta_i)\%K]$$

where $0 \le i < m$, and $0 \le j < K$.

As shown in FIG. 32, the inner-code encoding is performed on the second bit matrix $M_2$ to obtain the inner-code codeword matrix $M_c$. In the "round-robin reading" means reading 2 bits from each row in the inner-code codeword matrix $M_c$ through round robin, and all m $\times$ N bits are read through m $\times$ N/2 operations in total, to obtain an array A that includes m $\times$ N interleaved bits. A bit in an $i^{th}$ row and a $j^{th}$ column in the inner-code codeword matrix $M_c$ is output to a ($\lfloor j/2 \rfloor \times (m \times 2) + (i \times 2) + (j\%2))^{th}$ bit in the array A. This satisfies a formula (X-13):

$$A[\lfloor j/2 \rfloor \times (m \times 2) + (i \times 2) + (j\%2)] = M_c[i][j]$$

where $0 \le i < m$, $0 \le j < N$, and $\lfloor \cdot \rfloor$ represents a rounding down operation.

402: Separately map every two bits in the $n_2$ second data streams to one PAM4 symbol, to obtain $n_2$ PAM4 symbol data streams.

For PAM4 modulation, every two bits are mapped to one PAM4 modulation symbol. The fourth bit set or the array A including the m $\times$ N bits is mapped to m $\times$ N/2 PAM4 modulation symbols. The two bits mapped to the one PAM4 modulation symbol are from one inner-code codeword, and m $\times$ 2 bits mapped to m consecutive PAM4 modulation symbols are from m inner-code codewords.

Further, two outer-code symbols from a same RS outer-code codeword in one first data stream are mapped to a plurality of PAM4 symbols in a same PAM4 symbol data stream through the foregoing data processing. An appropriate offset constraint factor $\varphi_i$ of the left circular shift or constraint factor $\delta_i$ of the right circular shift offset is selected, so that any two of the plurality of PAM4 symbols are separated by at least two PAM4 symbols in the PAM4 symbol data stream. It should be noted that two adjacent PAM4 symbols in one PAM4 symbol data stream are considered as being separated by one PAM4 symbol.

In some specific application, before the bit mapping is performed on the $n_2$ second data streams, padding (padding) bits are periodically inserted into the $n_2$ second data streams, where the padding bit include an alignment marker for alignment and synchronization of a receiver.

In this embodiment of this application, a concatenated-FEC transmission solution is used. That is, the outer-code encoding and the inner-code encoding are sequentially performed on the data streams. On this basis, this application designs an interleaving and encoding processing method, so that both bits in an outer-code codeword and bits in an inner-code codeword are discretely and evenly mapped to modulation symbols. In this way, the concatenated-FEC transmission solution has a strong burst resistance capability. Particularly, a burst error with a small length may be directly corrected through inner-code decoding. The concatenated-FEC transmission solution is widely applicable to transmission scenarios, particularly an actual coherent transmission scenario in which there is colored noise on a channel.

It should be noted that, in the materials of this application, in the round-robin reading, two bits are obtained from each third bit set through round robin, to obtain the fourth bit set including the $m \times N$ bits. That is, two bits are obtained from the $0^{th}$ third bit set, two bits are obtained from the $1^{st}$ third bit set, ..., two bits are obtained from an $(m-1)^{th}$ third bit set, and then two bits are obtained from the $0^{th}$ third bit set until all $m \times N$ bits are obtained. In some specific implementations, an order of the round-robin reading may be changed. Correspondingly, corresponding order change only needs to be performed on the offset constraint factor $\varphi_0, \varphi_1, ..., \varphi_{m-1}$ of the left circular shift or the offset constraint factor $\delta_0, \delta_1, ..., \delta_{m-1}$ of the right circular shift in the circular shift operation.

With reference to some specific embodiments, the following further describes a procedure of the data processing method described in FIG. 26. The following Embodiment X-1 to Embodiment X-6 describe the data processing procedures shown in FIG. 27 and FIG. 28.

Embodiment X-1: $n_0 = 4$, $n_1 = 1$, and $a_0 = 8$. A data processing procedure includes convolutional interleaving. For example, a bit set is for representation, and left circular shift is used.

A physical medium attachment (Physical Medium Attachment, PMA) sublayer of a transmitter processing module performs first data processing on data from a plurality of synchronous client lanes (client lanes) to obtain $n_0 = 4$ first data streams. The foregoing $n_0 = 4$ first data streams are all outer-code encoded data streams. Interleaving and encoding processing is performed on every $n_1 = 1$ first data stream in the $n_0 = 4$ first data streams to obtain one second data stream, to obtain a total of $n_2 = 4$ second data streams.

Refer to FIG. 27. In the interleaving and encoding processing, inner-code encoding is first performed, then circular shift is performed, and then round-robin reading is performed. For the $n_1 = 1$ first data stream, $m = n_1 \times a_0 = 8$ first bit sets that include $K = 120$ bits are obtained, so that $m \times K = 960$ bits are included in total. Convolutional interleaving processing is further performed on the first data stream before the inner-code encoding, so that the $K = 120$ bits are from 12 KP4 symbols in 12 different outer-code KP4 RS codewords.

The inner-code encoding is performed on every $K = 120$ bit by using the inner-code encoding, and $P=8$ parity bits are added, to obtain an inner-code codeword including $N= 128$ bits, to obtain $m = 8$ inner-code codewords in total. The $K = 120$ bits are also referred to as an information bit sequence.

In this application, in a circular shift operation, the left circular shift is performed on $K=120$ information bits in an $i^{th}$ ($0 \leq i < 8$) inner-code codeword, namely, an $i^{th}$ first bit set, by $\varphi_i$ bits, to obtain an $i^{th}$ second bit set, where specific values of eight offset constraint factors $\{\varphi_0, \varphi_1, \varphi_2, \varphi_3, \varphi_4, \varphi_5, \varphi_6, \varphi_7\}$ of the left circular shift are one of the following value items 1:

{0, 30, 60, 90, 110, 20, 50, 80},
{0, 30, 90, 60, 110, 20, 80, 50},
{0, 60, 30, 90, 110, 50, 20, 80},
{0, 60, 90, 30, 110, 50, 80, 20},
{0, 90, 30, 60, 110, 80, 20, 50}, or
{0, 90, 60, 30, 110, 80, 50, 20}

It should be understood that, for any item, a fixed offset is added to a value of each of the eight offset constraint factors $\{\varphi_0, \varphi_1, \varphi_2, \varphi_3, \varphi_4, \varphi_5, \varphi_6, \varphi_7\}$ of the left circular shift. That is, $\{(\varphi_0 + \Delta)\%K, (\varphi_1 + \Delta)\%K, (\varphi_2 + \Delta)\%K, (\varphi_3 + \Delta)\%K, (\varphi_4 + \Delta)\%K, (\varphi_5 + \Delta)\%K, (\varphi_6 + \Delta)\%K, (\varphi_7 + \Delta)\%K\}$ is still considered as a valid parameter item, where $\Delta$ is an integer.

The $i^{th}$ second bit set is combined with $P=8$ parity bits in the $i^{th}$ inner-code codeword to obtain an $i^{th}$ third bit set that includes $N=128$ bits.

Refer to FIG. 27. For $m = 8$ third bit sets output after the circular shift, in the round-robin reading, two bits are obtained from each third bit set through round robin, and consecutive 512 operations are performed to obtain all bits in the $m = 8$ third bit sets, to obtain a fourth bit set including $m \times N = 1024$ bits.

Every two bits in the fourth bit set including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift in the value item 1 is used, so that any two of the 10 PAM4 symbols can be separated by at least two PAM4 symbols in the PAM4 symbol data stream. More specifically, when the two of the 10 PAM4 symbols are from different KP4 outer-code codewords, the two of the 10 PAM4 symbols are separated by at least 12 PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

Embodiment X-2: $n_0 = 4$, $n_1 = 1$, and $a_0 = 8$. A data processing procedure includes convolutional interleaving. For example, a matrix is for representation, and left circular shift is used.

Based on the solution in Embodiment X-1, m = 8 first bit set may be represented by using a first bit matrix $M_1$ with 8 rows and 120 columns. Inner-code encoding is performed on K=120 bits in each row in the first bit matrix $M_1$ to obtain one inner code with N=128 bits. 8 inner-code codewords may be represented by using an inner-code codeword matrix $M_c$ with 8 rows and 128 columns, where each row in the inner-code codeword matrix $M_c$ includes N=128 bits in one inner-code codeword. In the inner-code codeword matrix $M_c$, a total of $m \times K = 960$ bits in the $0^{th}$ column to a $(K-1=119)^{th}$ column correspond to $m \times K = 960$ information bits in m=8 inner-code codewords, and in the inner-code codeword matrix, a total of $m \times P = 64$ bits in a $(K=120)^{th}$ column to an $(N-1=127)^{th}$ column in the inner-code codeword matrix $M_c$ correspond to $m \times P = 64$ parity bits in the m=8 inner-code codewords.

The left circular shift is performed on 120 information bits (namely, 120 bits in an $i^{th}$ row in the first bit matrix $M_1$) in an $i^{th}$ ($0 \leq i < 8$) row in the inner-code codeword matrix $M_c$ by $\varphi_i$ bits, to obtain 120 bits in an $i^{th}$ row in a third bit matrix $M_3$. The following formula is satisfied:

$$M_3[i][j] = \begin{cases} M_c[i][(j + \varphi_i)\%120], 0 \leq j < 120 \\ M_c[i][j], 120 \leq j < 128 \end{cases}$$

Y%Z represents a remainder obtained by dividing the integer Y by the integer Z, and $0 \leq i < 8$. Specific values of eight offset constraint factors $\{\varphi_0, \varphi_1, \varphi_2, \varphi_3, \varphi_4, \varphi_5, \varphi_6, \varphi_7\}$ of the left circular shift are one of value items 1.

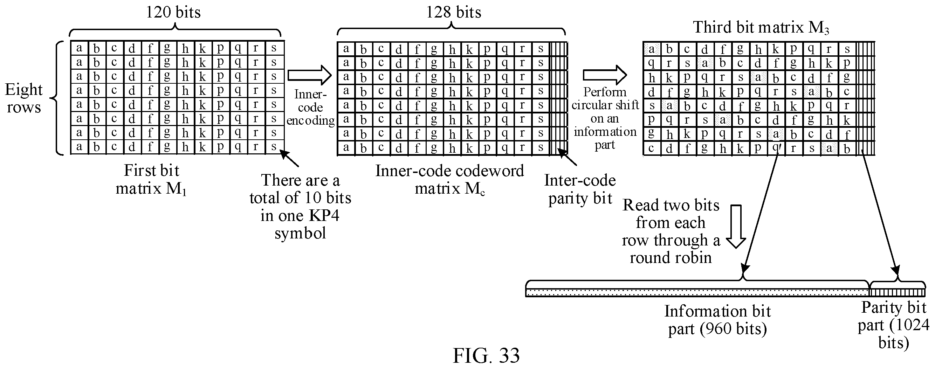

FIG. 33 is a diagram of a seventh implementation of interleaving and encoding processing. As shown in FIG. 33, $\{\varphi_0 = 0, \varphi_1 = 90, \varphi_2 = 60, \varphi_3 = 30, \varphi_4 = 110, \varphi_5 = 80, \varphi_6 = 50, \varphi_7 = 20\}$ is considered. Letters a, b, c, d, f, g, h, k, p, q, r, and s respectively represent one KP4 symbol, and the KP4 symbol includes 10 bits. In FIG. 33, KP4 symbols represented by same letters are from a same KP4 outer code, and KP4 symbols represented by different letters are from different KP4 outer codes. For example, eight KP4 symbols represented by same letters a in FIG. 33 are from a same KP4 outer code.

2 bits are read from each row in the third bit matrix $M_3$ through round robin, and all 1024 bits are read through 512 operations in total, to obtain an array A that includes $m \times N = 1024$ interleaved bits. A bit in the $i^{th}$ row and a $j^{th}$ column in the third bit matrix $M_3$ is output to a $(\lfloor j/2 \rfloor \times 16 + (i \times 2) + (j\%2))^{th}$ bit in the array A, and the following formula is satisfied:

$$A[\lfloor j/2 \rfloor \times 16 + (i \times 2) + (j\%2)] = M_3[i][j]$$

where $0 \leq i < 8$, $0 \leq j < 128$, and $\lfloor \cdot \rfloor$ represents a rounding down operation.

It should be noted that, circular shift and the round-robin reading that are performed on the inner-code codeword matrix $M_c$ to obtain the array A of the 1024 bits are performed by using two operations, or may be performed by using one operation. The following directly provides a direct correspondence between $M_c$ and A:

$$A[\lfloor j/2 \rfloor \times 16 + (i \times 2) + (j\%2)] = \begin{cases} M_c[i][(j + \varphi_i)\%120], 0 \leq j < 120 \\ M_c[i][j], 120 \leq j < 128 \end{cases}$$

where $0 \leq i < 8$.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift in the value item 1 is used, so that any two of the 10 PAM4 symbols can be separated by at least two PAM4 symbols in the PAM4 symbol data stream. More specifically, when the two of the 10 PAM4 symbols are from different KP4 outer-code codewords, the two of the 10 PAM4 symbols are separated by at least 12 PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

Embodiment X-3: $n_0 = 4$, $n_1 = 1$, and $a_0 = 8$. A data processing procedure includes convolutional interleaving. For example, a matrix is for representation, and right circular shift is used.

Based on the solution in Embodiment X-2, the right circular shift is used. The right circular shift is performed on 120 information bits (namely, 120 bits in an $i^{th}$ row in the first bit matrix $M_1$) in an $i^{th}$ ($0 \le i < 8$) row in the inner-code codeword matrix $M_c$ by $\delta_i$ bits, to obtain 120 bits in an $i^{th}$ row in a third bit matrix $M_3$. The following formula is satisfied:

$$M_3[i][j] = \begin{cases} M_c[i][(j-\delta_i)\%120], & 0 \le j < 120 \\ M_c[i][j], & 120 \le j < 128 \end{cases}$$

Y%Z represents a remainder obtained by dividing the integer Y by the integer Z, and $0 \le i < m$. Specific values of eight offset constraint factors $\{\delta_0, \delta_1, \delta_2, \delta_3, \delta_4, \delta_5, \delta_6, \delta_7\}$ of the right circular shift are one of the following value items 2:

{0, 30, 60, 90, 10, 40, 70, 100},
{0, 30, 90, 60, 10, 40, 100, 70},
{0, 60, 30, 90, 10, 40, 40, 100},
{0, 60, 90, 30, 10, 70, 100, 40},
{0, 90, 30, 60, 10, 100, 40, 70}, or
{0, 90, 60, 30, 10, 100, 70, 40}

It should be noted that a correspondence between $M_3$ and $M_2$ may alternatively be written as the following formula:

$$M_c[i][j] = \begin{cases} M_3[i][(j + \delta_i)\%120], & 0 \le j < 120 \\ M_3[i][j], & 120 \le j < 128 \end{cases}$$

where $0 \le i < 8$.

It should be noted that, for any one of the value items 2, a fixed offset is added to a value of each of the eight offset constraint factors $\{\delta_0, \delta_1, \delta_2, \delta_3, \delta_4, \delta_5, \delta_6, \delta_7\}$ of the right circular shift. That is, $\{(\delta_0 + \Delta)\%K, (\delta_1 + \Delta)\%K, (\delta_2 + \Delta)\%K, (\delta_3 + \Delta)\%K, (\delta_4 + \Delta)\%K, (\delta_5 + \Delta)\%K, (\delta_6 + \Delta)\%K, (\delta_7 + \Delta)\%K\}$ is still considered as a valid parameter item, where $\Delta$ is an integer.

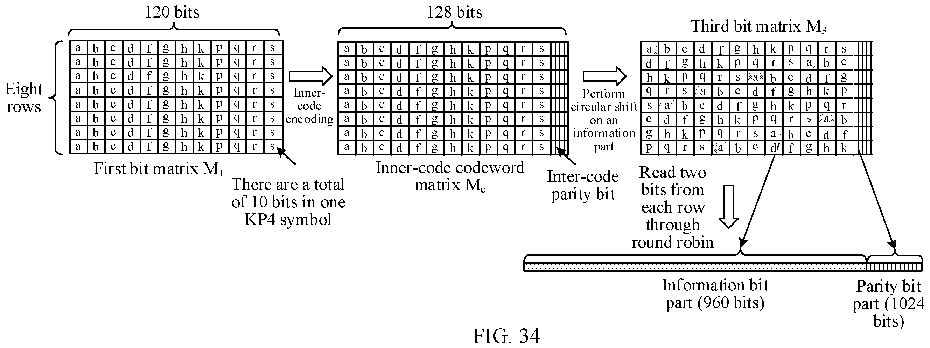

FIG. 34 is a diagram of an eighth implementation of interleaving and encoding processing. As shown in FIG. 34, $\{\delta_0 = 0, \delta_1 = 90, \delta_2 = 60, \delta_3 = 30, \delta_4 = 10, \delta_5 = 100, \delta_6 = 70, \delta_7 = 40\}$ is considered. Letters a, b, c, d, f, g, h, k, p, q, r, and s respectively represent one KP4 symbol, and the KP4 symbol includes 10 bits. In FIG. 34, KP4 symbols represented by same letters are from a same KP4 outer code, and KP4 symbols represented by different letters are from different KP4 outer codes. For example, eight KP4 symbols represented by same letters a in FIG. 34 are from a same KP4 outer code.

2 bits are read from each row in the third bit matrix $M_3$ through round robin, and all 1024 bits are read through 512 operations in total, to obtain an array A that includes $m \times N = 1024$ interleaved bits. A bit in the $i^{th}$ row and a $j^{th}$ column in the third bit matrix $M_3$ is output to a $(\lfloor j/2 \rfloor \times 16 + (i \times 2) + (j\%2))^{th}$ bit in the array A, and the following formula is satisfied:

$$A[\lfloor j/2 \rfloor \times 16 + (i \times 2) + (j\%2)] = M_3[i][j]$$

where $0 \le i < 8$, $0 \le j < 128$, and $\lfloor \cdot \rfloor$ represents a rounding down operation.

It should be noted that, circular shift and the round-robin reading that are performed on the inner-code codeword matrix $M_c$ to obtain the array A of the 1024 bits are performed by using two operations, or may be performed by using one operation. The following directly provides a direct correspondence between $M_c$ and A:

$$A[\lfloor j/2 \rfloor \times 16 + (i \times 2) + (j\%2)] = \begin{cases} M_c[i][(j-\delta_i)\%120], 0 \le j < 120 \\ M_c[i][j], 120 \le j < 128 \end{cases}$$

where $0 \le i < 8$.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\delta_i$ of the right circular shift in the value item 2 is used, so that any two of the 10 PAM4 symbols can be separated by at least two PAM4 symbols in the PAM4 symbol data stream. More specifically, when the two of the 10 PAM4 symbols are from different KP4 outer-code codewords, the two of the 10 PAM4 symbols are separated by at least 12 PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

Embodiment X-4: $n_0 = 4$, $n_1 = 1$, and $a_0 = 8$. A data processing procedure does not include convolutional interleaving. For example, a bit set is for representation, and left circular shift is used.

Based on Embodiment X-1, a convolutional interleaving operation is not performed (is bypassed), which has a low-delay advantage and satisfy an application scenario with a high delay requirement. A physical medium attachment (Physical Medium Attachment, PMA) sublayer of a transmitter processing module performs first data processing on data from a plurality of synchronous client lanes (client lanes) to obtain $n_0 = 4$ first data streams. The foregoing $n_0 = 4$ first data streams are all outer-code encoded data streams. The interleaving and encoding processing is performed on every $n_1 = 1$ first data stream in the $n_0 = 4$ first data streams to obtain one second data stream, to obtain a total of $n_2 = 4$ second data streams.

Refer to FIG. 27. In the interleaving and encoding processing, inner-code encoding is first performed, then circular shift is performed, and then round-robin reading is performed. For the $n_1 = 1$ first data stream, $m = n_1 \times a_0 = 8$ first bit sets that include $K = 120$ bits are obtained, so that $m \times K = 960$ bits are included in total. 120 information bits in each inner-code codeword are from 12 KP4 symbols in four different outer-code KP4 RS codewords.

The inner-code encoding is performed on every $K = 120$ bit by using the inner-code encoding, and P=8 parity bits are added, to obtain an inner-code codeword including N=128 bits, to obtain $m = 8$ inner-code codewords in total. The K = 120 bits are also referred to as an information bit sequence.

In this application, in a circular shift operation, the left circular shift is performed on K=120 information bits in an $i^{th}$ ($0 \le i < 8$) inner-code codeword, namely, an $i^{th}$ first bit set, by $\varphi_i$ bits, to obtain an ith second bit set, where specific values of eight offset constraint factors $\{\varphi_0, \varphi_1, \varphi_2, \varphi_3, \varphi_4, \varphi_5, \varphi_6, \varphi_7\}$ of the left circular shift are one of the following value items 3:

{0, 30, 60, 90, 110, 20, 50, 80}, or
{0, 60, 30, 90, 110, 50, 20, 80}

It should be understood that, for any item, a fixed offset is added to a value of each of the eight offset constraint

factors $\{\varphi_0, \varphi_1, \varphi_2, \varphi_3, \varphi_4, \varphi_5, \varphi_6, \varphi_7\}$ of the left circular shift. That is, $\{(\varphi_0 + \Delta)\%K, (\varphi_1 + \Delta)\%K, (\varphi_2 + \Delta)\%K, (\varphi_3 + \Delta)\%K, (\varphi_4 + \Delta)\%K, (\varphi_5 + \Delta)\%K, (\varphi_6 + \Delta)\%K, (\varphi_7 + \Delta)\%K\}$ is still considered as a valid parameter item, where $\Delta$ is an integer.

The $i^{th}$ second bit set is combined with P=8 parity bits in the $i^{th}$ inner-code codeword to obtain an $i^{th}$ third bit set that includes N=128 bits.

Refer to FIG. 27. For m = 8 third bit sets output after the circular shift, in the round-robin reading, two bits are obtained from each third bit set through round robin, and consecutive 512 operations are performed to obtain all bits in the m = 8 third bit sets, to obtain a fourth bit set including m $\times$ N = 1024 bits.

Every two bits in the fourth bit set including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1$ = 1 first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift in the value item 3 is used, so that any two of the 10 PAM4 symbols can be separated by at least two PAM4 symbols in the PAM4 symbol data stream.

According to the bit interleaving and mapping method designed in this embodiment, when a low delay is ensured, bits in an outer-code codeword and bits in an inner-code codeword are discretely and evenly mapped to modulation symbols. In this way, a concatenated-FEC transmission solution has a good burst resistance capability.

It should be noted that, in this embodiment, $n_0$ = 4, $n_1$ = 1, $a_0$ = 8, and $n_2 = n_0/n_1$ = 4, which may be applied to an 800GE scenario, where the $n_2$ = 4 second data streams have a rate about 200G, and are correspondingly carried on four lanes of optical signals for sending. The interleaving and encoding processing used in this embodiment may be applied to a 1.6TE scenario, where $n_0$ = 8, $n_1$ = 1, $a_0$ = 8, and $n_2 = n_0/n_1$ = 8. In this case, the physical medium attachment (Physical Medium Attachment, PMA) sublayer of the transmitter processing module performs the first data processing on the data from the plurality of synchronous client lanes (client lanes) to obtain $n_0$ = 8 first data streams. The foregoing $n_0$ = 8 first data streams are all outer-code encoded data streams. The interleaving and encoding processing is performed on every $n_1$ = 1 first data stream in the $n_0$ = 8 first data streams to obtain one second data stream, to obtain a total of $n_2$ = 8 second data streams. The $n_2$ = 8 second data streams (a rate is approximately 200G per second data stream) are correspondingly carried on eight lanes of optical signals for sending.

Embodiment X-5: $n_0$ = 4, $n_1$ = 1, and $a_0$ = 8. In a data processing procedure, convolutional interleaving is not performed. For example, a matrix is for representation, and left circular shift is used.

Based on Embodiment X-4, m = 8 bit sets may be represented by using a matrix. Inner-code encoding is performed on K=120 bits in each row in a first bit matrix $M_1$ to obtain an inner-code codeword matrix $M_c$. Left circular shift is performed on 120 information bits (namely, 120 bits in an $i^{th}$ row in the first bit matrix $M_1$) in an $i^{th}$ ($0 \le i < 8$) row in the inner-code codeword matrix $M_c$ by $\varphi_i$ bits, to obtain 120 bits in an $i^{th}$ row in a third bit matrix $M_3$. The following formula is satisfied:

$$M_3[i][j] = \begin{cases} M_c[i][(j + \varphi_i)\%120], 0 \le j < 120 \\ M_c[i][j], 120 \le j < 128 \end{cases}$$

Y%Z represents a remainder obtained by dividing the integer Y by the integer Z, and $0 \le i < 8$. Specific values of eight offset constraint factors $\{\varphi_0, \varphi_1, \varphi_2, \varphi_3, \varphi_4, \varphi_5, \varphi_6, \varphi_7\}$ of the left circular shift are one of value items 3.

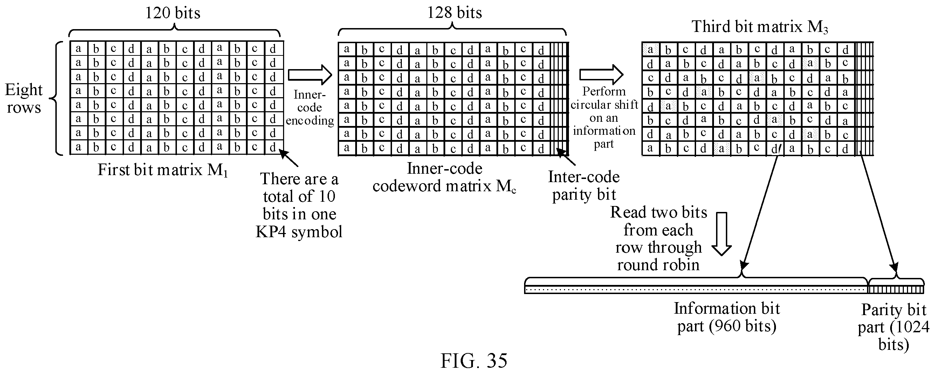

FIG. 35 is a diagram of a ninth implementation of interleaving and encoding processing. As shown in FIG. 35, $\{\varphi_0 = 0, \varphi_1 = 30, \varphi_2 = 60, \varphi_3 = 90, \varphi_4 = 110, \varphi_5 = 20, \varphi_6 = 50, \varphi_7 = 80\}$ is considered. Letters a, b, c, and d respectively represent one KP4 symbol, and the KP4 symbol includes 10 bits. In FIG. 35, KP4 symbols represented by same letters are from a same KP4 outer code, and KP4 symbols represented by different letters are from different KP4 outer codes. For example, 24 KP4 symbols represented by same letters a in FIG. 35 are from a same KP4 outer code.

2 bits are read from each row in the third bit matrix $M_3$ through round robin, and all 1024 bits are read through 512 operations in total, to obtain an array A that includes m $\times$ N = 1024 interleaved bits.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1$ = 1 first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift in the value item 3 is used, so that any two of the 10 PAM4 symbols can be separated by at least two PAM4 symbols in the PAM4 symbol data stream.

According to the bit interleaving and mapping method designed in this embodiment, when a low delay is ensured, bits in an outer-code codeword and bits in an inner-code codeword are discretely and evenly mapped to modulation symbols. In this way, a concatenated-FEC transmission solution has a good burst resistance capability.

It should be noted that, in this embodiment, $n_0$ = 4, $n_1$ = 1, $a_0$ = 8, and $n_2 = n_0/n_1$ = 4, which may be applied to an 800GE scenario, where the $n_2$ = 4 second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

Embodiment X-6: $n_0 = 4$, $n_1 = 1$, and $a_0 = 8$. In a data processing procedure, convolutional interleaving is not performed. For example, a matrix is for representation, and right circular shift is used.

Based on Embodiment X-5, the right circular shift is used. The right circular shift is performed on 120 information bits (namely, 120 bits in an $i^{th}$ row in the first bit matrix $M_1$) in an $i^{th}$ ($0 \le i < 8$) row in the inner-code codeword matrix $M_c$ by $\delta_i$ bits, to obtain 120 bits in an $i^{th}$ row in a third bit matrix $M_3$. The following formula is satisfied:

$$M_3[i][j] = \begin{cases} M_c[i][(j - \delta_i)\%120], 0 \le j < 120 \\ M_c[i][j], 120 \le j < 128 \end{cases}$$

Y%Z represents a remainder obtained by dividing the integer Y by the integer Z, and $0 \le i < m$. Specific values of eight offset constraint factors $\{\delta_0, \delta_1, \delta_2, \delta_3, \delta_4, \delta_5, \delta_6, \delta_7\}$ of the right circular shift are one of the following value items 4:

{0, 60, 90, 30, 10, 70, 100, 40}, or
{0, 90, 60, 30, 10, 100, 70, 40}

It should be understood that, for any item, a fixed offset is added to a value of each of the eight offset constraint factors $\{\delta_0, \delta_1, \delta_2, \delta_3, \delta_4, \delta_5, \delta_6, \delta_7\}$ of the right circular shift. That is, $\{(\delta_0 + \Delta)\%K, (\delta_1 + \Delta)\%K, (\delta_2 + \Delta)\%K, (\delta_3 + \Delta)\%K, (\delta_4 + \Delta)\%K, (\delta_5 + \Delta)\%K, (\delta_6 + \Delta)\%K, (\delta_7 + \Delta)\%K\}$ is still considered as a valid parameter item, where $\Delta$ is an integer.

It should be noted that a correspondence between $M_3$ and $M_c$ may alternatively be written as the following:

$$M_c[i][j] = \begin{cases} M_3[i][(j + \delta_i)\%120], 0 \le j < 120 \\ M_3[i][j], 120 \le j < 128 \end{cases}$$

where $0 \le i < 8$.

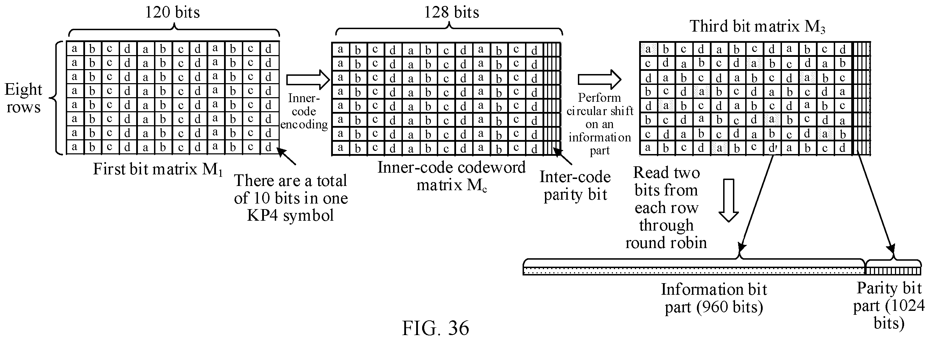

FIG. 36 is a diagram of a tenth implementation of interleaving and encoding processing. As shown in FIG. 36, $\{\delta_0 = 0, \delta_1 = 60, \delta_2 = 90, \delta_3 = 30, \delta_4 = 10, \delta_5 = 70, \delta_6 = 100, \delta_7 = 40\}$ is considered. Letters a, b, c, and d respectively represent one KP4 symbol, and the KP4 symbol includes 10 bits. In FIG. 36, KP4 symbols represented by same letters are from a same KP4 outer code, and KP4 symbols represented by different letters are from different KP4 outer codes. For example, 24 KP4 symbols represented by same letters a in FIG. 36 are from a same KP4 outer code.

2 bits are read from each row in the third bit matrix $M_3$ through round robin, and all 1024 bits are read through 512 operations in total, to obtain an array A that includes $m \times N = 1024$ interleaved bits.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\delta_i$ of the right circular shift in the value item 4 is used, so that any two of the 10 PAM4 symbols can be separated by at least two PAM4 symbols in the PAM4 symbol data stream.

According to the bit interleaving and mapping method designed in this embodiment, when a low delay is ensured, bits in an outer-code codeword and bits in an inner-code codeword are discretely and evenly mapped to modulation symbols. In this way, a concatenated-FEC transmission solution has a good burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

It should be noted that, in Embodiment X-1 to Embodiment X-6, the inner-code encoding is first performed, and then the circular shift is performed. The inner-code encoding and the circular shift may alternatively be performed in parallel, as shown in FIG. 29 and FIG. 30. The following uses Embodiment X-7 as an example for description, and provides an equivalent execution manner of Embodiment X-3.

Embodiment X-7: $n_0 = 4$, $n_1 = 1$, and $a_0 = 8$. A data processing procedure includes convolutional interleaving. For example, a matrix is for representation, and left circular shift is used. Inner-code encoding and the circular shift are performed in parallel.

Based on the solution in Embodiment X-3, the inner-code encoding and the circular shift in this embodiment are performed in parallel.

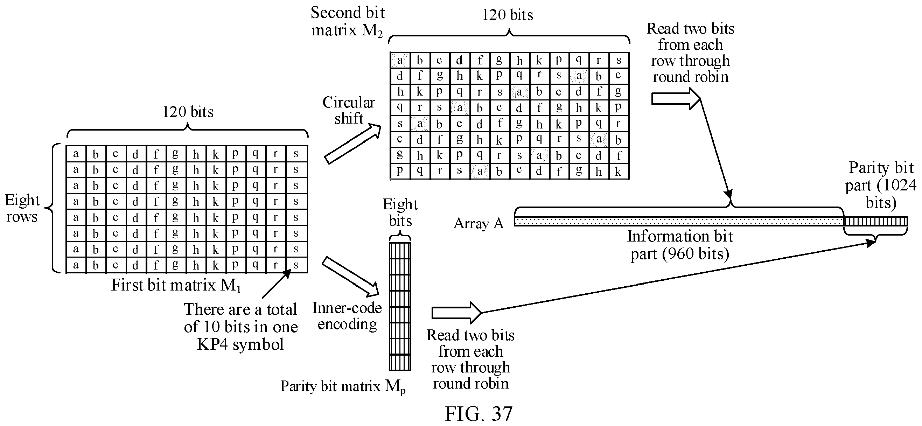

FIG. 37 is a diagram of an eleventh implementation of interleaving and encoding processing. As shown in FIG. 37, left circular shift is performed on 120 information bits (namely, 120 bits in an $i^{th}$ row in the first bit matrix $M_1$) in an $i^{th}$ ($0 \leq i < 8$) row in the first bit matrix $M_1$ by $\varphi_i$ bits, to obtain 120 bits in an $i^{th}$ row in a second bit matrix $M_2$. The following formula is satisfied:

$$M_2[i][j] = M_1[i][(j + \varphi_i)\%K]$$

Y%Z represents a remainder obtained by dividing the integer Y by the integer Z, $0 \leq i < 8$, and $0 \leq j < 120$. Specific values of eight offset constraint factors $\{\varphi_0, \varphi_1, \varphi_2, \varphi_3, \varphi_4, \varphi_5, \varphi_6, \varphi_7\}$ of the left circular shift are one of value items 1. As shown in FIG. 37, $\{\varphi_0 = 0, \varphi_1 = 90, \varphi_2 = 60, \varphi_3 = 30, \varphi_4 = 110, \varphi_5 = 80, \varphi_6 = 50, \varphi_7 = 20\}$ is considered.

The inner-code encoding is performed on K=120 bits in each row in the first bit matrix $M_1$ to obtain one P=8 parity bit, to obtain a parity bit matrix $M_p$.

2 bits are read from each row in the third bit matrix $M_3$ through round robin, and all 1024 bits are read through 512 operations in total, to obtain an array A that includes m × N = 1024 interleaved bits. A bit in the $i^{th}$ row and a $j^{th}$ column in the third bit matrix $M_3$ is output to an $(i \times \lfloor j/2 \rfloor \times 16 + (i \times 2) + (j\%2))^{th}$ bit in the array A, and the following formula is satisfied:

$$A[i \times \lfloor j/2 \rfloor \times 16 + (i \times 2) + (j\%2)] = M_3[i][j]$$

where $0 \leq i < 8$, $0 \leq j < 128$, and $\lfloor \cdot \rfloor$ represents a rounding down operation.

It should be noted that, circular shift and the round-robin reading that are performed on the inner-code codeword matrix $M_c$ to obtain the array A of the 1024 bits are performed by using two operations, or may be performed by using one operation. The following directly provides a direct correspondence between $M_c$ and A:

$$A[i \times \lfloor j/2 \rfloor \times 16 + (i \times 2) + (j\%2)] = \begin{cases} M_c[i][(j + \varphi_i)\%120], 0 \leq j < 120 \\ M_c[i][j], 120 \leq j < 128 \end{cases}$$

where $0 \leq i < 8$.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift is used, so that any two of the 10 PAM4 symbols can be separated by at least two PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

The following Embodiment X-8 to Embodiment X-11 describe the data processing procedures shown in FIG. 31 and FIG. 32.

Embodiment X-8: $n_0 = 4$, $n_1 = 1$, and $a_0 = 8$. A data processing procedure includes convolutional interleaving. For example, a bit set is for representation, and left circular shift is used.

A physical medium attachment (Physical Medium Attachment, PMA) sublayer of a transmitter processing module performs first data processing on data from a plurality of synchronous client lanes (client lanes) to obtain $n_0 = 4$ first data streams. The foregoing $n_0 = 4$ first data streams are all outer-code encoded data streams. The interleaving and encoding processing is performed on every $n_1 = 1$ first data stream in the $n_0 = 4$ first data streams to obtain one second data stream, to obtain a total of $n_2 = 4$ second data streams.

Refer to FIG. 31. In the interleaving and encoding processing, the circular shift is first performed, then the inner-code encoding is performed, and then the round-robin reading is performed. For the $n_1 = 1$ first data stream, $m = n_1 \times a_0 = 8$ first bit sets that include K = 120 bits are obtained, so that $m \times K = 960$ bits are included in total. Convolutional interleaving processing is further performed on the first data stream before the circular shift, so that the K = 120 bits are from 12 KP4 symbols in 12 different outer-code KP4 RS codewords.

In this application, in a circular shift operation, the left circular shift is performed on an $i^{th}$ ($0 \le i < 8$) first bit set by $\varphi_i$ bits, to obtain an $i^{th}$ second bit set, where specific values of eight offset constraint factors $\{\varphi_0, \varphi_1, \varphi_2, \varphi_3, \varphi_4, \varphi_5, \varphi_6, \varphi_7\}$ of the left circular shift are one of value items 1:

The inner-code encoding is performed on K = 120 bits in the $i^{th}$ second bit set, and P=8 parity bits are added to obtain an $i^{th}$ inner-code codeword including N=128 bits, to obtain m = 8 inner-code codewords in total. The K = 120 bits are also referred to as an information bit sequence.

Refer to FIG. 31. For m = 8 third bit sets output after the circular shift, in the round-robin reading, two bits are obtained from each third bit set through round robin, and consecutive 512 operations are performed to obtain all bits in the m = 8 third bit sets, to obtain a fourth bit set including $m \times N = 1024$ bits.

Every two bits in the fourth bit set including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift is used, so that any two of the 10 PAM4 symbols can be separated by at least two PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 4$, $n_1 = 1$, $a_0 = 8$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 8$, $n_1 = 1$, $a_0 = 8$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 8$ first data streams. The foregoing $n_0 = 8$ first data streams are all outer-code encoded data streams. The interleaving and encoding processing is performed on every $n_1 = 1$ first data stream in the $n_0 = 8$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

Embodiment X-9: $n_0 = 4$, $n_1 = 1$, and $a_0 = 8$. A data processing procedure includes convolutional interleaving. For example, a matrix is for representation, and left circular shift is used.

Based on the solution in Embodiment X-8, m = 8 first bit set may be represented by using a first bit matrix $M_1$ with 8 rows and 120 columns. The left circular shift is performed on 120 information bits in an $i^{th}$ ($0 \le i < 8$) row in the first bit matrix $M_1$ by $\varphi_i$ bits, to obtain 120 bits in an $i^{th}$ row in a second bit matrix $M_2$. The following formula is satisfied:

$$M_2[i][j] = M_1[i][(j + \varphi_i)\%K]$$

Y%Z represents a remainder obtained by dividing the integer Y by the integer Z, $0 \le i < 8$, and $0 \le j < 120$. Specific values of eight offset constraint factors $\{\varphi_0, \varphi_1, \varphi_2, \varphi_3, \varphi_4, \varphi_5, \varphi_6, \varphi_7\}$ of the left circular shift are one of value items 1.

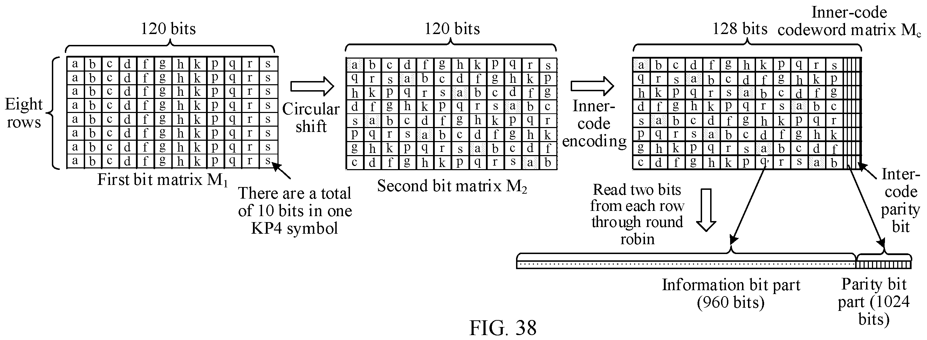

FIG. 38 is a diagram of a twelfth implementation of interleaving and encoding processing. As shown in FIG. 38, $\{\varphi_0 = 0, \varphi_1 = 90, \varphi_2 = 60, \varphi_3 = 30, \varphi_4 = 110, \varphi_5 = 80, \varphi_6 = 50, \varphi_7 = 20\}$ is considered. Inner-code encoding is separately performed on the K=120 bits in the $i^{th}$ ($0 \le i < 8$) row in the second bit matrix $M_2$ to obtain an $i^{th}$ inner-code codeword, to obtain an inner-code codeword matrix $M_c$.

2 bits are read from each row in the inner-code codeword matrix $M_c$ through round robin, and all 1024 bits are read through 512 operations in total, to obtain an array A that includes m × N = 1024 interleaved bits. A bit in an $i^{th}$ row and a $j^{th}$ column in the inner-code codeword matrix $M_c$ is output to an $(i \times \lfloor j/2 \rfloor \times 16 + (i \times 2) + (j\%2))^{th}$ bit in the array A, and the following formula is satisfied:

$$A[i \times \lfloor j/2 \rfloor \times 16 + (i \times 2) + (j\%2)] = M_c[i][j]$$

where $0 \le i < 8$, $0 \le j < 128$, and $\lfloor \cdot \rfloor$ represents a rounding down operation.

Every two bits in the array A including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1$ = 1 first data stream, there are a total of 20 bits. The 20 bits undergo the foregoing interleaving and encoding processing, and are mapped to 10 PAM4 symbols in one PAM4 symbol data stream. The offset constraint factor $\varphi_i$ of the left circular shift is used, so that any two of the 10 PAM4 symbols can be separated by at least two PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0$ = 4, $n_1$ = 1, $a_0$ = 8, and $n_2 = n_0/n_1$ = 4, which may be applied to an 800GE scenario, where the $n_2$ = 4 second data streams have a rate about 200G, and are correspondingly carried on four lanes of optical signals for sending. The interleaving and encoding processing used in this embodiment may be applied to a 1.6TE scenario, where $n_0$ = 8, $n_1$ = 1, $a_0$ = 8, and $n_2 = n_0/n_1$ = 8. In this case, the physical medium attachment (Physical Medium Attachment, PMA) sublayer of the transmitter processing module performs the first data processing on the data from the plurality of synchronous client lanes (client lanes) to obtain $n_0$ = 8 first data streams. The foregoing $n_0$ = 8 first data streams are all outer-code encoded data streams. The interleaving and encoding processing is performed on every $n_1$ = 1 first data stream in the $n_0$ = 8 first data streams to obtain one second data stream, to obtain a total of $n_2$ = 8 second data streams. The $n_2$ = 8 second data streams (a rate is approximately 200G per second data stream) are correspondingly carried on eight lanes of optical signals for sending.

Embodiment X-10: $n_0$ = 8, $n_1$ = 2, and $a_0$ = 4. A data processing procedure includes convolutional interleaving. For example, a bit set is for representation, and right circular shift is used.

A physical medium attachment (Physical Medium Attachment, PMA) sublayer of a transmitter processing module performs first data processing on data from a plurality of synchronous client lanes (client lanes) to obtain $n_0$ = 8 first data streams. The foregoing $n_0$ = 8 first data streams are all outer-code encoded data streams. The interleaving and encoding processing is performed on every $n_1$ = 2 first data stream in the $n_0$ = 8 first data streams to obtain one second data stream, to obtain a total of $n_2$ = 4 second data streams.

Refer to FIG. 31. In the interleaving and encoding processing, the circular shift is first performed, then the inner-code encoding is performed, and then the round-robin reading is performed. For the $n_0$ = 2 first data streams, $a_0$ = 4 first bit sets are obtained from each first data stream, to obtain a total of m = $n_1 \times a_0$ = 8 first bit sets. Each first bit set includes K = 120 bits, and the 8 first bit sets include m × K = 960 bits in total. Convolutional interleaving processing is further performed on the first data stream before the circular shift, so that the K = 120 bits are from 12 KP4 symbols in 12 different outer-code KP4 RS codewords. Four consecutive first bit sets in one first data stream are referred to as the $0^{th}$ first bit set, the $1^{st}$ first bit set, the $2^{nd}$ first bit set, and the $3^{rd}$ first bit set. Four consecutive first bit sets in another first data stream are referred to as the $4^{th}$ first bit set, the $5^{th}$ first bit set, the $6^{th}$ first bit set, and the $7^{th}$ first bit set.

In this application, in a circular shift operation, the right circular shift is performed on an $i^{th}$ ($0 \le i < 8$) first bit set by $\delta_i$ bits, to obtain an $i^{th}$ second bit set, where specific values of eight offset constraint factors $\{\delta_0, \delta_1, \delta_2, \delta_3, \delta_4, \delta_5, \delta_6, \delta_7\}$ of the right circular shift are one of value items 2:

The inner-code encoding is performed on K = 120 bits in the $i^{th}$ second bit set, and P=8 parity bits are added to obtain an $i^{th}$ inner-code codeword including N=128 bits, to obtain m = 8 inner-code codewords in total. The K = 120 bits are also referred to as an information bit sequence.

Refer to FIG. 31. For m = 8 third bit sets output after the circular shift, in the round-robin reading, two bits are obtained from each third bit set through round robin, and consecutive 512 operations are performed to obtain all bits in the m = 8 third bit sets, to obtain a fourth bit set including m × N = 1024 bits. More specifically, two bits are obtained from the $0^{th}$ third bit set, two bits are obtained from the $1^{st}$ third bit set, ..., two bits are obtained from the $7^{th}$ third bit set, and then two bits are obtained from the $0^{th}$ third bit set until all 1024 bits are obtained.

It should be noted that, in the eight third bit sets, the $0^{th}$ third bit set, the $1^{st}$ third bit set, the $2^{nd}$ third bit set, and the $3^{rd}$ third bit set are from a same data stream, and the $4^{th}$ third bit set, the $5^{th}$ third bit set, the $6^{th}$ third bit set, and the $7^{th}$ third bit set are from the other data stream. That is, in the round-robin read operation, eight bits are first obtained from one data stream, and then eight bits are obtained from one data stream.

Every two bits in the fourth bit set including the 1024 bits are mapped to one PAM4 modulation symbol, to obtain 512 PAM4 symbols in total. The two bits mapped to the one PAM4 modulation symbol are from one inner-code codeword, and 16 bits mapped to 8 consecutive PAM4 modulation symbols are from 8 inner-code codewords.

For two KP4 outer-code symbols from a same RS outer-code codeword in the $n_1 = 1$ first data stream, there are a total of 20 bits. The 20 bits undergo the foregoing interleaving and encoding processing, and are mapped to 10 PAM4 symbols in one PAM4 symbol data stream. The offset constraint factor $\delta_i$ of the right circular shift is used, so that any two of the 10 PAM4 symbols can be separated by at least two PAM4 symbols in the PAM4 symbol data stream.

According to the interleaving and encoding processing method designed in this embodiment, both bits in an outer-code codeword and bits in an inner-code codeword are discretely and evenly mapped to modulation symbols. In this way, a concatenated-FEC transmission solution has a strong burst resistance capability.

It should be noted that, in this embodiment, $n_0 = 8$, $n_1 = 2$, $a_0 = 4$, and $n_2 = n_0/n_1 = 4$, which may be applied to an 800GE scenario, where the $n_2 = 4$ second data streams have a rate about 200G, and are correspondingly carried on four lanes of optical signals for sending. The interleaving and encoding processing used in this embodiment may be applied to a 1.6TE scenario, where $n_0 = 16$, $n_1 = 2$, $a_0 = 4$, and $n_2 = n_0/n_1 = 8$. In this case, the physical medium attachment (Physical Medium Attachment, PMA) sublayer of the transmitter processing module performs the first data processing on the data from the plurality of synchronous client lanes (client lanes) to obtain $n_0 = 16$ first data streams. The foregoing $n_0 = 16$ first data streams are all outer-code encoded data streams. The interleaving and encoding processing is performed on every $n_1 = 2$ first data stream in the $n_0 = 16$ first data streams to obtain one second data stream, to obtain a total of $n_2 = 8$ second data streams. The $n_2 = 8$ second data streams (a rate is approximately 200G per second data stream) are correspondingly carried on eight lanes of optical signals for sending.

It should be noted that, in some other specific implementations, four consecutive first bit sets in one first data stream are referred to as the 0th first bit set, the 2nd first bit set, the 4th first bit set, and the 6th first bit set. Four consecutive first bit sets in another first data stream are referred to as the 1st first bit set, the 3rd first bit set, the 5th first bit set, and the 7th first bit set. For m = 8 third bit sets output after the circular shift, in the round-robin reading, two bits are obtained from the 0th third bit set, two bits are obtained from the 1st third bit set, ..., two bits are obtained from the 7th third bit set, and then two bits are obtained from the 0th third bit set until all 1024 bits are obtained. Correspondingly, in the eight third bit sets, the 0th first bit set, the 2nd first bit set, the 4th first bit set, and the 6th third bit set are from a same data stream, and the 1st third bit set, the 3rd third bit set, the 5th third bit set, and the 7th third bit set are from the other data stream. That is, in the round-robin read operation, two bits are first obtained from one data stream, and then two bits are obtained from one data stream.

It should be noted that, in some other specific implementations, four consecutive first bit sets in one first data stream are referred to as the 0th first bit set, the 1st first bit set, the 4th first bit set, and the 5th first bit set. Four consecutive first bit sets in another first data stream are referred to as the 2nd first bit set, the 3rd first bit set, the 6th first bit set, and the 7th first bit set. For m = 8 third bit sets output after the circular shift, in the round-robin reading, two bits are obtained from the 0th third bit set, two bits are obtained from the 1st third bit set, ..., two bits are obtained from the 7th third bit set, and then two bits are obtained from the 0th third bit set until all 1024 bits are obtained. Correspondingly, in the eight third bit sets, the 0th third bit set, the 1st third bit set, the 4th third bit set, and the 5th third bit set are from a same data stream, and the 2nd third bit set, the 3rd third bit set, the 6th third bit set, and the 7th third bit set are from the other data stream. That is, in the round-robin read operation, four bits are first obtained from one data stream, and then four bits are obtained from one data stream.

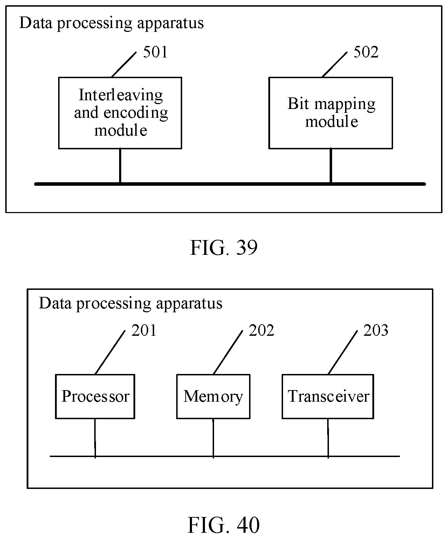

FIG. 39 is a diagram of another structure of a data processing apparatus according to an embodiment of this application. As shown in FIG. 39, the data processing apparatus includes an interleaving and encoding module 501 and a bit mapping module 502. The interleaving and encoding module 501 is configured to perform an operation of step 401 in the data processing method shown in FIG. 26. The bit mapping module 502 is configured to perform an operation of step 402 in the data processing method shown in FIG. 26. For details, refer to related descriptions in the data processing method shown in FIG. 26. Details are not described herein again.

It should be understood that the apparatus provided in this application may alternatively be implemented in another manner. For example, division into the units in the foregoing apparatus is merely logical function division and may be other division during actual implementation. For example, a plurality of units or components may be combined or integrated into another system. In addition, functional units in embodiments of this application may be integrated into one processing unit, each may be an independent physical unit, or two or more functional units may be integrated into one processing unit. The integrated unit may be implemented in a form of hardware, or may be implemented in a form of a software functional unit.

FIG. 40 is a diagram of another structure of a data processing apparatus according to an embodiment of this application. As shown in FIG. 40, the data processing apparatus includes a processor 201, a memory 202, and a transceiver 203. The processor 201, the memory 202, and the transceiver 203 are connected to each other through a line. The memory 202 is configured to store program instructions and data. Specifically, the transceiver 203 is configured to receive a first data stream. The processor 201 is configured to perform operations of the steps shown in FIG. 3 or FIG. 26. In a possible implementation, the processor 201 may include the encoding module 101, the bit interleaving module 102, and the bit mapping module 103 shown in FIG. 22. In another possible implementation, the processor 201 may include the interleaving and encoding module 501 and the bit mapping module 502 shown in FIG. 39.

It should be noted that the processor shown in FIG. 40 may be a general-purpose central processing unit (Central Processing Unit, CPU), a general-purpose processor, a digital signal processor (DSP), an application-specific integrated circuit (ASIC), a field programmable gate array (FPGA) or another programmable logic device, a transistor logic device, a hardware component, or any combination thereof. The memory shown in FIG. 40 may store an operating system and another application program. When the technical solutions provided in embodiments of this application are implemented by using software or firmware, program code for implementing the technical solutions provided in embodiments of this application is stored in the memory and is executed by the processor. In an embodiment, the processor may include the memory inside. In another embodiment, the processor and the memory are two independent structures.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

A person of ordinary skill in the art may understand that all or some of the steps in the foregoing embodiments may be implemented through hardware or a program instructing related hardware. The program may be stored in a computer-readable storage medium. The storage medium mentioned above may be a read-only memory, a random access memory, or the like. Whether the functions are performed by hardware or software depends on particular applications and design constraint conditions of the technical solutions. A person skilled in the art may use different methods to implement the functions for each particular application, but it should not be considered that this implementation goes beyond the scope of this application.

When software is used to implement the functions, all or some of the method steps described in the foregoing embodiments may be implemented in a form of a computer program product. The computer program product includes one or more computer instructions. When the computer program instructions are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from one computer-readable storage medium to another computer-readable storage medium. For example, the computer instructions may be transmitted from one website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive Solid State Disk (SSD)), or the like.

**Claims**

1. A data processing method, comprising:

   separately performing inner-code encoding on n first data streams to obtain n second data streams, wherein outer-code encoding is performed on all of the n first data streams, both the inner-code encoding and the outer-code encoding are forward error correction FEC encoding, the n second data streams at least comprise n inner-code codewords, the n inner-code codewords are respectively from the n second data streams, the n inner-code codewords comprise n/m codeword sets, each codeword set comprises m inner-code codewords, each of the inner-code codewords comprises N bits, the N bits comprise K information bits and P parity bits, n is an integer greater than 1, and n is divisible by m;
   separately performing bit interleaving on the n/m codeword sets to obtain n/m target bit sets, wherein each of the target bit sets comprises $m \times N$ bits; and
   mapping the $m \times N$ bits in each of the target bit sets to obtain $m \times N/L$ modulation symbols, to obtain a total of $n \times N/L$ modulation symbols, wherein every L bits are mapped to one modulation symbol, m is divisible by L, and the L bits mapped to the modulation symbol are respectively from L inner-code codewords, wherein
   if the L bits mapped to the modulation symbol are all from information bits in the inner-code codewords, any two of the L bits mapped to the modulation symbol are from two different locations in two different inner-code codewords.

2. The method according to claim 1, wherein N is divisible by L, the N bits in each inner-code codeword are mapped to N modulation symbols, the N bits in the inner-code codeword comprise L first bit subsets, bits in a same first bit subset are separately mapped to same bits in different modulation symbols, and bits in different first bit subsets are separately mapped to different bits in different modulation symbols.

3. The method according to claim 1 or 2, wherein performing the bit interleaving on the codeword set to obtain the target bit set comprises:

   performing first location transformation on the K information bits in each inner-code codeword in the codeword set to obtain a first bit set, and
   performing second location transformation on bits at a same location in the first bit set to obtain the target bit set.

4. The method according to claim 3, wherein the performing first location transformation on the K information bits in each inner-code codeword in the codeword set comprises:
   performing left circular shift or right circular shift on the K information bits in each inner-code codeword in the codeword set.

5. The method according to claim 3 or 4, wherein both the codeword set and the first bit set are represented as bit matrixes, the target bit set is represented as a bit matrix or a one-dimensional array, the bit matrix comprises m rows and N columns of bits, the one-dimensional array comprises the $m \times N$ bits, and the bits at the same location in the first bit set are a total of m bits in one column in the bit matrix corresponding to the first bit set.

6. The method according to claim 5, wherein the first location transformation satisfies a first condition, and the first condition comprises:

$$H_2[i][j] = \begin{cases} H_1[i][(j + i \times \Delta)\%K], & 0 \le j < K \\ H_1[i][j], & K \le j < N \end{cases}$$

   wherein $H_1[i][j]$ represents a bit in an $i^{th}$ row and a $j^{th}$ column in the bit matrix on which the first location transformation has not been performed, $H_2[i][j]$ represents a bit in an $i^{th}$ row and a $j^{th}$ column in the bit matrix obtained through the first location transformation, Y%Z represents a remainder obtained by dividing the integer Y by the integer Z, $\Delta$ is a non-zero integer greater than -K and less than K, and $0 \le i < m$.

7. The method according to any one of claims 3 to 6, wherein each same location in the first bit set comprises m/L second bit subsets, each second bit subset comprises L bits, and the performing second location transformation on bits at a same location in the first bit set comprises:
   performing upward circular shift or downward circular shift on the m/L second bit subsets at each same location in the first bit set.

8. The method according to claim 5, wherein the second location transformation satisfies a second condition, and the second condition comprises:

$$H_3[i][j] = H_2\big[(i + \theta \times (j\%L))\%L + \lfloor i/L \rfloor \times L\big][j]$$

   wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, $\theta$ is a non-zero integer greater than -L and less than L, $0 \le i < m$, and $0 \le j < N$.

9. The method according to claim 5, wherein the second location transformation satisfies a third condition, and the third condition comprises:

$$H_3[i][j] = H_2[(i\%L)^\wedge(j\%L) + \lfloor i/L \rfloor \times L][j]$$

   wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \le i < m$, and $0 \le j < N$.

10. The method according to claim 5, wherein the second location transformation satisfies a fourth condition, and the fourth condition comprises:

$$H_3[i][j] = H_2[i^\wedge(j\%L)][j]$$

wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \leq i < m$, and $0 \leq j < N$.

11. The method according to claim 1 or 2, wherein the codeword set is represented as a bit matrix, the target bit set is represented as a bit matrix or a one-dimensional array, the bit matrix comprises m rows and N columns of bits, and the one-dimensional array comprises the m×N bits.

12. The method according to claim 11, wherein the target bit set is the bit matrix, the bit interleaving satisfies a fifth condition, and the fifth condition comprises:

$$H_3[i][j] = \begin{cases} H_1\big[(i + \theta \times (j\%L))\%L + \lfloor i/L \rfloor \times L\big]\big[(j + ((i + \theta \times (j\%L))\%L + \lfloor i/L \rfloor \times L) \times \Delta)\%K\big], & 0 \leq j < K \\ H_1\big[(i + \theta \times (j\%L))\%L + \lfloor i/L \rfloor \times L\big][j], & K \leq j < N \end{cases}$$

wherein $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \leq i < m$.

13. The method according to claim 11, wherein the target bit set is the one-dimensional array, the bit interleaving satisfies a sixth condition, and the sixth condition comprises:

$$A[i + j \times m] = \begin{cases} H_1\big[(i + \theta \times (j\%L))\%L + \lfloor i/L \rfloor \times L\big]\big[(j + ((i + \theta \times (j\%L))\%L + \lfloor i/L \rfloor \times L) \times \Delta)\%K\big], & 0 \leq j < K \\ H_1\big[(i + \theta \times (j\%L))\%L + \lfloor i/L \rfloor \times L\big][j], & K \leq j < N \end{cases}$$

wherein $H_1[i][j]$ represents a bit in an $i^{th}$ row and a $j^{th}$ column in the bit matrix on which the bit interleaving has not been performed, A[t] represents a $t^{th}$ bit in the one-dimensional array obtained through the bit interleaving, $0 \leq t < m \times N$, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \leq i < m$.

14. The method according to claim 11, wherein the target bit set is the bit matrix, the bit interleaving satisfies a seventh condition, and the seventh condition comprises:

$$H_3[i][j] = \begin{cases} H_1[i^\wedge(j\%L)]\big[(j + (i^\wedge(j\%L)) \times \Delta)\%K\big], & 0 \leq j < K \\ H_1[i^\wedge(j\%L)][j], & K \leq j < N \end{cases}$$

wherein $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, Y^Z represents an integer corresponding to a bit sequence obtained through an exclusive OR operation performed on a bit sequence corresponding to the integer Y and a bit sequence corresponding to the integer Z, and $0 \leq i < m$.

15. The method according to claim 11, wherein the target bit set is the one-dimensional array, the bit interleaving satisfies an eighth condition, and the eighth condition comprises:

$$A[i + j \times m] = \begin{cases} H_1[i^{\wedge}(j\%L)][(j + (i^{\wedge}(j\%L)) \times \Delta)\%K], \ 0 \le j < K \\ H_1[i^{\wedge}(j\%L)][j], \ K \le j < N \end{cases}$$

wherein $H_1[i][j]$ represents a bit in an $i^{th}$ row and a $j^{th}$ column in the bit matrix on which the bit interleaving has not been performed, $A[t]$ represents a $t^{th}$ bit in the one-dimensional array obtained through the bit interleaving, $0 \le t < m \times N$, Y% Z represents a remainder obtained by dividing the integer Y by the integer Z, $\Delta$ is a non-zero integer greater than -K and less than K, Y^Z represents an integer corresponding to a bit sequence obtained through an exclusive OR operation performed on a bit sequence corresponding to the integer Y and a bit sequence corresponding to the integer Z, and $0 \le i < m$.

16. The method according to any one of claims 1 to 15, wherein the mapping the m×N bits in each target bit set to obtain m×N/L modulation symbols comprises:
mapping every L consecutive bits at a same location in each target bit set to one modulation symbol, to obtain the m×N/L modulation symbols.

17. The method according to claim 16, wherein a modulation symbol stream comprises the m×N/L modulation symbols obtained through the mapping, and m/L modulation symbols obtained through mapping of m bits at the same location in each target bit set are consecutive in the modulation symbol stream, wherein
when the target bit set is represented as the bit matrix, the m bits at the same location in the target bit set are m bits in one column in the bit matrix; or when the target bit set is represented as the one-dimensional array, the m bits at the same location in the target bit set are m consecutive bits in the one-dimensional array.

18. The method according to claim 16, wherein a modulation symbol stream comprises the m×N/L modulation symbols obtained through the mapping, each target bit set is represented as the bit matrix comprising the m rows and the N columns of bits, m bits in one column in each target bit set are mapped to obtain m/L first modulation symbols, every T consecutive first modulation symbols in the m/L first modulation symbols are consecutive in the modulation symbol stream, m bits in another column in each target bit set are mapped to obtain m/L second modulation symbols, every T consecutive second modulation symbols in the m/L second modulation symbols are consecutive in the modulation symbol stream, the column is adjacent to the another column, the T consecutive first modulation symbols in the m/L first modulation symbols and the T consecutive second modulation symbols in the m/L second modulation symbols are consecutive in the modulation symbol stream, and m/L is divisible by T.

19. The method according to any one of claims 1 to 18, wherein alignment marker lock and lane de-skew processing are performed on all of the n first data streams; and when W×L bits in W consecutive modulation symbols are all information bits in an inner-code codeword, the W×L bits are from more than two outer-code codewords obtained through the outer-code encoding, wherein W≥2.

20. The method according to any one of claims 1 to 19, wherein each modulation symbol is a dual-polarization 16 quadrature amplitude modulation DP-16QAM modulation symbol, and each modulation symbol comprises eight bits; or
each modulation symbol is a four-level pulse amplitude modulation PAM4 modulation symbol, and each modulation symbol comprises two bits.

21. A data processing method, comprising:

separately performing inner-code encoding on n first data streams to obtain n second data streams, wherein outer-code encoding is performed on all of the n first data streams, both the inner-code encoding and the outer-code encoding are forward error correction FEC encoding, the n second data streams at least comprise n inner-code codewords, the n inner-code codewords are respectively from the n second data streams, the n inner-code codewords comprise n/m codeword sets, each codeword set comprises m inner-code codewords, each of the inner-code codewords comprises N bits, the N bits comprise K information bits and P parity bits, n is an integer greater than 1, and n is divisible by m;
separately performing bit interleaving on the n/m codeword sets to obtain n/m target bit sets, wherein each of the target bit sets comprises m×N bits, and the bit interleaving comprises performing location transformation on the K information bits in each inner-code codeword in the codeword set, and
separately mapping the m×N bits in each of the target bit sets to obtain m×N/L modulation symbols, to obtain a total of n×N/L modulation symbols, wherein every L bits are mapped to one modulation symbol, m is divisible by L, the L bits mapped to the modulation symbol are from $L_r$ inner-code codewords, $L_c$ bits in each of the $L_r$ inner-code codewords are mapped to the modulation symbol, 2L bits mapped to two consecutive modulation symbols are from $2L_r$ inner-code codewords, $L = L_r \times L_c$, and $L_c > 1$.

22. The method according to claim 21, wherein the performing location transformation on the K information bits in each inner-code codeword in the codeword set comprises:
performing left circular shift or right circular shift on the K information bits in each inner-code codeword in the codeword set.

23. The method according to claim 21 or 22, wherein the codeword set is represented as a bit matrix, the target bit set is represented as a bit matrix or a one-dimensional array, the bit matrix comprises m rows and N columns of bits, and the one-dimensional array comprises the m×N bits.

24. The method according to claim 23, wherein the location transformation satisfies a target condition, and the target condition comprises:

$$H_2[i][j] = \begin{cases} H_1[i][(j + i \times \Delta)\%K], & 0 \le j < K \\ H_1[i][j], & K \le j < N \end{cases}$$

wherein $H_1[i][j]$ represents a bit in an $i^{th}$ row and a $j^{th}$ column in the bit matrix on which the location transformation has not been performed, $H_2[i][j]$ represents a bit in an $i^{th}$ row and a $j^{th}$ column in the bit matrix obtained through the location transformation, Y%Z represents a remainder obtained by dividing the integer Y by the integer Z, $\Delta$ is a non-zero integer greater than -K and less than K, and $0 \le i < m$.

25. The method according to any one of claims 21 to 24, wherein each target bit set comprises the m rows and the N columns of bits, and a total of L bits in every $L_r$ rows and $L_c$ columns in the target bit set are mapped to one modulation symbol.

26. The method according to claim 25, wherein a modulation symbol stream comprises the m×N/L modulation symbols obtained through the mapping, $m/L_r$ modulation symbols obtained through mapping of every $L_c$ columns of bits in the target bit set are consecutive in the modulation symbol stream, and m × N/L modulation symbols obtained through mapping of every N columns of bits in the target bit set are consecutive in the modulation symbol stream.

27. The method according to claim 25, wherein a modulation symbol stream comprises the m×N/L modulation symbols obtained through the mapping, bits in $L_c$ columns in each target bit set are mapped to obtain $m/L_r$ first modulation symbols, every T consecutive first modulation symbols in the $m/L_r$ first modulation symbols are consecutive in the modulation symbol stream, bits in $L_c$ other columns in each target bit set are mapped to obtain $m/L_r$ second modulation symbols, every T consecutive second modulation symbols in the $m/L_r$ second modulation symbols are consecutive in the modulation symbol stream, the $L_c$ columns are adjacent to the $L_c$ other columns, the T consecutive first modulation symbols in the $m/L_r$ first modulation symbols and the T consecutive second modulation symbols in the $m/L_r$ second modulation symbols are consecutive in the modulation symbol stream, and $m/L_r$ is divisible by T.

28. The method according to any one of claims 21 to 27, wherein each modulation symbol is a dual-polarization 16 quadrature amplitude modulation DP-16QAM modulation symbol, and each modulation symbol comprises eight bits;
or
each modulation symbol is a four-level pulse amplitude modulation PAM4 modulation symbol, and each modulation symbol comprises two bits.

29. A data processing apparatus, comprising: an encoding module, a bit interleaving module, and a bit mapping module, wherein

the encoding module is configured to separately perform inner-code encoding on n first data streams to obtain n second data streams, wherein outer-code encoding is performed on all of the n first data streams, both the inner-code encoding and the outer-code encoding are forward error correction FEC encoding, the n second data streams at least comprise n inner-code codewords, the n inner-code codewords are from the n second data streams, the n inner-code codewords comprise n/m codeword sets, each codeword set comprises m inner-code codewords, each of the inner-code codewords comprises N bits, the N bits comprise K information bits and P parity bits, n is an integer greater than 1, and n is divisible by m;

the bit interleaving module is configured to separately perform bit interleaving on the n/m codeword sets to obtain n/m target bit sets, wherein each of the target bit sets comprises m×N bits; and

the bit mapping module is configured to map the m×N bits in each of the target bit sets to obtain m×N/L modulation symbols, to obtain a total of n×N/L modulation symbols, wherein every L bits are mapped to one modulation symbol, m is divisible by L, and the L bits mapped to the modulation symbol are from L inner-code codewords, wherein

if the L bits mapped to the modulation symbol are all from information bits in the inner-code codewords, any two of the L bits mapped to the modulation symbol are from two different locations in two different inner-code codewords.

30. The data processing apparatus according to claim 29, wherein N is divisible by L, the N bits in each inner-code codeword are mapped to N modulation symbols, the N bits in the inner-code codeword comprise L first bit subsets, bits in a same first bit subset are separately mapped to same bits in different modulation symbols, and bits in different first bit subsets are separately mapped to different bits in different modulation symbols.

31. The data processing apparatus according to claim 29 or 30, wherein the bit mapping module is specifically configured to:

perform first location transformation on the K information bits in each inner-code codeword in the codeword set to obtain a first bit set, and

perform second location transformation on bits at a same location in the first bit set to obtain the target bit set.

32. The data processing apparatus according to claim 31, wherein the bit mapping module is specifically configured to: perform left circular shift or right circular shift on the K information bits in each inner-code codeword in the codeword set.

33. The data processing apparatus according to claim 31 or 32, wherein both the codeword set and the first bit set are represented as bit matrixes, the target bit set is represented as a bit matrix or a one-dimensional array, the bit matrix comprises m rows and N columns of bits, the one-dimensional array comprises the m×N bits, and the bits at the same location in the first bit set are a total of m bits in one column in the bit matrix corresponding to the first bit set.

34. The data processing apparatus according to claim 33, wherein the first location transformation satisfies a first condition, and the first condition comprises:

$$H_2[i][j] = \begin{cases} H_1[i][(j + i \times \Delta)\%K], & 0 \le j < K \\ H_1[i][j], & K \le j < N \end{cases}$$

wherein $H_1[i][j]$ represents a bit in an $i^{th}$ row and a $j^{th}$ column in the bit matrix on which the first location transformation has not been performed, $H_2[i][j]$ represents a bit in an $i^{th}$ row and a $j^{th}$ column in the bit matrix obtained through the first location transformation, Y%Z represents a remainder obtained by dividing the integer Y by the integer Z, $\Delta$ is a non-zero integer greater than -K and less than K, and $0 \le i < m$.

35. The data processing apparatus according to any one of claims 31 to 34, wherein each same location in the first bit set comprises m/L second bit subsets, each second bit subset comprises L bits, and the bit mapping module is specifically configured to:
perform upward circular shift or downward circular shift on the m/L second bit subsets at each same location in the first bit set.

36. The data processing apparatus according to claim 33, wherein the second location transformation satisfies a second condition, and the second condition comprises:

$$H_3[i][j] = H_2\big[(i + \theta \times (j\%L))\%L + \lfloor i/L \rfloor \times L\big][j]$$

wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, $\theta$ is a non-zero integer greater than -L and less than L, $0 \le i < m$, and $0 \le j < N$.

37. The data processing apparatus according to claim 33, wherein the second location transformation satisfies a third condition, and the third condition comprises:

$$H_3[i][j] = H_2[(i\%L)^\wedge(j\%L) + \lfloor i/L \rfloor \times L][j]$$

wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, $\lfloor \cdot \rfloor$ represents rounding down, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \le i < m$, and $0 \le j < N$.

38. The data processing apparatus according to claim 33, wherein the second location transformation satisfies a fourth condition, and the fourth condition comprises:

$$H_3[i][j] = H_2[i^\wedge(j\%L)][j]$$

wherein $H_2[i][j]$ represents a bit in an $i^{th}$ row and a $j^{th}$ column in the bit matrix on which the second location transformation has not been performed, $H_3[i][j]$ represents a bit in an $i^{th}$ row and a $j^{th}$ column in the bit matrix obtained through the second location transformation, Y%Z represents a remainder obtained by dividing the integer Y by the integer Z, Y^Z represents an integer corresponding to a bit sequence obtained through an exclusive OR operation performed on a bit sequence corresponding to the integer Y and a bit sequence corresponding to the integer Z, $0 \le i < m$, and $0 \le j < N$.

39. The data processing apparatus according to claim 29 or 30, wherein the codeword set is represented as a bit matrix, the target bit set is represented as a bit matrix or a one-dimensional array, the bit matrix comprises m rows and N columns of bits, and the one-dimensional array comprises the m$\times$N bits.

40. The data processing apparatus according to claim 39, wherein the target bit set is the bit matrix, the bit interleaving satisfies a fifth condition, and the fifth condition comprises:

$$H_3[i][j] = \begin{cases} H_1\left[(i + \theta \times (j\%L))\%L + \lfloor i/L \rfloor \times L\right]\left[\left(j + \left((i + \theta \times (j\%L))\%L + \lfloor i/L \rfloor \times L\right) \times \Delta\right)\%K\right], 0 \le j < K \\ H_1\left[(i + \theta \times (j\%L))\%L + \lfloor i/L \rfloor \times L\right][j], K \le j < N \end{cases}$$

wherein $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \le i < m$.

41. The data processing apparatus according to claim 39, wherein the target bit set is the one-dimensional array, the bit interleaving satisfies a sixth condition, and the sixth condition comprises:

$$A[i + j \times m] = \begin{cases} H_1\left[(i + \theta \times (j\%L))\%L + \lfloor i/L \rfloor \times L\right]\left[\left(j + \left((i + \theta \times (j\%L))\%L + \lfloor i/L \rfloor \times L\right) \times \Delta\right)\%K\right], 0 \le j < K \\ H_1\left[(i + \theta \times (j\%L))\%L + \lfloor i/L \rfloor \times L\right][j], K \le j < N \end{cases}$$

wherein $H_1[i][j]$ represents a bit in an $i^{th}$ row and a $j^{th}$ column in the bit matrix on which the bit interleaving has not been performed, A[t] represents a $t^{th}$ bit in the one-dimensional array obtained through the bit interleaving, $0 \le t < m \times N$, Y%Z represents a remainder obtained by dividing the integer Y by the integer Z, $\Delta$ is a non-zero integer greater than -K and less than K, $\lfloor \cdot \rfloor$ represents rounding down, $\theta$ is a non-zero integer greater than -L and less than L, and $0 \le i < m$.

42. The data processing apparatus according to claim 39, wherein the target bit set is the bit matrix, the bit interleaving satisfies a seventh condition, and the seventh condition comprises:

$$H_3[i][j] = \begin{cases} H_1[i\wedge(j\%L)][(j + (i\wedge(j\%L)) \times \Delta)\%K], 0 \le j < K \\ H_1[i\wedge(j\%L)][j], K \le j < N \end{cases}$$

wherein $H_1[i][j]$ represents a bit in an $i^{th}$ row and a $j^{th}$ column in the bit matrix on which the bit interleaving has not been performed, $H_3[i][j]$ represents a bit in an $i^{th}$ row and a $j^{th}$ column in the bit matrix obtained through the bit interleaving, $Y\%Z$ represents a remainder obtained by dividing the integer Y by the integer Z, $\Delta$ is a non-zero integer greater than -K and less than K, $Y\wedge Z$ represents an integer corresponding to a bit sequence obtained through an exclusive OR operation performed on a bit sequence corresponding to the integer Y and a bit sequence corresponding to the integer Z, and $0 \le i < m$.

43. The data processing apparatus according to claim 39, wherein the target bit set is the one-dimensional array, the bit interleaving satisfies an eighth condition, and the eighth condition comprises:

$$A[i + j \times m] = \begin{cases} H_1[i\wedge(j\%L)][(j + (i\wedge(j\%L)) \times \Delta)\%K], 0 \le j < K \\ H_1[i\wedge(j\%L)][j], K \le j < N \end{cases}$$

wherein $H_1[i][j]$ represents a bit in an $i^{th}$ row and a $j^{th}$ column in the bit matrix on which the bit interleaving has not been performed, $A[t]$ represents a $t^{th}$ bit in the one-dimensional array obtained through the bit interleaving, $0 \le t < m \times N$, $Y\%Z$ represents a remainder obtained by dividing the integer Y by the integer Z, $\Delta$ is a non-zero integer greater than -K and less than K, $Y\wedge Z$ represents an integer corresponding to a bit sequence obtained through an exclusive OR operation performed on a bit sequence corresponding to the integer Y and a bit sequence corresponding to the integer Z, and $0 \le i < m$.

44. The data processing apparatus according to any one of claims 29 to 43, wherein the bit mapping module is specifically configured to:
map every L consecutive bits at a same location in each target bit set to one modulation symbol, to obtain the $m\times N/L$ modulation symbols.

45. The data processing apparatus according to claim 44, wherein a modulation symbol stream comprises the $m\times N/L$ modulation symbols obtained through the mapping, and m/L modulation symbols obtained through mapping of m bits at the same location in each target bit set are consecutive in the modulation symbol stream, wherein
when the target bit set is represented as the bit matrix, the m bits at the same location in the target bit set are m bits in one column in the bit matrix; or when the target bit set is represented as the one-dimensional array, the m bits at the same location in the target bit set are m consecutive bits in the one-dimensional array.

46. The data processing apparatus according to claim 44, wherein a modulation symbol stream comprises the $m\times N/L$ modulation symbols obtained through the mapping, each target bit set is represented as the bit matrix comprising the m rows and the N columns of bits, m bits in one column in each target bit set are mapped to obtain m/L first modulation symbols, every T consecutive first modulation symbols in the m/L first modulation symbols are consecutive in the modulation symbol stream, m bits in another column in each target bit set are mapped to obtain m/L second modulation symbols, every T consecutive second modulation symbols in the m/L second modulation symbols are consecutive in the modulation symbol stream, the column is adjacent to the another column, the T consecutive first modulation symbols in the m/L first modulation symbols and the T consecutive second modulation symbols in the m/L second modulation symbols are consecutive in the modulation symbol stream, and m/L is divisible by T.

47. The data processing apparatus according to any one of claims 29 to 46, wherein marker lock and lane de-skew processing are performed on all of the n first data streams; and when $W\times L$ bits in W consecutive modulation symbols are all information bits in an inner-code codeword, the $W\times L$ bits are from more than two outer-code codewords obtained through the outer-code encoding, wherein $W \ge 2$.

48. The data processing apparatus according to any one of claims 29 to 47, wherein each modulation symbol is a dual-polarization 16 quadrature amplitude modulation DP-16QAM modulation symbol, and each modulation symbol comprises eight bits; or
each modulation symbol is a four-level pulse amplitude modulation PAM4 modulation symbol, and each modulation symbol comprises two bits.

**49.** A data processing apparatus, comprising: an encoding module, a bit interleaving module, and a bit mapping module, wherein

the encoding module is configured to separately perform inner-code encoding on n first data streams to obtain n second data streams, wherein outer-code encoding is performed on all of the n first data streams, both the inner-code encoding and the outer-code encoding are forward error correction FEC encoding, the n second data streams at least comprise n inner-code codewords, the n inner-code codewords are from the n second data streams, the n inner-code codewords comprise n/m codeword sets, each codeword set comprises m inner-code codewords, each of the inner-code codewords comprises N bits, the N bits comprise K information bits and P parity bits, n is an integer greater than 1, and n is divisible by m;
the bit interleaving module is configured to separately perform bit interleaving on the n/m codeword sets to obtain n/m target bit sets, wherein each of the target bit sets comprises m×N bits, and the bit interleaving comprises performing location transformation on the K information bits in each inner-code codeword in the codeword set; and
the bit mapping module is configured to map the m×N bits in each of the target bit sets to obtain m×N/L modulation symbols, to obtain a total of n×N/L modulation symbols, wherein every L bits are mapped to one modulation symbol, m is divisible by L, the L bits mapped to the modulation symbol are from $L_r$ inner-code codewords, $L_c$ bits in each of the $L_r$ inner-code codewords are mapped to the modulation symbol, 2L bits mapped to two consecutive modulation symbols are from $2L_r$ inner-code codewords, $L = L_r \times L_c$, and $L_c > 1$.

**50.** The data processing apparatus according to claim 49, wherein the bit interleaving module is specifically configured to: perform left circular shift or right circular shift on the K information bits in each inner-code codeword in the codeword set.

**51.** The data processing apparatus according to claim 49 or 50, wherein the codeword set is represented as a bit matrix, the target bit set is represented as a bit matrix or a one-dimensional array, the bit matrix comprises m rows and N columns of bits, and the one-dimensional array comprises the m×N bits.

**52.** The data processing apparatus according to claim 51, wherein the location transformation satisfies a target condition, and the target condition comprises:

$$H_2[i][j] = \begin{cases} H_1[i][(j + i \times \Delta)\%K], & 0 \leq j < K \\ H_1[i][j], & K \leq j < N \end{cases}$$

wherein $H_1[i][j]$ represents a bit in an $i^{th}$ row and a $j^{th}$ column in the bit matrix on which the location transformation has not been performed, $H_2[i][j]$ represents a bit in an $i^{th}$ row and a $j^{th}$ column in the bit matrix obtained through the location transformation, Y%Z represents a remainder obtained by dividing the integer Y by the integer Z, $\Delta$ is a non-zero integer greater than -K and less than K, and $0 \leq i < m$.

**53.** The data processing apparatus according to any one of claims 49 to 52, wherein each target bit set comprises the m rows and the N columns of bits, and a total of L bits in every $L_r$ rows and $L_c$ columns in the target bit set are mapped to one modulation symbol.

**54.** The data processing apparatus according to claim 53, wherein a modulation symbol stream comprises the m×N/L modulation symbols obtained through the mapping, $m/L_r$ modulation symbols obtained through mapping of every $L_c$ columns of bits in the target bit set are consecutive in the modulation symbol stream, and m × N/L modulation symbols obtained through mapping of every N columns of bits in the target bit set are consecutive in the modulation symbol stream.

**55.** The data processing apparatus according to claim 53, wherein a modulation symbol stream comprises the m×N/L modulation symbols obtained through the mapping, bits in $L_c$ columns in each target bit set are mapped to obtain $m/L_r$ first modulation symbols, every T consecutive first modulation symbols in the $m/L_r$ first modulation symbols are consecutive in the modulation symbol stream, bits in $L_c$ other columns in each target bit set are mapped to obtain $m/L_r$ second modulation symbols, every T consecutive second modulation symbols in the $m/L_r$ second modulation symbols are consecutive in the modulation symbol stream, the $L_c$ columns are adjacent to the $L_c$ other columns, the T consecutive first modulation symbols in the $m/L_r$ first modulation symbols and the T consecutive second modulation symbols in the $m/L_r$ second modulation symbols are consecutive in the modulation symbol stream, and $m/L_r$ is

divisible by T.

**56.** The data processing apparatus according to any one of claims 49 to 55, wherein each modulation symbol is a dual-polarization 16 quadrature amplitude modulation DP-16QAM modulation symbol, and each modulation symbol comprises eight bits; or
each modulation symbol is a four-level pulse amplitude modulation PAM4 modulation symbol, and each modulation symbol comprises two bits.

**57.** A data processing method, comprising:

separately performing interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0; and
separately mapping every two bits in the $n_2$ second data streams to one PAM4 symbol, to obtain a total of $n_2$ PAM4 symbol data streams, wherein
the interleaving and encoding processing comprises:

obtaining $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1;
separately performing inner-code encoding on the m first bit sets to obtain m inner-code codewords, wherein both the inner-code encoding and the outer-code encoding are forward error correction FEC encoding, each of the inner-code codewords comprises one first bit set and one parity bit set that participate in the inner-code encoding and that have a total of N bits, N=K+P, each parity bit set comprises P bits, and P is an integer greater than or equal to 1;
separately performing circular shift on the m inner-code codewords to obtain m third bit sets, wherein each of the third bit sets comprises one parity bit set and one second bit set that is obtained by performing the circular shift on the first bit set; and
obtaining, through round robin, two bits from each of the third bit sets to obtain a fourth bit set, wherein the fourth bit set comprises m × N bits, a total of m × K bits that are from m second bit sets are consecutive in the fourth bit set, and a total of m × P bits that are from m parity bit sets are consecutive in the fourth bit set, wherein
each of the second data streams comprises a plurality of fourth bit sets, a total of m × N/2 PAM4 symbols are obtained through the mapping of each of the fourth bit sets, and m × 2 bits mapped to m consecutive PAM4 symbols in the m × N/2 PAM4 symbols are from the m inner-code codewords.

**58.** The method according to claim 57, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

**59.** The method according to claim 57 or 58, wherein quantities of bits by which the circular shift is performed on any two of the m first bit sets are different.

**60.** The method according to any one of claims 57 to 59, wherein both the m inner-code codewords and the m third bit sets are represented as bit matrixes, and the bit matrix comprises m rows and N columns of bits.

**61.** The method according to claim 60, wherein the second bit set is obtained by performing left circular shift on the first bit set by $\varphi_i$ bits, the left circular shift satisfies a first condition, and the first condition comprises:

$$M_3[i][j] = \begin{cases} M_c[i][(j + \varphi_i)\%K], 0 \le j < K \\ M_c[i][j], K \le j < N \end{cases}$$

wherein $M_c[i][j]$ represents a bit in an $i^{th}$ row and a $j^{th}$ column in the bit matrix corresponding to the m inner-code codewords on which the left circular shift has not been performed, $M_3[i][j]$ represents a bit in an $i^{th}$ row and a $j^{th}$ column in the bit matrix corresponding to the m third bit sets obtained through the left circular shift, Y%Z represents a remainder obtained by dividing the integer Y by the integer Z, $0 \le i < m$, and $0 \le \varphi_i < K$.

62. The method according to claim 60, wherein the second bit set is obtained by performing right circular shift on the first bit set by $\delta_i$ bits, the right circular shift satisfies a second condition, and the second condition comprises:

$$M_3[i][j] = \begin{cases} M_c[i][(j-\delta_i)\%K], 0 \le j < K \\ M_c[i][j], K \le j < N \end{cases}$$

wherein $M_c[i][j]$ represents a bit in an $i^{th}$ row and a $j^{th}$ column in the bit matrix corresponding to the m inner-code codewords on which the right circular shift has not been performed, $M_3[i][j]$ represents a bit in an $i^{th}$ row and a $j^{th}$ column in the bit matrix corresponding to the m third bit sets obtained through the right circular shift, Y%Z represents a remainder obtained by dividing the integer Y by the integer Z, $0 \le i < m$, and $0 \le \delta_i < K$.

63. The method according to any one of claims 60 to 62, wherein the m third bit sets and the fourth bit set satisfy a third condition, and the third condition comprises:

$$A[\lfloor j/2 \rfloor \times (m \times 2) + (i \times 2) + (j\%2)] = M_3[i][j]$$

wherein $M_3[i][j]$ represents the bit in the $i^{th}$ row and the $j^{th}$ column in the bit matrix corresponding to the m third bit sets, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the fourth bit set, $0 \le i < m$, $0 \le j < N$, and $\lfloor \cdot \rfloor$ represents a rounding-down operation.

64. The method according to claim 57, 58, 59, 60, 61, or 63, wherein K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

65. The method according to claim 57, 58, 59, 60, 62, or 63, wherein K = 120, m = 8, an $i^{th}$ second bit set is obtained by performing the right circular shift on an $i^{th}$ first bit set by $\delta_i$ bits, $0 \le i < 8$, a value of $\delta_i$ satisfies any one of second value items $\{\delta_0, \delta_1, \delta_2, \delta_4, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90, 10, 40, 70, 100};
{0, 60, 90, 30, 10, 70, 100, 40};
{0, 90, 30, 60, 10, 100, 40, 70}; or
{0, 90, 60, 30, 10, 100, 70, 40}.

66. A data processing method, comprising:

separately performing interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0; and
separately mapping every two bits in the $n_2$ second data streams to one PAM4 symbol, to obtain a total of $n_2$ PAM4 symbol data streams, wherein
the interleaving and encoding processing comprises:

obtaining $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1;

separately performing circular shift on the m first bit sets to obtain m second bit sets, and separately performing inner-code encoding on the m first bit sets to obtain m parity bit sets, wherein both the inner-code encoding and the outer-code encoding are forward error correction FEC encoding, each of the second bit sets comprises K bits, each of the parity bit sets comprises P bits, and P is an integer greater than or equal to 1; and

obtaining, through round robin, two bits from each of the second bit sets to obtain a total of m $\times$ K consecutive bits, and obtaining, through round robin, two bits from each of the parity bit sets to obtain a total of m $\times$ P consecutive bits, to obtain a third bit set comprising m $\times$ N bits, wherein N=K+P, wherein

each second data stream comprises a plurality of third bit sets, each of the third bit sets comprises the m $\times$ K bits in the second bit sets and the m $\times$ P bits in the parity bit sets, a total of m $\times$ K/2 PAM4 symbols are obtained through the mapping of the m $\times$ K bits that are from the second bit sets and that are in each of the third bit sets, a total of m $\times$ P/2 PAM4 symbols are obtained through the mapping of the m $\times$ P bits that are from the parity bit sets and that are in each of the third bit sets, and m $\times$ 2 bits mapped to m consecutive PAM4 symbols in a total of m $\times$ N/2 PAM4 symbols are from the m second bit sets and/or the m parity bit sets.

67. The method according to claim 66, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

68. The method according to claim 66 or 67, wherein quantities of bits by which the circular shift is performed on any two of the m first bit sets are different.

69. The method according to any one of claims 66 to 68, wherein both the m first bit sets and the m second bit sets are represented as bit matrixes, and the bit matrix comprises m rows and K columns of bits.

70. The method according to claim 69, wherein the second bit set is obtained by performing left circular shift on the first bit set by $\varphi_i$ bits, the left circular shift satisfies a first condition, and the first condition comprises:

$$M_2[i][j] = M_1[i][(j + \varphi_i)\%K]$$

wherein $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \leq j < K$, $0 \leq i < m$, and $0 \leq \varphi_i < K$.

71. The method according to claim 69, wherein the second bit set is obtained by performing right circular shift on the first bit set by $\delta_i$ bits, the right circular shift satisfies a second condition, and the second condition comprises:

$$M_2[i][j] = M_1[i][(j - \delta_i)\%K]$$

wherein $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \leq j < K$, $0 \leq i < m$, and $0 \leq \delta_i < K$.

72. The method according to any one of claims 66 to 70, wherein K = 120, m = 8, an $i^{th}$ second bit set is obtained by performing the left circular shift on an $i^{th}$ first bit set by $\varphi_i$ bits, $0 \leq i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}.

**73.** The method according to claim 66, 67, 68, 69, or 71, wherein K = 120, m = 8, an $i^{th}$ second bit set is obtained by performing the right circular shift on an $i^{th}$ first bit by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90, 10, 40, 70, 100};
{0, 60, 90, 30, 10, 70, 100, 40};
{0, 90, 30, 60, 10, 100, 40, 70}; or
{0, 90, 60, 30, 10, 100, 70, 40}.

**74.** A data processing method, comprising:

separately performing interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0; and
separately mapping every two bits in the $n_2$ second data streams to one PAM4 symbol, to obtain a total of $n_2$ PAM4 symbol data streams, wherein
the interleaving and encoding processing comprises:

obtaining $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1;
separately performing circular shift on the m first bit sets to obtain m second bit sets, wherein each of the second bit sets comprises K bits;
separately performing inner-code encoding on the m second bit sets to obtain m inner-code codewords, wherein both the inner-code encoding and the outer-code encoding are forward error correction FEC encoding, each of the inner-code codewords comprises one second bit set and one parity bit set that participate in the inner-code encoding and that have a total of N bits, N=K+P, each parity bit set comprises P bits, and P is an integer greater than or equal to 1; and
obtaining, through round robin, two bits from each inner-code codeword to obtain a third bit set, wherein the third bit set comprises $m \times N$ bits, a total of $m \times K$ bits that are from the m second bit sets are consecutive in the third bit set, and a total of $m \times P$ bits that are from m parity bit sets are consecutive in the third bit set, wherein each second data stream comprises a plurality of third bit sets, a total of $m \times N/2$ PAM4 symbols are obtained through the mapping of each of the third bit sets, and $m \times 2$ bits mapped to m consecutive PAM4 symbols in the $m \times N/2$ PAM4 symbols are from the m inner-code codewords.

**75.** The method according to claim 74, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

**76.** The method according to claim 74 or 75, wherein quantities of bits by which the circular shift is performed on any two of the m first bit sets are different.

**77.** The method according to any one of claims 74 to 76, wherein both the m first bit sets and the m second bit sets are represented as bit matrixes, and the bit matrix comprises m rows and K columns of bits.

**78.** The method according to claim 77, wherein the second bit set is obtained by performing left circular shift on the first bit set by $\varphi_i$ bits, the left circular shift satisfies a first condition, and the first condition comprises:

$$M_2[i][j] = M_1[i][(j + \varphi_i)\%K]$$

wherein $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \le i < m$, $0 \le j < K$, and $0 \le \varphi_i < K$.

79. The method according to claim 77, wherein the second bit set is obtained by performing right circular shift on the first bit set by $\delta_i$ bits, the right circular shift satisfies a second condition, and the second condition comprises:

$$M_2[i][j] = M_1[i][(j-\delta_i)\%K]$$

wherein $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \le i < m$, $0 \le j < K$, and $0 \le \delta_i < K$.

80. The method according to any one of claims 77 to 79, wherein the m inner-code codewords are represented as a bit matrix comprising m rows and N columns, the m inner-code codewords and the third bit set satisfy a third condition, and the third condition comprises:

$$A[\lfloor j/2 \rfloor \times (m \times 2) + (i \times 2) + (j\%2)] = M_c[i][j]$$

wherein $M_c[i][j]$ represents a bit in an $i^{th}$ row and a $j^{th}$ column in the bit matrix corresponding to the m inner-code codewords, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the third bit set, $0 \le i < m$, $0 \le j < N$, and $\lfloor \cdot \rfloor$ represents a rounding-down operation.

81. The method according to claim 74, 75, 76, 77, 78, or 80, wherein K = 120, m = 8, an $i^{th}$ second bit set is obtained by performing the left circular shift on an $i^{th}$ first bit set by $\varphi_i$ bits, $0 \le i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30,110, 80, 50, 20}.

82. The method according to claim 74, 75, 76, 77, 79, or 80, wherein K = 120, m = 8, an $i^{th}$ second bit set is obtained by performing the right circular shift on an $i^{th}$ first bit set by $\delta_i$ bits, $0 \le i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90,10, 40, 70, 100};
{0, 60, 90, 30, 10, 70, 100, 40};
{0, 90, 30, 60, 10, 100, 40, 70}; or
{0, 90, 60, 30, 10, 100, 70, 40}.

83. A data processing method, comprising:

separately performing interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0; and
separately mapping every two bits in the $n_2$ second data streams to one PAM4 symbol, to obtain a total of $n_2$ PAM4 symbol data streams, wherein
the interleaving and encoding processing comprises:

obtaining $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1;

separately performing inner-code encoding on the m first bit sets to obtain m inner-code codewords, wherein both the inner-code encoding and the outer-code encoding are forward error correction FEC encoding, each of the inner-code codewords comprises one first bit set and one parity bit set that participate in the inner-code encoding and that have a total of N bits, N=K+P, each parity bit set comprises P bits, and P is an integer greater than or equal to 1; and

separately interleaving the m inner-code codewords to obtain one second bit set, wherein the second bit set comprises $m \times N$ bits, a $(\lfloor j/2 \rfloor \times (m \times 2) + (i \times 2) + (j\%2))^{th}$ bit in the second bit set satisfies a first condition or a second condition, $0 \le i < m$, and $0 \le j < N$, wherein

the first condition comprises:

$$A[\lfloor j/2 \rfloor \times (m \times 2) + (i \times 2) + (j\%2)] = \begin{cases} C_i[(j + \varphi_i)\%K], 0 \le j < K \\ C_i[j], K \le j < N \end{cases}$$

wherein $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j + \varphi_i)\%K]$ represents a $((j + \varphi_i)\%K)^{th}$ bit in an $i^{th}$ inner-code codeword, and $C_i[j]$ represents a $j^{th}$ bit in the $i^{th}$ inner-code codeword, and

the second condition comprises:

$$A[\lfloor j/2 \rfloor \times (m \times 2) + (i \times 2) + (j\%2)] = \begin{cases} C_i[(j - \delta_i)\%K], 0 \le j < K \\ C_i[j], K \le j < N \end{cases}$$

wherein $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j - \delta_i)\%K]$ represents a $((j - \delta_i)\%K)^{th}$ bit in the $i^{th}$ inner-code codeword, and $C_i[j]$ represents the $j^{th}$ bit in the $i^{th}$ inner-code codeword, wherein

each second data stream comprises a plurality of second bit sets, a total of $m \times N/2$ PAM4 symbols are obtained through the mapping of each of the second bit sets, and $m \times 2$ bits mapped to m consecutive PAM4 symbols in the $m \times N/2$ PAM4 symbols are from the m inner-code codewords.

84. The method according to claim 83, wherein K = 120, m = 8, a value of $\varphi_i$ satisfies any one of first value items {$\varphi_0$, $\varphi_1$, $\varphi_2$, $\varphi_3$, $\varphi_4$, $\varphi_5$, $\varphi_6$, $\varphi_7$}, and the first value items {$\varphi_0$, $\varphi_1$, $\varphi_2$, $\varphi_3$, $\varphi_4$, $\varphi_5$, $\varphi_6$, $\varphi_7$} comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60, 110, 80, 20, 50}; or
{0, 90, 60, 30, 110, 80, 50, 20}; and
a value of $\delta_i$ satisfies any one of second value items {$\delta_0$, $\delta_1$, $\delta_2$, $\delta_3$, $\delta_4$, $\delta_5$, $\delta_6$, $\delta_7$}, and the second value items {$\delta_0$, $\delta_1$, $\delta_2$, $\delta_3$, $\delta_4$, $\delta_5$, $\delta_6$, $\delta_7$} comprise:

{0, 30, 60, 90, 10, 40, 70, 100};
{0, 30, 90, 60, 10, 40, 100, 70};
{0, 60, 30, 90, 10, 40, 70, 100};
{0, 60, 90, 30, 10, 70, 100, 40};
{0, 90, 30, 60, 10, 100, 40, 70}; or
{0, 90, 60, 30, 10, 100, 70, 40}.

85. A data processing apparatus, comprising an interleaving and encoding module and a bit mapping module, wherein

the interleaving and encoding module is configured to separately perform interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0;
the bit mapping module is configured to separately map every two bits in the $n_2$ second data streams to one PAM4 symbol, to obtain a total of $n_2$ PAM4 symbol data streams; and
the interleaving and encoding module is specifically configured to: obtain $a_0$ first bit sets from each of the $n_1$ first data streams to obtain a total of $m = n_1 \times a_0$ first bit sets, wherein outer-code encoding is performed on all of the $n_1$

first data streams, each of the first bit sets comprises K bits, and $n_1$, $a_0$, and K are all integers greater than 1; separately perform inner-code encoding on the m first bit sets to obtain m inner-code codewords, wherein both the inner-code encoding and the outer-code encoding are forward error correction FEC encoding, each of the inner-code codewords comprises one first bit set and one parity bit set that participate in the inner-code encoding and that have a total of N bits, N=K+P, each parity bit set comprises P bits, and P is an integer greater than or equal to 1; separately perform circular shift on the m inner-code codewords to obtain m third bit sets, wherein each of the third bit sets comprises one parity bit set and one second bit set that is obtained by performing the circular shift on the first bit set; and

obtain a fourth bit set on a 2-bit round robin basis in each of the third bit sets, wherein the fourth bit set comprises m × N bits, a total of m × K bits that are from m second bit sets are consecutive in the fourth bit set, and a total of m × P bits that are from m parity bit sets are consecutive in the fourth bit set, wherein

each of the second data streams comprises a plurality of fourth bit sets, a total of m × N/2 PAM4 symbols are obtained through the mapping of each of the fourth bit sets, and m × 2 bits mapped to m consecutive PAM4 symbols in the m × N/2 PAM4 symbols are from the m inner-code codewords.

86. The data processing apparatus according to claim 85, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

87. The data processing apparatus according to claim 85 or 86, wherein quantities of bits by which the circular shift is performed on any two of the m first bit sets are different.

88. The data processing apparatus according to any one of claims 85 to 87, wherein both the m inner-code codewords and the m third bit sets are represented as bit matrixes, and the bit matrix comprises m rows and N columns of bits.

89. The data processing apparatus according to claim 88, wherein the second bit set is obtained by performing left circular shift on the first bit set by $\varphi_i$ bits, the left circular shift satisfies a first condition, and the first condition comprises:

$$M_3[i][j] = \begin{cases} M_c[i][(j + \varphi_i)\%K], 0 \le j < K \\ M_c[i][j], K \le j < N \end{cases}$$

wherein $M_c[i][j]$ represents a bit in an $i^{th}$ row and a $j^{th}$ column in the bit matrix corresponding to the m inner-code codewords on which the left circular shift has not been performed, $M_3[i][j]$ represents a bit in an $i^{th}$ row and a $j^{th}$ column in the bit matrix corresponding to the m third bit sets obtained through the left circular shift, Y%Z represents a remainder obtained by dividing the integer Y by the integer Z, $0 \le i < m$, and $0 \le \varphi_i < K$.

90. The data processing apparatus according to claim 88, wherein the second bit set is obtained by performing right circular shift on the first bit set by $\delta_i$ bits, the right circular shift satisfies a second condition, and the second condition comprises:

$$M_3[i][j] = \begin{cases} M_c[i][(j - \delta_i)\%K], 0 \le j < K \\ M_c[i][j], K \le j < N \end{cases}$$

wherein $M_c[i][j]$ represents a bit in an $i^{th}$ row and a $j^{th}$ column in the bit matrix corresponding to the m inner-code codewords on which the right circular shift has not been performed, $M_3[i][j]$ represents a bit in an $i^{th}$ row and a $j^{th}$ column in the bit matrix corresponding to the m third bit sets obtained through the right circular shift, Y%Z represents a remainder obtained by dividing the integer Y by the integer Z, $0 \le i < m$, and $0 \le \delta_i < K$.

91. The data processing apparatus according to any one of claims 88 to 90, wherein the m third bit sets and the fourth bit set satisfy a third condition, and the third condition comprises:

$$A[\lfloor j/2 \rfloor \times (m \times 2) + (i \times 2) + (j\%2)] = M_3[i][j]$$

wherein $M_3[i][j]$ represents the bit in the $i^{th}$ row and the $j^{th}$ column in the bit matrix corresponding to the m third bit sets,

$A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the fourth bit set, $0 \leq i < m$, $0 \leq j < N$, and $\lfloor \cdot \rfloor$ represents a rounding-down operation.

92. The data processing apparatus according to claim 85, 86, 87, 88, 89, or 91, wherein K = 120, m = 8, an $i^{th}$ second bit set is obtained by performing the left circular shift on an $i^{th}$ first bit set by $\varphi_i$; bits, $0 \leq i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

> {0, 30, 60, 90, 110, 20, 50, 80};
> {0, 30, 90, 60, 110, 20, 80, 50};
> {0, 60, 30, 90, 110, 50, 20, 80};
> {0, 60, 90, 30, 110, 50, 80, 20};
> {0, 90, 30, 60, 110, 80, 20, 50}; or
> {0, 90, 60, 30, 110, 80, 50, 20}.

93. The data processing apparatus according to claim 85, 86, 87, 88, 90, or 91, wherein K = 120, m = 8, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

> {0, 30, 60, 90, 10, 40, 70, 100};
> {0, 30, 90, 60, 10, 40, 100, 70};
> {0, 60, 30, 90,10,40,70, 100};
> {0, 60, 90, 30, 10, 70, 100, 40};
> {0, 90, 30, 60, 10, 100, 40, 70}; or
> {0, 90, 60, 30, 10, 100, 70, 40}.

94. A data processing apparatus, comprising an interleaving and encoding module and a bit mapping module, wherein

> the interleaving and encoding module is configured to separately perform interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0;
> the bit mapping module is configured to separately map every two bits in the $n_2$ second data streams to one PAM4 symbol, to obtain a total of $n_2$ PAM4 symbol data streams; and
> the interleaving and encoding module is specifically configured to: obtain $a_0$ first bit sets from each of the $n_1$ first data streams to obtain a total of m = $n_1 \times a_0$ first bit sets, wherein outer-code encoding is performed on all of the $n_1$ first data streams, each of the first bit sets comprises K bits, and $n_1$, $a_0$, and K are all integers greater than 1; separately perform circular shift on the m first bit sets to obtain m second bit sets, and separately performing inner-code encoding on the m first bit sets to obtain m parity bit sets, wherein both the inner-code encoding and the outer-code encoding are forward error correction FEC encoding, each of the second bit sets comprises K bits, each of the parity bit sets comprises P bits, and P is an integer greater than or equal to 1; and obtain, through round robin, two bits from each second bit set to obtain a total of m × K consecutive bits, and obtain, through round robin, two bits from each parity bit set to obtain a total of m × P consecutive bits, to obtain a third bit set comprising m × N bits, wherein N=K+P, wherein
> each second data stream comprises a plurality of third bit sets, each of the third bit sets comprises the m × K bits in the second bit sets and the m × P bits in the parity bit sets, a total of m × K/2 PAM4 symbols are obtained through the mapping of the m × K bits that are from the second bit sets and that are in each of the third bit sets, a total of m × P/2 PAM4 symbols are obtained through the mapping of the m × P bits that are from the parity bit sets and that are in each of the third bit sets, and m × 2 bits mapped to m consecutive PAM4 symbols in a total of m × N/2 PAM4 symbols are from the m second bit sets and/or the m parity bit sets.

95. The data processing apparatus according to claim 94, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

96. The data processing apparatus according to claim 94 or 95, wherein quantities of bits by which the circular shift is performed on any two of the m first bit sets are different.

97. The data processing apparatus according to any one of claims 94 to 96, wherein both the m first bit sets and the m second bit sets are represented as bit matrixes, and the bit matrix comprises m rows and K columns of bits.

98. The data processing apparatus according to claim 97, wherein the second bit set is obtained by performing left circular shift on the first bit set by $\varphi_i$; bits, the left circular shift satisfies a first condition, and the first condition comprises:

$$M_2[i][j] = M_1[i][(j + \varphi_i)\%K]$$

wherein $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \leq j < K$, $0 \leq i < m$, and $0 \leq \varphi_i < K$.

99. The data processing apparatus according to claim 97, wherein the second bit set is obtained by performing right circular shift on the first bit set by $\delta_i$ bits, the right circular shift satisfies a second condition, and the second condition comprises:

$$M_2[i][j] = M_1[i][(j-\delta_i)\%K]$$

wherein $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \leq j < K$, $0 \leq i < m$, and $0 \leq \delta_i < K$.

100.
The data processing apparatus according to any one of claims 94 to 98, wherein K = 120, m = 8, an $i^{th}$ second bit set is obtained by performing the left circular shift on an $i^{th}$ first bit set by $\varphi_i$; bits, $0 \leq i < 8$, a value of $\varphi_i$; satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60,110,80,20, 50}; or
{0, 90, 60, 30,110, 80, 50, 20}.

101.
The data processing apparatus according to claim 94, 95, 96, 97, or 99, wherein K = 120, m = 8, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90,10,40,70, 100};
{0, 60, 90, 30, 10, 70, 100, 40};
{0, 90, 30, 60, 10, 100,40, 70}; or
{0, 90, 60, 30, 10, 100, 70, 40}.

102.
A data processing apparatus, comprising an interleaving and encoding module and a bit mapping module, wherein

the interleaving and encoding module is configured to separately perform interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0;
the bit mapping module is configured to separately map every two bits in the $n_2$ second data streams to one PAM4 symbol, to obtain a total of $n_2$ PAM4 symbol data streams; and

the interleaving and encoding module is specifically configured to: obtain $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1;

separately perform circular shift on the m first bit sets to obtain m second bit sets, wherein each of the second bit sets comprises K bits,

separately perform inner-code encoding on the m second bit sets to obtain m inner-code codewords, wherein both the inner-code encoding and the outer-code encoding are forward error correction FEC encoding, each of the inner-code codewords comprises one second bit set and one parity bit set that participate in the inner-code encoding and that have a total of N bits, N=K+P, each parity bit set comprises P bits, and P is an integer greater than or equal to 1; and

obtain, through round robin, two bits from each inner-code codeword to obtain a third bit set, wherein the third bit set comprises m × N bits, a total of m × K bits that are from the m second bit sets are consecutive in the third bit set, and a total of m × P bits that are from m parity bit sets are consecutive in the third bit set, wherein

each second data stream comprises a plurality of third bit sets, a total of m × N/2 PAM4 symbols are obtained through the mapping of each of the third bit sets, and m × 2 bits mapped to m consecutive PAM4 symbols in the m × N/2 PAM4 symbols are from the m inner-code codewords.

**103.**

The data processing apparatus according to claim 102, wherein the outer-code encoding is performed on each of the first data streams, at least 10 PAM4 symbols are obtained through the interleaving and encoding processing and the mapping of 20 consecutive bits in the first data stream, the 20 consecutive bits are from two outer-code symbols in one outer-code codeword, and any two of the at least 10 PAM4 symbols are separated by at least two PAM4 symbols in the PAM4 symbol data stream.

**104.**

The data processing apparatus according to claim 102 or 103, wherein quantities of bits by which the circular shift is performed on any two of the m first bit sets are different.

**105.**

The data processing apparatus according to any one of claims 102 to 104, wherein both the m first bit sets and the m second bit sets are represented as bit matrixes, and the bit matrix comprises m rows and K columns of bits.

**106.**

The data processing apparatus according to claim 105, wherein the second bit set is obtained by performing left circular shift on the first bit set by $\varphi_i$ bits, the left circular shift satisfies a first condition, and the first condition comprises:

$$M_2[i][j] = M_1[i][(j + \varphi_i)\%K]$$

wherein $M_1[i][j]$ represents a bit in an $i^{th}$ row and a $j^{th}$ column in the bit matrix corresponding to the m first bit sets on which the left circular shift has not been performed, $M_2[i][j]$ represents a bit in an $i^{th}$ row and a $j^{th}$ column in the bit matrix corresponding to the m second bit sets obtained through the left circular shift, Y%Z represents a remainder obtained by dividing the integer Y by the integer Z, $0 \leq i < m$, $0 \leq j < K$, and $0 \leq \varphi_i < K$.

**107.**

The data processing apparatus according to claim 105, wherein the second bit set is obtained by performing right circular shift on the first bit set by $\delta_i$ bits, the right circular shift satisfies a second condition, and the second condition comprises:

$$M_2[i][j] = M_1[i][(j - \delta_i)\%K]$$

wherein $M_1[i][j]$ represents a bit in an $i^{th}$ row and a $j^{th}$ column in the bit matrix corresponding to the m first bit sets on which the right circular shift has not been performed, $M_2[i][j]$ represents a bit in an $i^{th}$ row and a $j^{th}$ column in the bit matrix corresponding to the m second bit sets obtained through the right circular shift, Y%Z represents a remainder obtained by dividing the integer Y by the integer Z, $0 \leq i < m$, $0 \leq j < K$, and $0 \leq \delta_i < K$.

**108.**

The data processing apparatus according to any one of claims 105 to 107, wherein the m inner-code codewords are represented as a bit matrix comprising m rows and N columns, the m inner-code codewords and the third bit set satisfy a third condition, and the third condition comprises:

$$A[\lfloor j/2 \rfloor \times (m \times 2) + (i \times 2) + (j\%2)] = M_c[i][j]$$

wherein $M_c[i][j]$ represents a bit in an $i^{th}$ row and a $j^{th}$ column in the bit matrix corresponding to the m inner-code codewords, $A[\lfloor j/2 \rfloor \times (m \times 2) + (i \times 2) + (j\%2)]$ represents a $(\lfloor j/2 \rfloor \times (m \times 2) + (i \times 2) + (j\%2))^{th}$ bit in the third bit set, $0 \leq i < m$, $0 \leq j < N$, and $\lfloor \cdot \rfloor$ represents a rounding-down operation.

109.
The data processing apparatus according to claim 102, 103, 104, 105, 106, or 108, wherein K = 120, m = 8, an $i^{th}$ second bit set is obtained by performing the left circular shift on an $i^{th}$ first bit set by $\varphi_i$ bits, $0 \leq i < 8$, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60,110, 80, 20, 50}; or
{0, 90, 60, 30,110, 80, 50, 20}.

110.
The data processing apparatus according to claim 102, 103, 104, 105, 107, or 108, wherein K = 120, m = 8, an $i^{th}$ second bit set is obtained by performing the right circular shift on an $i^{th}$ first bit set by $\delta_i$ bits, $0 \leq i < 8$, a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90, 10, 40, 70, 100};
{0, 60, 90, 30, 10, 70, 100, 40};
{0, 90, 30, 60, 10, 100,40, 70}; or
{0, 90, 60, 30, 10, 100, 70, 40}.

111. A data processing apparatus, comprising an interleaving and encoding module and a bit mapping module, wherein

the interleaving and encoding module is configured to separately perform interleaving and encoding processing on every $n_1$ first data streams in $n_0$ first data streams to obtain one second data stream, to obtain a total of $n_2$ second data streams, wherein $n_2 = n_0/n_1$, $n_0$ is an integer greater than 1, and $n_1$ is an integer greater than 0; the bit mapping module is configured to separately map every two bits in the $n_2$ second data streams to one PAM4 symbol, to obtain a total of $n_2$ PAM4 symbol data streams; and the interleaving and encoding module is specifically configured to: obtain $a_0$ first bit sets from each of the $n_1$ first data streams to obtain a total of $m = n_1 \times a_0$ first bit sets, wherein outer-code encoding is performed on all of the $n_1$ first data streams, each of the first bit sets comprises K bits, and $n_1$, $a_0$, and K are all integers greater than 1; separately perform inner-code encoding on the m first bit sets to obtain m inner-code codewords, wherein both the inner-code encoding and the outer-code encoding are forward error correction FEC encoding, each of the inner-code codewords comprises one first bit set and one parity bit set that participate in the inner-code encoding and that have a total of N bits, N=K+P, each parity bit set comprises P bits, and P is an integer greater than or equal to 1; and separately interleave the m inner-code codewords to obtain one second bit set, wherein the second bit set comprises $m \times N$ bits, a $(\lfloor j/2 \rfloor \times (m \times 2) + (i \times 2) + (j\%2))^{th}$ bit in the second bit set satisfies a first condition or a second condition, $0 \leq i < m$, and $0 \leq j < N$, wherein the first condition comprises:

$$A[\lfloor j/2 \rfloor \times (m \times 2) + (i \times 2) + (j\%2)] = \begin{cases} C_i[(j + \varphi_i)\%K], 0 \leq j < K \\ C_i[j], K \leq j < N \end{cases}$$

wherein $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j + \varphi_i)\%K]$ represents a $((j + \varphi i)\%K)^{th}$ bit in an $i^{th}$ inner-code codeword, and $C_i[j]$ represents a $j^{th}$ bit in the $i^{th}$ inner-code codeword, and

the second condition comprises:

$$A[\lfloor j/2 \rfloor \times (m \times 2) + (i \times 2) + (j\%2)] = \begin{cases} C_i[(j - \delta_i)\%K], 0 \le j < K \\ C_i[j], K \le j < N \end{cases}$$

wherein $A[\lfloor j/2 \rfloor \times (m \times 2) + (i \times 2) + (j\%2)]$ represents the $(\lfloor j/2 \rfloor \times (m \times 2) + (i \times 2) + (j\%2))^{th}$ bit in the second bit set, $C_i[(j - \delta_i)\%K]$ represents a $((j - \delta_i)\%K)^{th}$ bit in the $i^{th}$ inner-code codeword, and $C_i[j]$ represents the $j^{th}$ bit in the $i^{th}$ inner-code codeword, wherein

each second data stream comprises a plurality of second bit sets, a total of $m \times N/2$ PAM4 symbols are obtained through the mapping of each of the second bit sets, and $m \times 2$ bits mapped to m consecutive PAM4 symbols in the $m \times N/2$ PAM4 symbols are from the m inner-code codewords.

112.
The data processing apparatus according to claim 111, wherein K = 120, m = 8, a value of $\varphi_i$ satisfies any one of first value items $\{\varphi_0, \varphi_1, \varphi_2, \varphi_3, \varphi_4, \varphi_5, \varphi_6, \varphi_7\}$, and the first value items $\{\varphi_0, \varphi_1, \varphi_2, \varphi_3, \varphi_4, \varphi_5, \varphi_6, \varphi_7\}$ comprise:

{0, 30, 60, 90, 110, 20, 50, 80};
{0, 30, 90, 60, 110, 20, 80, 50};
{0, 60, 30, 90, 110, 50, 20, 80};
{0, 60, 90, 30, 110, 50, 80, 20};
{0, 90, 30, 60,110, 80, 20, 50}; or
{0, 90, 60, 30, 110, 80, 50, 20}; and
a value of $\delta_i$ satisfies any one of second value items $\{\delta_0, \delta_1, \delta_2, \delta_3, \delta_4, \delta_5, \delta_6, \delta_7\}$, and the second value items $\{\delta_0, \delta_1, \delta_2, \delta_3, \delta_4, \delta_5, \delta_6, \delta_7\}$ comprise:

{0, 30, 60, 90, 10, 40, 70, 100};
{0, 30, 90, 60, 10, 40, 100, 70};
{0, 60, 30, 90,10,40,70, 100};
{0, 60, 90, 30, 10, 70, 100, 40};
{0, 90, 30, 60, 10, 100,40, 70}; or
{0, 90, 60, 30, 10, 100, 70, 40}.

| Transmitter device 01 | Attachment unit interface AUI | Transmitter processing module 02 | Channel transmission medium 03 | Receiver processing module 04 | Attachment unit interface AUI | Receiver device 05 |

FIG. 1

| Transmitter device 01 | Outer-code encoded data → | Transmitter processing module 02 | Outer-code encoded and inner-code encoded data → | Channel transmission medium 03 |

| Receiver device 05 | ← Inner-code decoded data | Receiver processing module 04 | ← Outer-code encoded and inner-code encoded data | |

FIG. 2

Separately perform inner-code encoding on n first data streams to obtain n second data streams    / 301

Separately perform bit interleaving on n/m codeword sets to obtain n/m target bit sets    / 302

Separately map m×N bits in each of the target bit sets to obtain m×N/L modulation symbols, to obtain a total of n×N/L modulation symbols    / 303

FIG. 3

Information bits
whose length K=8

Parity bit whose
length is P

| $U_{i,0}$ | $U_{i,1}$ | $U_{i,2}$ | $U_{i,3}$ | $U_{i,4}$ | $U_{i,5}$ | $U_{i,6}$ | $U_{i,7}$ | |
|---|---|---|---|---|---|---|---|---|

Perform left circular
shift by two bits

| $U_{i,2}$ | $U_{i,3}$ | $U_{i,4}$ | $U_{i,5}$ | $U_{i,6}$ | $U_{i,7}$ | $U_{i,0}$ | $U_{i,1}$ | |
|---|---|---|---|---|---|---|---|---|

(a)

| $U_{0,0}$ | $U_{0,1}$ | $U_{0,2}$ | $U_{0,3}$ | $U_{0,4}$ | $U_{0,5}$ | $U_{0,6}$ | $U_{0,7}$ | |
|---|---|---|---|---|---|---|---|---|
| $U_{1,0}$ | $U_{1,1}$ | $U_{1,2}$ | $U_{1,3}$ | $U_{1,4}$ | $U_{1,5}$ | $U_{1,6}$ | $U_{1,7}$ | |
| $U_{2,0}$ | $U_{2,1}$ | $U_{2,2}$ | $U_{2,3}$ | $U_{2,4}$ | $U_{2,5}$ | $U_{2,6}$ | $U_{2,7}$ | |

Perform the left circular
shift by zero bits

Perform the left circular
shift by two bits

Perform the left circular
shift by four bits

| $U_{0,0}$ | $U_{0,1}$ | $U_{0,2}$ | $U_{0,3}$ | $U_{0,4}$ | $U_{0,5}$ | $U_{0,6}$ | $U_{0,7}$ | |
|---|---|---|---|---|---|---|---|---|
| $U_{1,2}$ | $U_{1,3}$ | $U_{1,4}$ | $U_{1,5}$ | $U_{1,6}$ | $U_{1,7}$ | $U_{1,0}$ | $U_{1,1}$ | |
| $U_{2,4}$ | $U_{2,5}$ | $U_{2,6}$ | $U_{2,7}$ | $U_{2,0}$ | $U_{2,1}$ | $U_{2,2}$ | $U_{2,3}$ | |

$\vdots$

(b)

$\vdots$

FIG. 4

| $U_{0,j}$ |
|-----------|
| $U_{1,j}$ |
| $U_{2,j}$ |
| $U_{3,j}$ |
| $U_{4,j}$ |
| $U_{5,j}$ |
| $U_{6,j}$ |
| $U_{7,j}$ |

| $U_{0,0}$ | $U_{0,1}$ | $U_{0,2}$ |
|-----------|-----------|-----------|
| $U_{1,0}$ | $U_{1,1}$ | $U_{1,2}$ |
| $U_{2,0}$ | $U_{2,1}$ | $U_{2,2}$ |
| $U_{3,0}$ | $U_{3,1}$ | $U_{3,2}$ |
| $U_{4,0}$ | $U_{4,1}$ | $U_{4,2}$ |
| $U_{5,0}$ | $U_{5,1}$ | $U_{5,2}$ |
| $U_{6,0}$ | $U_{6,1}$ | $U_{6,2}$ |
| $U_{7,0}$ | $U_{7,1}$ | $U_{7,2}$ |

...

Perform upward circular shift by two bits

Perform the upward circular shift by zero bits

Perform the upward circular shift by two bits

Perform the upward circular shift by four bits

| $U_{2,j}$ |
|-----------|
| $U_{3,j}$ |
| $U_{4,j}$ |
| $U_{5,j}$ |
| $U_{6,j}$ |
| $U_{7,j}$ |
| $U_{0,j}$ |
| $U_{1,j}$ |

| $U_{0,0}$ | $U_{2,1}$ | $U_{4,2}$ |
|-----------|-----------|-----------|
| $U_{1,0}$ | $U_{3,1}$ | $U_{5,2}$ |
| $U_{2,0}$ | $U_{4,1}$ | $U_{6,2}$ |
| $U_{3,0}$ | $U_{5,1}$ | $U_{7,2}$ |
| $U_{4,0}$ | $U_{6,1}$ | $U_{0,2}$ |
| $U_{5,0}$ | $U_{7,1}$ | $U_{1,2}$ |
| $U_{6,0}$ | $U_{0,1}$ | $U_{2,2}$ |
| $U_{7,0}$ | $U_{1,1}$ | $U_{3,2}$ |

...

(a)

(b)

FIG. 5

| $U_{0,0+8*k}$ | $U_{0,1+8*k}$ | $U_{0,2+8*k}$ | $U_{0,3+8*k}$ | $U_{0,4+8*k}$ | $U_{0,5+8*k}$ | $U_{0,6+8*k}$ | $U_{0,7+8*k}$ |
|---|---|---|---|---|---|---|---|
| $U_{1,0+8*k}$ | $U_{1,1+8*k}$ | $U_{1,2+8*k}$ | $U_{1,3+8*k}$ | $U_{1,4+8*k}$ | $U_{1,5+8*k}$ | $U_{1,6+8*k}$ | $U_{1,7+8*k}$ |
| $U_{2,0+8*k}$ | $U_{2,1+8*k}$ | $U_{2,2+8*k}$ | $U_{2,3+8*k}$ | $U_{2,4+8*k}$ | $U_{2,5+8*k}$ | $U_{2,6+8*k}$ | $U_{2,7+8*k}$ |
| $U_{3,0+8*k}$ | $U_{3,1+8*k}$ | $U_{3,2+8*k}$ | $U_{3,3+8*k}$ | $U_{3,4+8*k}$ | $U_{3,5+8*k}$ | $U_{3,6+8*k}$ | $U_{3,7+8*k}$ |
| $U_{4,0+8*k}$ | $U_{4,1+8*k}$ | $U_{4,2+8*k}$ | $U_{4,3+8*k}$ | $U_{4,4+8*k}$ | $U_{4,5+8*k}$ | $U_{4,6+8*k}$ | $U_{4,7+8*k}$ |
| $U_{5,0+8*k}$ | $U_{5,1+8*k}$ | $U_{5,2+8*k}$ | $U_{5,3+8*k}$ | $U_{5,4+8*k}$ | $U_{5,5+8*k}$ | $U_{5,6+8*k}$ | $U_{5,7+8*k}$ |
| $U_{6,0+8*k}$ | $U_{6,1+8*k}$ | $U_{6,2+8*k}$ | $U_{6,3+8*k}$ | $U_{6,4+8*k}$ | $U_{6,5+8*k}$ | $U_{6,6+8*k}$ | $U_{6,7+8*k}$ |
| $U_{7,0+8*k}$ | $U_{7,1+8*k}$ | $U_{7,2+8*k}$ | $U_{7,3+8*k}$ | $U_{7,4+8*k}$ | $U_{7,5+8*k}$ | $U_{7,6+8*k}$ | $U_{7,7+8*k}$ |

Second matrix $H_2$

| $U_{0,0+8*k}$ | $U_{1,1+8*k}$ | $U_{2,2+8*k}$ | $U_{3,3+8*k}$ | $U_{4,4+8*k}$ | $U_{5,5+8*k}$ | $U_{6,6+8*k}$ | $U_{7,7+8*k}$ |
|---|---|---|---|---|---|---|---|
| $U_{1,0+8*k}$ | $U_{0,1+8*k}$ | $U_{3,2+8*k}$ | $U_{2,3+8*k}$ | $U_{5,4+8*k}$ | $U_{4,5+8*k}$ | $U_{7,6+8*k}$ | $U_{6,7+8*k}$ |
| $U_{2,0+8*k}$ | $U_{3,1+8*k}$ | $U_{0,2+8*k}$ | $U_{1,3+8*k}$ | $U_{6,4+8*k}$ | $U_{7,5+8*k}$ | $U_{4,6+8*k}$ | $U_{5,7+8*k}$ |
| $U_{3,0+8*k}$ | $U_{2,1+8*k}$ | $U_{1,2+8*k}$ | $U_{0,3+8*k}$ | $U_{7,4+8*k}$ | $U_{6,5+8*k}$ | $U_{5,6+8*k}$ | $U_{4,7+8*k}$ |
| $U_{4,0+8*k}$ | $U_{5,1+8*k}$ | $U_{6,2+8*k}$ | $U_{7,3+8*k}$ | $U_{0,4+8*k}$ | $U_{1,5+8*k}$ | $U_{2,6+8*k}$ | $U_{3,7+8*k}$ |
| $U_{5,0+8*k}$ | $U_{4,1+8*k}$ | $U_{7,2+8*k}$ | $U_{6,3+8*k}$ | $U_{1,4+8*k}$ | $U_{0,5+8*k}$ | $U_{3,6+8*k}$ | $U_{2,7+8*k}$ |
| $U_{6,0+8*k}$ | $U_{7,1+8*k}$ | $U_{4,2+8*k}$ | $U_{5,3+8*k}$ | $U_{2,4+8*k}$ | $U_{3,5+8*k}$ | $U_{0,6+8*k}$ | $U_{1,7+8*k}$ |
| $U_{7,0+8*k}$ | $U_{6,1+8*k}$ | $U_{5,2+8*k}$ | $U_{4,3+8*k}$ | $U_{3,4+8*k}$ | $U_{2,5+8*k}$ | $U_{1,6+8*k}$ | $U_{0,7+8*k}$ |

Third matrix $H_3$

FIG. 6

| S(0,0) | S(0,1) | S(0,2) | ... | S(0,N–2) | S(0,N–1) |
|--------|--------|--------|-----|----------|----------|
| S(1,0) | S(1,1) | S(1,2) | ... | S(1,N–2) | S(1,N–1) |

Modulation symbols to which
a matrix H₃ is mapped

| S(0,0) | S(1,0) | S(0,1) | S(1,1) | S(0,2) | S(1,2) | ... | S(0,N–2) | S(1,N–2) | S(0,N–1) | S(1,N–1) |
|--------|--------|--------|--------|--------|--------|-----|----------|----------|----------|----------|

Modulation symbol stream

FIG. 7

EP 4 529 059 A1

| S(0,0) | S(0,1) | S(0,2) | ... | S(0,N−2) | S(0,N−1) |
|--------|--------|--------|-----|----------|----------|
| S(1,0) | S(1,1) | S(1,2) | ... | S(1,N−2) | S(1,N−1) |
| S(2,0) | S(2,1) | S(2,2) | ... | S(2,N−2) | S(2,N−1) |
| S(3,0) | S(3,1) | S(3,2) | ... | S(3,N−2) | S(3,N−1) |

Modulation symbols to which
a matrix $H_3$ is mapped

| S(0,0) | S(1,0) | S(0,1) | S(1,1) | ... | S(0,N−2) | S(1,N−1) | S(2,0) | S(3,0) | S(2,1) | S(3,1) | ... | S(2,N−1) | S(3,N−1) |

Modulation symbol stream

FIG. 8

| S(0,0) | S(0,1) | S(0,2) | ... | S(0,N/$L_c$−2) | S(0,N/$L_c$−1) |
|--------|--------|--------|-----|----------------|----------------|
| S(1,0) | S(1,1) | S(1,2) | ... | S(1,N/$L_c$−2) | S(1,N/$L_c$−1) |

Modulation symbols to which
a matrix $H_3$ is mapped

| S(0,0) | S(1,0) | S(0,1) | S(1,1) | S(0,2) | S(1,2) | ... | S(0,N/$L_c$−2) | S(1,N/$L_c$−2) | S(0,N/$L_c$−1) | S(1,N/$L_c$−1) |
|--------|--------|--------|--------|--------|--------|-----|----------------|----------------|----------------|----------------|

Modulation symbol stream

FIG. 9

| | | | | | |
|---|---|---|---|---|---|
| S(0,0) | S(0,1) | S(0,2) | ... | S(0,N/$L_c$−2) | S(0,N/$L_c$−1) |
| S(1,0) | S(1,1) | S(1,2) | ... | S(1,N/$L_c$−2) | S(1,N/$L_c$−1) |
| S(2,0) | S(2,1) | S(2,2) | ... | S(2,N/$L_c$−2) | S(2,N/$L_c$−1) |
| S(3,0) | S(3,1) | S(3,2) | ... | S(3,N/$L_c$−2) | S(3,N/$L_c$−1) |

Modulation symbols to which
a matrix H$_3$ is mapped

| | | | | | | | | | | | | | |
|---|---|---|---|---|---|---|---|---|---|---|---|---|---|
| S(0,0) | S(1,0) | S(0,1) | S(1,1) | ... | S(0,N/$L_c$−1) | S(1,N/$L_c$−1) | S(2,0) | S(3,0) | S(2,1) | S(3,1) | ... | S(2,N/$L_c$−1) | S(3,N/$L_c$−1) |

Modulation symbol stream

FIG. 10

FIG. 11

AUI client lane → Physical medium attachment PMA sublayer → Alignment marker lock → Lane de-skew processing → Lane reorder → Concatenated interleaving

Data stream 0 → Inner-code encoding → Bit interleaving and mapping

Data stream 1 → Inner-code encoding → Bit interleaving and mapping

Data stream n → Inner-code encoding → Bit interleaving and mapping

FIG. 12(a)

EP 4 529 059 A1

FIG. 12(b)

FIG. 12(c)

EP 4 529 059 A1

FIG. 12(d)

FIG. 13

FIG. 14

FIG. 15

FIG. 16

Four symbols

Delay line 0

D ... D D ... D D ... D

$C_r(16t)$, $C_r(16t+1)$, $C_r(16t+2)$, and $C_r(16t+3)$

3Q

$C_r(16t-48Q)$, $C_r(16t-48Q+1)$, $C_r(16t-48Q+2)$, and $C_r(16t-48Q+3)$

Delay line 1

D ... D D ... D

$C_r(16t+4)$, $C_r(16t+5)$, $C_r(16t+6)$, and $C_r(16t+7)$

2Q

$C_r(16t-32Q+4)$, $C_r(16t-32Q+5)$, $C_r(16t-32Q+6)$, and $C_r(16t-32Q+7)$

Delay line 2

D ... D

$C_r(16t+8)$, $C_r(16t+9)$, $C_r(16t+10)$, and $C_r(16t+11)$

Q

$C_r(16t-16Q+8)$, $C_r(16t-16Q+9)$, $C_r(16t-16Q+10)$, and $C_r(16t-16Q+11)$

Delay line 3

$C_r(16t+12)$, $C_r(16t+13)$, $C_r(16t+14)$, and $C_r(16t+15)$

$C_r(16t+12)$, $C_r(16t+13)$, $C_r(16t+14)$, and $C_r(16t+15)$

FIG. 17

FIG. 18

Two symbols

Delay line 0

$C_r(8t)$ and $C_r(8t+1)$

| D | ... | D | D | ... | D | D | ... | D |

$C_r(8t-24Q)$ and $C_r(8t-24Q+1)$

3Q

Delay line 1

$C_r(8t+2)$ and $C_r(8t+3)$

| D | ... | D | D | ... | D |

$C_r(8t-16Q+2)$ and $C_r(8t-16Q+3)$

2Q

Delay line 2

$C_r(8t+4)$ and $C_r(8t+5)$

| D | ... | D |

$C_r(8t-8Q+4)$ and $C_r(8t-8Q+5)$

Q

Delay line 3

$C_r(8t+6)$ and $C_r(8t+7)$

$C_r(8t+6)$ and $C_r(8t+7)$

FIG. 19

| Lane data stream 0 | → | Convolutional interleaving | → | First data stream 0 |
| Lane data stream 1 | → | Convolutional interleaving | → | First data stream 1 |
| ⋮ | | ⋮ | | ⋮ |
| Lane data stream 6 | → | Convolutional interleaving | → | First data stream 6 |
| Lane data stream 7 | → | Convolutional interleaving | → | First data stream 7 |

FIG. 20

Delay line 0

Two symbols

$C_r(12t)$ and $C_r(12t+1)$ ... $C_r(12t-60Q)$ and $C_r(12t-60Q+1)$

5Q

Delay line 1

$C_r(12t+2)$ and $C_r(12t+3)$ ... $C_r(12t-48Q+2)$ and $C_r(12t-48Q+3)$

4Q

Delay line 2

$C_r(12t+4)$ and $C_r(12t+5)$ ... $C_r(12t-36Q+4)$ and $C_r(12t-36Q+5)$

3Q

Delay line 3

$C_r(12t+6)$ and $C_r(12t+7)$ ... $C_r(12t-24Q+6)$ and $C_r(12t-24Q+7)$

2Q

Delay line 4

$C_r(12t+8)$ and $C_r(12t+9)$ ... $C_r(12t-12Q+8)$ and $C_r(12t-12Q+9)$

Q

Delay line 5

$C_r(12t+10)$ and $C_r(12t+11)$ $C_r(12t+10)$ and $C_r(12t+11)$

FIG. 21

Four symbols

Delay line 0

$C_r(16t)$, $C_r(16t+1)$, $C_r(16t+2)$, and $C_r(16t+3)$

2Q

$C_r(16t-24Q)$, $C_r(16t-24Q+1)$, $C_r(16t-24Q+2)$, and $C_r(16t-24Q+3)$

Delay line 1

$C_r(16t+4)$, $C_r(16t+5)$, $C_r(16t+6)$, and $C_r(16t+7)$

Q

$C_r(16t-12Q+4)$, $C_r(16t-12Q+5)$, $C_r(16t-12Q+6)$, and $C_r(16t-12Q+7)$

Delay line 2

$C_r(16t+8)$, $C_r(16t+9)$, $C_r(16t+10)$, and $C_r(16t+11)$

$C_r(16t+8)$, $C_r(16t+9)$, $C_r(16t+10)$, and $C_r(16t+11)$

FIG. 22

Delay line 0

$C_r(6t)$ and $C_r(6t+1)$ ——— [D] ··· [D] [D] ··· [D] ——— $C_r(6t-12Q)$ and $C_r(6t-12Q+1)$

Two symbols

2Q

Delay line 1

$C_r(6t+2)$ and $C_r(6t+3)$ ——— [D] ··· [D] ——— $C_r(6t-6Q+2)$ and $C_r(6t-6Q+3)$

Q

Delay line 2

$C_r(6t+4)$ and $C_r(6t+5)$ ——————————— $C_r(6t+4)$ and $C_r(6t+5)$

FIG. 23

Bit interleaving
and mapping 0

Bit interleaving
and mapping 1

Inner-code
encoding

**n first
data
streams**

**n second
data
streams**

⋮

Bit interleaving
and mapping V−1

FIG. 24

Data processing apparatus

101

102

103

Encoding
module

Bit
interleaving
module

Bit mapping
module

FIG. 25

Separately perform interleaving and encoding processing on every $n_1$ first data streams in $n_0$ first data streams to obtain one second data stream, to obtain a total of $n_2$ second data streams

401

Separately map every two bits in the $n_2$ second data streams to one PAM4 symbol, to obtain $n_2$ PAM4 symbol data streams

402

FIG. 26

FIG. 27

K bits

m
rows

First bit
matrix $M_1$

There are a total
of 10 bits in one
KP4 symbol

Inner-code
encoding

N bits

m
rows

Inter-code
parity bit

Inner-code codeword
matrix $M_c$

Perform circular
shift on an
information part

Third bit
matrix $M_3$

m
rows

Read two
bits from
each row
through
round
robin

Array A

Information part

Parity part

FIG. 28

FIG. 29

First bit
matrix $M_1$

K bits

m
rows

There are a total of 10 bits
in one KP4 symbol

Second bit
matrix $M_2$

K bits

Circular
shift

m
rows

Read two bits from
each row through
round robin

Information bit part

Parity bit
part

Array A

Inner-code
encoding

m
rows

Parity bit
matrix $M_p$

P parity bits

Read two bits from
each row through
round robin

FIG. 30

FIG. 31

FIG. 32

EP 4 529 059 A1

120 bits

128 bits

Third bit matrix $M_3$

Eight rows

First bit matrix $M_1$

Inner-code encoding

There are a total of 10 bits in one KP4 symbol

Inner-code codeword matrix $M_c$

Inter-code parity bit

Perform circular shift on an information part

Read two bits from each row through a round robin

Information bit part (960 bits)

Parity bit part (1024 bits)

FIG. 33

120 bits

| a | b | c | d | f | g | h | k | p | q | r | s |
|---|---|---|---|---|---|---|---|---|---|---|---|
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |

Eight rows

First bit matrix $M_1$

Inner-code encoding

There are a total of 10 bits in one KP4 symbol

128 bits

| a | b | c | d | f | g | h | k | p | q | r | s | |
|---|---|---|---|---|---|---|---|---|---|---|---|---|
| a | b | c | d | f | g | h | k | p | q | r | s | |
| a | b | c | d | f | g | h | k | p | q | r | s | |
| a | b | c | d | f | g | h | k | p | q | r | s | |
| a | b | c | d | f | g | h | k | p | q | r | s | |
| a | b | c | d | f | g | h | k | p | q | r | s | |
| a | b | c | d | f | g | h | k | p | q | r | s | |
| a | b | c | d | f | g | h | k | p | q | r | s | |

Inner-code codeword matrix $M_c$

Inter-code parity bit

Perform circular shift on an information part

Third bit matrix $M_3$

| a | b | c | d | f | g | h | k | p | q | r | s | |
|---|---|---|---|---|---|---|---|---|---|---|---|---|
| d | f | g | h | k | p | q | r | s | a | b | c | |
| h | k | p | q | r | s | a | b | c | d | f | g | |
| q | r | s | a | b | c | d | f | g | h | k | p | |
| s | a | b | c | d | f | g | h | k | p | q | r | |
| c | d | f | g | h | k | p | q | r | s | a | b | |
| g | h | k | p | q | r | s | a | b | c | d | f | |
| p | q | r | s | a | b | c | d | f | g | h | k | |

Read two bits from each row through round robin

Information bit part (960 bits)

Parity bit part (1024 bits)

FIG. 34

114

FIG. 35

FIG. 36

EP 4 529 059 A1

Second bit matrix $M_2$

120 bits

Read two bits from each row through round robin

| a | b | c | d | f | g | h | k | p | q | r | s |
|---|---|---|---|---|---|---|---|---|---|---|---|
| d | f | g | h | k | p | q | r | s | a | b | c |
| h | k | p | q | r | s | a | b | c | d | f | g |
| q | r | s | a | b | c | d | f | g | h | k | p |
| s | a | b | c | d | f | g | h | k | p | q | r |
| c | d | f | g | h | k | p | q | r | s | a | b |
| g | h | k | p | q | r | s | a | b | c | d | f |
| p | q | r | s | a | b | c | d | f | g | h | k |

Circular shift

120 bits

| a | b | c | d | f | g | h | k | p | q | r | s |
|---|---|---|---|---|---|---|---|---|---|---|---|
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |

Eight rows

First bit matrix $M_1$

There are a total of 10 bits in one KP4 symbol

Inner-code encoding

Eight bits

Parity bit matrix $M_p$

Read two bits from each row through round robin

Array A

Parity bit part (1024 bits)

Information bit part (960 bits)

FIG. 37

120 bits

120 bits

Inner-code
128 bits codeword matrix M$_c$

| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |
| a | b | c | d | f | g | h | k | p | q | r | s |

Eight rows

Circular shift

First bit matrix M$_1$

There are a total of 10 bits in one KP4 symbol

| a | b | c | d | f | g | h | k | p | q | r | s |
| q | r | s | a | b | c | d | f | g | h | k | p |
| h | k | p | q | r | s | a | b | c | d | f | g |
| d | f | g | h | k | p | q | r | s | a | b | c |
| s | a | b | c | d | f | g | h | k | p | q | r |
| p | q | r | s | a | b | c | d | f | g | h | k |
| g | h | k | p | q | r | s | a | b | c | d | f |
| c | d | f | g | h | k | p | q | r | s | a | b |

Second bit matrix M$_2$

Inner-code encoding

| a | b | c | d | f | g | h | k | p | q | r | s |
| q | r | s | a | b | c | d | f | g | h | k | p |
| h | k | p | q | r | s | a | b | c | d | f | g |
| d | f | g | h | k | p | q | r | s | a | b | c |
| s | a | b | c | d | f | g | h | k | p | q | r |
| p | q | r | s | a | b | c | d | f | g | h | k |
| g | h | k | p | q | r | s | a | b | c | d | f |
| c | d | f | g | h | k | p | q | r | s | a | b |

Inter-code parity bit

Read two bits from each row through round robin

Information bit part (960 bits)

Parity bit part (1024 bits)

FIG. 38

EP 4 529 059 A1

Data processing apparatus

501

502

Interleaving and encoding module

Bit mapping module

FIG. 39

Data processing apparatus

201

202

203

Processor

Memory

Transceiver

FIG. 40

## INTERNATIONAL SEARCH REPORT

| International application No. |
| --- |
| **PCT/CN2023/098219** |

**A.    CLASSIFICATION OF SUBJECT MATTER**

H04L 1/00(2006.01)i

According to International Patent Classification (IPC) or to both national classification and IPC

**B.    FIELDS SEARCHED**

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

DWPI, ENTXT, CNTXT, CJFD, 3GPP: 内码, 外码, 编码, 前向纠错编码, 码字, 集合, 比特, 交织, 映射, 校验, 循环, 移位, inner code, outer code, FEC, aggregate, bit, interleave, map, verify, circle, shift

**C.    DOCUMENTS CONSIDERED TO BE RELEVANT**

| Category* | Citation of document, with indication, where appropriate, of the relevant passages | Relevant to claim No. |
| --- | --- | --- |
| A | CN 111277830 A (HUAWEI TECHNOLOGIES CO., LTD.) 12 June 2020 (2020-06-12) description, paragraphs [0054]-[0275] | 1-112 |
| A | CN 101013931 A (INNOFIDEI TECHNOLOGY CO., LTD.) 08 August 2007 (2007-08-08) entire document | 1-112 |
| A | CN 1427548 A (NEC CORP.) 02 July 2003 (2003-07-02) entire document | 1-112 |
| A | US 2007098110 A1 (GENERAL INSTRUMENT CORP.) 03 May 2007 (2007-05-03) the whole document | 1-112 |

☐ Further documents are listed in the continuation of Box C.        ☑ See patent family annex.

| | |
| --- | --- |
| *       Special categories of cited documents:<br>"A"    document defining the general state of the art which is not considered to be of particular relevance<br>"D"    document cited by the applicant in the international application<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
| --- | --- |
| **14 August 2023** | **18 August 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

| Patent document cited in search report | | | Publication date (day/month/year) | Patent family member(s) | | | Publication date (day/month/year) |
|---|---|---|---|---|---|---|---|
| CN | 111277830 | A | 12 June 2020 | EP | 3737013 | A1 | 11 November 2020 |
| | | | | US | 2020382142 | A1 | 03 December 2020 |
| | | | | WO | 2020114318 | A1 | 11 June 2020 |
| CN | 101013931 | A | 08 August 2007 | None | | | |
| CN | 1427548 | A | 02 July 2003 | US | 2003126549 | A1 | 03 July 2003 |
| | | | | EP | 1324501 | A1 | 02 July 2003 |
| | | | | JP | 2003188738 | A | 04 July 2003 |
| | | | | AU | 2002318785 | A1 | 10 July 2003 |
| US | 2007098110 | A1 | 03 May 2007 | None | | | |

**INTERNATIONAL SEARCH REPORT**
Information on patent family members

International application No.

**PCT/CN2023/098219**

Form PCT/ISA/210 (patent family annex) (July 2022)

**REFERENCES CITED IN THE DESCRIPTION**

**Patent documents cited in the description**

- CN 202210727137
- CN 202210867882
- CN 202310382561